(19) Europäisches Patentamt
European Patent Office
Office européen des brevets

(11) EP 3 203 543 B1

(12) # EUROPEAN PATENT SPECIFICATION

(45) Date of publication and mention of the grant of the patent:
**13.05.2020 Bulletin 2020/20**

(21) Application number: **15846617.7**

(22) Date of filing: **25.09.2015**

(51) Int Cl.:
***H01L 51/50*** (2006.01)
***C09K 11/06*** (2006.01)
***H01L 51/00*** (2006.01)
***C09K 11/02*** (2006.01)
***C08G 61/12*** (2006.01)

(86) International application number:
**PCT/JP2015/077113**

(87) International publication number:
**WO 2016/052337 (07.04.2016 Gazette 2016/14)**

(54) **LIGHT-EMITTING ELEMENT**
LICHTEMITTIERENDES ELEMENT
ÉLÉMENT ÉLECTROLUMINESCENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.09.2014 JP 2014201264**

(43) Date of publication of application:
**09.08.2017 Bulletin 2017/32**

(73) Proprietors:
- **Sumitomo Chemical Company Limited**
  **Tokyo 104-8260 (JP)**
- **Cambridge Display Technology Limited**
  **Cardinal Way**
  **Godmanchester**
  **Cambridgeshire PE29 2XG (GB)**

(72) Inventors:
- **ANRYU Makoto**
  **Osaka-shi**
  **Osaka 541-8550 (JP)**
- **KING Simon**
  **Godmanchester**
  **Cambrideshire PE29 2XG (GB)**
- **STEUDEL Annette Regine**
  **Dresden 01309 (DE)**
- **HUMPHRIES Martin John**
  **Godmanchester**
  **Cambrideshire PE29-2XG (GB)**

(74) Representative: **J A Kemp LLP**
**14 South Square**
**Gray's Inn**
**London WC1R 5JJ (GB)**

(56) References cited:
**EP-A1- 3 131 131**
**EP-A1- 3 136 462**
**EP-A1- 3 154 101**
**EP-A1- 3 235 891**
**EP-A1- 3 288 094**
**EP-A1- 3 306 694**
**WO-A1-2013/102992**
**WO-A1-2015/156235**
**WO-A2-2007/076146**
**JP-A- 2011 176 326**
**JP-A- 2013 041 990**
**JP-A- 2013 247 174**
**JP-A- 2013 256 655**
**JP-A- 2014 033 008**
**JP-A- 2015 144 260**
**US-A1- 2001 019 782**

Remarks:
The file contains technical information submitted after the application was filed and not included in this specification

EP 3 203 543 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Technical Field

The present invention relates to a light-emitting device.

### Background Art

Light-emitting devices such as organic electroluminescence devices (organic EL devices), because having properties such as a high external quantum efficiency and a low-voltage drive, can suitably be used in applications of display and illumination, and have recently attracted attention. The light-emitting devices comprise organic layers such as a light emitting layer and a charge transporting layer.

Patent Literatures 1 and 2 describe light-emitting devices comprising a light emitting layer formed by using a blue phosphorescent compound having a ligand formed from a 6-membered ring and a 5-membered ring, and a hole transporting layer formed by using a polymer compound comprising an aromatic amine constitutional unit and a crosslinkable constitutional unit.

The blue phosphorescent compound described in Patent Literature 2 is a phosphorescent compound represented by the following formula. The polymer compound comprising an aromatic amine constitutional unit and a crosslinkable constitutional unit described in Patent Literature 2 is a polymer compound represented by the following formula. The value of $(Y_1 \times 1000)/X_1$ described later of the polymer compound is calculated, and is 0.09.

[Chemical Formula A]

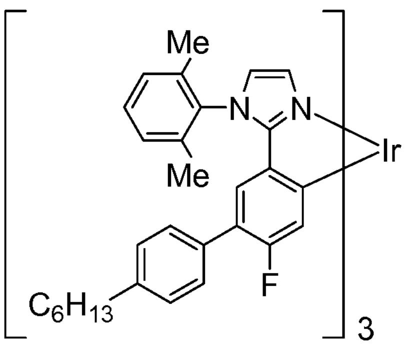

**blue phosphorescent compound**

[Chemical Formula B]

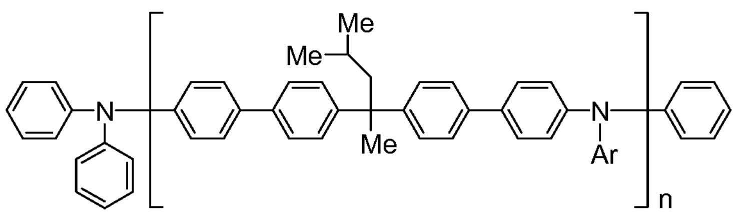

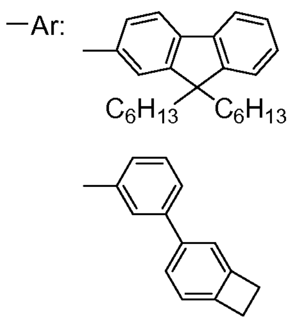

x:0.9361

x:0.0639

polymer compound

Citation List

### Patent Literature

Patent Literature 1: International Publication No. WO2013/191086
Patent Literature 2: Japanese Unexamined Patent Publication No. 2013-216789

EP3131131 may be citable under Article 54(3) EPC. The document relates to a light emitting device comprising an anode, a cathode, a first organic layer disposed between the anode and the cathode and a second organic layer disposed between the anode and the cathode, wherein the first organic layer is a layer obtained by using a composition comprising a compound represented by the formula (H-A) and a metal complex represented by the formula (1), and the second organic layer is a layer obtained by using a polymer compound comprising a constitutional unit having a crosslinkable group:

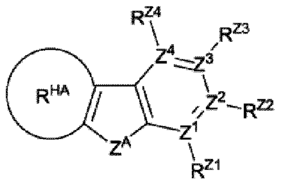

**(H-A)**

wherein $Z^A$ represents a group represented by $-N(R^{ZA})-$, a sulfur atom, an oxygen atom or the like, and $R^{ZA}$ and $R^{Z1}$ to $R^{Z4}$ represent a hydrogen atom or a substituent, and at least one of $R^{Z1}$ to $R^{Z4}$ is a monovalent heterocyclic group, $Z^1$ to $Z^4$ represent a carbon atom or a nitrogen atom, and the ring $R^{HA}$ represents an aromatic hydrocarbon ring or an aromatic heterocyclic ring:

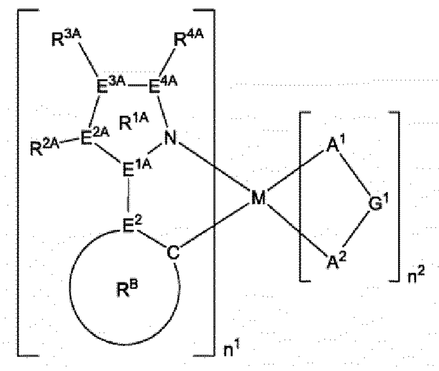

**(1)**

wherein M represents an iridium atom, a platinum atom or the like, $n^1$ represents an integer of 1 or more, $n^2$ represents an integer of 0 or more, and $n^1 + n^2$ is 2 or 3, $E^{1A}$ to $E^{4A}$ and $E^2$ represent a nitrogen atom or a carbon atom, $R^{2A}$ , $R^{3A}$ and $R^{4A}$ represent a hydrogen atom or a substituent, the ring $R^{1A}$ represents a triazole ring, the ring $R^B$ represents an aromatic hydrocarbon ring or an aromatic heterocyclic ring, and $A^1$-$G^1$-$A^2$ represents an anionic bidentate ligand.

The document also discloses a method of preparing a light emitting device as follows:

(a) An ITO film with a thickness of 45 nm was attached to a glass substrate by a sputtering method, to form an anode; on the anode, a polythiophene-sulfonic acid type hole injection material AQ-1200 (manufactured by Plextronics) was spin-coated to form a film with a thickness of 35 nm, and the film was heated on a hot plate at 170°C for 15 minutes under an air atmosphere, to form a hole injection layer.

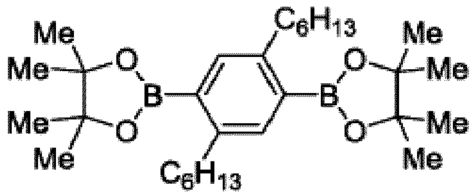

Compound CM1

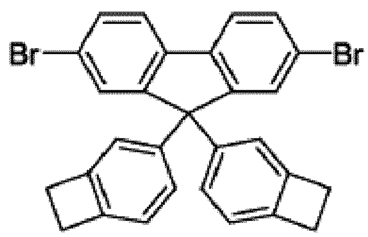

Compound CM2

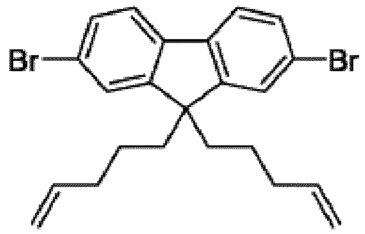

Compound CM3

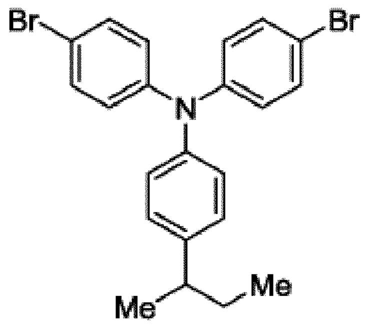

Compound CM4

A polymer compound HTL-1 was dissolved at a concentration of 0.7 wt% in xylene, wherein HTL-1 is a copolymer constituted of constitutional units derived from the monomer compounds CM1, CM2, CM3 and CM4 at a molar ratio of 50:5:5:40; the resultant xylene solution was spin-coated on the hole injection layer to form a film with a thickness of 20 nm, and the film was heated on a hot plate at 180°C for 60 minutes under a nitrogen gas atmosphere, to form a hole transporting layer.

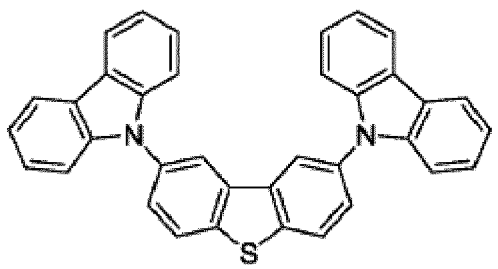

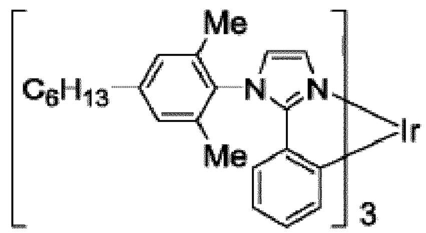

Metal complex 3

Low molecular weight compound SM1

A low molecular weight compound SM1 (manufactured by Luminescense Technology) and a metal complex 3 (low molecular weight compound SMI/metal complex 3 = 75 wt%/25 wt%) were dissolved at a concentration of 2.0 wt% in toluene; the resultant toluene solution was spin-coated on the hole transporting layer to form a film with a thickness of 75 nm, and the film was heated at 130°C for 10 minutes under a nitrogen gas atmosphere, to form a light emitting layer.

The substrate carrying the light emitting layer formed thereon was placed in a vapor deposition machine, and the pressure was reduced to 1.0 x $10^{-4}$ Pa or less, then, as a cathode, sodium fluoride was vapor-deposited with a thickness of about 7 nm on the light emitting layer, then, aluminum was vapor-deposited with a thickness of about 120 nm on the sodium fluoride layer; after vapor deposition, sealing was performed using a glass substrate, to fabricate a light emitting device. This subject-matter is disclaimed from the present claims.

EP3154101 may be citable under Article 54(3) EPC. The document relates to a light emitting device comprising an anode, a cathode, a first organic layer disposed between the anode and the cathode (a layer comprising one or more phosphorescent compounds) and a second organic layer disposed between the anode and the first organic layer (a layer comprising one or more phosphorescent compounds and a crosslinked body of a crosslinkable material), wherein at least one phosphorescent compound contained in the first organic layer and at least one phosphorescent compound contained in the second organic layer are the same phosphorescent compound represented by the formula (1):

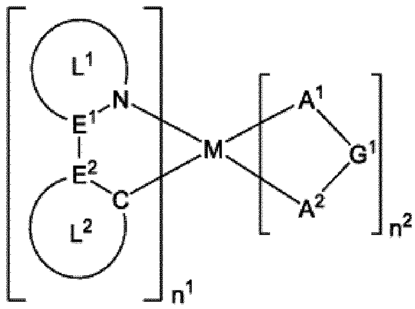

(1)

wherein M represents an iridium atom or the like, $n^1$ represents an integer of 1 or more, $n^2$ represents an integer of 0 or more, $E^1$ and $E^2$ represent a carbon atom or the like, the ring $L^1$ represents an aromatic heterocyclic ring, the ring $L^2$ represents an aromatic hydrocarbon ring or the like, $A^1$-$G^1$-$A^2$ represents an anionic bidentate ligand, and at least one ring selected from among the ring $L^1$ and the ring $L^2$ has an aryl group, a monovalent heterocyclic group or a substituted amino group.

The document also discloses methods of preparing light emitting devices as follows:

(b) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer.

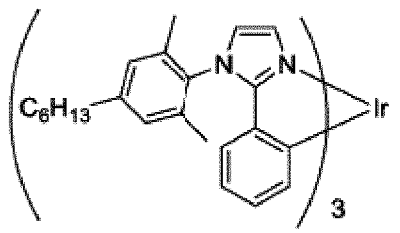

Compound G2

The polymer compound P1 and the compound G2 (polymer compound PI/compound G2 = 85 wt%/15 wt%) were dissolved at a concentration of 0.5 wt% in chlorobenzene, wherein P1 is a copolymer constituted of constitutional units derived from the monomer compounds CM1, CM2, CM3 and CM4 as defined in (a) above at a molar ratio of 50:5:5:40; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound P1.

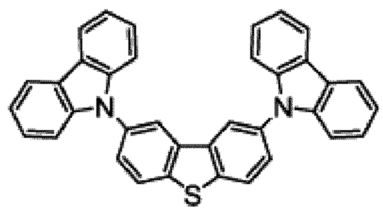

DCzDBT

2,8-di(9H-carbazol-9-yl)dibenzo[b,d]thiophene (DCzDBT) (manufactured by Luminescence Technology Corp) and the compound G2 (DCzDBT/compound G2 = 70 wt%/30 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer.

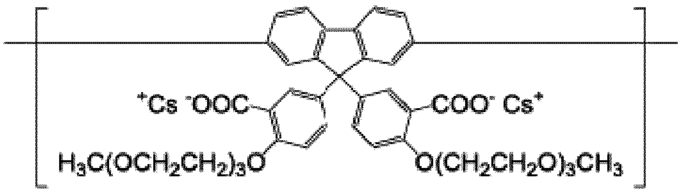

Polymer compound P4 repeat unit

The polymer compound P4 was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer.

The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device.

(c) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer.

The polymer compound P1 and the compound G2 as defined in (b) above (polymer compound PI/compound G2 = 70 wt%/30 wt%) were dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound P1.

2,8-di(9H-carbazol-9-yl)dibenzo[b,d]thiophene (DCzDBT) (manufactured by Luminescence Technology Corp) and the compound G2 as defined in (b) above (DCzDBT/compound G2 = 70 wt%/30 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer.

The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer.

The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device.

(d) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer.

The polymer compound P1 and the compound G2 as defined in (b) above (polymer compound PI/compound G2 = 85 wt%/15 wt%) were dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound P1.

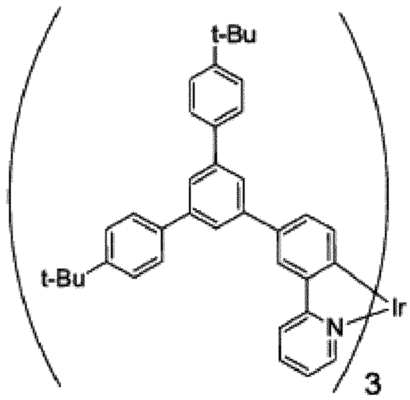

Compound G1

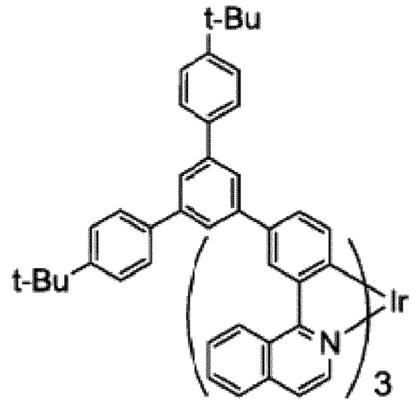

Compound G3

2,8-di(9H-carbazol-9-yl)dibenzo[b,d]thiophene (DCzDBT) (manufactured by Luminescence Technology Corp), the compound G2 as defined in (b) above, the compound G1 and the compound G3 (DCzDBT/compound G2/compound G1/compound G3 = 69 wt%/30 wt%/0.6 wt%/0.4 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer.

The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer.

The substrate carrying the electron transporting layer formed thereon was placed in a vapor deposition machine, and the pressured was reduced to $1.0 \times 10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device.

(e) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer.

The polymer compound P1 as defined in (b) above, the compound G1 and the compound G3 as defined in (d) above (polymer compound PI/compound G1/compound G3 = 95 wt%/3 wt%/2 wt%) were dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound P1.

2,8-di(9H-carbazol-9-yl)dibenzo[b,d]thiophene (DCzDBT) (manufactured by Luminescence Technology Corp), the compound G2 as defined in (b) above, the compound G1 and the compound G3 as defined in (d) above (DCzDBT/compound G2/compound G1/compound G3 = 69 wt%/30 wt%/0.6 wt%/0.4 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer.

The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer.

The substrate carrying the electron transporting layer formed thereon was placed in a vapor deposition machine, and the pressured was reduced to $1.0 \times 10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device.

(f) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer.

The polymer compound P1 as defined in (b) above, the compound G1 and the compound G3 as defined in (d) above (polymer compound PI/compound G1 /compound G3 = 90 wt%/6 wt%/4 wt%) were dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound P1.

2,8-di(9H-carbazol-9-yl)dibenzo[b,d]thiophene (DCzDBT) (manufactured by Luminescence Technology Corp), the compound G2 as defined in (b) above, the compound G1 and the compound G3 as defined in (d) above (DCzDBT/compound G2/compound G1/compound G3 = 69 wt%/30 wt%/0.6 wt%/0.4 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer.

The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer.

The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device.

(g) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer.

The polymer compound P1 as defined in (b) above was dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound P1.

2,8-di(9H-carbazol-9-yl)dibenzo[b,d]thiophene (DCzDBT) (manufactured by Luminescence Technology Corp) and the compound G2 as defined in (b) above (DCzDBT/compound G2 = 70 wt%/30 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer.

The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer.

The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device.

(h) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer.

The polymer compound P1 as defined in (b) above was dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound P1.

2,8-di(9H-carbazol-9-yl)dibenzo[b,d]thiophene (DCzDBT) (manufactured by Luminescence Technology Corp), the compound G2 as defined in (b) above, the compound G1 and the compound G3 as defined in (d) above (DCzDBT/compound G2/compound G1/compound G3 = 69 wt%/30 wt%/0.6 wt%/0.4 wt%) were dissolved at a concentration

of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer.

The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer.

The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device.

This subject-matter is disclaimed from the present claims.

EP3136462 may be citable under Article 54(3) EPC. The document relates to a light emitting device comprises an anode, a cathode, a first light-emitting layer provided between the anode and the cathode, and a second light-emitting layer provided between the anode and the cathode. The first light-emitting layer is a layer obtained by using a polymer compound comprising a constitutional unit having a cross-linkable group and a phosphorescent constitutional unit, and the second light-emitting layer is a layer obtained by using a composition comprising a non-phosphorescent low molecular weight compound having a heterocyclic structure and at least two phosphorescent compounds.

The document also discloses methods of preparing light emitting devices as follows:

(i) An anode was formed by providing an ITO film having a thickness of 45 nm by sputtering method on a glass substrate; on the anode, AQ-1200 (manufactured by Plectronics Inc.) as a hole injection agent based on polythiophene-sulfonic acid was applied by spin-coating method to form a film having a thickness of 35 nm, and then it was heated on a hot plate for 15 minutes at 170°C in an ambient atmosphere, thereby forming a hole injection layer.

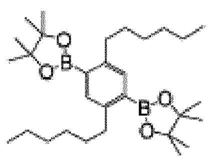

Compound 1

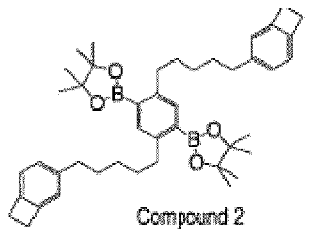

Compound 2

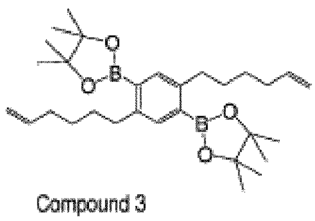

Compound 3

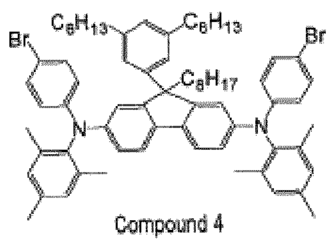

Compound 4

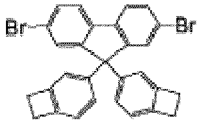

Compound 5

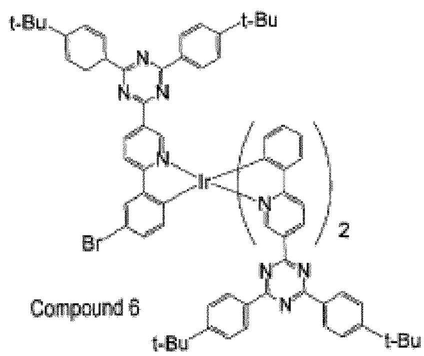

Compound 6

Polymer compound 1 was dissolved in xylene at a concentration of 0.6 wt%, wherein polymer compound 1 is a copolymer comprising constitutional units derived from Compound 1, Compound 2, Compound 3, Compound 4, Compound 5 and Compound 6 at a molar ratio of 30:10:10:39.4:10:1.2; the resultant xylene solution was used to form a film having a thickness of 20 nm by spin-coating on the hole injection layer, and then it was heated on a hot plate for 60 minutes at 180°C in a nitrogen gas atmosphere, thereby forming a first light-emitting layer.

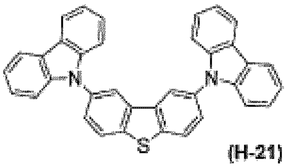
(H-21)

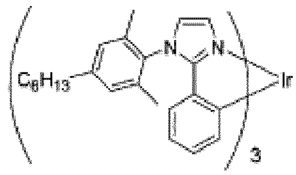
(1-A3-6)

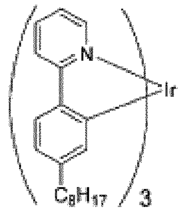
COM-1

A first ink was prepared by dissolving Compound (H-21), Compound (1-A3-6), Compound COM-1 (Compound (H-21)/Compound (1-A3-6)/Compound COM-1 (weight ratio)=69.77/30/0.23) in toluene at a concentration of 2.0 wt%; the first ink was applied on the first light-emitting layer by spin-coating method to form a film having a thickness of 75 nm, and then it was heated on a hot plate for 10 minutes at 130°C in a nitrogen gas atmosphere, thereby forming a second light-emitting layer.

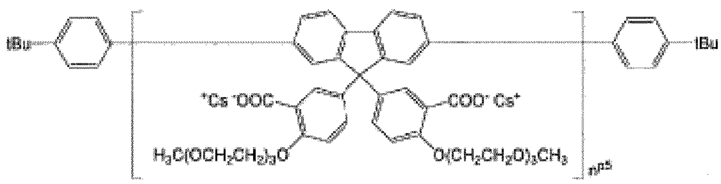
Polymer compound 5

A second ink was prepared by dissolving Polymer compound 5 in 2,2,3,3,4,4,5,5-octafluoro-1-pentanol at a concentration of 0.25 wt%; the structure of Polymer compound 5 is shown above, wherein $n^{p5}$ denotes a polymerization degree; the second ink was applied on the second light-emitting layer by spin-coating method to form a film having a thickness of 10 nm, and then it was heated on a hot plate for 10 minutes at 130°C in a nitrogen gas atmosphere, thereby forming an electron transport layer; on the electron transport layer, sodium fluoride as a cathode was evaporated to have a thickness of about 7 nm and then aluminum was evaporated to have a thickness of about 120 nm, whereby a light emitting device was fabricated.

(j) An anode was formed by providing an ITO film having a thickness of 45 nm by sputtering method on a glass substrate; on the anode, AQ-1200 (manufactured by Plectronics Inc.) as a hole injection agent based on polythiophene-sulfonic acid was applied by spin-coating method to form a film having a thickness of 35 nm, and then it was heated on a hot plate for 15 minutes at 170°C in an ambient atmosphere, thereby forming a hole injection layer.

Polymer compound 1 as defined in (i) above was dissolved in xylene at a concentration of 0.6 wt%; the resultant xylene solution was used to form a film having a thickness of 20 nm by spin-coating on the hole injection layer, and then it was heated on a hot plate for 60 minutes at 180°C in a nitrogen gas atmosphere, thereby forming a first light-emitting layer.

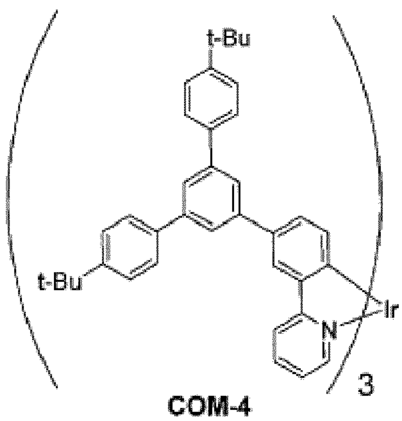
COM-4

A first ink was prepared by dissolving Compound (H-21) and Compound (1-A3-6), as defined in (i) above, and Compound COM-4 (Compound (H-21)/Compound (1-A3-6)/Compound COM-4 weight ratio =69.6/30/0.4) in toluene at

a concentration of 2.0 wt%; the first ink was applied on the first light-emitting layer by spin-coating method to form a film having a thickness of 75 nm, and then it was heated on a hot plate for 10 minutes at 130°C in a nitrogen gas atmosphere, thereby forming a second light-emitting layer.

A second ink was prepared by dissolving Polymer compound 5 as defined in (i) above in 2,2,3,3,4,4,5,5-octafluoro-1-pentanol at a concentration of 0.25 wt%; the second ink was applied on the second light-emitting layer by spin-coating method to form a film having a thickness of 10 nm, and then it was heated on a hot plate for 10 minutes at 130°C in a nitrogen gas atmosphere, thereby forming an electron transport layer; on the electron transport layer, sodium fluoride as a cathode was evaporated to have a thickness of about 7 nm and then aluminum was evaporated to have a thickness of about 120 nm, whereby a light emitting device was fabricated.

(k) An anode was formed by providing an ITO film having a thickness of 45 nm by sputtering method on a glass substrate; on the anode, AQ-1200 (manufactured by Plectronics Inc.) as a hole injection agent based on polythiophene-sulfonic acid was applied by spin-coating method to form a film having a thickness of 35 nm, and then it was heated on a hot plate for 15 minutes at 170°C in an ambient atmosphere, thereby forming a hole injection layer.

Polymer compound 1 as defined in (i) above was dissolved in xylene at a concentration of 0.6 wt%; the resultant xylene solution was used to form a film having a thickness of 20 nm by spin-coating on the hole injection layer, and then it was heated on a hot plate for 60 minutes at 180°C in a nitrogen gas atmosphere, thereby forming a first light-emitting layer.

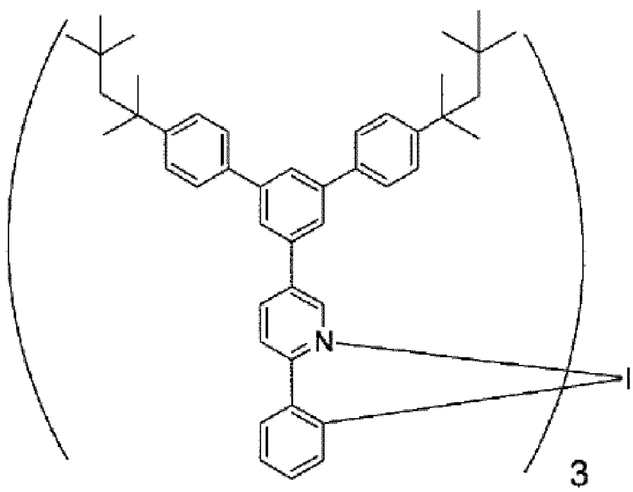

COM-9

A first ink was prepared by dissolving Compound (H-21), Compound (1-A3-6), Compound COM-4 as defined in (i) and (j) above, and Compound COM-9 (Compound (H-21)/Compound (1-A3-6)/Compound COM-4/Compound COM-9 weight ratio =69.6/30/0.2/0.2) in toluene at a concentration of 2.0 wt%; the first ink was applied on the first light-emitting layer by spin-coating method to form a film having a thickness of 75 nm, and then it was heated on a hot plate for 10 minutes at 130°C in a nitrogen gas atmosphere, thereby forming a second light-emitting layer.

A second ink was prepared by dissolving Polymer compound 5 as defined in (i) above in 2,2,3,3,4,4,5,5-octafluoro-1-pentanol at a concentration of 0.25 wt%; the second ink was applied on the second light-emitting layer by spin-coating method to form a film having a thickness of 10 nm, and then it was heated on a hot plate for 10 minutes at 130°C in a nitrogen gas atmosphere, thereby forming an electron transport layer; on the electron transport layer, sodium fluoride as a cathode was evaporated to have a thickness of about 7 nm and then aluminum was evaporated to have a thickness of about 120 nm, whereby a light emitting device was fabricated.

This subject-matter is disclaimed from the present claims.

WO2007076146 relates to copolymers useful as hole transport materials in making electronic devices. The document further relates to electronic devices having at least one active layer comprising such a hole transport copolymer.

## Summary of Invention

### Technical Problem

As a light-emitting device, one having an excellent external quantum efficiency is demanded. Then, the present invention has an object to provide a light-emitting device excellent in the external quantum efficiency.

**Solution to Problem**

One aspect of the present invention relates to the following light-emitting devices.

[1] A light-emitting device comprising an anode, a cathode, a first organic layer disposed between the anode and the cathode, and a second organic layer disposed between the anode and the first organic layer and adjacent to the first organic layer,

wherein the first organic layer comprises a phosphorescent compound represented by the formula (1);
the second organic layer comprises a cured polymer product formed from a polymer composition in which one or two or more polymer compounds including a crosslinkable polymer compound having at least one crosslinkable group selected from Group A of crosslinkable groups are compounded; and
with respect to each monomer unit constituting the polymer compounds, a value x obtained by multiplying a molar ratio C of the each monomer unit to a total mol of all the monomer units by a molecular weight M of the each monomer unit, and a value y obtained by multiplying the molar ratio C by a number n of the crosslinkable groups in the each monomer unit are determined, a value of $(Y_1 \times 1000)/X_1$ calculated from $X_1$ being the total of the values x and $Y_1$ being the total of the values y being 0.5 or more:

[Chemical Formula 1]

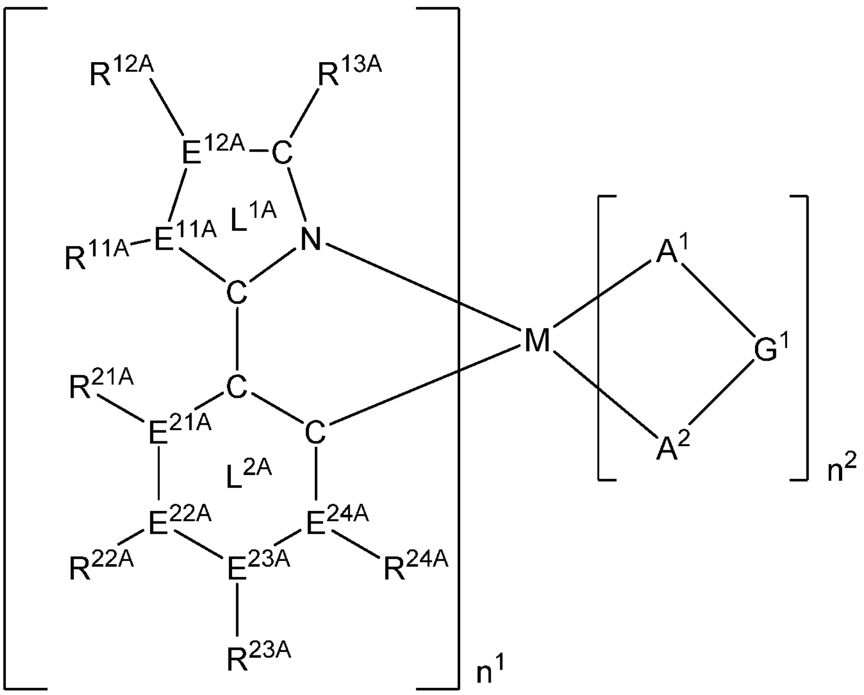

(1)

wherein,

M represents a ruthenium atom, a rhodium atom, a palladium atom, an iridium atom or a platinum atom;
$n^1$ represents an integer of 1 to 3, $n^2$ represents an integer of 0 to 2, and $n^1 + n^2$ is 2 or 3; and $n^1 + n^2$ is 3 when M is a ruthenium atom, a rhodium atom or an iridium atom, while $n^1 + n^2$ is 2 when M is a palladium atom or a platinum atom;
$E^{11A}$, $E^{12A}$, $E^{21A}$, $E^{22A}$, $E^{23A}$ and $E^{24A}$ each independently represent a nitrogen atom or a carbon atom; when a plurality of $E^{11A}$, $E^{12A}$, $E^{21A}$, $E^{22A}$, $E^{23A}$ and $E^{24A}$ are present, they may be the same or different at each occurrence, provided that one of $E^{11A}$ and $E^{12A}$ is a carbon atom and the other is a nitrogen atom; and when $E^{21A}$, $E^{22A}$, $E^{23A}$ and $E^{24A}$ are nitrogen atoms, $R^{21A}$, $R^{22A}$, $R^{23A}$ and $R^{24A}$ are not present;
$R^{11A}$, $R^{12A}$, $R^{13A}$, $R^{21A}$, $R^{22A}$, $R^{23A}$ and $R^{24A}$ each independently represent a hydrogen atom, an alkyl group, a cycloalkyl group, an alkoxy group, a cycloalkoxy group, an aryl group, an aryloxy group, a monovalent heterocyclic group, a substituted amino group or a halogen atom, and these groups each optionally have a substituent; when a plurality of $R^{11A}$, $R^{12A}$, $R^{13A}$, $R^{21A}$, $R^{22A}$, $R^{23A}$ and $R^{24A}$ are present, they may

be the same or different at each occurrence; and $R^{11A}$ and $R^{12A}$, $R^{12A}$ and $R^{13A}$, $R^{11A}$ and $R^{21A}$, $R^{21A}$ and $R^{22A}$, $R^{22A}$ and $R^{23A}$, and $R^{23A}$ and $R^{24A}$ each may be combined together to form a ring together with the atoms to which they are attached;

a ring $L^{1A}$ represents an imidazole ring constituted of a nitrogen atom, two carbon atoms, $E^{11A}$ and $E^{12A}$;

a ring $L^{2A}$ represents a benzene ring, a pyridine ring or a pyrimidine ring constituted of two carbon atoms, $E^{21A}$, $E^{22A}$, $E^{23A}$ and $E^{24A}$; and

$A^1$-$G^1$-$A^2$ represents an anionic bidentate ligand; $A^1$ and $A^2$ each independently represent a carbon atom, an oxygen atom or a nitrogen atom, and these atoms may be atoms constituting a ring; $G^1$ represents a single bond, or an atomic group constituting the bidentate ligand together with $A^1$ and $A^2$; and when a plurality of $A^1$-$G^1$-$A^2$ are present, they may be the same or different at each occurrence

(Group A of crosslinkable groups)

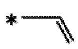
(XL-1)

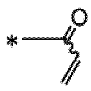
(XL-2)

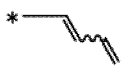
(XL-3)

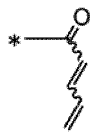
(XL-4)

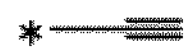
(XL-5)

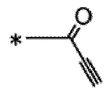
(XL-6)

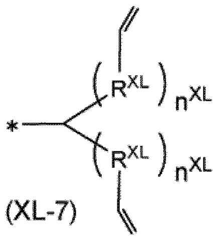
(XL-7)

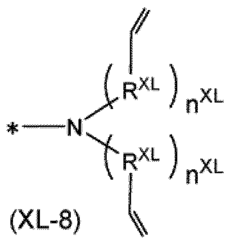
(XL-8)

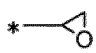
(XL-9)

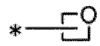
(XL-10)

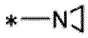
(XL-11)

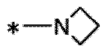
(XL-12)

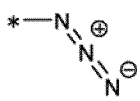
(XL-13)

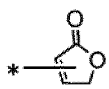
(XL-14)

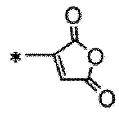
(XL-15)

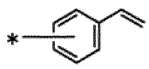
(XL-16)

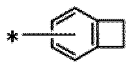
(XL-17)

wherein $R^{XL}$ represents a methylene group, an oxygen atom or a sulfur atom, and $n^{XL}$ represents an integer of 0 to 5; when a plurality of $R^{XL}$ are present, they may be the same or different; and when a plurality of $n^{XL}$ are present, they may be the same or different; * represents a bonding position; and these crosslinkable groups each optionally have a substituent;

wherein the light emitting device is not a light emitting device prepared by any methods (a) to (k) as set out in present claim 1.

[2] The light emitting device according to [1] wherein the phosphorescent compound is not a phosphorescent compound represented by any of the following formula COM-17, B2 or B3:

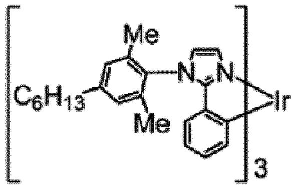

COM-17 ,

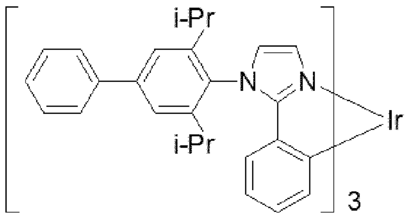

phosphorescent compound B2 , or

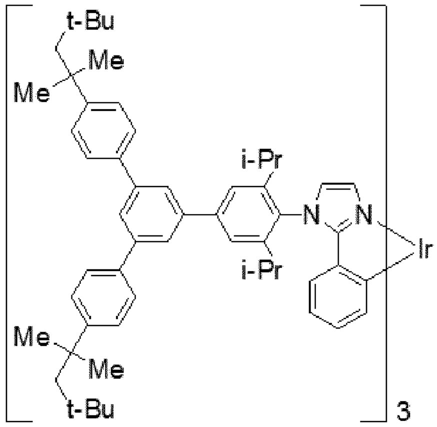

phosphorescent compound B3 .

[3] The light-emitting device according to [1] wherein the phosphorescent compound of formula (1) is a phosphorescent compound represented by the following formula COM-18 to COM-28:

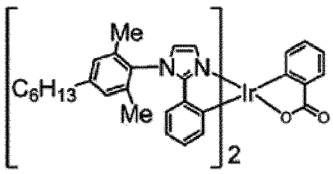

COM-18

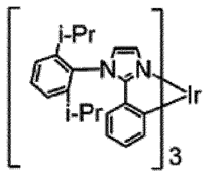

COM-19

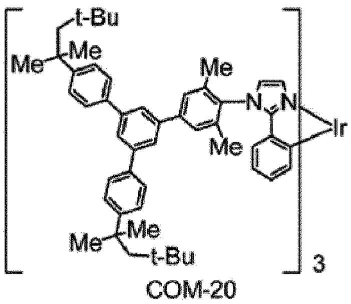

COM-20

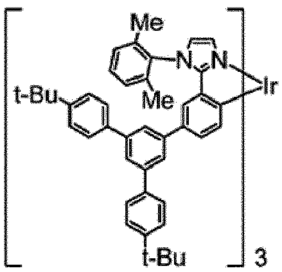

COM-21

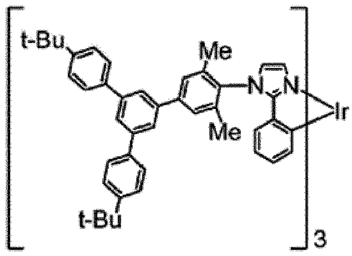

COM-22

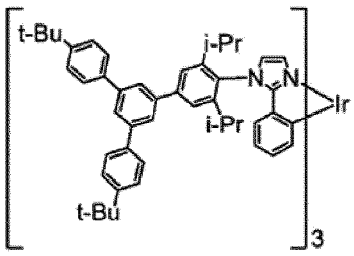

COM-23

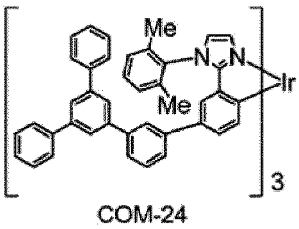

COM-24

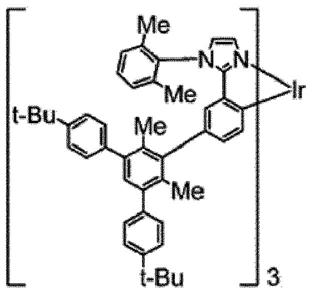

COM-25

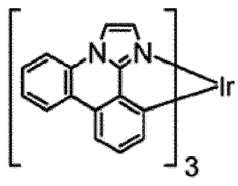

COM-26

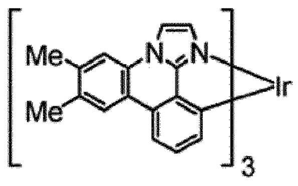

COM-27

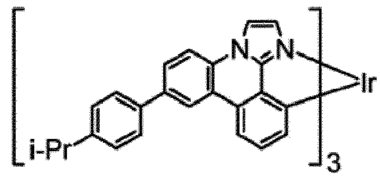

COM-28

.

[4] The light-emitting device according to any one of [1] to [3], wherein the value of $(Y_1 \times 1000)/X_1$ is 0.65 or more.

[5] The light-emitting device according to any one of [1] to [4], wherein at least one selected from the group consisting of the $R^{11A}$, $R^{12A}$, $R^{13A}$, $R^{21A}$, $R^{22A}$, $R^{23A}$ and $R^{24A}$ is a group represented by the formula (D-A) or (D-B):

[Chemical Formula 2]

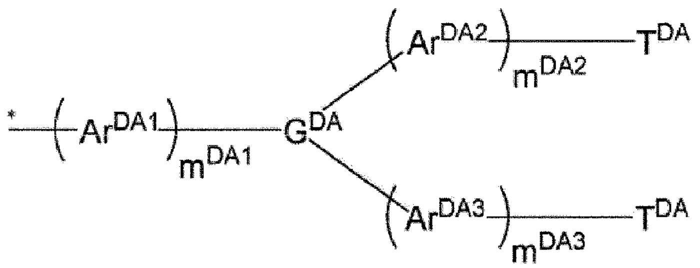

(D-A)

wherein,

$m^{DA1}$, $m^{DA2}$ and $m^{DA3}$ each independently represent an integer of 0 or more;
$G^{DA}$ represents a nitrogen atom, an aromatic hydrocarbon group or a heterocyclic group, and these groups each optionally have a substituent;
$Ar^{DA1}$, $Ar^{DA2}$ and $Ar^{DA3}$ each independently represent an arylene group or a divalent heterocyclic group, and these groups each optionally have a substituent; and when a plurality of $Ar^{DA1}$, $Ar^{DA2}$ and $Ar^{DA3}$ are present, they may be the same or different at each occurrence; and
$T^{DA}$ represents an aryl group or a monovalent heterocyclic group, and these groups each optionally have a substituent; and the plurality of $T^{DA}$ may be the same or different; and
* represents a bonding position, and

[Chemical Formula 3]

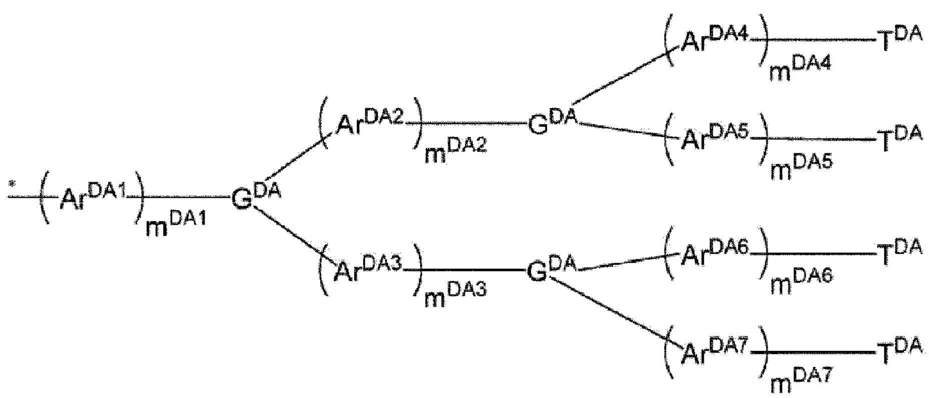

(D-B)

wherein,

$m^{DA1}$, $m^{DA2}$, $m^{DA3}$, $m^{DA4}$, $m^{DA5}$, $m^{DA6}$ and $m^{DA7}$ each independently represent an integer of 0 or more;
$G^{DA}$ represents a nitrogen atom, an aromatic hydrocarbon group or a heterocyclic group, and these groups each optionally have a substituent, and the plurality of $G^{DA}$ may be the same or different;
$Ar^{DA1}$, $Ar^{DA2}$ , $Ar^{DA3}$ , $Ar^{DA4}$, $Ar^{DA5}$, $Ar^{DA6}$ and $Ar^{DA7}$ each independently represent an arylene group or a divalent heterocyclic group, and these groups each optionally have a substituent; and when a plurality of $Ar^{DA1}$, $Ar^{DA2}$, $Ar^{DA3}$, $Ar^{DA4}$, $Ar^{DA5}$, $Ar^{DA6}$ and $Ar^{DA7}$ are present, they may be the same or different at each occurrence; and
$T^{DA}$ represents an aryl group or a monovalent heterocyclic group, and these groups each optionally have a substituent, and the plurality of $T^{DA}$ may be the same or different; and
* represents a bonding position.

[6] The light-emitting device according to any one of [1], [4] or [5], wherein the phosphorescent compound is represented by the formula (1-1) or (1-2):

[Chemical Formula 4]

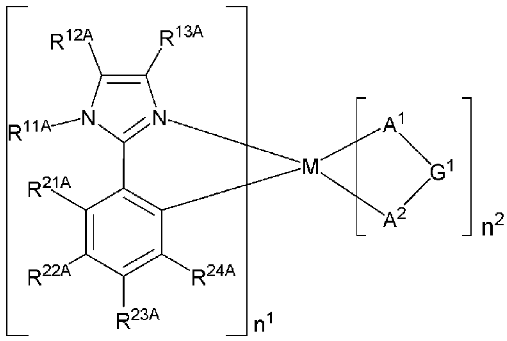

(1-1)

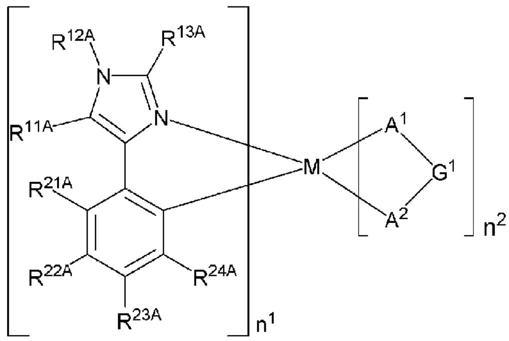

(1-2)

wherein M, $n^1$ , $n^2$, $R^{11A}$, $R^{12A}$, $R^{13A}$, $R^{21A}$, $R^{22A}$, $R^{23A}$, $R^{24A}$ and $A^1$-$G^1$-$A^2$ represent the same meanings as described above.
[7] The light-emitting device according to any one of [1] to [6], wherein the crosslinkable polymer compound comprises a constitutional unit represented by the formula (2):

[Chemical Formula 5]

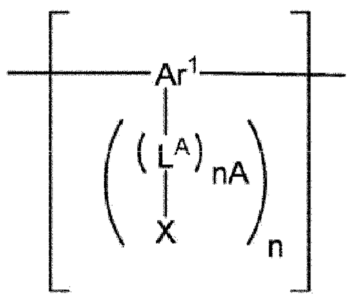

(2)

wherein,

nA represents an integer of 0 to 5, and n represents 1 or 2;
$Ar^1$ represents an aromatic hydrocarbon group or a heterocyclic group, and these groups each optionally have a substituent;
$L^A$ represents an alkylene group, a cycloalkylene group, an arylene group, a divalent heterocyclic group, a group represented by -NR'-, an oxygen atom or a sulfur atom, and these groups each optionally have a substituent;
R' represents a hydrogen atom, an alkyl group, a cycloalkyl group, an aryl group or a monovalent heterocyclic

group, and these groups each optionally have a substituent: and when a plurality of $L^A$ are present, they may be the same or different; and

X represents a crosslinkable group selected from Group A of crosslinkable groups, and when a plurality of X are present, they may be the same or different.

[8] The light-emitting device according to any one of [1] to [7], wherein the crosslinkable polymer compound comprises a constitutional unit represented by the formula (3):

[Chemical Formula 6]

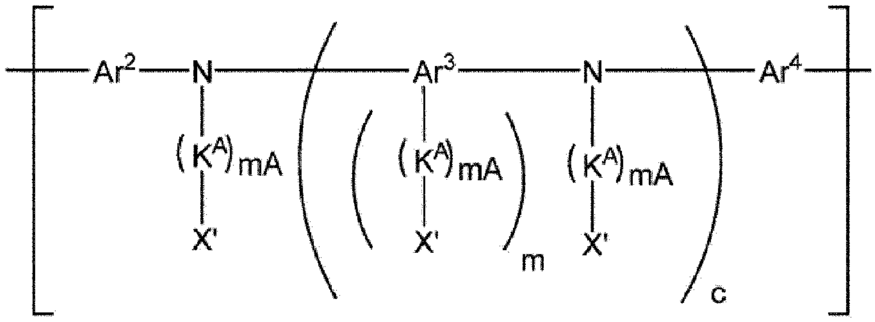

(3)

wherein,

mA represents an integer of 0 to 5, m represents an integer of 1 to 4, c represents 0 or 1, and when a plurality of mA are present, they may be the same or different;

$Ar^3$ represents an aromatic hydrocarbon group, a heterocyclic group or a group in which at least one aromatic hydrocarbon ring and at least one heterocyclic ring are bonded directly to each other, and these groups each optionally have a substituent;

$Ar^2$ and $Ar^4$ each independently represent an arylene group or a divalent heterocyclic group, and these groups each optionally have a substituent;

each of $Ar^2$, $Ar^3$ and $Ar^4$ may be bonded directly or via an oxygen atom or a sulfur atom to a group that is different from that group and that is attached to the nitrogen atom to which that group is attached, thereby forming a ring;

$K^A$ represents an alkylene group, a cycloalkylene group, an arylene group, a divalent heterocyclic group, a group represented by -NR"-, an oxygen atom or a sulfur atom, and these groups each optionally have a substituent; and R" represents a hydrogen atom, an alkyl group, a cycloalkyl group, an aryl group or a monovalent heterocyclic group, and these groups each optionally have a substituent; and when a plurality of $K^A$ are present, they may be the same or different; and

X' represents a crosslinkable group selected from Group A of crosslinkable groups, a hydrogen atom, an alkyl group, a cycloalkyl group, an aryl group or a monovalent heterocyclic group, and these groups each optionally have a substituent; and when a plurality of X' are present, they may be the same or different; provided that at least one X' is a crosslinkable group selected from Group A of crosslinkable groups.

[9] The light-emitting device according to any one of [1] to [8], wherein the first organic layer further comprises a polymer compound comprising a constitutional unit represented by the formula (Y):

[Chemical Formula 8] $-[-Ar^{Y1}-]-$ (Y)

wherein $Ar^{Y1}$ represents an arylene group, a divalent heterocyclic group or a divalent group in which at least one arylene group and at least one divalent heterocyclic group are bonded directly to each other, and these groups each optionally have a substituent.

[10] The light-emitting device according to any one of [1] to [8], wherein the first organic layer further comprises a compound represented by the formula (H-1):

[Chemical Formula 9]

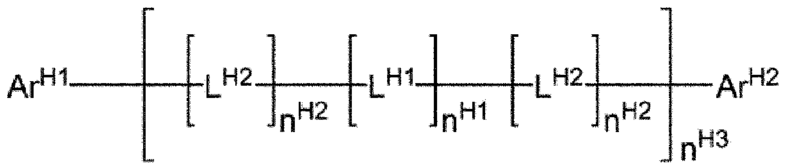

**(H-1)**

wherein,

$Ar^{H1}$ and $Ar^{H2}$ each independently represent an aryl group or a monovalent heterocyclic group, and these groups each optionally have a substituent;
$n^{H1}$ and $n^{H2}$ each independently represent 0 or 1; when a plurality of $n^{H1}$ are present, they may be the same or different; and when a plurality of $n^{H2}$ are present, they may be the same or different;
$n^{H3}$ represents an integer of 0 or more;
$L^{H1}$ represents an arylene group, a divalent heterocyclic group or a group represented by $-[C(R^{H11})_2]n^{H11}-$, and these groups each optionally have a substituent; and when a plurality of $L^{H1}$ are present, they may be the same or different;
$n^{H11}$ represents an integer of 1 to 10; $R^{H11}$ represents a hydrogen atom, an alkyl group, a cycloalkyl group, an alkoxy group, a cycloalkoxy group, an aryl group or a monovalent heterocyclic group, and these groups each optionally have a substituent; the plurality of $R^{H11}$ may be the same or different and may be combined together to form a ring together with the carbon atoms to which they are attached;
$L^{H2}$ represents a group represented by $-N(-L^{H21}-R^{H21})-$; and when a plurality of $L^{H2}$ are present, they may be the same or different; and
$L^{H21}$ represents a single bond, an arylene group or a divalent heterocyclic group, and these groups each optionally have a substituent; and $R^{H21}$ represents a hydrogen atom, an alkyl group, a cycloalkyl group, an aryl group or a monovalent heterocyclic group, and these groups each optionally have a substituent.

## Advantageous Effects of Invention

According to the present invention, a light-emitting device excellent in the external quantum efficiency can be provided.

## Modes for Carrying Out the Invention

The present invention will be illustrated in detail below.

<Explanation of common term>

Terms commonly used in the present specification have the following meanings unless otherwise stated.
Me represents a methyl group, Et represents an ethyl group, Bu represents a butyl group, i-Pr represents an isopropyl group, and t-Bu represents a tert-butyl group.
A hydrogen atom may be a heavy hydrogen atom or a light hydrogen atom.
In a formula representing a metal complex (for example, in the formula (1) representing a phosphorescent compound), a solid line representing a bond to a central metal denotes a covalent bond or a coordinate bond.
"Polymer compound" denotes a polymer having molecular weight distribution and having a polystyrene-equivalent number average molecular weight of $1\times10^3$ to $1\times10^8$.
"Low molecular weight compound" denotes a compound having no molecular weight distribution and having a molecular weight of $1\times10^4$ or less.
"Constitutional unit" denotes a unit structure found once or more in a polymer compound.
"Alkyl group" may be any of linear or branched. The number of carbon atoms of the linear alkyl group is, not including the number of carbon atoms of a substituent, usually 1 to 50, preferably 3 to 30, more preferably 4 to 20. The number of carbon atoms of the branched alkyl groups is, not including the number of carbon atoms of a substituent, usually 3 to 50, preferably 3 to 30, more preferably 4 to 20.
The alkyl group includes, for example, a methyl group, an ethyl group, a propyl group, an isopropyl group, a butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group,

a 2-ethyloctyl group, a 2-hexyldecyl group,a dodecyl group and the like. The alkyl group optionally has a substituent, and examples thereof may be groups obtained by substituting a part or all of hydrogen atoms in alkyl groups with a cycloalkyl group, an alkoxy group, a cycloalkoxy group, an aryl group, a fluorine atom or the like. The alkyl group having a substituent includes, for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di- hexylphenyl) propyl group and a 6-ethyloxyhexyl group.

The number of carbon atoms of "Cycloalkyl group" is, not including the number of carbon atoms of a substituent, usually 3 to 50, preferably 3 to 30, more preferably 4 to 20.

The cycloalkyl group includes, for example, a cyclohexyl group, a cyclopentyl group and the like. The cycloalkyl group optionally has a substituent, and examples thereof may be groups obtained by substituting a part or all of hydrogen atoms in cycloalkyl groups with an alkyl group, a cycloalkyl group, an alkoxy group, a cycloalkoxy group, an aryl group, a fluorine atom or the like. The cycloalkyl group having a substituent includes, for example, a cyclohexylmethyl group, a cyclohexylethyl group and the like.

"Aryl group" denotes an atomic group remaining after removing from an aromatic hydrocarbon one hydrogen atom linked directly to a carbon atom constituting the aromatic ring. The number of carbon atoms constituting the aromatic ring in the aryl group is usually 6 to 60, preferably 6 to 20, more preferably 6 to 10.

The aryl group includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group and the like. The aryl group optionally has a substituent, and examples thereof may be groups obtained by substituting a part or all of hydrogen atoms in aryl groups with an alkyl group, a cycloalkyl group, an alkoxy group, a cycloalkoxy group, an aryl group, a fluorine atom or the like.

"Alkoxy group" may be any of linear or branched. The number of carbon atoms of the linear alkoxy group is, not including the number of carbon atoms of a substituent, usually 1 to 40, preferably 4 to 10. The number of carbon atoms of the branched alkoxy group is, not including the number of carbon atoms of a substituent, usually 3 to 40, preferably 4 to 10.

The alkoxy group includes, for example, a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group, a lauryloxy group and the like. The alkoxy group optionally has a substituent, and examples thereof may be groups obtained by substituting a part or all of hydrogen atoms in alkoxy groups with a cycloalkyl group, an alkoxy group, a cycloalkoxy group, an aryl group, a fluorine atom or the like.

The number of carbon atoms of "Cycloalkoxy group" is, not including the number of carbon atoms of a substituent, usually 3 to 40, preferably 4 to 10.

The cycloalkoxy group includes a cyclohexyloxy group, a cyclopentyloxy group and the like. The cycloalkoxy group optionally has a substituent, and examples thereof may be groups obtained by substituting a part or all of hydrogen atoms in cycloalkoxy groups with an alkyl group, a cycloalkyl group, an alkoxy group, a cycloalkoxy group, an aryl group, a fluorine atom or the like.

"Aryloxy group" denotes an aromatic group in which an aryl group is linked to an oxygen atom. The number of carbon atoms constituting the aromatic ring in the aryloxy group is usually 6 to 60, preferably 6 to 20.

The aryloxy group includes, for example, a phenoxy group, a 1-naphthyloxy group, a 2-naphthyloxy group, a 1-anthracenyloxy group, a 9-anthracenyloxy group, a 1-pyrenyloxy group and the like. The aryloxy group optionally has a substituent, and examples thereof may be groups obtained by substituting a part or all of hydrogen atoms in aryloxy groups with an alkyl group, a cycloalkyl group, an alkoxy group, a cycloalkoxy group, a fluorine atom or the like.

"p-Valent heterocyclic group" (p represents an integer of 1 or more) denotes an atomic group remaining after removing from a heterocyclic compound p hydrogen atoms among hydrogen atoms directly linked to a carbon atom or a hetero atom constituting the heterocyclic ring or the ring condensed to the heterocyclic ring. Of p-valent heterocyclic groups, "p-valent aromatic heterocyclic groups" as an atomic group remaining after removing from an aromatic heterocyclic compound p hydrogen atoms among hydrogen atoms directly linked to a carbon atom or a hetero atom constituting the heterocyclic ring or the ring condensed to the heterocyclic ring are preferable.

"Aromatic heterocyclic compound" denotes a compound in which the heterocyclic ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole and dibenzophosphole, and a compound in which an aromatic ring is condensed to the heterocyclic ring even if the heterocyclic ring itself shows no aromaticity such as phenoxazine, phenothiazine, dibenzoborole, dibenzosilole and benzopyran.

The number of carbon atoms constituting the heterocyclic ring and the ring condensed to the heterocyclic ring in the monovalent heterocyclic group is usually 2 to 60, preferably 4 to 20.

The monovalent heterocyclic group includes a thienyl group, a pyrrolyl group, a furyl group, a pyridyl group, a

piperidyl group, a quinolinyl group, an isoquinolinyl group, a pyrimidinyl group, a triazinyl group and the like. The monovalent heterocyclic group optionally has a substituent, and examples thereof may be groups obtained by substituting a part or all of hydrogen atoms in monovalent heterocyclic groups with an alkyl group, a cycloalkyl group, an alkoxy group, a cycloalkoxy group, a fluorine atom or the like.

"Halogen atom" denotes a fluorine atom, a chlorine atom, a bromine atom or an iodine atom.

"Amino group" optionally has a substituent, and a substituted amino group is preferable. The substituent which an amino group has is preferably an alkyl group, a cycloalkyl group, an aryl group or a monovalent heterocyclic group.

The substituted amino group includes, for example, a dialkylamino group, a dicycloalkylamino group and a diarylamino group. The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"Alkenyl group" may be any of linear or branched. The number of carbon atoms of the linear alkenyl group, not including the number of carbon atoms of the substituent, is usually 2 to 30, preferably 3 to 20. The number of carbon atoms of the branched alkenyl group, not including the number of carbon atoms of the substituent, is usually 3 to 30, preferably 4 to 20.

The number of carbon atoms of "Cycloalkenyl group", not including the number of carbon atoms of the substituent, is usually 3 to 30, preferably 4 to 20.

The alkenyl group and cycloalkenyl group include, for example, a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group and the like. The alkenyl group optionally has a substituent, and examples thereof may be groups obtained by substituting a part or all of hydrogen atoms in alkenyl groups with a cycloalkyl group, an alkoxy group, a cycloalkoxy group, an aryl group, a fluorine atom or the like. The cycloalkenyl group optionally has a substituent, and examples thereof may be groups obtained by substituting a part or all of hydrogen atoms in cycloalkenyl groups with an alkyl group, a cycloalkyl group, an alkoxy group, a cycloalkoxy group, an aryl group, a fluorine atom or the like.

"Alkynyl group" may be any of linear or branched. The number of carbon atoms of the alkynyl group, not including the number of carbon atoms of the substituent, is usually 2 to 20, preferably 3 to 20. The number of carbon atoms of the branched alkynyl group, not including the number of carbon atoms of the substituent, is usually 4 to 30, preferably 4 to 20.

The number of carbon atoms of "Cycloalkynyl group", not including the number of carbon atoms of the substituent, is usually 4 to 30, preferably 4 to 20.

The alkynyl group and cycloalkynyl group include, for example, an ethynyl group, a 1-propynyl group, a 2-propynyl group, a 2-butynyl group, a 3-butynyl group, a 3-pentynyl group, a 4-pentynyl group, a 1-hexynyl group, a 5-hexynyl group and the like. The alkynyl group optionally has a substituent, and examples thereof may be groups obtained by substituting a part or all of hydrogen atoms in alkynyl groups with a cycloalkyl group, an alkoxy group, a cycloalkoxy group, an aryl group, a fluorine atom or the like. The cycloalkynyl group optionally has a substituent, and examples thereof may be groups obtained by substituting a part or all of hydrogen atoms in cycloalkynyl groups with an alkyl group, a cycloalkyl group, an alkoxy group, a cycloalkoxy group, an aryl group, a fluorine atom or the like.

"Arylene group" denotes an atomic group remaining after removing from an aromatic hydrocarbon two hydrogen atoms linked directly to carbon atoms constituting the aromatic ring. The number of carbon atoms constituting the aromatic ring in the arylene group is usually 6 to 60, preferably 6 to 30, more preferably 6 to 18.

The arylene group includes, for example, a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group and the like. The arylene group optionally has a substituent, and examples thereof may be groups obtained by substituting a part or all of hydrogen atoms in arylene groups with an alkyl group, a cycloalkyl group, an alkoxy group, a cycloalkoxy group, an aryl group, a fluorine atom or the like.

The arylene group is preferably a group represented by the formula (A-1), (A-2), (A-3), (A-4), (A-5), (A-6), (A-7), (A-8), (A-9), (A-10), (A-11), (A-12), (A-13), (A-14), (A-15), (A-16), (A-17), (A-18), (A-19) or (A-20) (hereinafter, referred to as "groups represented by the formulae (A-1) to (A-20)" in some cases).
The arylene group includes groups obtained by linking a plurality of these groups.

[Chemical Formula 12]

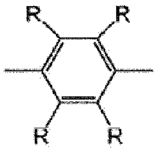
(A-1)
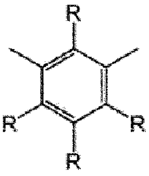
(A-2)
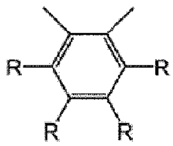
(A-3)
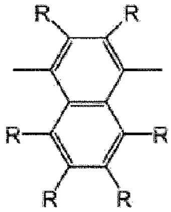
(A-4)
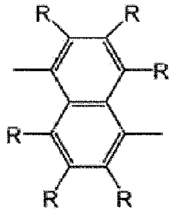
(A-5)
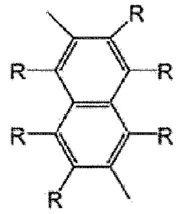
(A-6)

[Chemical Formula 13]

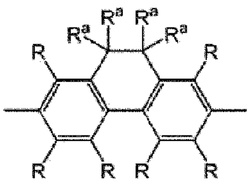
(A-7)
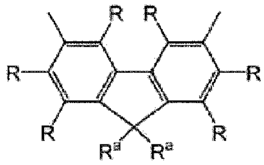
(A-8)
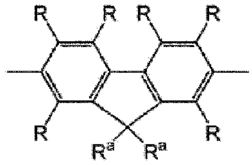
(A-9)
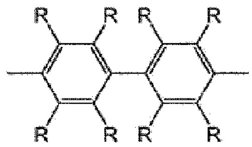
(A-10)

[Chemical Formula 14]

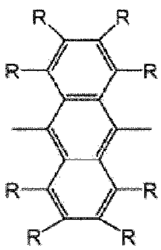
(A-11)
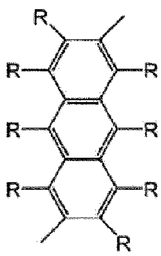
(A-12)
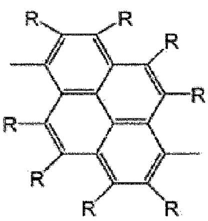
(A-13)
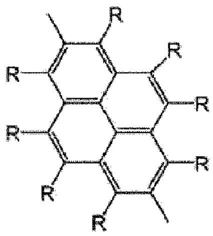
(A-14)
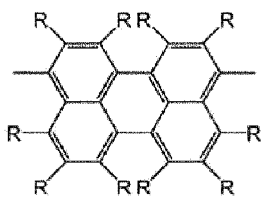
(A-15)

[Chemical Formula 15]

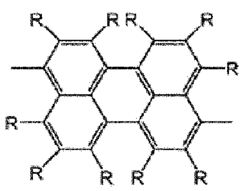
(A-16)
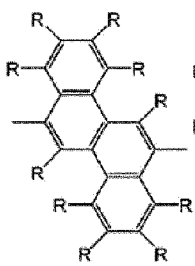
(A-17)
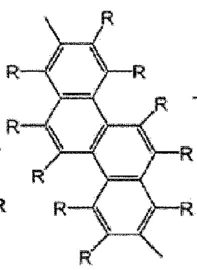
(A-18)
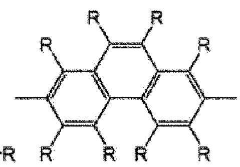
(A-19)
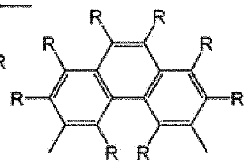
(A-20)

Wherein, R and $R^a$ each independently represent a hydrogen atom, an alkyl group, a cycloalkyl group, an aryl group or a monovalent heterocyclic group. The plurality of R and $R^a$ each may be the same or different, and groups $R^a$ may be combined together to form a ring together with the atoms to which they are attached.

The number of carbon atoms constituting the heterocyclic ring and the ring condensed to the heterocyclic ring in the divalent heterocyclic group is usually 2 to 60, preferably 3 to 20, more preferably 4 to 15.

The divalent heterocyclic group includes, for example, divalent groups obtained by removing from heterocyclic

compounds such as pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms linking directly to a carbon atom or a hetero atom constituting the heterocyclic ring or the ring condensed to the heterocyclic ring.

The divalent heterocyclic group is preferably a group represented by the formula (AA-1), (AA-2), (AA-3), (AA-4), (AA-5), (AA-6), (AA-7), (AA-8), (AA-9), (AA-10), (AA-11), (AA-12), (AA-13), (AA-14), (AA-15), (AA-16), (AA-17), (AA-18), (AA-19), (AA-20), (AA-21), (AA-22), (AA-23), (AA-24), (AA-25), (AA-26), (AA-27), (AA-28), (AA-29), (AA-30), (AA-31), (AA-32), (AA-33) or (AA-34) (hereinafter, referred to as "groups represented by the formulae (AA-1) to (AA-34)" in some cases). The divalent heterocyclic group includes groups obtained by linking a plurality of these groups.

[Chemical Formula 16]

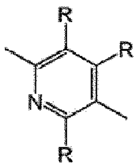
(AA-1)
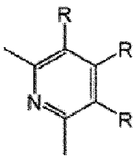
(AA-2)
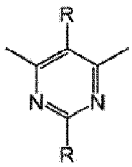
(AA-3)
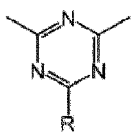
(AA-4)
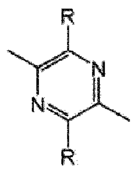
(AA-5)
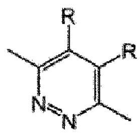
(AA-6)
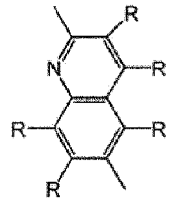
(AA-7)

[Chemical Formula 17]

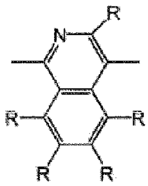
(AA-8)
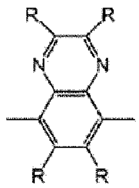
(AA-9)
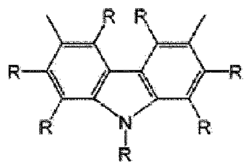
(AA-10)
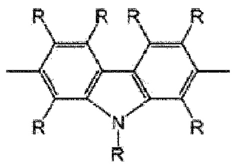
(AA-11)
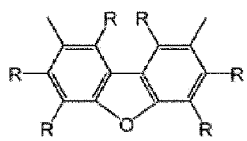
(AA-12)

[Chemical Formula 18]

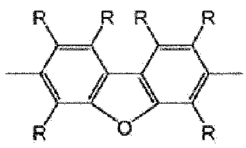
(AA-13)
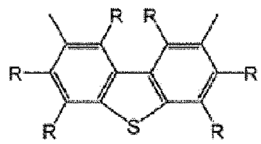
(AA-14)
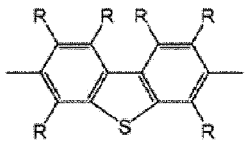
(AA-15)
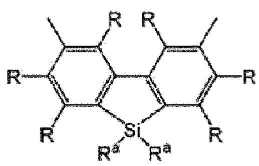
(AA-16)

[Chemical Formula 19]

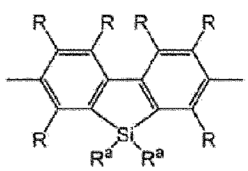
(AA-17)
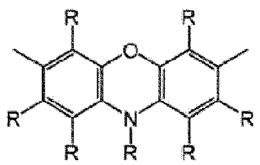
(AA-18)
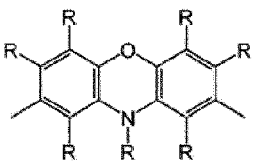
(AA-19)
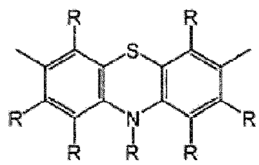
(AA-20)

[Chemical Formula 20]

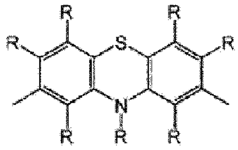
(AA-21)

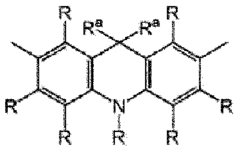
(AA-22)

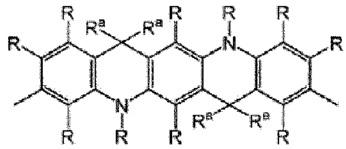
(AA-23)

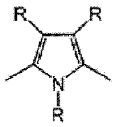
(AA-24)

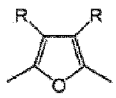
(AA-25)

[Chemical Formula 21]

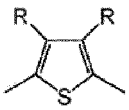
(AA-26)

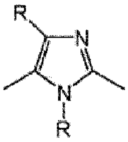
(AA-27)

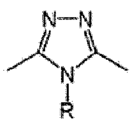
(AA-28)

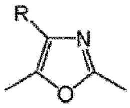
(AA-29)

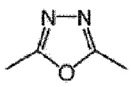
(AA-30)

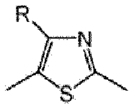
(AA-31)

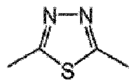
(AA-32)

[Chemical Formula 22]

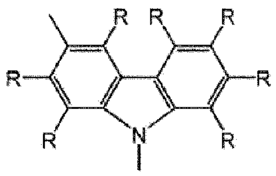
(AA-33)

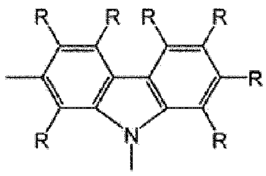
(AA-34)

Wherein, R and $R^a$ represent the same meaning as described above.

"Crosslinkable group" is a group capable of forming a new bond by being subjected to a heating treatment, an ultraviolet irradiation treatment, a radical reaction and the like, and is preferably a crosslinkable group represented by the formula (XL-1), (XL-2), (XL-3), (XL-4), (XL-5), (XL-6), (XL-7), (XL-8), (XL-9), (XL-10), (XL-11), (XL-12), (XL-13), (XL-14), (XL-15), (XL-16) or (XL-17) in the above-described Group A of crosslinkable group (hereinafter, referred to as "groups represented by the formulae (XL-1) to (XL-17)" in some cases).

"Substituent" represents a halogen atom, a cyano group, an alkyl group, a cylcoalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group or a cycloalkynyl group. The substutuent may be a crosslinkable group.

<Light-emitting device>

Then, a light-emitting device according to the present invention will be described.

A light-emitting device according to the present invention comprises an anode, a cathode, a first organic layer disposed between the anode and the cathode, and a second organic layer disposed between the anode and the first organic layer and adjacent to the first organic layer. The first organic layer is a layer formed by using a phosphorescent compound represented by the formula (1), and the second organic layer is a layer formed by using a polymer composition in which one or two or more polymer compounds including a crosslinkable polymer compound having at least one crosslinkable group selected from Group A of crosslinkable groups are compounded. Further for the one or two or more polymer compounds compounded in the polymer composition, with respect to each monomer unit constituting the polymer compounds, the value x obtained by multiplying the molar ratio C of the each monomer unit to the total mol of all the monomer units by the molecular weight M of the each monomer unit, and the value y obtained by multiplying the molar ratio C by the number n of the crosslinkable groups in the each monomer unit are determined, the value of $(Y_1 \times 1000)/X_1$ calculated from $X_1$ being the total of the values x and $Y_1$ being the total of the values y being 0.5.

"Being formed by using" mentioned for the relation between the first organic layer and the phosphorescent compound represented by the formula (1) means that the first organic layer is formed by using the phosphorescent compound represented by the formula (1). The phosphorescent compound represented by the formula (1) as it is may be contained in the first organic layer, or the phosphorescent compound represented by the formula (1) may be contained

in the state of being intramolecularly, intermolecularly or in both manners crosslinked in the first organic layer. That is, the first organic layer may comprise the phosphorescent compound represented by the formula (1) and/or a crosslinked form of the phosphorescent compound.

"Being formed by using" mentioned for the relation between the second organic layer and the polymer composition means that the second organic layer is formed by using the polymer composition. The polymer composition as it is may be contained in the second organic layer, or the crosslinkable polymer compound contained in the polymer composition may be contained in the state of being intramolecularly, intermolecularly or in both manners crosslinked in the second organic layer. That is, the second organic layer may comprise the polymer composition and/or a cured polymer product produced by curing the polymer composition.

Examples of the methods for forming the first organic layer and the second organic layer include a vacuum vapor deposition method, and coating methods typified by a spin coat method and an inkjet printing method.

When the first organic layer is formed by a coating method, it is preferable to use an ink for the first organic layer described later. After the first organic layer is formed, the phosphorescent compound can be crosslinked by heating it or irradiating it with light. When the phosphorescent compound is contained in the state of being crosslinked in the first organic layer, the first organic layer is substantially insolubilized to solvents. Hence, the first organic layer can suitably be used for lamination of the light-emitting device.

When the second organic layer is formed by a coating method, it is preferable to use an ink for the second organic layer described later. After the second organic layer is formed, a crosslinkable polymer compound contained in the polymer composition can be crosslinked by heating it or irradiating it with light. When the polymer compound is contained in the state of being crosslinked in the second organic layer, the second organic layer is substantially insolubilized to solvents. Hence, the second organic layer can suitably be used for lamination of the light-emitting device.

In the light-emitting device according to the present invention, it is preferable that the crosslinkable polymer compound contained in the polymer composition is contained in the state of being crosslinked in the second organic layer.

The heating temperature for the crosslinking is usually 25 to 300°C, preferably 50 to 250°C, and more preferably 150 to 200°C.

The kind of light to be used for light irradiation for the crosslinking is, for example, ultraviolet light, near-ultraviolet light or visible light.

<First organic layer>

The first organic layer is a layer formed by using a phosphorescent compound represented by the formula (1).

[Phosphorescent compound represented by the formula (1)]

The phosphorescent compound represented by the formula (1) is constituted of M being the central metal, a ligand(s) the number of which is specified by a subscript $n^1$, and a ligand(s) the number of which is specified by a subscript $n^2$.

M is preferably an iridium atom or a platinum atom, and more preferably an iridium atom, because the external quantum efficiency of the light-emitting device according to the present invention is excellent.

When M is a ruthenium atom, a rhodium atom or an iridium atom, it is preferable that $n^1$ is 2 or 3; and it is more preferable to be 3.

When M is a palladium atom or a platinum atom, it is preferable that $n^1$ is 2.

It is preferable that $E^1$ is a carbon atom.

The ring $L^{1A}$ is an imidazole ring in which $E^{11A}$ is a nitrogen atom or $E^{12A}$ is a nitrogen atom, and the imidazole ring in which $E^{11A}$ is a nitrogen atom is preferable.

When $E^{11A}$ is a nitrogen atom, $R^{11A}$ is preferably an alkyl group, a cycloalkyl group, an aryl group, a monovalent heterocyclic group or a substituted amino group; more preferably an alkyl group, a cycloalkyl group or an aryl group; and further preferably an aryl group; and these groups each optionally have a substituent.

When $E^{11A}$ is a carbon atom, $R^{11A}$ is preferably an alkyl group, a cycloalkyl group, an aryl group, a monovalent heterocyclic group or a substituted amino group; more preferably a hydrogen atom, an alkyl group, a cycloalkyl group or an aryl group; further preferably a hydrogen atom, an alkyl group or a cycloalkyl group; and it is especially preferably a hydrogen atom; and these groups each optionally have a substituent.

When $E^{12A}$ is a nitrogen atom, $R^{12A}$ is preferably an alkyl group, a cycloalkyl group, an aryl group, a monovalent heterocyclic group or a substituted amino group; more preferably an alkyl group, a cycloalkyl group or an aryl group; and it is further preferably an aryl group; and these groups each optionally have a substituent.

When $E^{12A}$ is a carbon atom, $R^{12A}$ is preferably an alkyl group, a cycloalkyl group, an aryl group, a monovalent heterocyclic group or a substituted amino group; more preferably a hydrogen atom, an alkyl group, a cycloalkyl group or an aryl group; further preferably a hydrogen atom, an alkyl group or a cycloalkyl group; and especially preferably a

hydrogen atom; and these groups each optionally have a substituent.

$R^{13A}$ is preferably an alkyl group, a cycloalkyl group, an aryl group, a monovalent heterocyclic group or a substituted amino group; more preferably a hydrogen atom, an alkyl group, a cycloalkyl group or an aryl group; further preferably a hydrogen atom, an alkyl group or a cycloalkyl group; and especially preferably a hydrogen atom; and these groups each optionally have a substituent.

When the ring $L^{2A}$ is a pyridine ring, the pyridine ring in which $E^{21A}$ is a nitrogen atom, the pyridine ring in which $E^{22A}$ is a nitrogen atom, or the pyridine ring in which $E^{23A}$ is a nitrogen atom is preferable; and the pyridine ring in which $E^{22A}$ is a nitrogen atom is more preferable.

When the ring $L^{2A}$ is a pyrimidine ring, the pyrimidine ring in which $E^{21A}$ and $E^{23A}$ are nitrogen atoms, or the pyrimidine ring in which $E^{22A}$ and $E^{24A}$ are nitrogen atoms is preferable; and the pyrimidine ring in which $E^{22A}$ and $E^{24A}$ are nitrogen atoms is more preferable.

It is preferable that the ring $L^{2A}$ is a benzene ring.

$R^{21A}$, $R^{22A}$, $R^{23A}$ and $R^{24A}$ each preferably independently represent an alkyl group, a cycloalkyl group, an aryl group, a monovalent heterocyclic group or a substituted amino group; are more preferably a hydrogen atom, an alkyl group, a cycloalkyl group or an aryl group; and further preferably a hydrogen atom, an alkyl group or an aryl group; and these groups each optionally have a substituent.

It is preferable that a substituent which $R^{11A}$, $R^{12A}$, $R^{13A}$, $R^{21A}$, $R^{22A}$, $R^{23A}$ and $R^{24A}$ optionally have is an alkyl group, a cycloalkyl group, an aryl group, a monovalent heterocyclic group or a substituted amino group; and these groups each optionally further have a substituent.

When $R^{11A}$, $R^{12A}$, $R^{13A}$, $R^{21A}$, $R^{22A}$, $R^{23A}$ and $R^{24A}$ are an aryl group, a monovalent heterocyclic group or a substituted amino group, it is preferable to be a dendron because the external quantum efficiency of the light-emitting device is excellent.

"Dendron" denotes a group having a regular dendritic branched structure having a branching point at an atom or ring (that is, a dendrimer structure). A compound having a dendron (hereinafter, referred to as "dendrimer") includes, for example, structures described in literatures such as International Publication WO02/067343, JP-A No. 2003-231692, International Publication WO2003/079736, International Publication WO2006/097717 and the like.

The dendron is preferably a group represented by the above-described formula (D-A) or the above-described (D-B).

$G^{DA}$ is preferably a group represented by the formula (GDA-11), (GDA-12), (GDA-13), (GDA-14) or (GDA-15) (hereinafter, referred to as "groups represented by the formulae (GDA-11) to (GDA-15)" in some cases), and these groups each optionally have a substituent.

[Chemical Formula 23]

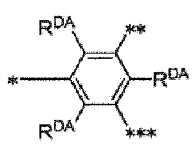
(GDA-11)

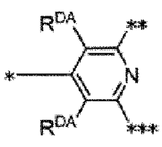
(GDA-12)

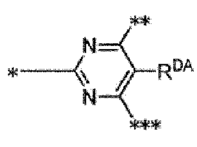
(GDA-13)

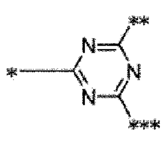
(GDA-14)

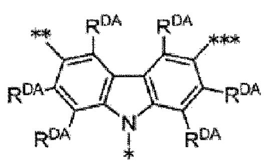
(GDA-15)

Wherein,

* represents a bond to $Ar^{DA1}$ in the formula (D-A), $Ar^{DA1}$ in the formula (D-B), $Ar^{DA2}$ in the formula (D-B) or $Ar^{DA3}$ in the formula (D-B).
** represents a bond to $Ar^{DA2}$ in the formula (D-A), $Ar^{DA2}$ in the formula (D-B), $Ar^{DA4}$ in the formula (D-B) or $Ar^{DA6}$ in the formula (D-B).
*** represents a bond to $Ar^{DA3}$ in the formula (D-A), $Ar^{DA3}$ in the formula (D-B), $Ar^{DA5}$ in the formula (D-B) or $Ar^{DA7}$ in the formula (D-B).

$R^{DA}$ represents a hydrogen atom, an alkyl group, a cycloalkyl group, an alkoxy group, a cycloalkoxy group, an aryl group or a monovalent heterocyclic group, and these groups each optionally have a substituent. When a plurality of $R^{DA}$ are present, they may be the same or different.

$R^{DA}$ is preferably a hydrogen atom, an alkyl group, a cycloalkyl group, an alkoxy group or a cycloalkoxy group, more preferably a hydrogen atom, an alkyl group or cycloalkyl group, and these groups each optionally have a substituent.

It is preferable that $Ar^{DA1}$, $Ar^{DA2}$, $Ar^{DA3}$, $Ar^{DA4}$, $Ar^{DA5}$, $Ar^{DA6}$ and $Ar^{DA7}$ are groups represented by the formula

(ArDA-1), (ArDA-2) or (ArDA-3) (hereinafter, referred to as "groups represented by the formulae (ArDA-1) to (ArDA-3)" in some cases).

[Chemical Formula 24]

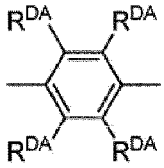
(ArDA-1)

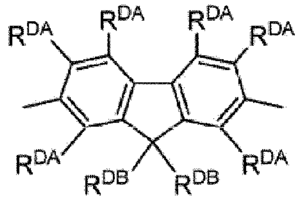
(ArDA-2)

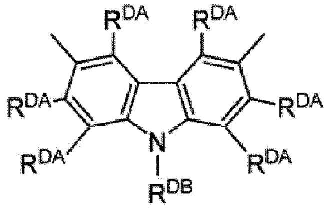
(ArDA-3)

Wherein,
$R^{DA}$ represents the same meaning as described above.
$R^{DB}$ represents a hydrogen atom, an alkyl group, a cycloalkyl group, an aryl group or a monovalent heterocyclic group, and these groups each optionally have a substituent. When a plurality of $R^{DB}$ are present, they may be the same or different.

$R^{DB}$ is preferably an alkyl group, a cycloalkyl group, an aryl group or a monovalent heterocyclic group, more preferably an aryl group or a monovalent heterocyclic group, further preferably an aryl group, and these groups each optionally have a substituent.

$T^{DA}$ is preferably groups represented by the formula (TDA-1), (TDA-2) or (TDA-3) (hereinafter, referred to as "groups represented by the formulae (TDA-1) to (TDA-3)" in some cases).

[Chemical Formula 25]

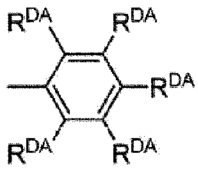
(TDA-1)

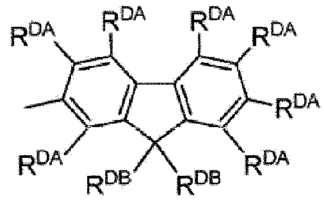
(TDA-2)

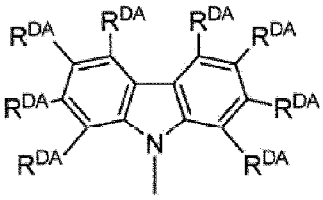
(TDA-3)

Wherein, $R^{DA}$ and $R^{DB}$ represent the same meaning described above.

The group represented by the formula (D-A) is preferably a group represented by the formula (D-A1), (D-A2) or (D-A3) (hereinafter, referred to as "groups represented by the formulae (D-A1) to (D-A3)" in some cases).

[Chemical Formula 26]

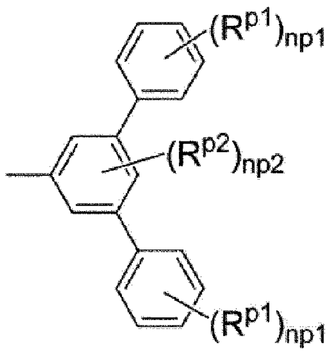
(D-A1)

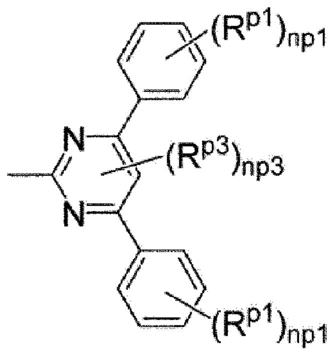
(D-A2)

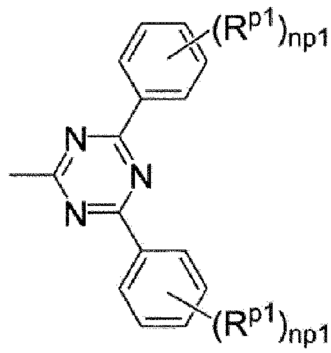
(D-A3)

Wherein,
$R^{p1}$, $R^{p2}$ and $R^{p3}$ each independently represent an alkyl group, a cycloalkyl group, an alkoxy group, a cycloalkoxy group or a halogen atom. When a plurality of $R^{p1}$ and $R^{p2}$ are present, they may be the same or different at each occurrence.
np1 represents an integer of 0 to 5, np2 represents an integer of 0 to 3, and np3 represents 0 or 1. The plurality of np1 may be the same or different.
The group represented by the formula (D-B) is preferably a group represented by the formula (D-B1), (D-B2) or (D-B3) (hereinafter, referred to as "groups represented by the formulae (D-B1) to (D-B3)" in some cases).

[Chemical Formula 27]

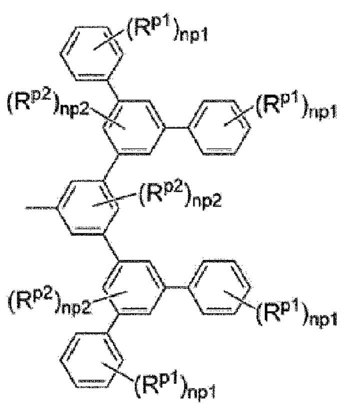

(D-B1)

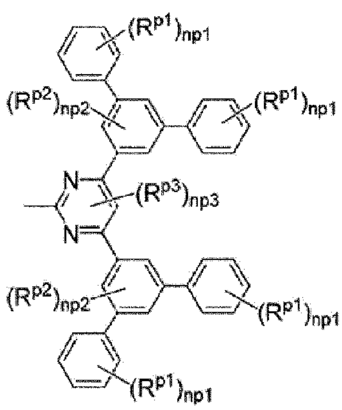

(D-B2)

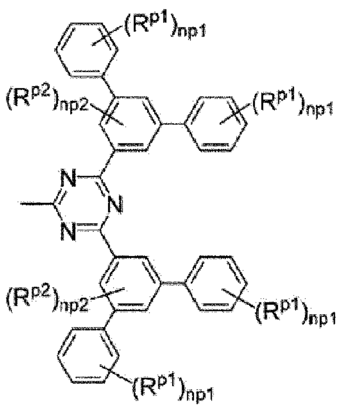

(D-B3)

Wherein,
$R^{p1}$, $R^{p2}$ and $R^{p3}$ each independently represent an alkyl group, a cycloalkyl group, an alkoxy group, a cycloalkoxy group or a halogen atom. When a plurality of $R^{p1}$ and $R^{p2}$ are present, they may be the same or different at each occurrence.
np1 represents an integer of 0 to 5, np2 represents an integer of 0 to 3, and np3 represents 0 or 1. When a plurarity of np1 and np2 are present, they may be the same or different at each occurrence.
np1 is preferably 0 or 1, more preferably 1. np2 is preferably 0 or 1, more preferably 0. np3 is preferably 0.
$R^{p1}$, $R^{p2}$ and $R^{p3}$ are preferably an alkyl group or a cycloalkyl group.
Examples of an anionic bidentate ligand represented by $A^1$-$G^1$-$A^2$ include ligands represented by the following.

[Chemical Formula 28]

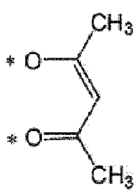 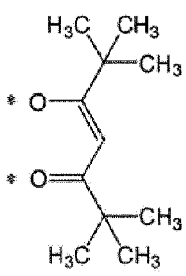 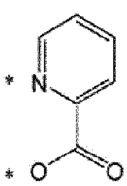 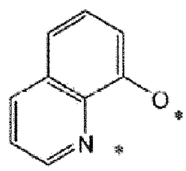 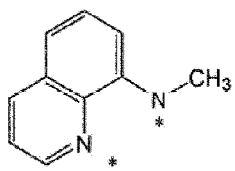

[Chemical Formula 29]

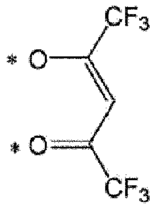
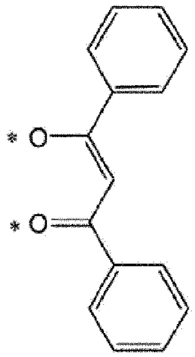
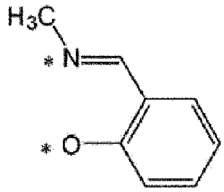
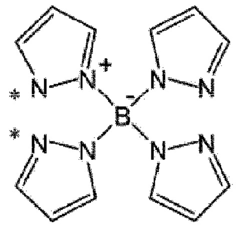

Wherein, * indicates bonding portions to M.

The anionic bidentate ligand represented by $A^1$-$G^1$-$A^2$ may be ligands represented by the following. Here, the anionic bidentate ligand represented by $A^1$-$G^1$-$A^2$ is different from the ligand the number of which is defined by the subscript $n^1$.

[Chemical Formula 30]

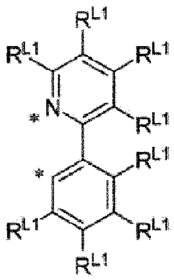
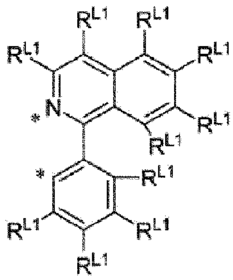
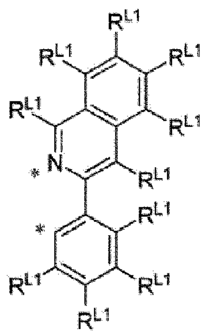
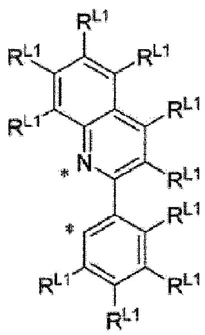
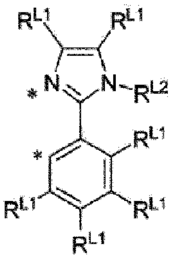
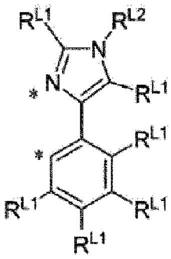
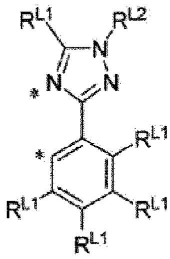
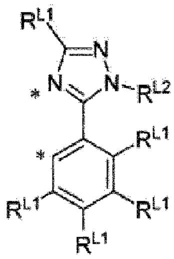
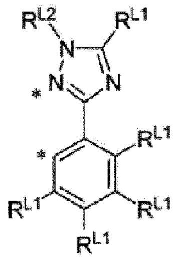
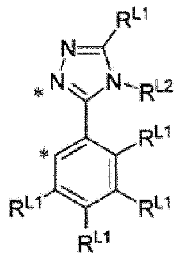

Wherein, * indicates bonding portions to M.

$R^{L1}$ represents a hydrogen atom, an alkyl group, a cycloalkyl group or a halogen atom, and these groups each optionally have a substituent. The plurality of $R^{L1}$ may be the same or different.

$R^{L2}$ represents an alkyl group, a cycloalkyl group or a halogen atom, and these groups each optionally have a substituent.

The phosphorescent compound represented by the formula (1) is preferably a phosphorescent compound represented by the above formula (1-1) or a phosphorescent compound represented by the formula (1-2); and more preferably a phosphorescent compound represented by the above formula (1-1).

Examples of the phosphorescent compound represented by the formula (1) include phosphorescent compounds represented by the following formulae.

[Chemical Formula 31]

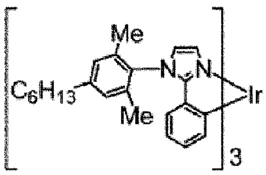
COM-17

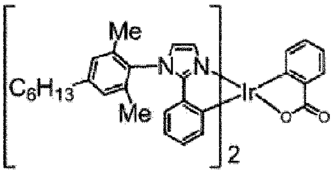
COM-18

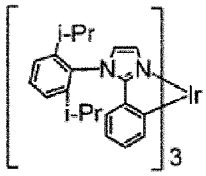
COM-19

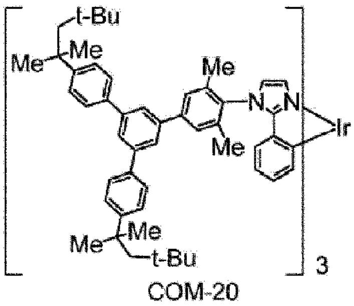
COM-20

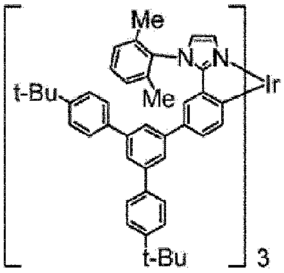
COM-21

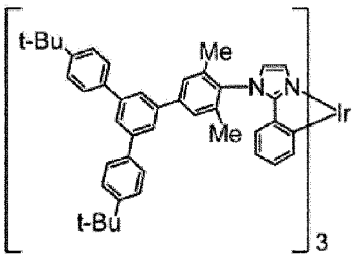
COM-22

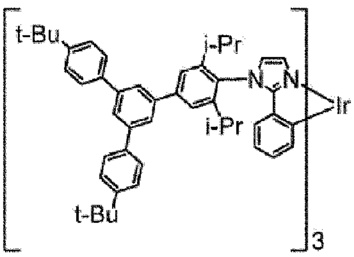
COM-23

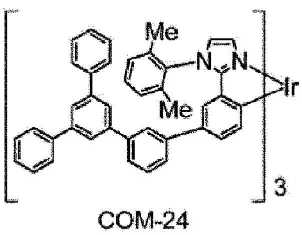
COM-24

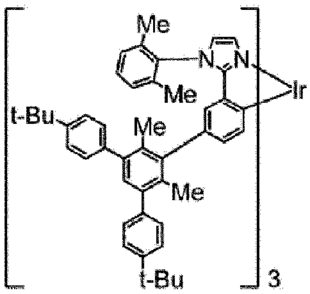
COM-25

[Chemical Formula 32]

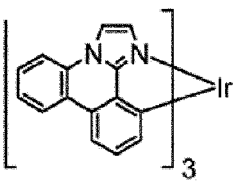
COM-26

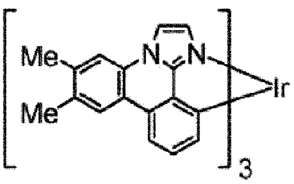
COM-27

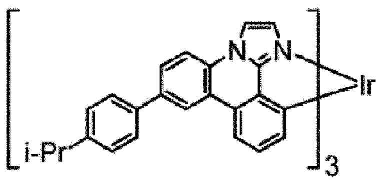
COM-28

As described above, although the first organic layer is formed by using at least the phosphorescent compound represented by the formula (1), the first organic layer may be a layer formed by using the phosphorescent compound represented by the formula (1) and other phosphorescent compounds in combination. That is, the first organic layer may further comprise the other phosphorescent compounds other than the phosphorescent compound represented by the formula (1). Examples of the other phosphorescent compounds include phosphorescent compounds represented by the following formulae.

[Chemical Formula 33]

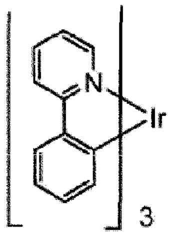

$Ir(ppy)_3$

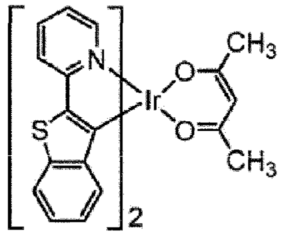

$Btp_2Ir(acac)$

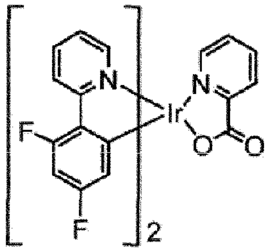

FIrpic

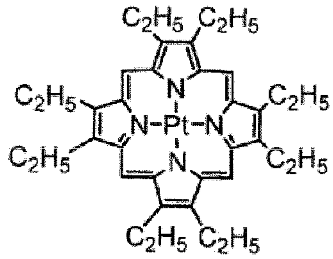

PtOEP

[Chemical Formula 34]

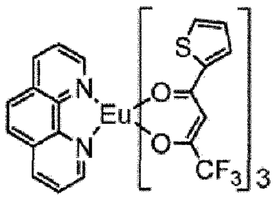

$Eu(TTA)_3phen$

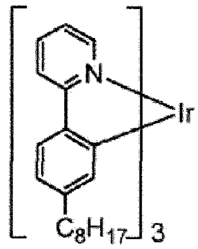

COM-1

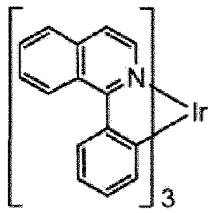

COM-2

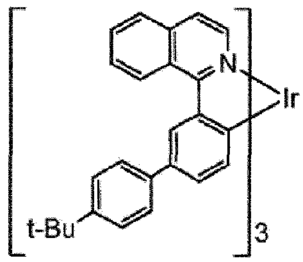

COM-3

[Chemical Formula 35]

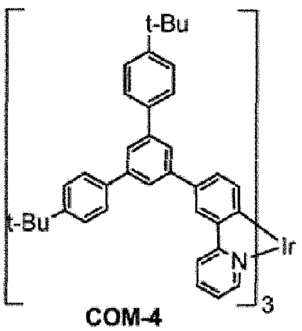

COM-4

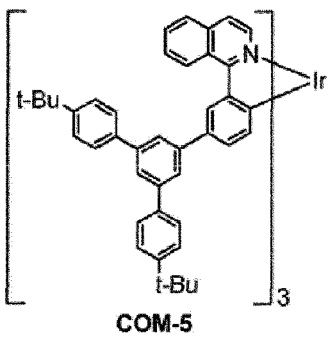

COM-5

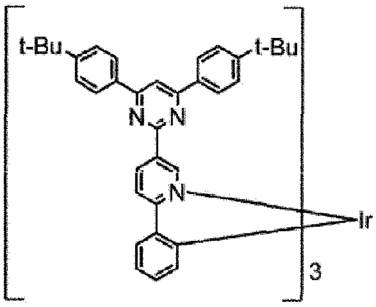

COM-6

[Chemical Formula 36]

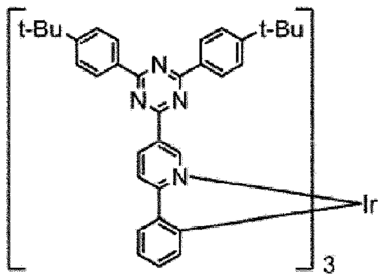

COM-7

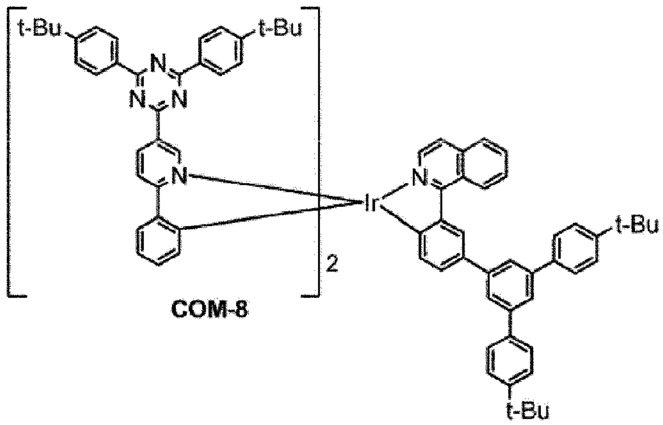

COM-8

The phosphorescent compound used for formation of the first organic layer can be synthesized according to methods described, for example, in Japanese Patent Application National Publication No. 2004-530254, JP-A No. 2008-179617, JP-A No. 2011-105701, Japanese Patent Application National Publication No. 2007-504272, JP-A No. 2013-147449 and JP-A No. 2013-147450.

[Host material]

Because the external quantum efficiency of the light-emitting device according to the present invention is excellent, it is preferable that the first organic layer of the light-emitting device according to the present invention is a layer formed by using a composition comprising one or more phosphorescent compounds represented by the formula (1), and a host material having at least one function selected from the group consisting of the hole injectability, the hole transportability, the electron injectability and the electron transportability. In the composition, the host material may be contained singly or two or more materials may be contained.

That is, the first organic layer may be a layer further comprising a host material having at least one function selected from the group consisting of the hole injectability, the hole transportability, the electron injectability and the electron transportability. Further the first organic layer may be a layer constituted of a composition comprising one or more phosphorescent compounds represented by the formula (1), and a host material having at least one function selected from the group consisting of the hole injectability, the hole transportability, the electron injectability and the electron transportability.

In the composition comprising the phosphorescent compounds represented by the formula (1) and the host material, the content of the phosphorescent compounds represented by the formula (1) is, when the total of the phosphorescent compounds represented by the formula (1) and the host material is taken to be 100 parts by mass, usually 0.1 to 50 parts by mass, preferably 1 to 45 parts by mass, and more preferably 5 to 40 parts by mass.

It is preferable that the lowest excited triplet state ($T_1$) the host material has is at the same energy level as that of $T_1$ the phosphorescent compound represented by the formula (1) to be used for formation of the first organic layer has, or at a higher energy level than that, because the external quantum efficiency of the light-emitting device according to the present invention is excellent.

It is preferable that the host material is soluble in a solvent capable of dissolving the phosphorescent compound represented by the formula (1), because the light-emitting device according to the present invention can be fabricated by a solution coating process.

The host material is classified into low molecular weight compounds and polymer compounds.

[Low molecular weight host]

The low molecular weight compound which is preferable as a host compound (hereinafter, referred to as "low molecular weight host") will be explained below. The low molecular weight host is a compound having no molecular weight distribution and having a molecular weight of $1\times10^4$ or less among host materials described above.

The low molecular weight host is preferably a compound represented by the formula (H-1).

$Ar^{H1}$ and $Ar^{H2}$ are preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a spirobifluorenyl group, a pyridyl group, a pyrimidinyl group, a

triazinyl group, a dibenzothienyl group, a dibenzofuryl group, a carbazolyl group or an azacarbazolyl group, further preferably a phenyl group, a pyridyl group, a carbazolyl group or an azacarbazolyl group, particularly preferably a group represented by formula (TDA-1) or (TDA-3) described above, especially preferably a group represented by the formula (TDA-3) described above, and these groups each optionally have a substituent.

The substituent which $Ar^{H1}$ and $Ar^{H2}$ optionally have is preferably a halogen atom, an alkyl group, a cycloalkyl group, an alkoxy group, a cycloalkoxy group, an aryl group or a monovalent heterocyclic group, more preferably an alkyl group, a cycloalkoxy group, an alkoxy group or cycloalkoxy group, further preferably an alkyl group or cycloalkoxy group, and these groups each optionally further have a substituent.

$n^{H1}$ is preferably 1. $n^{H2}$ is preferably 0.

$n^{H3}$ is usually an integer of 0 to 10, preferably an integer of 0 to 5, further preferably an integer of 1 to 3, particularly preferably 1.

$n^{H11}$ is preferably an integer of 1 to 5, more preferably an integer of 1 to 3, further preferably 1.

$R^{H11}$ is preferably a hydrogen atom, an alkyl group, a cycloalkyl group, an aryl group or a monovalent heterocyclic group, more preferably a hydrogen atom, an alkyl group or a cycloalkyl group, further preferably a hydrogen atom or an alkyl group, and these groups each optionally have a substituent.

$L^{H1}$ is preferably an arylene group or a divalent heterocyclic group, and these groups optionally have a substituent.

$L^{H1}$ is preferably a group represented by the formula (A-1) to (A-3), the formula (A-8) to (A-10), the formula (AA-1) to (AA-6), the formula (AA-10) to (AA-21) or the formula (AA-24) to (AA-34), more preferably a group represented by the formula (A-1), the formula (A-2), the formula (A-8), the formula (A-9), the formula (AA-1) to (AA-4), the formula (AA-10) to (AA-15) or the formula (AA-29) to (AA-34), further preferably a group represented by the formula (A-1), the formula (A-2), the formula (A-8), the formula (A-9), the formula (AA-2), the formula (AA-4) or the formula (AA-10) to (AA-15), particularly preferably a group represented by the formula (A-1), the formula (A-2), the formula (A-8), the formula (AA-2), the formula (AA-4), the formula (AA-10), the formula (AA-12) or the formula (AA-14), especially preferably a group represented by the formula (A-1), the formula (A-2), the formula (AA-2), the formula (AA-4) or the formula (AA-14).

The substituent which $L^{H1}$ optionally has is preferably a halogen atom, an alkyl group, a cycloalkyl group, an alkoxy group, a cycloalkoxy group, an aryl group or a monovalent heterocyclic group, more preferably an alkyl group, an alkoxy group, an aryl group or a monovalent heterocyclic group, further preferably an alkyl group, an aryl group or a monovalent heterocyclic group, and these groups each optionally further have a substituent.

$L^{H21}$ is preferably a single bond or an arylene group, more preferably a single bond, and this arylene group optionally has a substituent.

The definition and examples of the arylene group or the divalent heterocyclic group represented by $L^{H21}$ are the same as the definition and examples of the arylene group or the divalent heterocyclic group represented by $L^{H1}$.

$R^{H21}$ is preferably an aryl group or a monovalent heterocyclic group, and these groups each optionally have a substituent.

The definition and examples of the aryl group and the monovalent heterocyclic group represented by $R^{H21}$ are the same as the definition and examples of the aryl group and the monovalent heterocyclic group represented by $Ar^{H1}$ and $Ar^{H2}$.

The definition and examples of the substituent which $R^{H21}$ may optionally has are the same as the definition and examples of the substituent which $Ar^{H1}$ and $Ar^{H2}$ optionally have.

The compound represented by the formula (H-1) is preferably a compound represented by the formula (H-2).

[Chemical Formula 37]

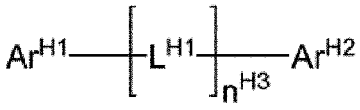

(H-2)

Wherein, $Ar^{H1}$, $Ar^{H2}$, $n^{H3}$ and $L^{H1}$ represent the same meaning as described above.

As the compound represented by the formula (H-1), compounds represented by the following formula (H-101), (H-102), (H-103), (H-104), (H-105), (H-106), (H-107), (H-108), (H-109), (H-110), (H-111), (H-112), (H-113), (H-114), (H-115), (H-116), (H-117) or (H-118) (hereinafter, referred to as "compounds represented by the formulae (H-101) to (118)" in some cases) are exemplified.

[Chemical Formula 38]

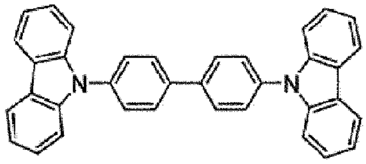
(H-101)

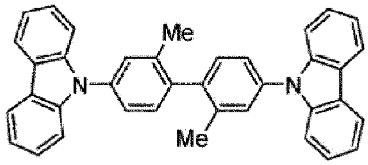
(H-102)

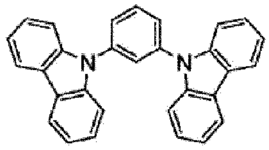
(H-103)

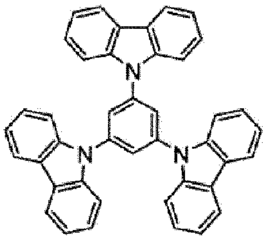
(H-104)

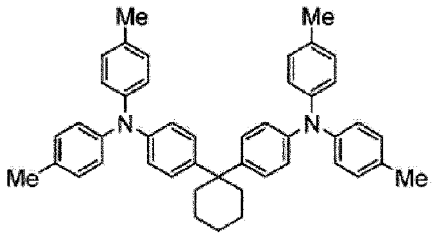
(H-105)

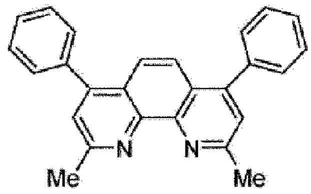
(H-106)

[Chemical Formula 39]

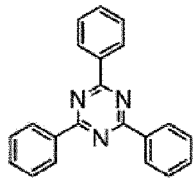
(H-107)

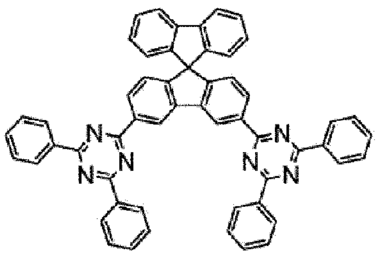
(H-108)

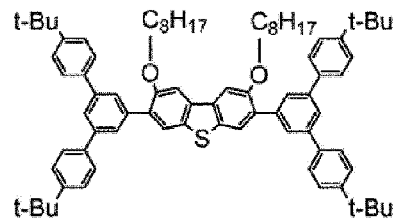
(H-109)

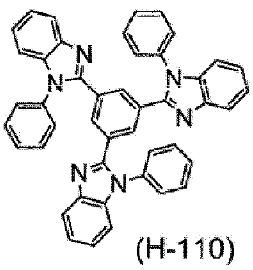
(H-110)

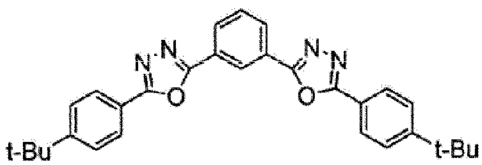
(H-111)

[Chemical Formula 40]

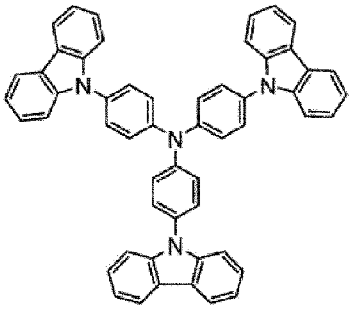

(H-112)

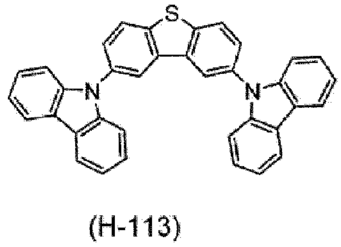

(H-113)

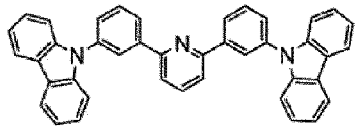

(H-114)

[Chemical Formula 41]

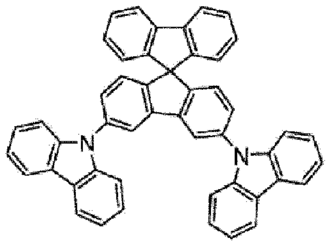

(H-115)

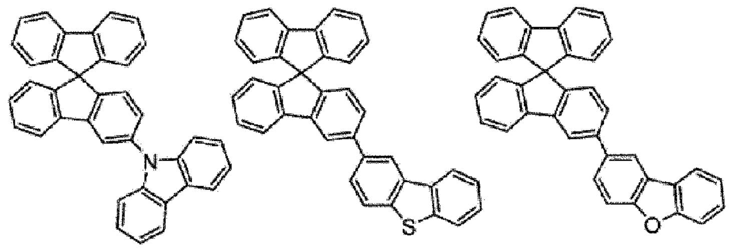

(H-116) (H-117) (H-118)

[Polymer host]

The polymer compound which is preferable as a host compound (hereinafter, referred to as "polymer host") will be explained below. The polymer host is a polymer having molecular weight distribution and having a polystyrene-equivalent number average molecular weight of $1\times10^3$ to $1\times10^8$ among host materials described above.

The polymer host includes, for example, polymer compounds as a hole transporting material described later and polymer compounds as an electron transporting material described later.

The polymer host is preferably a polymer compound comprising a constitutional unit represented by the formula (Y) described above.

The arylene group represented by $Ar^{Y1}$ is more preferably a group represented by the formula (A-1), the formula (A-2), the formula (A-6) to (A-10), the formula (A-19) or the formula (A-20), further preferably a group represented by the formula (A-1), the formula (A-2), the formula (A-7), the formula (A-9) or the formula (A-19), and these groups each optionally have a substituent.

The divalent heterocyclic group represented by $Ar^{Y1}$ is more preferably a group represented by the formula (AA-1) to (AA-4), the formula (AA-10) to (AA-15), the formula (AA-18) to (AA-21), the formula (AA-33) or the formula (AA-34), further preferably a group represented by the formula (AA-4), the formula (AA-10), the formula (AA-12), the formula (AA-14) or the formula (AA-33), and these groups each optionally have a substituent.

The more preferable range and the further preferable range of the arylene group and the divalent heterocyclic group in the divalent group in which at least one arylene group and at least one divalent heterocyclic group are bonded directly to each other represented by $Ar^{Y1}$ are the same as the more preferable range and the further preferable range of the arylene group and the divalent heterocyclic group represented by $Ar^{Y1}$ described above, respectively.

"The divalent group in which at least one arylene group and at least one divalent heterocyclic group are bonded directly to each other" includes, for example, groups represented by the following formulae, and each of them optionally has a substituent.

[Chemical Formula 42]

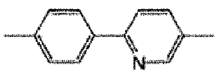 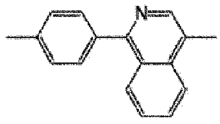 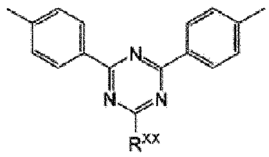 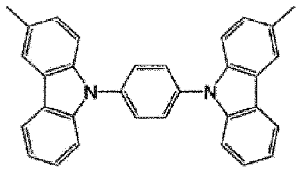

Wherein, $R^{XX}$ represents a hydrogen atom, an alkyl group, a cycloalkyl group, an aryl group or a monovalent heterocyclic group and these groups each optionally have a substituent.

$R^{XX}$ is preferably an alkyl group, a cycloalkyl group or an aryl group, and these groups each optionally have a substituent.

The substituent which the group represented by $Ar^{Y1}$ optionally has is preferably an alkyl group, a cycloalkyl group or an aryl group, and these groups each optionally further have a substituent.

The constitutional unit represented by the formula (Y) includes, for example, constitutional units represented by the formula (Y-1), (Y-2), (Y-3), (Y-4), (Y-5), (Y-6), (Y-7), (Y-8), (Y-9) or (Y-10) (hereinafter, referred to as "constitutional units represented by the formulae (Y-1) to (Y-9)" in some cases), and from the standpoint of the luminance life of the light-emitting device of the present invention preferable are constitutional units represented by the formulae (Y-1) to (Y-3), from the standpoint of electron transportability of the light-emitting device of the present invention preferable are constitutional units represented by the formulae (Y-4) to (Y-7), and from the standpoint of hole transportability of the light-emitting device of the present invention preferable are constitutional units represented by the formulae (Y-8) to (Y-10).

[Chemical Formula 43]

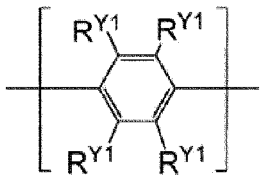 (Y-1)

Wherein, $R^{Y1}$ represents a hydrogen atom, an alkyl group, a cycloalkyl group, an alkoxy group, a cycloalkoxy group, an aryl group or a monovalent heterocyclic group, and these groups each optionally have a substituent. The plurality of $R^{Y1}$ may be the same or different, and adjacent $R^{Y1}$ s may be combined together to form a ring together with the carbon atoms to which they are attached.

$R^{Y1}$ is preferably a hydrogen atom, an alkyl group, a cycloalkyl group or an aryl group, and these groups each optionally have a substituent.

It is preferable that the constitional unit represented by the formula (Y-1) is a constitutional unit represented by the formula (Y-1').

[Chemical Formula 44]

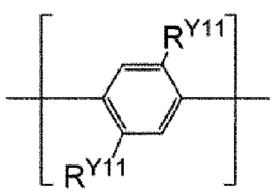 (Y-1')

Wherein, $R^{Y11}$ represents an alkyl group, a cycloalkyl group, an alkoxy group, a cycloalkoxy group, an aryl group or a monovalent heterocyclic group, and these groups each optionally have a substituent. The plurality of $R^{Y11}$ may be the same or different.

$R^{Y11}$ is preferably an alkyl group, a cycloalkyl group or an aryl group, more preferably an alkyl group or a cycloalkyl group, and these groups each optionally have a substituent.

[Chemical Formula 45]

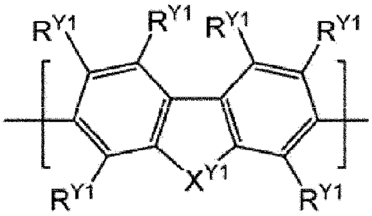

(Y-2)

Wherein, $R^{Y1}$ represents the same meaning as described above. $X^{Y1}$ represents a group represented by $-C(R^{Y2})_2-$, $-C(R^{Y2})=C(R^{Y2})-$ or $-C(R^{Y2})_2$ $-C(R^{Y2})_2-$. $R^{Y2}$ represents a hydrogen atom, an alkyl group, a cycloalkyl group, an alkoxy group, a cycloalkoxy group, an aryl group or a monovalent heterocyclic group and these groups each optionally have a substituent. The plurality of $R^{Y2}$ may be the same or different, and groups $R^{Y2}$ may be combined together to form a ring together with the carbon atoms to which they are attached.

$R^{Y2}$ is preferably an alkyl group, a cycloalkyl group, an aryl group or a monovalent heterocyclic group, more preferably an alkyl group a cycloalkyl group or an aryl group, and these groups each optionally have a substituent.

Regarding the combination of two $R^{Y2}$s in the group represented by $-C(R^{Y2})_2-$ in $X^{Y1}$, it is preferable that the both are an alkyl group or a cycloalkyl group, the both are an aryl group, the both are a monovalent heterocyclic group, or one is an alkyl group or a cycloalkyl group and the other is an aryl group or a monovalent heterocyclic group, it is more preferable that one is an alkyl group or cycloalkyl group and the other is an aryl group, and these groups each optionally have a substituent. The two groups $R^{Y2}$ may be combined together to form a ring together with the atoms to which they are attached, and when the groups $R^{Y2}$ form a ring, the group represented by $-C(R^{Y2})_2-$ is preferably a group represented by the formula (Y-A1), (Y-A2), (Y-A3), (Y-A4) or (Y-A5), more preferably a group represented by the formula (Y-A4), and these groups each optionally have a substituent.

[Chemical Formula 46]

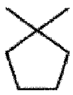
(Y-A1)

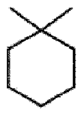
(Y-A2)

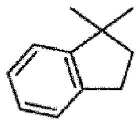
(Y-A3)

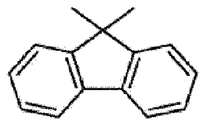
(Y-A4)

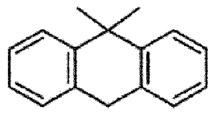
(Y-A5)

Regarding the combination of two $R^{Y2}$s in the group represented by $-C(R^{Y2})=C(R^{Y2})-$ in $X^{Y1}$, it is preferable that the both are an alkyl group or cycloalkyl group, or one is an alkyl group or a cycloalkyl group and the other is an aryl group, and these groups each optionally have a substituent.

Four $R^{Y2}$s in the group represented by $-C(R^{Y2})_2-C(R^{Y2})_2-$ in $X^{Y1}$ are preferably an alkyl group or a cycloalkyl group each optionally having a substituent. The plurality of $R^{Y2}$ may be combined together to form a ring together with the atoms to which they are attached, and when the groups $R^{Y2}$ form a ring, the group represented by $-C(R^{Y2})_2-C(R^{Y2})_2-$ is preferably a group represented by the formula (Y-B1), (Y-B2), (Y-B3), (Y-B4) or (Y-B5), more preferably a group represented by the formula (Y-B3), and these groups each optionally have a substituent.

[Chemical Formula 47]

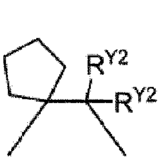
(Y-B1)

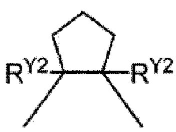
(Y-B2)

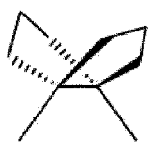
(Y-B3)

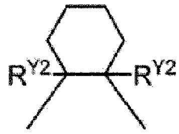
(Y-B4)

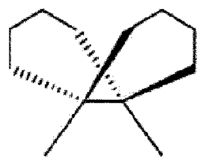
(Y-B5)

Wherein, $R^{Y2}$ represents the same meaning as described above.

It is preferable that the constitutional unit represented by the formula (Y-2) is a constitutional unit represented

by the formula (Y-2').

[Chemical Formula 48]

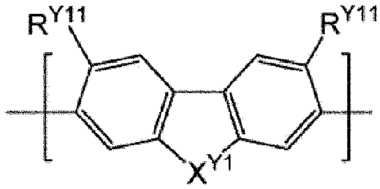

(Y-2')

Wherein, $R^{Y1}$ and $X^{Y1}$ represent the same meaning as described above.

[Chemical Formula 49]

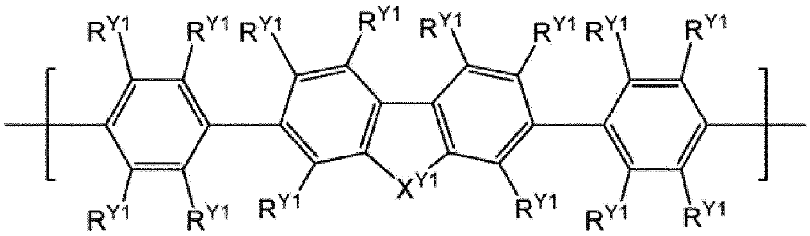

(Y-3)

Wherein, $R^{Y1}$ and $X^{Y1}$ represent the same meaning as described above.

It is preferable that the constitutional unit represented by the formula (Y-3) is a constitutional unit represented by the formula (Y-3').

[Chemical Formula 50]

[

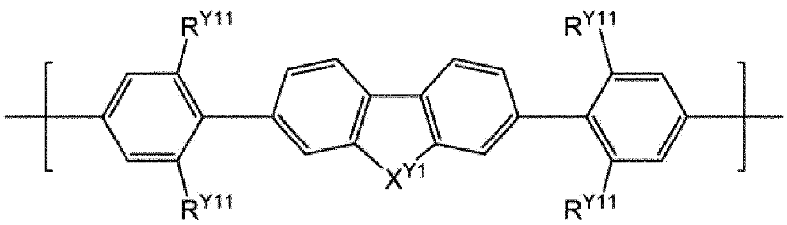

(Y-3')

Wherein, $R^{Y11}$ and $X^{Y1}$ represent the same meaning as described above.

[Chemical Formula 51]

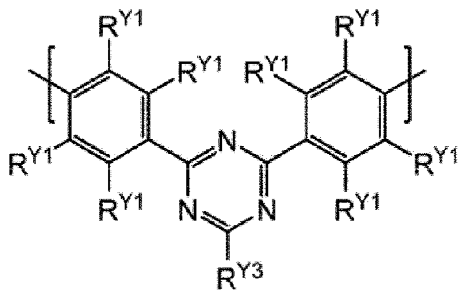

(Y-4)

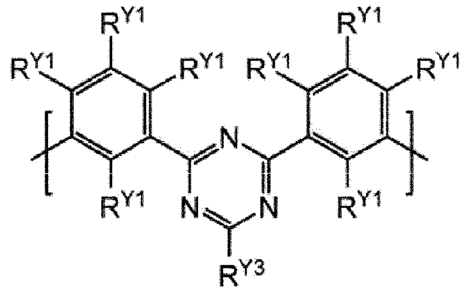

(Y-5)

[Chemical Formula 52]

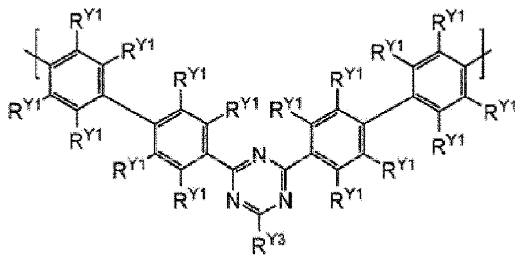

(Y-6)

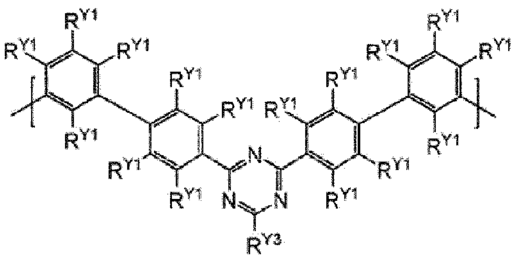

(Y-7)

Wherein, $R^{Y1}$ represents the same meaning as described above. $R^{Y3}$ represents a hydrogen atom, an alkyl group, a cycloalkyl group, an alkoxy group, a cycloalkoxy group, an aryl group or a monovalent heterocyclic group and these groups each optionally have a substituent.

$R^{Y3}$ is preferably an alkyl group, a cycloalkyl group, an alkoxy group, a cycloalkoxy group, an aryl group or a monovalent heterocyclic group, more preferably an aryl group, and these groups each optionally have a substituent.

It is preferable that the constitutional unit represented by the formula (Y-4) is a constitutional unit represented by the formula (Y-4'), and it is preferable that the constitutional unit represented by the formula (Y-6) is a constitutional unit represented by the formula (Y-6').

[Chemical Formula 53]

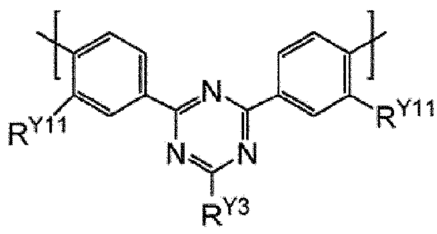

(Y-4')

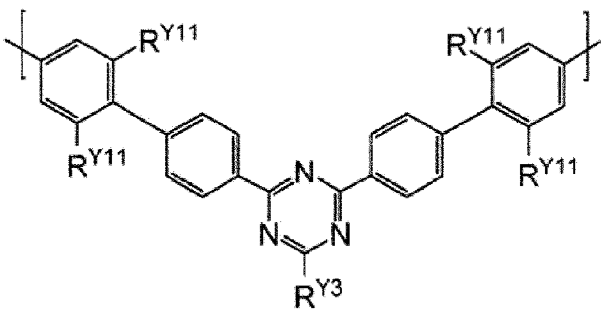

(Y-6')

Wherein, $R^{Y11}$ and $R^{Y3}$ represent the same meaning as described above.

[Chemical Formula 54]

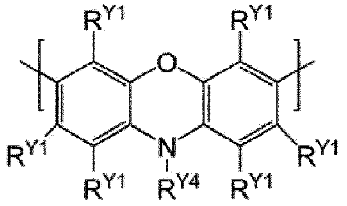
(Y-8)

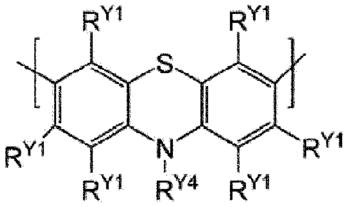
(Y-9)

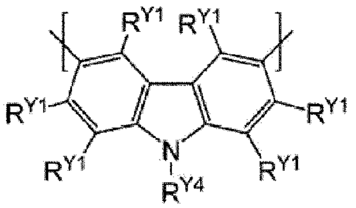
(Y-10)

Wherein, $R^{Y1}$ represents the same meaning as described above. $R^{Y4}$ represents a hydrogen atom, an alkyl group, a cycloalkyl group, an alkoxy group, a cycloalkoxy group, an aryl group or a monovalent heterocyclic group, and these groups each optionally have a substituent.

$R^{Y4}$ is preferably an alkyl group, a cycloalkyl group, an alkoxy group, a cycloalkoxy group, an aryl group or a monovalent heterocyclic group, more preferably an aryl group, and these groups each optionally have a substituent.

The constitutional unit represented by the formula (Y) includes, for example, a constitutional unit composed of an arylene group represented by the formula (Y-101), (Y-102), (Y-103), (Y-104), (Y-105), (Y-106), (Y-107), (Y-108), (Y-109), (Y-110), (Y-111), (Y-112), (Y-113), (Y-114), (Y-115), (Y-116), (Y-117), (Y-118), (Y-119), (Y-20) or (Y-121) (hereinafter, referred to as "arylene groups represented by the formulae (Y-101) to (Y-121)" in some cases), a constitutional unit composed of a divalent heterocyclic group represented by the formula (Y-201), (Y-202), (Y-203), (Y-204), (Y-205) or (Y-206) (hereinafter, referred to as "divalent heterocyclic groups represented by the formulae (Y-201) to (Y-206)" in some cases), and a constitutional unit composed of a divalent group in which at least one arylene group and at least one divalent heterocyclic group are bonded directly to each other represented by the formula (Y-301), (Y-302), (Y-303) or (Y-304) (hereinafter, referred to as "the formulae (Y-301) to (Y-304)" in some cases).

[Chemical Formula 55]

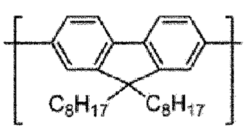
(Y-101)

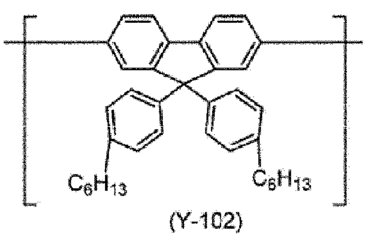
(Y-102)

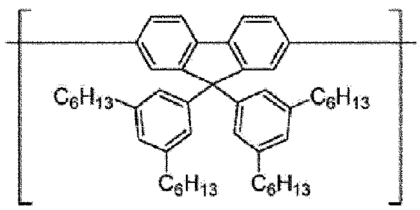
(Y-103)

[Chemical Formula 56]

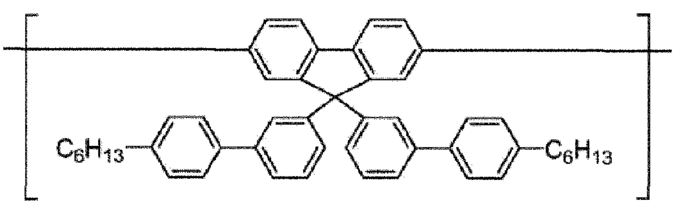
(Y-104)

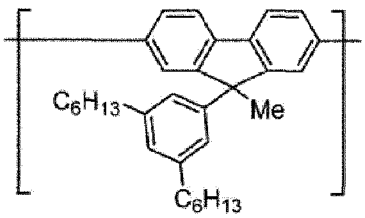
(Y-105)

[Chemical Formula 57]

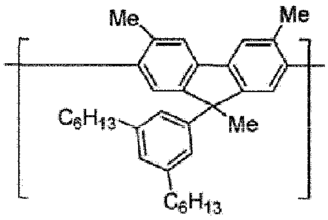
(Y-106)
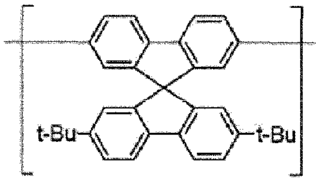
(Y-107)
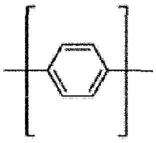
(Y-108)
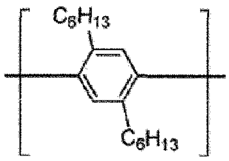
(Y-109)

[Chemical Formula 58]

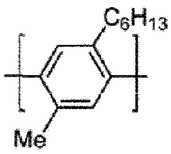
(Y-110)
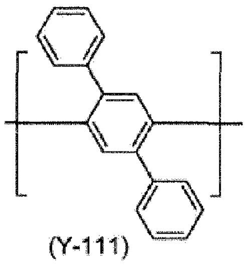
(Y-111)
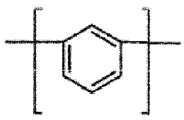
(Y-112)
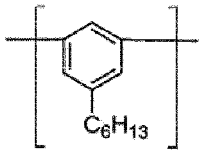
(Y-113)
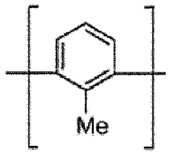
(Y-114)

[Chemical Formula 59]

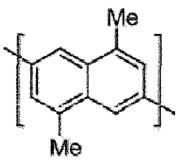
(Y-115)
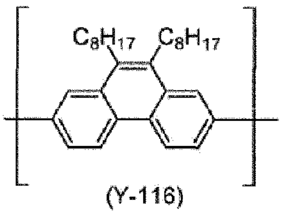
(Y-116)
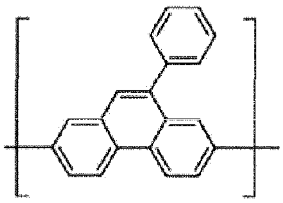
(Y-117)
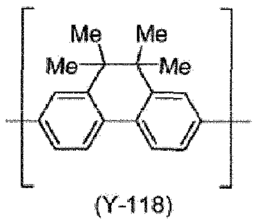
(Y-118)

[Chemical Formula 60]

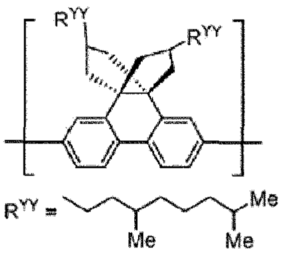
(Y-119)
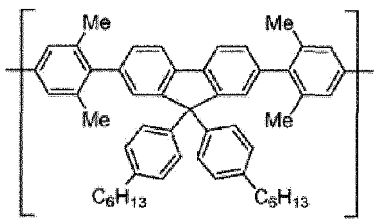
(Y-120)
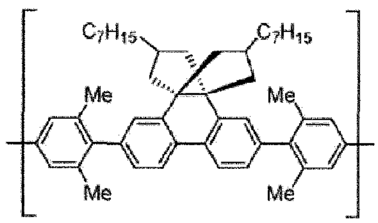
(Y-121)

[Chemical Formula 61]

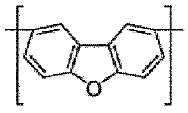
(Y-201)

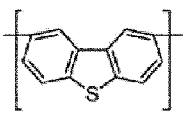
(Y-202)

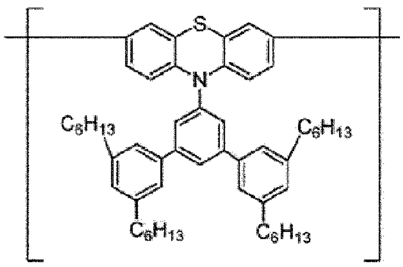
(Y-203)

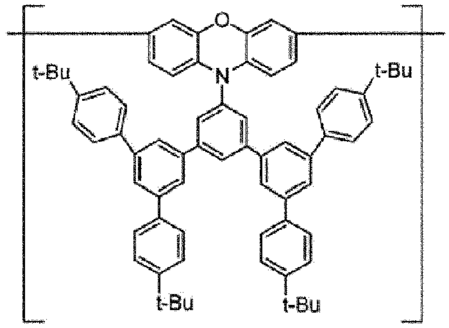
(Y-204)

[Chemical Formula 62]

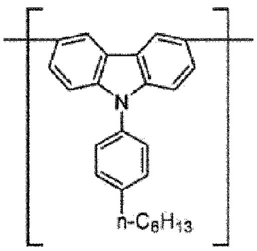
(Y-205)

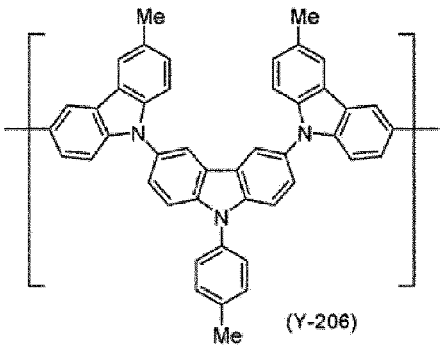
(Y-206)

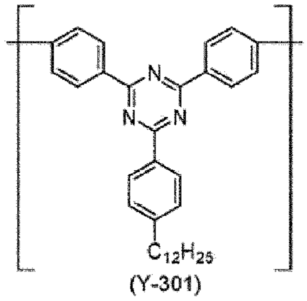
(Y-301)

[Chemical Formula 63]

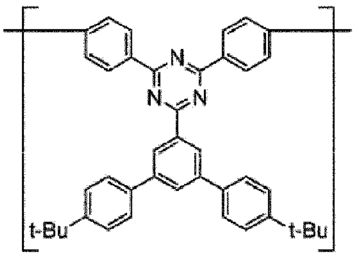
(Y-302)

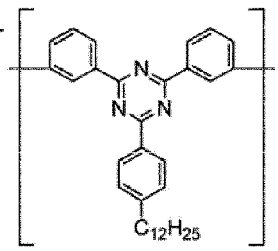
(Y-303)

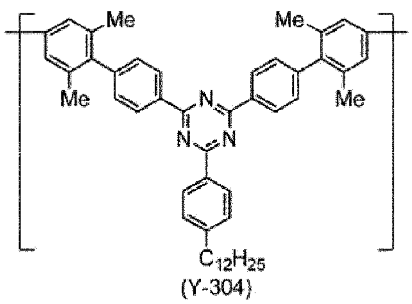
(Y-304)

When the constitutional unit represented by the formula (Y) in which $Ar^{Y1}$ is an arylene group is contained in a predetermined amount, the luminance life of the light-emitting device is likely to be better. Hence, it is preferable that the polymer compound is one obtained by polymerizing a monomer to make the above constitutional unit in a proportion of 0.5 to 80% by mol (preferably 30 to 60% by mol) to the total amount of the monomers to form the polymer compound.

When the constitutional unit represented by the formula (Y) in which $Ar^{Y1}$ is a divalent heterocyclic group or a divalent group in which at least one arylene group and at least one divalent heterocyclic group are bonded directly to each other is contained in a predetermined amount, the charge transportability of the light-emitting device is likely to be better. Hence, it is preferable that the polymer compound is one obtained by polymerizing a monomer to make the above constitutional unit in a proportion of 0.5 to 30% by mol (preferably 3 to 20% by mol) to the total amount of the monomers to form the polymer compound.

The constitutional unit represented by the formula (Y) may be contained only singly or two or more units thereof may be contained in the polymer host.

It is preferable that the polymer host further comprises a constitutional unit represented by the following formula (X), because hole transportability is excellent.

Chemical Formula 64]

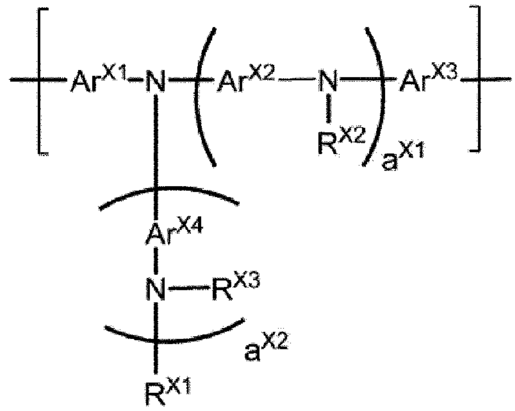

(X)

Wherein,
$a^{X1}$ and $a^{X2}$ each independently represent an integer of 0 or more.

$Ar^{X1}$ and $Ar^{X3}$ each independently represent an arylene group or a divalent heterocyclic group, and these groups each optionally have a substituent.

$Ar^{X2}$ and $Ar^{X4}$ each independently represent an arylene group, a divalent heterocyclic group or a divalent group in which at least one arylene group and at least one divalent heterocyclic group are bonded directly to each other, and these groups each optionally have a substituent. When a plurality of $Ar^{X2}$ and $Ar^{X4}$ are present, they may be the same or different at each occurrence.

$R^{X1}$, $R^{X2}$ and $R^{X3}$ each independently represent a hydrogen atom, an alkyl group, a cycloalkyl group, an aryl group or a monovalent heterocyclic group, and these groups each optionally have a substituent. When a plurality of $R^{X2}$ and $R^{X3}$ are present, they may be the same or different at each occurrence.

$a^{X1}$ is preferably 2 or less, more preferably 1, because the luminance life of the light-emitting device of the present invention is excellent.

$a^{X2}$ is preferably 2 or less, more preferably 0, because the luminance life of the light-emitting device of the present invention is excellent.

$R^{X1}$, $R^{X2}$ and $R^{X3}$ are preferably an alkyl group, a cycloalkyl group, an aryl group or a monovalent heterocyclic group, more preferably an aryl group, and these groups each optionally have a substituent.

The arylene group represented by $Ar^{X1}$ and $Ar^{X3}$ is more preferably a group represented by the formula (A-1) or the formula (A-9), further preferably a group represented by the formula (A-1), and these groups each optionally have a substituent.

The divalent heterocyclic group represented by $Ar^{X1}$ and $Ar^{X3}$ is more preferably a group represented by the formula (AA-1), the formula (AA-2) or the formula (AA-7) to (AA-26), and these groups each optionally have a substituent.

$Ar^{X1}$ and $Ar^{X3}$ are preferably an arylene group optionally having a substituent.

The arylene group represented by $Ar^{X2}$ and $Ar^{X4}$ is more preferably a group represented by the formula (A-1), the formula (A-6), the formula (A-7), the formula (A-9) to (A-11) or the formula (A-19), and these groups each optionally have a substituent.

The more preferable range of the divalent heterocyclic group represented by $Ar^{X2}$ and $Ar^{X4}$ is the same as the more preferable range of the divalent heterocyclic group represented by $Ar^{X1}$ and $Ar^{X3}$.

The more preferable range and the further preferable range of the arylene group and the divalent heterocyclic group in the divalent group in which at least one arylene group and at least one divalent heterocyclic group are bonded directly to each other represented by $Ar^{X2}$ and $Ar^{X4}$ are the same as the more preferable range and the further preferable range of the arylene group and the divalent heterocyclic group represented by $Ar^{X1}$ and $Ar^{X3}$, respectively.

The divalent group in which at least one arylene group and at least one divalent heterocyclic group are bonded directly to each other represented by $Ar^{X2}$ and $Ar^{X4}$ includes the same groups as the divalent group in which at least one arylene group and at least one divalent heterocyclic group are bonded directly to each other represented by $Ar^{Y1}$ in the formula (Y).

$Ar^{X2}$ and $Ar^{X4}$ are preferably an arylene group optionally having a substituent.

The substituent which the group represented by $Ar^{X1}$ to $Ar^{X4}$ and $R^{X1}$ to $R^{X3}$ optionally has is preferably an alkyl group, a cycloalkyl group or an aryl group, and these groups each optionally further have a substituent.

The constitutional unit represented by the formula (X) is preferably a constitutional unit represented by the formula (X-1), (X-2), (X-3), (X-4), (X-5), (X-6) or (X-7) (hereinafter, referred to as "constitutional units represented by the

formulae (Y-1) to (Y-7)" in some cases), more preferably a constitutional unit represented by the formula (X-1) to (X-6), further preferably a constitutional unit represented by the formula (X-3) to (X-6).

[Chemical Formula 65]

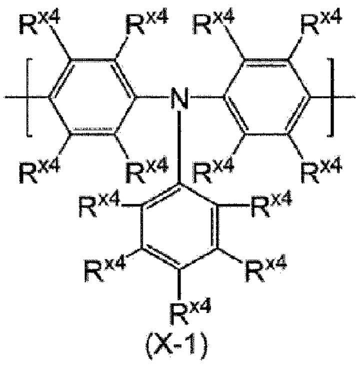

(X-1)

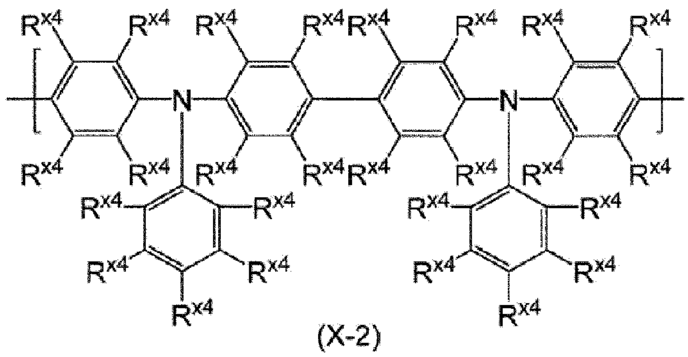

(X-2)

[Chemical Formula 66]

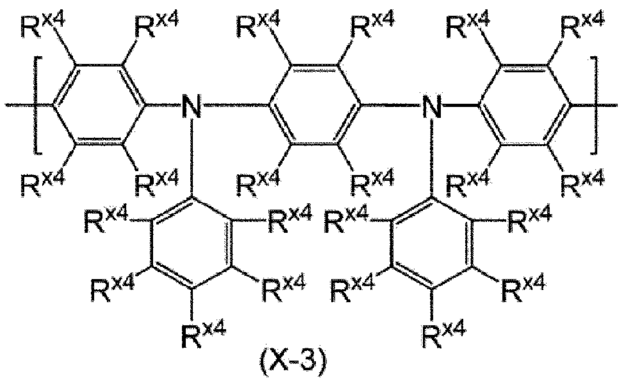

(X-3)

[Chemical Formula 67]

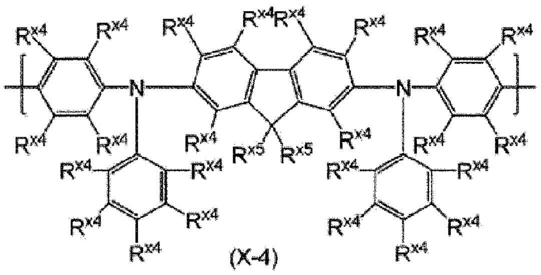

(X-4)

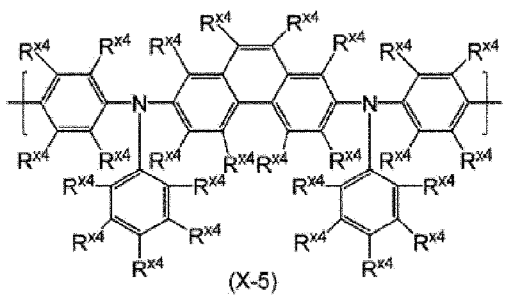

(X-5)

[Chemical Formula 68]

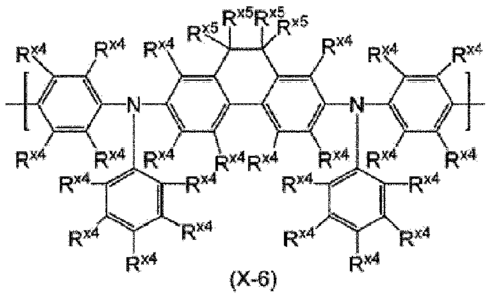
(X-6)

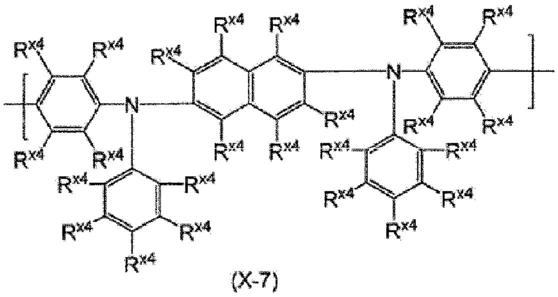
(X-7)

Wherein, $R^{X4}$ and $R^{X5}$ each independently represent a hydrogen atom, an alkyl group, a cycloalkyl group, an alkoxy group, a cycloalkoxy group, an aryl group, an aryloxy group, a halogen atom, a monovalent heterocyclic group or a cyano group, and these groups each optionally have a substituent. The plurality of $R^{X4}$ may be the same or different. The plurality of $R^{X5}$ may be the same or different, and adjacent groups $R^{X5}$ may be combined together to form a ring together with the carbon atoms to which they are attached.

It is preferable that the constitutional unit represented by the formula (X) is contained in a predetermined amount in the polymer host, because the hole transportability is excellent. That is, it is preferable that the polymer host is one obtained by polymerizing a monomer to form the constitutional unit represented by the formula (X) in a proportion of preferably 0.1 to 50% by mol (more preferably 1 to 40% by mass, further preferably 5 to 30% by mass) to the total amount of the monomers to form the polymer host.

The constitutional unit represented by the formula (X) includes, for example, constitutional units represented by the formula (X1-1), (X1-2), (X1-3), (X1-4), (X1-5), (X1-6), (X1-7), (X1-8), (X1-9), (X1-10) or (X1-11) (hereinafter, referred to as "constitutional units represented by the formulae (X1-1) to (X1-11)" in some cases), preferably constitutional units represented by the formulae (X1-3) to (X1-10).

[Chemical Formula 69]

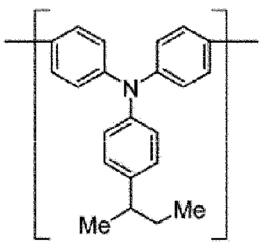
(X1-1)

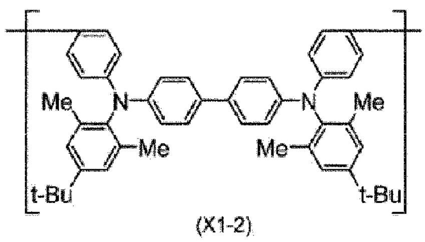
(X1-2)

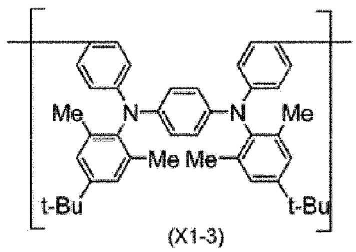
(X1-3)

[Chemical Formula 70]

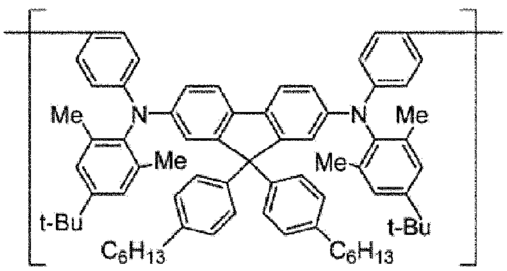
(X1-4)

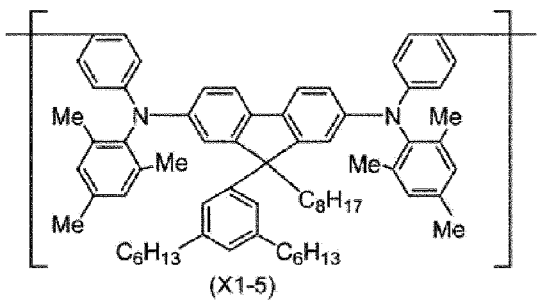
(X1-5)

[Chemical Formula 71]

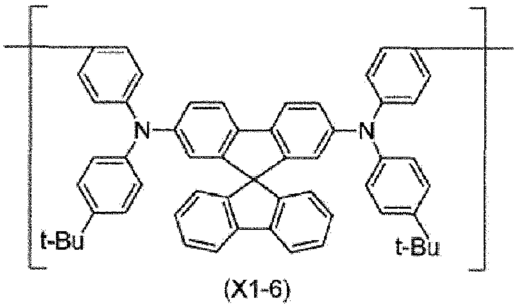

(X1-6)

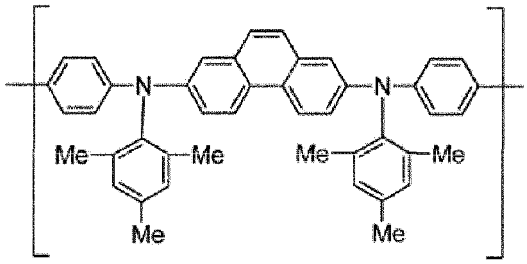

(X1-7)

[Chemical Formula 72]

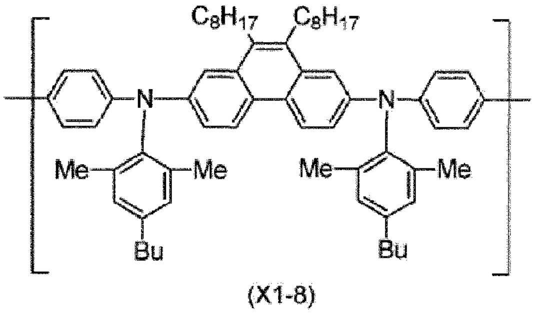

(X1-8)

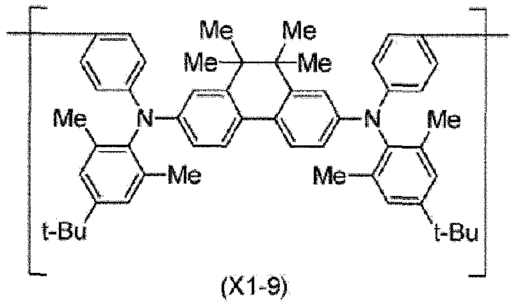

(X1-9)

[Chemical Formula 73]

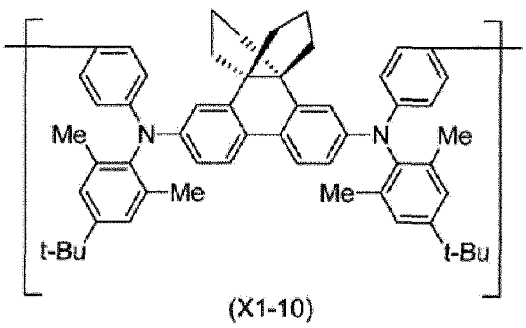

(X1-10)

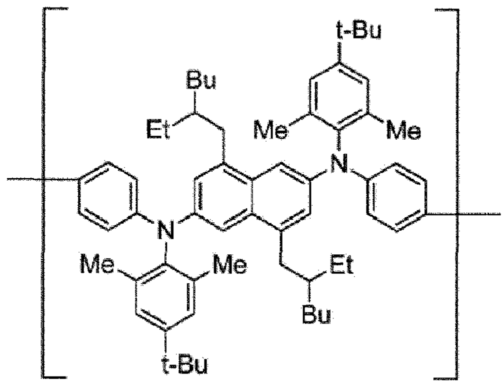

(X1-11)

The constitutional unit represented by the formula (X) may be contained only singly or two or more units thereof may be contained in the polymer host.

The polymer host include, for example, polymer compounds (P-1), (P-2), (P-3), (P-4), (P-5) and (P-6) in the Table 1.

[Table 1]

| polymer compound | constitutional unit and mole fraction thereof | | | | |
|---|---|---|---|---|---|
| | formula (Y) | | | formula (X) | other |
| | formulae (Y-1) to (Y-3) | formulae (Y-4) to (Y-7) | formulae (Y-8) to (Y-10) | formulae (X-1) to (X-7) | |
| | p | q | r | s | t |
| (P-1) | 0.1 to 99.9 | 0.1 to 99.9 | 0 | 0 | 0 to 30 |
| (P-2) | 0.1 to 99.9 | 0 | 0.1 to 99.9 | 0 | 0 to 30 |
| (P-3) | 0.1 to 99.8 | 0.1 to 99.8 | 0 | 0.1 to 99.8 | 0 to 30 |
| (P-4) | 0.1 to 99.8 | 0.1 to 99.8 | 0.1 to 99.8 | 0 | 0 to 30 |
| (P-5) | 0.1 to 99.8 | 0 | 0.1 to 99.8 | 0.1 to 99.8 | 0 to 30 |
| (P-6) | 0.1 to 99.7 | 0.1 to 99.7 | 0.1 to 99.7 | 0.1 to 99.7 | 0 to 30 |

In the table 1, p, q, r, s and t represent the mole fraction of each constitutional unit. p+q+r+s+t = 100, and 100 ≥ p+q+r+s ≥ 70. "Other" denotes a constitutional unit other than the constitutional unit represented by the formula (Y) and the constitutional unit represented by the formula (X).

The polymer host may be any of a block copolymer, a random copolymer, an alternating copolymer or a graft copolymer, and may also be another embodiment, and is preferably a copolymer produced by copolymerizing a plurality of raw material monomers.

<Production method of polymer host>

The polymer host can be produced by using a known polymerization method described in Chem. Rev., vol. 109, pp. 897-1091 (2009) and the like, exemplified are methods of causing polymerization by a coupling reaction using a transition metal catalyst such as the Suzuki reaction, the Yamamoto reaction, the Buchwald reaction, the Stille reaction, the Negishi reaction and the Kumada reaction.

In the polymerization method described above, the method of charging monomers includes, for example, a method in which the total amount of monomers is charged in a lump into the reaction system, a method in which monomers are partially charged and reacted, then, the remaining monomers are charged in a lump, continuously or in divided doses, and a method in which monomers are charged continuously or in divided doses.

The transition metal catalyst includes a palladium catalyst, a nicked catalyst and the like.

For the post treatment of the polymerization reaction, known methods, for example, a method of removing water-soluble impurities by liquid-separation, a method in which the reaction solution after the polymerization reaction is added to a lower alcohol such as methanol to cause deposition of a precipitate which is then filtrated before drying, and other methods, are used each singly or combined. When the purity of the polymer host is low, the polymer host can be purified by usual methods such as, for example, recrystallization, reprecipitation, continuous extraction with a Soxhlet extractor and column chromatography.

[Composition of the first organic layer]

The first organic layer may be a layer formed by using a composition (hereinafter, referred to also as "composition of the first organic layer") comprising one or more phosphorescent compounds represented by the formula (1), and at least one material selected from the group consisting of the host material described above, a hole transporting material, a hole injection material, an electron transporting material, an electron injection material, a light emitting material, an antioxidant and a solvent. Further the first organic layer may be a layer comprising the composition of the first organic layer.

[Hole transporting material]

The hole transporting material is classified into low molecular weight compounds and polymer compounds, and polymer compounds are preferable. The hole transporting material optionally has a crosslinkable group.
The polymer compound includes, for example, polyvinylcarbazole and derivatives thereof; polyarylene having an aromatic amine structure in the side chain or main chain and derivatives thereof. The polymer compound may also be a compound in which an electron accepting portion is linked. The electron accepting portion includes, for example, fullerene, tetrafluorotetracyanoquinodimethane, tetracyanoethylene, trinitrofluorenone and the like, preferably fullerene.
In the composition of the first organic layer, the compounding amount of the hole transporting material is usually 1 to 400 parts by weight, preferably 5 to 150 parts by weight when the content of the phosphorescent compound represented by the formula (1) is 100 parts by weight.
The hole transporting material may be used singly, or two or more hole transporting materials may be used in combination.

[Electron transporting material]

The electron transporting material is classified into low molecular weight compounds and polymer compounds. The electron transporting material optionally has a crosslinkable group.
The low molecular weight compound includes, for example, a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, diphenoquinone and derivatives thereof.
The polymer compound includes, for example, polyphenylene, polyfluorene and derivatives thereof. These polymer compounds may be doped with a metal.
In the composition of the first organic layer, the compounding amount of the electron transporting material is usually 1 to 400 parts by weight, preferably 5 to 150 parts by weight when the content of the phosphorescent compound represented by the formula (1) is 100 parts by weight.
The electron transporting material may be used singly, or two or more electron transporting materials may be used in combination.

[Hole injection material and electron injection material]

The hole injection material and the electron injection material are each classified into low molecular weight compounds and polymer compounds. The hole injection material and the electron injection material each optionally have a crosslinkable group.
The low molecular weight compound includes, for example, metal phthalocyanines such as copper phthalocyanine; carbon; oxides of metals such as molybdenum and tungsten; metal fluorides such as lithium fluoride, sodium fluoride, cesium fluoride and potassium fluoride.
The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer comprising an aromatic amine structure in the main chain or side chain.
In the composition of the first organic layer, the compounding amounts of the hole injection material and the electron injection material are each usually 1 to 400 parts by weight, preferably 5 to 150 parts by weight when the content of the phosphorescent compound represented by the formula (1) is 100 parts by weight.
The hole injection material and the electron injection material may each be used singly, or two or more of them may be used in combination.

[Ion dope]

When the hole injection material or the electron injection material comprises an electrically conductive polymer, the electric conductivity of the electrically conductive polymer is preferably $1\times10^{-5}$ S/cm to $1\times10^{3}$ S/cm. For adjusting the electric conductivity of the electrically conductive polymer within such a range, the electrically conductive polymer can be doped with a suitable amount of ions.
The kind of the ion to be doped is an anion for a hole injection material and a cation for an electron injection material. The anion includes, for example, a polystyrenesulfonate ion, an alkylbenzenesulfonate ion and a camphorsulfonate ion. The cation includes, for example, a lithium ion, a sodium ion, a potassium ion and a tetrabutylammonium ion.
The ion to be doped may be used singly, or two or more ions to be doped may be used.

[Light emitting material]

The light emitting material (different from the phosphorescent compound represented by the formula (1)) is classified into low molecular weight compounds and polymer compounds. The light emitting material optionally has a crosslinkable group.
The low molecular weight compound includes, for example, naphthalene and derivatives thereof, anthracene and derivatives thereof, and perylene and derivatives thereof.
The polymer compound includes, for example, polymer compounds comprising a phenylene group, a naphthalenediyl group, an anthracenediyl group, a fluorenediyl group, a phenanthrenediyl group, dihydrophenanthrenediyl group, a group represented by the formula (X), a carbazolediyl group, a phenoxazinediyl group, a phenothiazinediyl group, a pyrenediyl group and the like.
In the composition of the first organic layer, the compounding amount of the light emitting material is usually 1 to 400 parts by weight, preferably 5 to 150 parts by weight when the content of the phosphorescent compound represented by the formula (1) is 100 parts by weight.
The light emitting material may be used singly, or two or more light emitting materials may be used in combination.

[Antioxidant]

The antioxidant may advantageously be one which is soluble in the same solvent as for a phosphorescent compound and does not disturb light emission and charge transportation, and the examples thereof include phenol-based antioxidants and phosphorus-based antioxidants.
In the composition of the first organic layer, the compounding amount of the antioxidant is usually 0.001 to 10 parts by weight when the content of the phosphorescent compound represented by the formula (1) is 100 parts by weight.
The antioxidant may be used singly, or two or more antioxidants may be used in combination.

[Ink of first organic layer]

The composition of the first organic layer comprising a solvent (hereinafter, referred to also as "ink of first organic layer".) can be suitably used in application methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method and a nozzle coat method.
The viscosity of the ink of the first organic layer may be adjusted depending on the kind of the application method, and when a solution goes through a discharge apparatus such as in an inkjet printing method, the viscosity is preferably in the range of 1 to 20 mPa·s at 25°C because curved aviation and clogging in discharging are unlikely.
As the solvent contained in the ink of the first organic layer, those capable of dissolving or uniformly dispersing solid components in the ink are preferable. The solvent includes, for example, chlorine-based solvents such as 1,2-dichloroethane, 1,1,2-trichloroethane, chlorobenzene and o-dichlorobenzene; ether solvents such as THF (tetrahydrofuran), dioxane, anisole and 4-methylanisole; aromatic hydrocarbon solvents such as toluene, xylene, mesitylene, ethylbenzene, n-hexylbenzene and cyclohexylbenzene; aliphatic hydrocarbon solvents such as cyclohexane, methylcyclohexane, n-pentane, n-hexane, n-heptane, n-octane, n-nonane, n-decane, n-dodecane and bicyclohexyl; ketone solvents such as acetone, methylethylketone, cyclohexanone and acetophenone; ester solvents such as ethyl acetate, butyl acetate, ethylcellosolve acetate, methyl benzoate and phenyl acetate; poly-hydric alcohol solvents such as ethylene glycol, glycerin and 1,2-hexanediol and derivatives thereof; alcohol solvents such as isopropylalcohol and cyclohexanol; sulfoxide solvents such as dimethyl sulfoxide; and amide solvents such as N-methyl-2-pyrrolidone and N,N-dimethylformamide. These solvents may be used singly, or two or more of them may be used in combination.
In the ink of the first organic layer, the compounding amount of the solvent is usually 1000 to 100000 parts by weight, preferably 2000 to 20000 parts by weight when the content of the phosphorescent compound represented by the formula (1) is 100 parts by weight.

<Second organic layer>

The second organic layer is a layer formed by using a polymer composition in which one or two or more polymer compounds including a crosslinkable polymer compound having a crosslinkable group are compounded. The second organic layer preferably comprises a cured polymer product formed from the polymer composition.
In one suitable aspect, with respect to each monomer unit constituting the polymer compounds (one or two or more polymer compounds including a crosslinkable polymer compound), the value x obtained by multiplying the molar ratio C of the each monomer unit to the total mol of all the monomer units by the molecular weight M of the each monomer

unit, and the value y obtained by multiplying the molar ratio C by the number n of the crosslinkable groups in the each monomer unit are determined, the value of ($Y_1 \times 1000$)/$X_1$ calculated from $X_1$ being the total of the values x and $Y_1$ being the total of the values y being 0.5 or more.

In the case where the second organic layer is a layer formed by using one polymer compound (crosslinkable polymer compound having a crosslinkable group), with respect to each monomer unit constituting the one polymer compound, the value x obtained by multiplying the molar ratio C of the each monomer unit to the total mol of all the monomer units by the molecular weight M of the each monomer unit, and the value y obtained by multiplying the molar ratio C by the number n of the crosslinkable groups in the each monomer unit are determined, the value of ($Y_1 \times 1000$)/$X_1$ calculated from $X_1$ being the total of the values x and $Y_1$ being the total of the values y being 0.5 or more.

In the case where the second organic layer is a layer formed by using a polymer composition in which two or more polymer compounds including a crosslinkable polymer compound having a crosslinkable group are compounded, the weighted average (an average value from the compounding amount ratios of the two or more polymer compounds) of the values of ($Y_1 \times 1000$)/$X_1$ determined for the each polymer compound is 0.5 or more.

In the case where the second organic layer is a layer formed by using a polymer composition in which a crosslinkable polymer compound having a crosslinkable group and a polymer compound having no crosslinkable group are compounded, examples of the polymer compound having no crosslinkable group include polymer compounds comprising at least one constitutional unit selected from the group consisting of the constitutional unit represented by the formula (Y) and the constitutional unit represented by the formula (X).

[Crosslinkable polymer compound]

The crosslinkable polymer compound is a polymer compound having at least one crosslinkable group selected from the Group A of crosslinkable groups, because the external quantum efficiency of the light-emitting device according to the present invention is excellent.

The crosslinkable group selected from the Group A of crosslinkable groups is, because the luminance life of the light-emitting device according to the present invention is better, preferably a crosslinkable group represented by the formula (XL-1), (XL-3), (XL-9), (XL-16) or (XL-17), more preferably crosslinkable group represented by the formula (XL-1), (XL-16) or (XL-17), and further preferably a crosslinkable group represented by the formula (XL-1) or (XL-17).

The crosslinkable polymer compound comprises a constitutional unit (hereinafter, referred to also as "crosslinkable constitutional unit") having a crosslinkable group. Although it is preferable that the crosslinkable constitutional unit is a constitutional unit represented by the above formula (2) or the above formula (3), the crosslinkable constitutional unit may be a constitutional unit represented by the following formula.

[Chemical Formula 74]

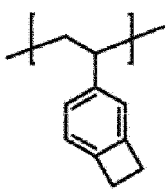
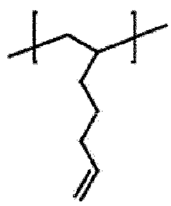
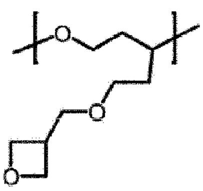
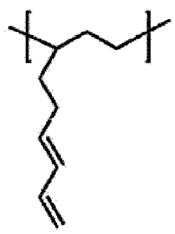

The crosslinkable polymer compound comprises a crosslinkable constitutional unit having at least one crosslinkable group selected from the Group A of crosslinkable groups, and it is preferable that the crosslinkable constitutional unit is a constitutional unit represented by the above formula (2) or the above formula (3).

nA is preferably an integer of 0 to 2, more preferably 0 or 1, further preferably 0, because the light-emitting device of the present invention is excellent in external quantum efficiency.

n is preferably 2, because the light-emitting device of the present invention is excellent in external quantum efficiency.

$Ar^1$ is preferably an aromatic hydrocarbon group optionally having a substituent, because the light-emitting device of the present invention is excellent in external quantum efficiency.

The number of carbon atoms constituting the aromatic ring in the aromatic hydrocarbon group represented by $Ar^1$ is usually 6 to 60, preferably 6 to 30, more preferably 6 to 18.

The arylene group portion obtained by removing n substituents of the aromatic hydrocarbon group represented by $Ar^1$ is preferably a group represented by the formula (A-1) to the formula (A-20), more preferably a group represented by the formula (A-1), the formula (A-2), the formula (A-6) to the formula (A-10), the formula (A-19) or the formula (A-20),

further preferably a group represented by the formula (A-1), the formula (A-2), the formula (A-7), the formula (A-9) or the formula (A-19), and these groups each optionally have a substituent.

The number of carbon atoms constituting the heterocyclic ring and the ring condensed to the heterocyclic ring in the divalent heterocyclic group in the heterocyclic group represented by $Ar^1$ is usually 2 to 60, preferably 3 to 20, more preferably 4 to 15.

The divalent heterocyclic group portion obtained by removing n substituents of the heterocyclic group represented by $Ar^1$ is preferably a group represented by the formula (AA-1) to the formula (AA-34).

The aromatic hydrocarbon group and the heterocyclic group represented by $Ar^1$ each optionally have a substituent, and the substituent which the aromatic hydrocarbon group and the heterocyclic group optionally have includes, for example, an alkyl group, a cycloalkyl group, an alkoxy group, a cycloalkoxy group, an aryl group, an aryloxy group, a halogen atom, a monovalent heterocyclic group and a cyano group.

The number of carbon atoms of the alkylene group represented by $L^A$, not including the number of carbon atoms of a substituent, is usually 1 to 10, preferably 1 to 5, more preferably 1 to 3. The number of carbon atoms of the cycloalkylene group represented by $L^A$, not including the number of carbon atoms of a substituent, is usually 3 to 10.

The alkylene group represented by $L^A$ includes, for example, a methylene group, an ethylene group, a propylene group, a butylene group, a hexylene group and an octylene group. The alkylene group represented by $L^A$ optionally has a substituent, and the substituent includes, for example, a cycloalkyl group, an alkoxy group, a cycloalkoxy group, a halogen atom and a cyano group.

The cycloalkylene group represented by $L^A$ includes, for example, a cyclohexylene group and a cyclopentylene group. The cycloalkylene group represented by $L^A$ optionally has a substituent, and the substituent includes, for example, an alkyl group, a cycloalkyl group, an alkoxy group, a cycloalkoxy group, a halogen atom and a cyano group.

The alkylene group and the cycloalkylene group represented by $L^A$ each optionally have a substituent. The substituent which the alkylene group and the cycloalkylene group optionally have includes, for example, an alkyl group, a cycloalkyl group, an alkoxy group, a cycloalkoxy group, a halogen atom and a cyano group.

$L^A$ is preferably a phenylene group or a methylene group, because production of the crosslinkable polymer compound is easy, and these groups each optionally have a substituent.

The preferable range, the more preferable range and the further preferable range of the crosslinkable group represented by X are the same as the preferable range, the more preferable range and the further preferable range of the crosslinkable group selected from the above-described Group A of crosslinkable group.

The constitutional unit represented by the formula (2) may be contained singly or two or more of the constitutional units may be contained in the crosslinkable polymer compound.

mA is preferably 0 or 1, more preferably 0, because the light-emitting device of the present invention is excellent in external quantum efficiency.

m is preferably 2, because the light-emitting device of the present invention is excellent in external quantum efficiency.

c is preferably 0, because production of the crosslinkable polymer compound is easy and because the light-emitting device of the present invention is excellent in external quantum efficiency.

$Ar^3$ is preferably an aromatic hydrocarbon group optionally having a substituent, because the light-emitting device of the present invention is excellent in external quantum efficiency.

The definition and examples of the arylene group portion obtained by removing m substituents of the aromatic hydrocarbon group represented by $Ar^3$ are the same as the definition and examples of the arylene group represented by $Ar^{X2}$ in the formula (X) described above.

The definition and examples of the divalent heterocyclic group portion obtained by removing m substituents of the heterocyclic group represented by $Ar^3$ are the same as the definition and examples of the divalent heterocyclic group portion represented by $Ar^{X2}$ in the formula (X) described above.

The definition and examples of the divalent group obtained by removing m substituents of the group in which at least one aromatic hydrocarbon ring and at least one heterocyclic ring are bonded directly to each other represented by $Ar^3$ are the same as the definition and examples of the divalent group in which at least one arylene group and at least one divalent heterocyclic group are bonded directly to each other represented by $Ar^{X2}$ in the formula (X) described above.

$Ar^2$ and $Ar^4$ are preferably an arylene group optionally having a substituent, because the light-emitting device of the present invention is more excellent in luminance life.

The definition and examples of the arylene group represented by $Ar^2$ and $Ar^4$ are the same as the definition and examples of the arylene group represented by $Ar^{X1}$ and $Ar^{X3}$ in the formula (X) descirbed above.

The definition and examples of the divalent heterocyclic group represented by $Ar^2$ and $Ar^4$ are the same as the definition and examples of the divalent heterocyclic group represented by $Ar^{X1}$ and $Ar^{X3}$ in the formula (X) described above.

The group represented by $Ar^2$, $Ar^3$ and $Ar^4$ optionally has a substituent, and the substituent includes an alkyl group, a cycloalkyl group, an alkoxy group, a cycloalkoxy group, an aryl group, an aryloxy group, a halogen atom, a

monovalent heterocyclic group and a cyano group.

The definitions and examples of the alkylene group, the cycloalkylene group, the arylene group and the divalent heterocyclic group represented by $K^A$ are the same as the definitions and examples of the alkylene group, the cycloalkylene group, the arylene group and the divalent heterocyclic group represented by $L^A$, respectively.

$K^A$ is preferably a phenylene group or a methylene group, because production of the crosslinkable polymer compound is easy, and these groups each optionally have a substituent.

The preferable range, the more preferable range and the further preferable range of the crosslinkable group represented by X' are the same as the preferable range, the more preferable range and the further preferable range of the crosslinkable group selected from the above-described Group A of crosslinkable group.

The constitutional unit represented by the formula (3) may be contained singly or two or more of the constitutional units may be contained in the crosslinkable polymer compound.

The constitutional unit represented by the formula (2) includes, for example, constitutional units represented by the formula (2-1), (2-2), (2-3), (2-4), (2-5), (2-6), (2-7), (2-8), (2-9), (2-10), (2-11), (2-12), (2-13), (2-14), (2-15), (2-16), (2-17), (2-18), (2-19), (2-20), (2-21), (2-22), (2-23), (2-24), (2-25), (2-26), (2-27), (2-28), (2-29) or (2-30) (hereinafter, referred to as "constitutional units represented by the formulae (2-1) to (2-30)" in some cases).

The constitutional unit represented by the formula (3) includes, for example, constitutional units represented by the formula (3-1), (3-2), (3-3), (3-4), (3-5), (3-6), (3-7), (3-8) or (3-9) (hereinafter, referred to as "constitutional units represented by the formulae (3-1) to (3-9)" in some cases).

Of them, preferable are constitutional units represented by the formula (2-1) to the formula (2-30), more preferable are constitutional units represented by the formula (2-1) to the formula (2-15), the formula (2-19), the formula (2-20), the formula (2-23), the formula (2-25), the formula (2-27) or the formula (2-30), further preferable are constitutional units represented by the formula (2-1) to the formula (2-13), the formula (2-20), the formula (2-27) or the formula (2-30), particularly preferable are constitutional units represented by the formula (2-1) to the formula (2-9), the formula (2-20), the formula (2-27) or the formula (2-30), because the crosslinkable polymer compound is excellent in crosslinkability.

[Chemical Formula 75]

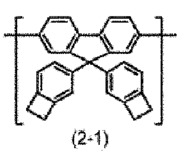
(2-1)

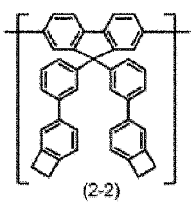
(2-2)

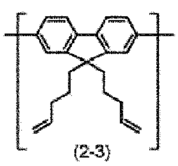
(2-3)

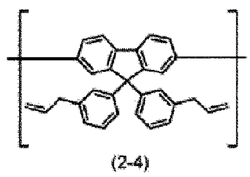
(2-4)

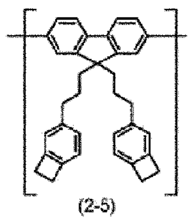
(2-5)

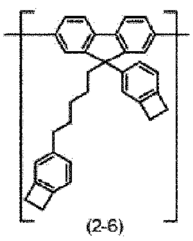
(2-6)

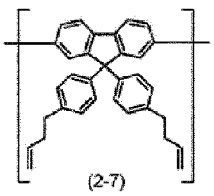
(2-7)

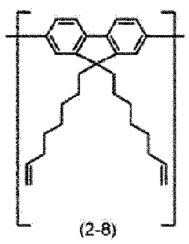
(2-8)

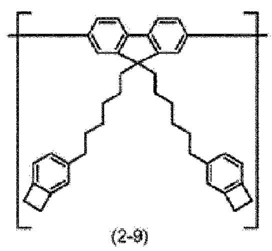
(2-9)

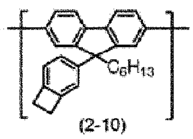
(2-10)

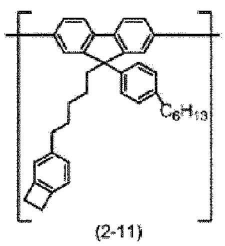
(2-11)

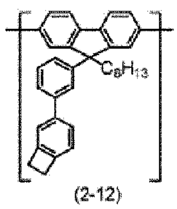
(2-12)

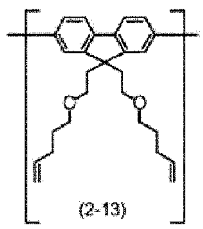
(2-13)

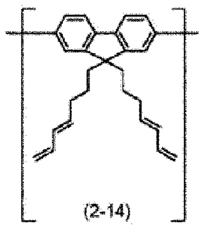
(2-14)

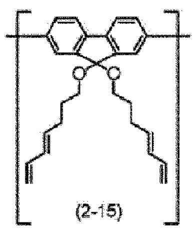
(2-15)

[Chemical Formula 76]

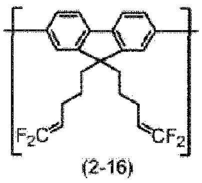
(2-16)
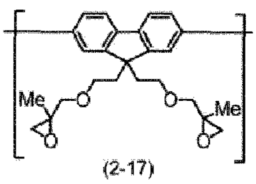
(2-17)
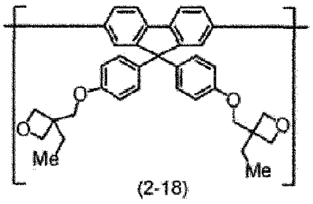
(2-18)
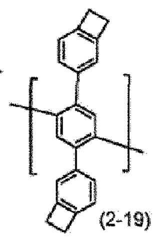
(2-19)
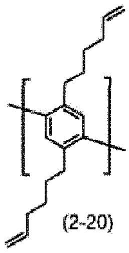
(2-20)

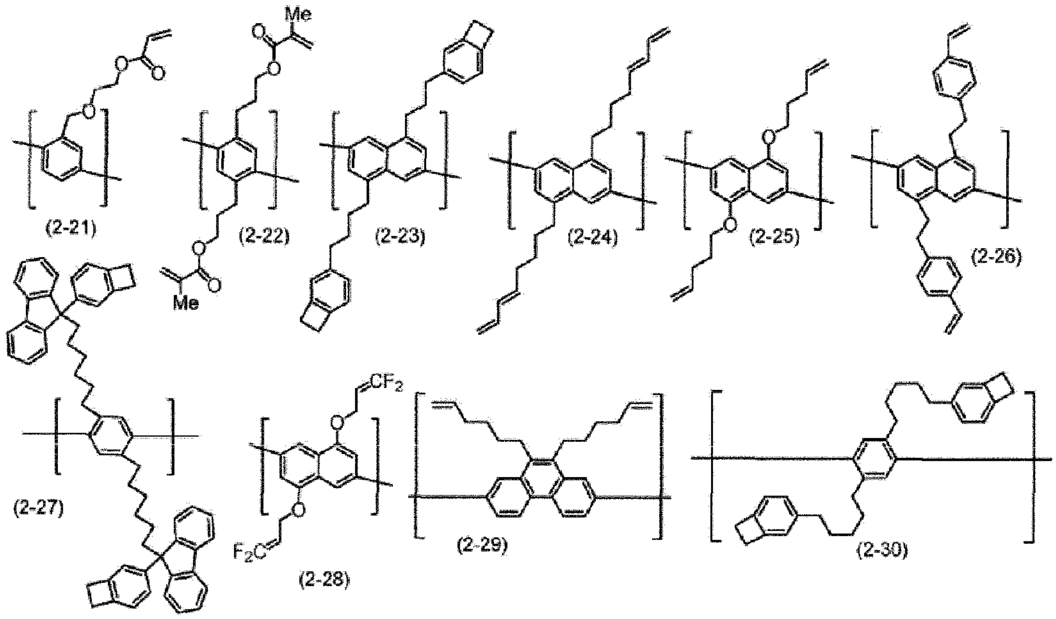
(2-21) (2-22) (2-23) (2-24) (2-25) (2-26) (2-27) (2-28) (2-29) (2-30)

[Chemical Formula 77]

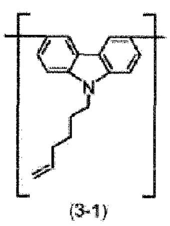
(3-1)
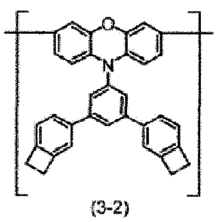
(3-2)
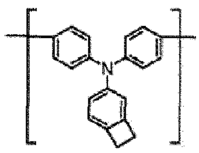
(3-3)
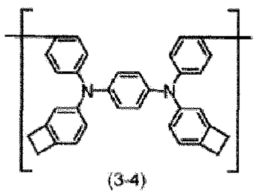
(3-4)
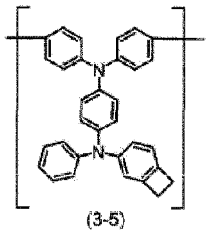
(3-5)

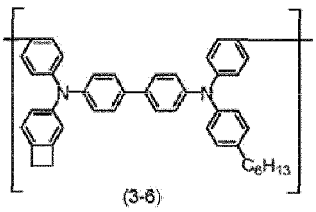
(3-6)
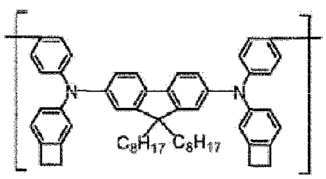
(3-7)
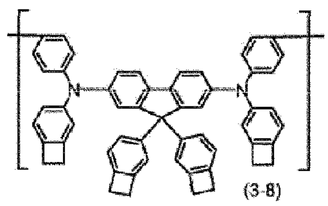
(3-8)

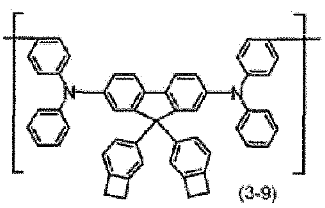
(3-9)

It is preferable that the crosslinkable polymer compound further comprises a constitutional unit represented by the formula (X), because the hole transportability is excellent.

The definition and examples of the constitutional unit represented by the formula (X) which the crosslinkable

polymer compound may comprise are the same as the definition and examples of the constitutional unit represented by the formula (X) which the polymer host described above may comprise.

The constitutional unit represented by the formula (X) may be contained singly, or two or more units thereof may be contained in the crosslinkable polymer compound.

It is preferable that the crosslinkable polymer compound further comprises at least one constitutional unit selected from the group consisting of constitutional units represented by the formula (Y11) and constitutional units represented by the formula (Y12), because the external quantum efficiency of the light-emitting device according to the present invention is excellent.

When the crosslinkable polymer compound comprises at least one constitutional unit selected from the group consisting of constitutional units represented by the formula (Y11) and constitutional units represented by the formula (Y12), and a constitutional unit represented by the formula (2), it is preferable that with respect to each monomer unit constituting the crosslinkable polymer compound, the value x obtained by multiplying the molar ratio C of the each monomer unit to the total mol of all the monomer units by the molecular weight M of the each monomer unit, and the value y obtained by multiplying the molar ratio C by the number n of the crosslinkable groups in the each monomer unit are determined, the value of $(Y_1 \times 1000)/X_1$ calculated from $X_1$ being the total of the values x and $Y_1$ being the total of the values y being 0.5 or more, because the external quantum efficiency of the light-emitting device according to the present invention is excellent.

When the crosslinkable polymer compound compriseis at least one constitutional unit selected from the group consisting of constitutional units represented by the formula (Y11) and constitutional units represented by the formula (Y12), and a constitutional unit represented by the formula (3), it is preferable that with respect to each monomer unit constituting the crosslinkable polymer compound, the value x obtained by multiplying the molar ratio C of the each monomer unit to the total mol of all the monomer units by the molecular weight M of the each monomer unit, and the value y obtained by multiplying the molar ratio C by the number n of the crosslinkable groups in the each monomer unit are determined, the value of $(Y_1 \times 1000)/X_1$ calculated from $X_1$ being the total of the values x and $Y_1$ being the total of the values y being 1.10 or more, because the external quantum efficiency of the light-emitting device according to the present invention is excellent.

[Chemical Formula 78]

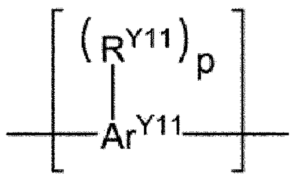

(Y11)

Wherein,
$Ar^{Y11}$ represents an aromatic hydrocarbon group, and the group optionally has a substituent other than $R^{Y11}$;
p represents an integer of 1 or more; and
$R^{Y11}$ represents an alkyl group, an alkoxy group, an aryl group or a monovalent heterocyclic group, and these groups each optionally have a substituent; and when a plurality of $R^{Y11}$ are present, they may be the same or different; provided that at least one of $R^{Y11}$ links to a carbon atom adjacent to a carbon atom forming a bond with another constitutional unit.

[Chemical Formula 79]

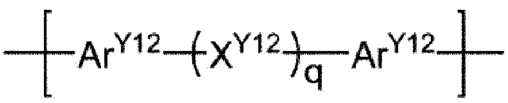

(Y12)

Wherein,
$Ar^{Y12}$ represents an arylene group or a divalent heterocyclic group, and these groups each optionally have a substituent; and the plurality of $Ar^{Y12}$ may be the same or different;
q represents an integer of 1 to 5; and
$X^{Y12}$ represents an alkyl group, a cycloalkylene group, an oxygen atom or a sulfur atom, and these groups each optionally have a substituent; and when a plurality of $X^{Y12}$ are present, they may be the same or different.

The aromatic hydrocarbon group of $Ar^{Y11}$ in the formula (Y11) denotes a group obtained by removing from an aromatic hydrocarbon one or more hydrogen atoms directly linked to carbon atoms constituting the aromatic ring. The

aromatic hydrocarbon preferably includes benzene, fluorene, naphthalene, anthracene, pyrene, chrysene and fluoranthene; benzene, fluorene, naphthalene and chrysene are preferable; more preferable are benzene, fluorene and naphthalene; and especially preferable are benzene and fluorene.

Preferable as $Ar^{Y11}$ is a constitutional unit represented by the above formula (Y-1'), (Y-2') or (Y-3').

The preferable range of $R^{Y11}$ in the formula (Y11) is the same as described above.

The definition, examples and the preferable range of $Ar^{Y12}$ in the formula (Y12) are the same as those of $Ar^{Y1}$.

q in the formula (Y12) represents an integer of 1 to 5, and is preferably an integer of 1 to 3, more preferably an integer of 1 or 2, and further preferably 1.

q in the formula (Y12) represents an integer of 1 to 5, and is preferably an integer of 1 to 3, more preferably an integer of 1 or 2, and further preferably 1.

$X^{Y12}$ in the formula (Y12) represents an alkylene group, a cycloalkylene group, an oxygen atom or a sulfur atom, and these groups each optionally have a substituent; and preferable as $X^{Y12}$ are an alkylene group and a cycloalkylene group; and when a plurality of $X^{Y12}$ are present, they may be the same or different.

The number of carbon atoms of the alkylene group is, not including the number of carbon atoms of substituents, usually 1 to 10, preferably 1 to 5, and more preferably 1 to 3. The number of carbon atoms of the cycloalkylene group is, not including the number of carbon atoms of substituents, usually 3 to 10.

Examples of the alkylene group include a methylene group, an ethylene group, a propylene group, a butylene group, a hexylene group and an octylene group. The alkylene group optionally has a substituent, and examples of the substituent include cycloalkyl groups, alkoxy groups, cycloalkoxy groups, halogen atoms and a cyano group.

Examples of the cycloalkylene group include a cyclohexylene group and a cyclopentylene group. The cycloalkylene group optionally has a substituent, and examples of the substituent include alkyl groups, cycloalkyl groups, alkoxy groups, cycloalkoxy groups, halogen atoms and a cyano group.

Examples of the constitutional unit represented by the formula (Y12) include the following.

[Chemical Formula 80]

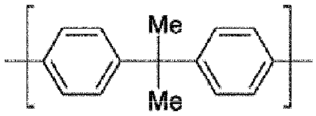
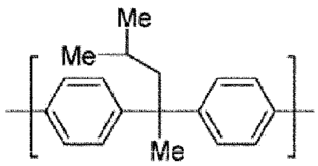
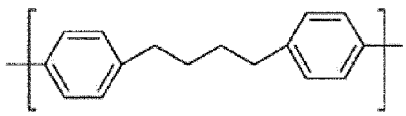
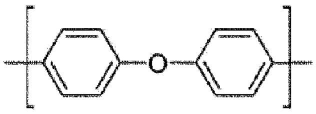
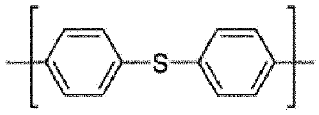

The constitutional unit represented by the formula (Y11) or (Y12) may be contained singly, or two or more units thereof may be contained in the crosslinkable polymer compound.

It is preferable that the crosslinkable polymer compound further comprises both of the constitutional unit represented by the formula (X) and the constitutional unit represented by the formula (Y11) or (Y12), because the external quantum efficiency of the light-emitting device according to the present invention is excellent.

Examples of the crosslinkable polymer compound include polymer compounds (P-11), (P-12), (P-13), (P-14), (P-15), (P-16), (P-17), (P-18), (P-19), (P-20), (P-21), (P-22) and (P-23), in Table 2.

[Table 2]

| Polymer compound | Constitutional unit and mole fraction thereof | | | | | |
|---|---|---|---|---|---|---|
| | Formula (2) | Formula (3) | Formulae (X-1) to (X-7) | Formula (Y11) | Formula (Y12) | Others |
| | p' | q' | r' | s' | t' | u' |
| P-11 | 0.1 to 99.9 | 0 | 0.1 to 99.9 | 0 | 0 | 0 to 30 |
| P-12 | 0 | 0.1 to 99.9 | 0.1 to 99.9 | 0 | 0 | 0 to 30 |
| P-13 | 0.1 to 99.9 | 0 | 0 | 0.1 to 99.9 | 0 | 0 to 30 |
| P-14 | 0 | 0.1 to 99.9 | 0 | 0.1 to 99.9 | 0 | 0 to 30 |
| P-15 | 0.1 to 99.8 | 0 | 0.1 to 99.8 | 0.1 to 99.8 | 0 | 0 to 30 |

(continued)

| Polymer compound | Constitutional unit and mole fraction thereof | | | | | |
|---|---|---|---|---|---|---|
| | Formula (2) | Formula (3) | Formulae (X-1) to (X-7) | Formula (Y11) | Formula (Y12) | Others |
| | p' | q' | r' | s' | t' | u' |
| P-16 | 0 | 0.1 to 99.8 | 0.1 to 99.8 | 0.1 to 99.8 | 0 | 0 to 30 |
| P-17 | 0.1 to 99.8 | 0.1 to 99.8 | 0.1 to 99.8 | 0 | 0 | 0 to 30 |
| P-18 | 0.1 to 99.8 | 0 | 0.1 to 99.8 | 0 | 0.1 to 99.8 | 0 to 30 |
| P-19 | 0 | 0.1 to 99.8 | 0.1 to 99.8 | 0 | 0.1 to 99.8 | 0 to 30 |
| P-20 | 0.1 to 99.7 | 0.1 to 99.7 | 0.1 to 99.7 | 0.1 to 99.7 | 0 | 0 to 30 |
| P-21 | 0.1 to 99.7 | 0.1 to 99.7 | 0 | 0.1 to 99.7 | 0.1 to 99.7 | 0 to 30 |
| P-22 | 0.1 to 99.7 | 0.1 to 99.7 | 0.1 to 99.7 | 0 | 0.1 to 99.7 | 0 to 30 |
| P-23 | 0.1 to 99.6 | 0.1 to 99.6 | 0.1 to 99.6 | 0.1 to 99.6 | 0.1 to 99.6 | 0 to 30 |

In Table 2, p', q', r', s', t' and u' represent the molar ratios of each constitutional unit. $p'+q'+r'+s'+t'+u' = 100$, and $70 \leq p'+q'+r'+s'+t' \leq 100$. "Others" denote a constitutional unit other than the constitutional unit represented by the formula (2), the constitutional unit represented by the formula (3), the constitutional unit represented by the formula (X) and the constitutional unit represented by the formula (Y11) or (Y12).

The crosslinkable polymer compound may be any of a block copolymer, a random copolymer, an alternating copolymer or a graft copolymer, and may also be another aspect; but it is preferable that the crosslinkable polymer compound is a copolymer produced by copolymerizing a plurality of raw material monomers.

[Production method of the crosslinkable polymer compound]

The crosslinkable polymer compound can be produced by the same production method as the method of production of the polymer host described above.

[Average number of the crosslinkable groups]

The second organic layer is formed by using a polymer composition in which one or two or more polymer compounds including a crosslinkable polymer compound having at least one crosslinkable group selected from Group A of crosslinkable groups are compounded. Here, the index to indicate the average number of the crosslinkable groups in the polymer compounds can be determined by the following method.

First, with respect to each monomer unit constituting the polymer compound, the value x obtained by multiplying the molar ratio C of the each monomer unit to the total mol of all the monomer units by the molecular weight M of the each monomer unit, and the value y obtained by multiplying the molar ratio C by the number n of the crosslinkable groups in the each monomer unit are determined. Then, the total of the values x determined for the each monomer unit is taken to be $X_1$, and the total of the values y determined for the each monomer unit is taken to be $Y_1$.

At this time, the value of $(Y_1 \times 1000)/X_1$ becomes a value nearly equal to the average number of the crosslinkable groups per 1000 in molecular weight of the polymer compound, and can effectively be used as an index indicating the average number of the crosslinkable groups in the polymer compound. Hereinafter, the value of $(Y_1 \times 1000)/X_1$ is referred to as "average number of the crosslinkable groups per 1000 in molecular weight" in some cases.

A specific calculation method of the average number of the crosslinkable groups will be described in detail by way of a polymer compound P1 used in Example 1 described below.

The polymer compound P1 has monomer units formed from a compound MM1, a compound MM2 and a compound MM3, which are monomers. The ratio to the total mol of all the monomer units is 0.45 for the monomer unit formed from the compound MM1, 0.05 for the monomer unit formed from the compound MM2, and 0.50 for the monomer unit formed from the compound MM3. Further the molecular weight of the monomer unit formed from the compound MM1 is 776.45; the molecular weight of the monomer unit formed from the compound MM2 is 240.20; and the molecular weight of the monomer unit formed from the compound MM3 is 750.51. Further the number of the crosslinkable groups the monomer unit formed from the compound MM1 has is 2; the number of the crosslinkable groups the monomer unit formed from the compound MM2 has is 2; and the number of the crosslinkable groups the monomer unit formed from the compound MM3 has is 0.

Therefore, $X_1$ can be determined as follows.

$$(0.45 \times 776.45) + (0.05 \times 240.20) + (0.50 \times 750.51) = 736.67$$

Further, $Y_1$ can be determined as follows.

$$(0.45 \times 2) + (0.05 \times 2) + (0.50 \times 0) = 1.00$$

Therefore, the average number of the crosslinkable groups per 1000 in molecular weight can be determined as follows.

$$(1.00 \times 1000)/736.67 = 1.36$$

when the polymer composition comprises two or more polymer compounds as the polymer compound, the value of $(Y_1 \times 1000)/X_1$ can be determined based on the monomer units constituting the each polymer compound. Further the value of $(Y_1 \times 1000)/X_1$ is determined for the each polymer compound, and the value of $(Y_1 \times 1000)/X_1$ of the whole polymer compounds is determined from the compounding amount ratios of the each polymer compound.

A specific calculation method will be described for the case where a polymer compound P4 and a polymer compound P5 of Comparative Example 4 described below are compounded in a ratio of 50 : 50.

The polymer compound P4 has monomer units formed from the compound MM1, the compound MM2, a compound MM4 and the compound MM3, which are monomers. In the polymer compound P4, the ratio to the total mol of all the monomer units is 0.05 for the monomer unit formed from the compound MM1, 0.05 for the monomer unit formed from compound MM2, 0.40 for the monomer unit formed from compound MM4, and 0.05 for the monomer unit formed from compound MM3. Further the molecular weight of the monomer unit formed from the compound MM1 is 776.45; the molecular weight of the monomer unit formed from the compound MM2 is 240.20; the molecular weight of the monomer unit formed from the compound MM4 is 244.23; and the molecular weight of the monomer unit formed from the compound MM3 is 750.51. Further the number of the crosslinkable groups the monomer unit formed from the compound MM1 has is 2; the number of the crosslinkable groups the monomer unit formed from the compound MM2 has is 2; the number of the crosslinkable groups the monomer unit formed from the compound MM4 has is 0; and the number of the crosslinkable groups the monomer unit formed from the compound MM3 has is 0. Therefore, for the polymer compound P4, the average number of the crosslinkable groups per 1000 in molecular weight as calculated by the method described above is 0.38.

The polymer compound P5 has monomers units formed from the compound MM4 and the compound MM3, which are monomers. In the polymer compound P5, the ratio to the total mol of all the monomer units is 0.50 for the monomer unit formed from the compound MM3, and 0.50 for the monomer unit from compound MM4. Further the molecular weight of the monomer unit formed from the compound MM4 is 244.23; and the molecular weight of the monomer unit formed from the compound MM3 is 750.51. Further the number of the crosslinkable groups the monomer unit formed from the compound MM4 has is 0; and the number of the crosslinkable groups the monomer unit formed from the compound MM3 has is 0. Therefore, for the polymer compound P5, the average number of the crosslinkable groups per 1000 in molecular weight as calculated by the method described above is 0.

In Comparative Example 4, the polymer compound P4 and the polymer compound P5 are compounded in a ratio of 50 : 50. Therefore, in Comparative Example 4, the average number of the crosslinkable groups per 1000 in molecular weight of the polymer compound can be determined to be 0.19 by the following formula.

$$0.38 \times 0.5 + 0 \times 0.5 = 0.19$$

In the present invention, the average number of the crosslinkable groups per 1000 in molecular weight is preferably 0.50 or more, more preferably 0.60 or more, further preferably 0.65 or more, still further preferably 0.90 or more, and especially preferably 1.10 or more. It is conceivable that when the average number of the crosslinkable groups increase, a more compact film is formed from the crosslinkable polymer compound, and the charge transportability of the second organic layer and/or the charge injection from the second organic layer to the first organic layer is improved.

Further in the present invention, the average number of the crosslinkable groups per 1000 in molecular weight may be, for example, 10 or less, or may be 3 or less. By making the average number of the crosslinkable groups in this

range, the effect that the luminance life of the light-emitting device is more improved is attained.

[Composition of the second organic layer]

The second organic layer may be a layer formed by using a composition (hereinafter, referred to also as "composition of the second organic layer") comprising the crosslinkable polymer compound, the phosphorescent compound, and at least one material selected from the group consisting of a hole transporting material, a hole injection material, an electron transporting material, an electron injection material, a light emitting material, an antioxidant and a solvent.

The second organic layer may be, for example, a layer comprising a crosslinked body formed from the crosslinkable polymer compound, the phosphorescent compound, and at least one material selected from the group consisting of a hole transporting material, a hole injection material, an electron transporting material, an electron injection material, a light emitting material, an antioxidant and a solvent.

Examples and the preferable ranges of the hole transporting material, the electron transporting material, the hole injection material, the electron injection material and the light emitting material contained in the composition of the second organic layer are the same as the examples and the preferable ranges of the hole transporting material, the electron transporting material, the hole injection material, the electron injection material and the light emitting material contained in the composition of the first organic layer.

In the composition of the second organic layer, the compounding amounts of the hole transporting material, the electron transporting material, the hole injection material, the electron injection material and the light emitting material are each, when the crosslinkable polymer compound is taken to be 100 parts by mass, usually 1 to 400 parts by mass, and preferably 5 to 150 parts by mass.

Examples and the preferable ranges of the antioxidant contained in the composition of the second organic layer are the same as the examples and the preferable ranges of the antioxidant contained in the composition of the first organic layer.

In the composition of the second organic layer, the compounding amount of the antioxidant is, when the crosslinkable polymer compound is taken to be 100 parts by mass, usually 0.001 to 10 parts by mass.

[Ink for the second organic layer]

The composition (hereinafter, referred to also as "ink for the second organic layer") of the second organic layer comprising a solvent can suitably be used, similarly to the ink for the first organic layer, in applying methods such as a spin coat method and an inkjet printing method.

The preferable range of the viscosity of the ink for the second organic layer is the same as the preferable range of the viscosity of the ink for the first organic layer.

The solvent contained in the ink for the second organic layer is preferably a solvent capable of dissolving or uniformly dispersing solid components in the ink. Examples and the preferable ranges of the solvent are the same as the examples and the preferable ranges of the solvent contained in the first organic layer.

In the ink for the second organic layer, the compounding amount of the solvent is, when the crosslinkable polymer compound is taken to be 100 parts by mass, usually 1000 to 100000 parts by mass, and preferably 2000 to 20000 parts by mass.

<Layer constitution of light-emitting device>

The light-emitting device of the present invention comprises an anode, a cathode, a first organic layer disposed between the anode and the cathode and a second organic layer disposed between the anode and the first organic layer. The light-emitting device of the present invention may comprise layers other than the anode, the cathode, the first organic layer and the second organic layer.

In the light-emitting device of the present invention, the first organic layer is usually a light emitting layer.

In the light-emitting device of the present invention, the first organic layer and the second organic layer are adjacent, because the light-emitting device of the present invention is more excellent in external quantum efficiency.

It is preferable for the light-emitting device of the present invention to further comprise at least one layer selected from the group consisting of a hole transporting layer and a hole injection layer between the anode and the second organic layer, because the light-emitting device of the present invention is more excellent in power efficiency. Further, it is preferable for the light-emitting device of the present invention to further comprise at least one layer selected from the group consisting of an electron transporting layer and an electron injection layer between the cathode and the first organic layer, because the light-emitting device of the present invention is excellent in power efficiency.

The specific layer constitution of the light-emitting device of the present invention includes layer constitutions

represented by ($D_1$), (D2), (D3), (D4), (D5), (D6), (D7), (D8), (D9), (D10), (D11), (D12), (D13), (D14), (D15) or (D16) described below (hereinafter, referred to as "layer constitution represented by (D1) to (D16)" in some cases). The light-emitting device of the present invention usually comprises a substrate, and the anode may be first laminated on the substrate or the cathode may be first laminated on the substrate.

(D1) anode/second organic layer/first organic layer/cathode
(D2) anode/second organic layer/first organic layer/electron transporting layer/cathode
(D3) anode/second organic layer/first organic layer/electron injection layer/cathode
(D4) anode/second organic layer/first organic layer/electron transporting layer/electron injection layer/cathode
(D5) anode/hole injection layer/second organic layer/first organic layer/cathode
(D6) anode/hole injection layer/second organic layer/first organic layer/electron transporting layer/cathode
(D7) anode/hole injection layer/second organic layer/first organic layer/electron injection layer/cathode
(D8) anode/hole injection layer/second organic layer/first organic layer/electron transporting layer/electron injection layer/cathode
(D9) anode/hole transporting layer/second organic layer/first organic layer/cathode
(D10) anode/hole transporting layer/second organic layer/first organic layer/electron transporting layer/cathode
(D11) anode/hole transporting layer/second organic layer/first organic layer/electron injection layer/cathode
(D12) anode/hole transporting layer/second organic layer/first organic layer/electron transporting layer/electron injection layer/cathode
(D13) anode/hole injection layer/hole transporting layer/second organic layer/first organic layer/cathode
(D14) anode/hole injection layer/hole transporting layer/second organic layer/first organic layer/electron transporting layer/cathode
(D15) anode/hole injection layer/hole transporting layer/second organic layer/first organic layer/electron injection layer/cathode
(D16) anode/hole injection layer/hole transporting layer/second organic layer/first organic layer/electron transporting layer/electron injection layer/cathode

In (D1) to (D16) described above, "/" denotes adjacent lamination of anterior and posterior layers. Specifically, "second organic layer/first organic layer" means that the second organic layer and the first organic layer are laminated adjacently.
In the light-emitting device of the present invention, if necessary, two or more of each of a hole injection layer, a hole transporting layer, an electron transporting layer and an electron injection layer may be provided.
The thickness of an anode, a cathode, a first organic layer, a second organic layer, a hole injection layer, a hole transporting layer, an electron injection layer and an electron transporting layer is usually 1 nm to 1 μm, preferably 2 nm to 500 nm, further preferably 5 nm to 150 nm.
In the light-emitting device of the present invention, the order, the number and the thickness of layers to be laminated may be advantageously adjusted in views of external quantum efficiency and device lifetime of the light-emitting device.

[Hole transporting layer]

The hole transporting layer is usually a layer formed by using a hole transporting material. The hole transporting material used for formation of the hole transporting layer includes, for example, hole transporting materials which the above-described composition of the first organic layer may comprise.
The hole transporting material may be used singly, or two or more hole transporting materials may be used in combination.

[Electron transporting layer]

The electron transporting layer is usually a layer formed by using an electron transporting material. The electron transporting material used for formation of the electron transporting layer includes, for example, electron transporting materials which the above-described composition of the first organic layer may comprise and a polymer compound comprising at least one constitutional unit selected from the group consisting of a constitutional unit represented by the formula (ET-1) and a constitutional unit represented by the formula (ET-2), preferably, a polymer compound comprising at least one constitutional unit selected from the group consisting of a constitutional unit represented by the formula (ET-1) and a constitutional unit represented by the formula (ET-2). The electron transporting material may be used singly, or two or more electron transporting materials may be used in combination.

[Chemical Formula 81]

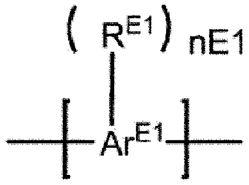

(ET-1)

Wherein,
nE1 represents an integer of 1 or more.

$Ar^{E1}$ represents an aromatic hydrocarbon group or a heterocyclic group, and these groups each optionally have a substituent other than $R^{E1}$.

$R^{E1}$ represents a group represented by the formula (ES-1). When a plurality of $R^{E1}$ are present, they may be the same or different.

$$-(R^{E3})_{cE1}-(Q^{E1})_{nE4}-Y^{E1}(M^{E2})_{aE1}(Z^{E1})_{bE1} \qquad \text{(ES-1)}$$

[wherein,

cE1 represents 0 or 1, nE4 represents an integer of 0 or more, aE1 represents an integer of 1 or more, and bE1 represents an integer of 0 or more.
$R^{E3}$ represents an arylene group or a divalent heterocyclic group, and these groups each optionally have a substituent.
$Q^{E1}$ represents an alkylene group, an arylene group, an oxygen atom or a sulfur atom, and these groups each optionally have a substituent. When a plurality of $Q^{E1}$ are present, they may be the same or different.
$Y^{E1}$ represents $-CO_2^-$, $-SO_3^-$, $-SO_2^-$ or $PO_3^{2-}$.
$M^{E2}$ represents a metal cation or an ammonium cation, and this ammonium cation optionally has a substituent. When a plurality of $M^{E2}$ are present, they may be the same or different.
$Z^{E1}$ represents $F^-$, $Cl^-$, $Br^-$, $I^-$, $OH^-$, $R^{E4}SO_3^-$, $R^{E4}COO^-$, $ClO^-$, $ClO_2^-$, $ClO_3^-$, $ClO_4^-$, $SCN^-$, $CN^-$, $NO_3^-$, $SO_4^{2-}$, $HSO_4^-$, $PO_4^{3-}$, $HPO_4^{2-}$, $H_2PO_4^-$, $BF_4^-$ or $PF_6^-$. $R^{E4}$ represents an alkyl group, a cycloalkyl group or an aryl group, and these groups each optionally have a substituent. When a plurality of $Z^{E1}$ are present, they may be the same or different.
aE1 and bE1 are selected so that the charge of the group represented by the formula (ES-1) is 0.]

nE1 is preferably an integer of 1 to 4, more preferably 1 or 2.

The aromatic hydrocarbon group or the heterocyclic group represented by $Ar^{E1}$ is preferably an atomic group remaining after removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group or a 2,7-carbazoledilyl group nE1 hydrogen atoms bonding directly to atoms constituting the ring, and optionally has a substituent other than $R^{E1}$.

The substituent other than $R^{E1}$ which $Ar^{E1}$ optionally has includes a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, a cycloalkynyl group, a carboxyl group, and a group represented by the formula (ES-3).

$$-O(C_{n'}H_{2n'}O)_{nx}C_{m'}H_{2m'}+1 \qquad \text{(ES-3)}$$

[wherein, n', m' and nx represent an integer of 1 or more.]

cE1 is preferably 0 or 1, and nE4 is preferably an integer of 0 to 6.

$R^{E3}$ is preferably an arylene group.

$Q^{E1}$ is preferably an alkylene group, an arylene group or an oxygen atom.

$Y^{E1}$ is preferably $-CO_2^-$ or $SO_3^-$.

$M^{E2}$ is preferably $Li^+$, $Na^+$, $K^+$, $Cs^+$, $N(CH_3)_4^+$, $NH(CH_3)_3^+$, $NH_2(CH_3)_2^+$ or $N(C_2H_5)_4^+$.

$Z^{E1}$ is preferably $F^-$, $Cl^-$, $Br^-$, $I^-$, $OH^-$, $R^{E4}SO_3^-$ or $R^{E4}COO^-$.

The group represented by the formula (ES-1) includes, for example, groups represented by the following formulae.

[Chemical Formula 82]

$—COO^-M^+$ $—CH_2\text{-}COO^-M^+$ $—C_2H_4—COO^-M^+$

$—O—CH_2\text{-}COO^-M^+$ $—O—C_2H_4\,COO^-M^+$

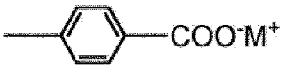 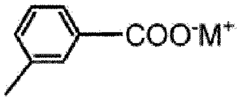 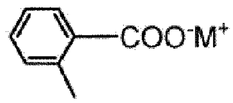

$—SO_3^-M^+$ $—CH_2\text{-}SO_3^-M^+$ $—C_2H_4—SO_3^-M^+$

$—O—CH_2\text{-}SO_3^-M^+$ $—O—C_2H_4{\cdot}SO_3^-M^+$

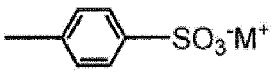 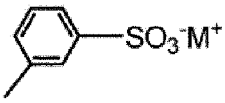 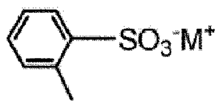

Wherein, $M^+$ represents $Li^+$, $Na^+$, $K^+$, $Cs^+$, $N(CH_{3)4}{}^+$, $NH(CH_3)_3{}^+$, $NH_2(CH_3)_2{}^+$ or $N(C_2\,H_5)_4{}^+$.

[Chemical Formula 83]

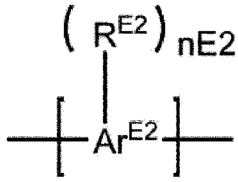 (ET-2)

Wherein,
nE2 represents an integer of 1 or more.

$Ar^{E2}$ represents an aromatic hydrocarbon group or a heterocyclic group, and these groups each optionally have a substituent other than $R^{E2}$.

$R^{E2}$ represents a group represented by the formula (ES-2). When a plurality of $R^{E2}$ are present, they may be the same or different.

$$-(R^{E6})_{cE2}\text{-}(Q^{E2})_{nE6}\text{-}Y^{E2}(M^{E3})_{bE2}(Z^{E2})_{aE2} \qquad \text{(ES-2)}$$

[wherein,

cE2 represents 0 or 1, nE6 represents an integer of 0 or more, bE2 represents an integer of 1 or more, and aE2 represents an integer of 0 or more.
$R^{E6}$ represents an arylene group or a divalent heterocyclic group, and these groups each optionally have a substituent.
$Q^{E2}$ represents an alkylene group, an arylene group, an oxygen atom or a sulfur atom, and these groups each optionally have a substituent. When a plurality of $Q^{E2}$ are present, they may be the same or different.
$Y^{E2}$ represents a carbocation, an ammonium cation, a phosphonyl cation or a sulfonyl cation.
$M^{E3}$ represents $F^-$, $Cl^-$, $Br^-$, $I^-$, $OH^-$, $R^{E7}SO_3^-$, $R^{E7}COO^-$, $ClO^-$, $ClO_2^-$, $ClO_3^-$, $ClO_4^-$, $SCN^-$, $CN^-$, $NO_3^-$, $SO_4^{2-}$, $HSO_4^-$, $PO_4^{3-}$, $HPO_4^{2-}$, $H_2PO_4^-$, tetraphenyl borate, $BF_4^-$ or $PF_6^-$. $R^{E7}$ represents an alkyl group, a perfluoroalkyl group or an aryl group, and these groups each optionally have a substituent. When a plurality of $M^{E3}$ are present, they may be the same or different.
$Z^{E2}$ represents a metal ion or an ammonium ion, and this ammonium ion optionally has a substituent. When a

plurality of $Z^{E2}$ are present, they may be the same or different.
aE2 and bE2 are selected so that the charge of the group represented by the formula (ES-2) is 0.]
nE2 is preferably an integer of 1 to 4, more preferably 1 or 2.

The aromatic hydrocarbon group or the heterocyclic group represented by $Ar^{E2}$ is preferably an atomic group remaining after removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group or a 2,7-carbazoledilyl group nE2 hydrogen atoms bonding directly to atoms constituting the ring, and optionally has a substituent other than $R^{E2}$ .

The substituent other than $R^{E2}$ which $Ar^{E2}$ optionally has is the same as the substituent other than $R^{E1}$ which $Ar^{E1}$ optionally has.

cE2 is preferably 0 or 1, and nE6 is preferably an integer of 0 to 6.

$R^{E6}$ is preferably an arylene group.

$Q^{E2}$ is preferably an alkylene group, an arylene group or an oxygen atom.

$Y^{E2}$ is preferably a carbocation or an ammonium cation.

$M^{E3}$ is preferably $F^-$, $Cl^-$, $Br^-$, $I^-$, tetraphenyl borate, $CF_3SO_3^-$ or $CH_3COO^-$ .

$Z^{E2}$ is preferably $Li^+$, $Na^+$, $K^+$, $Cs^+$, $N(CH_3)_4^+$, $NH(CH_3)_3^+$, $NH_2(CH_3)_2^+$ or $N(C_2H_5)_4^+$.

The group represented by the formula (ES-2) includes, for example, groups represented by the following formulae.

[Chemical Formula 84]

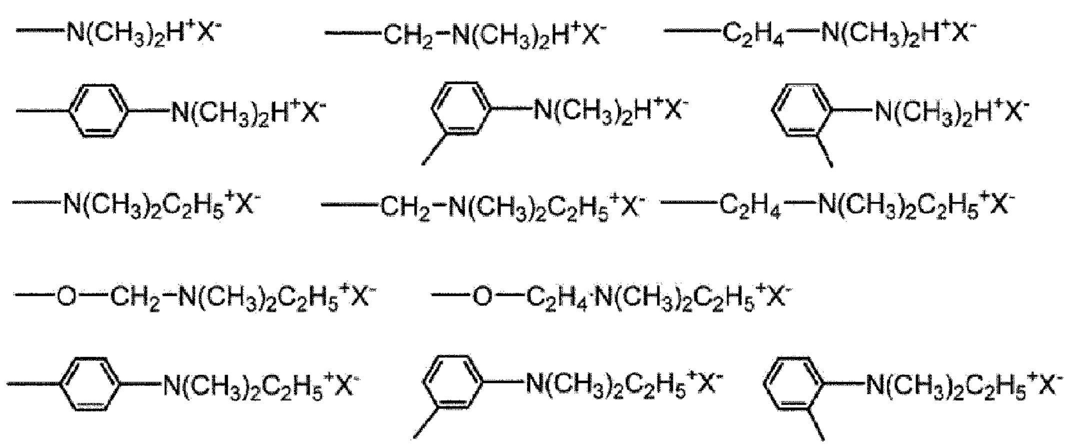

Wherein, $X^-$ represents $F^-$, $Cl^-$, $Br^-$, $I^-$, tetraphenyl borate, $CF_3SO_3^-$ or $CH_3COO^-$.

The constitutional unit represented by the formula (ET-1) and the formula (ET-2) includes, for example, constitutional units represented by the formula (ET-31), (ET-32), (ET-33) or (ET-34) dscribed below.

[Chemical Formula 85]

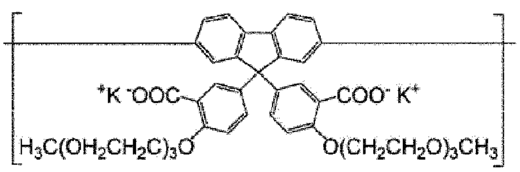
(ET-31)

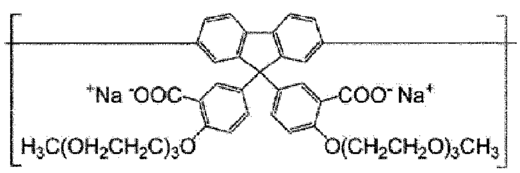
(ET-32)

[Chemical Formula 86]

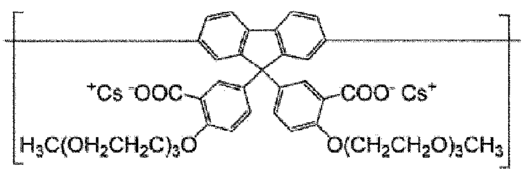

(ET-33)

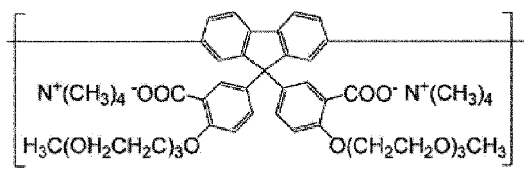

(ET-34)

When a material used for formation of the hole injection layer described later, a material used for formation of the hole transporting layer, a material used for formation of the second organic layer, a material used for formation of the first organic layer, a material used for formation of the electron transporting layer, and a material used for formation of the electron injection layer described later are each soluble in a solvent used in forming a layer adjacent to the hole injection layer, the hole transporting layer, the second organic layer, the first organic layer, the electron transporting layer and the electron injection layer in fabrication of a light-emitting device, it is preferable that dissolution of the material in the solvent is avoided. As the method for avoiding dissolution of the material, i) a method of using a material having a crosslinkable group or ii) a method of providing a difference of solubility between adjacent layers is preferable. In the above-described method i), a layer is formed using a material having a crosslinkable group, then, the crosslinkable group is crosslinked, thus, the layer can be insolubilized.

For example, when an electron transporting layer is laminated on the first organic layer by utilizing a difference of solubility, the electron transporting layer can be laminated by using a solution manifesting low solubility for the first organic layer.

As the solvent used in laminating an electron transporting layer on the first organic layer by utilizing a difference of solubility, preferable are water, alcohols, ethers, esters, nitrile compounds, nitro compounds, fluorinated alcohols, thiols, sulfides, sulfoxides, thioketones, amides, carboxylic acids and the like. Specific examples of the solvent include methanol, ethanol, 2-propanol, 1-butanol, tert-butyl alcohol, acetonitrile, 1,2-ethanediol, N,N-dimethylformamide, dimethyl sulfoxide, acetic acid, nitromethane, propylene carbonate, pyridine, carbon disulfide and a mixed solvent of these solvents. When the mixed solvent is used, mixed solvents composed of one or more solvents selected from water, alcohols, ethers, esters, nitrile compounds, nitro compounds, fluorinated alcohols, thiols, sulfides, sulfoxides, thioketones, amides, carboxylic acids and the like and one or more solvents selected from chlorine-based solvents, aromatic hydrocarbon solvents, aliphatic hydrocarbon solvents and ketone solvents may be permissible.

[Hole injection layer and electron injection layer]

The hole injection layer is usually a layer formed by using a hole injection material. The hole injection material used for formation of the hole injection layer includes, for example, hole injection materials which the above-described composition of the first organic layer may comprise. The hole injection material may be used singly, or two or more hole injection materials may be used in combination.

The electron injection layer is usually a layer formed by using an electron injection material. The electron injection material used for formation of the electron injection layer includes, for example, electron injection materials which the above-described composition of the first organic layer may comprise. The electron injection material may be used singly, or two or more electron injection materials may be used in combination.

[Substrate/electrode]

The substrate in the light-emitting device may advantageously be a substrate on which an electrode can be formed and which does not chemically change in forming an organic layer, and is a substrate made of a material such as, for example, glass, plastic and silicon. In the case of using an opaque substrate, it is preferable that an electrode most remote from the substrate is transparent or semi-transparent.

The material of the anode includes, for example, electrically conductive metal oxides and semi-transparent metals, preferably, indium oxide, zinc oxide and tin oxide; electrically conductive compounds such as indium·tin·oxide (ITO) and indium·zinc·oxide; a composite of silver, palladium and copper (APC); NESA, gold, platinum, silver and copper.

The material of the cathode includes, for example, metals such as lithium, sodium, potassium, rubidium, cesium, beryllium, magnesium, calcium, strontium, barium, aluminum, zinc and indium; alloys composed of two or more of them; alloys composed of one or more of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

The anode and the cathode each may be a laminated structure composed of two or more layers.

In the light-emitting device of the present invention, at least one of the anode and the cathode is usually transparent or semi-transparent, and it is preferable that the anode is transparent or semi-transparent.

Methods for forming the anode and the cathode include, for example, vacuum vapor deposition method, sputtering method, ion plating method, plating method, lamination method and the like.

[Production method of light-emitting device]

The method of forming each layer such as the first organic layer, the second organic layer, a hole transporting layer, an electron transporting layer, a hole injection layer and an electron injection layer in the light-emitting device of the present invention includes, for example, a vacuum vapor deposition method from a powder and a method of film formation from a solution or melted state when a low molecular weight compound is used, and includes, for example, a method of film formation from a solution or melted state when a polymer compound is used.

The first organic layer, the second organic layer, the hole transporting layer, the electron transporting layer, the hole injection layer and the electron injection layer can be formed by application methods typified by a spin coat method and an inkjet printing method using the ink of the first organic layer, the ink of the second organic layer, inks comprising the hole transporting material, the electron transporting material, the hole injection material and the electron injection material described above, respectively.

[Use of light-emitting device]

For obtaining planar light emission by using a light-emitting device, a planar anode and a planar cathode are disposed so as to overlap with each other. Patterned light emission can be produced by a method of placing a mask with a patterned window on the surface of a planer light-emitting device, a method of forming an extremely thick layer intended to be a non-light emitting, thereby having the layer essentially no-light emitting or a method of forming an anode, a cathode or both electrodes in a patterned shape. By forming a pattern with any of these methods and disposing certain electrodes so as to switch ON/OFF independently, a segment type display capable of displaying numbers and letters and the like is provided. For producing a dot matrix display, both an anode and a cathode are formed in a stripe shape and disposed so as to cross with each other. Partial color display and multi-color display are made possible by a method of printing separately certain polymer compounds showing different emission or a method of using a color filter or a fluorescence conversion filter. The dot matrix display can be passively driven, or actively driven combined with TFT and the like. These displays can be used in computers, television sets, portable terminals and the like. The planar light-emitting device can be suitably used as a planer light source for backlight of a liquid crystal display or as a planar light source for illumination. If a flexible substrate is used, it can be used also as a curved light source and a curved display.

EXAMPLES

In the present examples, the polystyrene-equivalent number average molecular weight (Mn) and the polystyrene-equivalent weight average molecular weight (Mw) of a polymer compound were measured by size exclusion chromatography (SEC) (manufactured by Shimadzu Corp., trade name: LC-10Avp). SEC measurement conditions are as follows:

[Measurement condition]

The polymer compound to be measured was dissolved in THF (tetrahydrofuran) at a concentration of about 0.05 wt%, and 10 μL of the solution was injected into SEC. As the mobile phase of SEC, THF was used and allowed to flow at a flow rate of 2.0 mL/min. As the column, PLgel MIXED-B (manufactured by Polymer Laboratories) was used. As the detector, UV-VIS detector (manufactured by Shimadzu Corp., trade name: SPD-10Avp) was used.

Liquid chromatograph mass spectrometry (LC-MS) was carried out according to the following method.

A measurement sample was dissolved in chloroform or THF so as to give a concentration of about 2 mg/mL, and about 1 μL of the solution was injected into LC-MS (manufactured by Agilent Technologies, trade name: 1100LCMSD). As the mobile phase of LC-MS, acetonitrile and THF were used while changing the ratio thereof and allowed to flow at a flow rate of 0.2 mL/min. As the column, L-column 2 ODS (3 μm) (manufactured by Chemicals Evaluation and Research Institute, internal diameter: 2.1 mm, length: 100 mm, particle size: 3 μm) was used.

Measurements of $^1$H-NMR and $^{13}$C-NMR were carried out by the following method.

5 to 10 mg of a measurement sample was dissolved in about 0.5 mL of deuterated chloroform ($CDCl_3$), deuterated tetrahydrofuran, deuterated dimethyl sulfoxide, deuterated acetone, deuterated N,N-dimethylformamide, deuterated toluene, deuterated methanol, deuterated 2-propanol or deuterated methylene chloride, and the measurements were carried out by using an NMR apparatus (manufactured by Agilent Technologies, Inc., trade name: INOVA300 or MERCURY 400VX).

As the index of the purity of a compound, a value of the high performance liquid chromatography (HPLC) area percentage was used. This value is a value in high performance liquid chromatography (HPLC, manufactured by Shimadzu Corp., trade name: LC-20A) at 254 nm, unless otherwise stated. In this operation, the compound to be measured was dissolved in THF or chloroform so as to give a concentration of 0.01 to 0.2 wt%, and depending on the concentration, 1 to 10 μL of the solution was injected into HPLC. As the mobile phase of HPLC, acetonitrile and THF were used and allowed to flow at a flow rate of 1 mL/min as gradient analysis of acetonitrile/THF = 100/0 to 0/100 (volume ratio). As the column, Kaseisorb LC ODS 2000 (manufactured by Tokyo Chemical Industry Co., Ltd.) or an ODS column having an equivalent performance was used. As the detector, a photo diode array detector (manufactured by Shimadzu Corp., trade name: SPD-M20A) was used.

(1) Phosphorescent compound

<1-1> Phosphorescent compound B1

As a phosphorescent compound B1, the following compound was purchased from Luminescence Technology Corp.

[Chemical Formula 87]

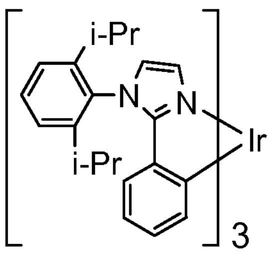

**phosphorescent compound B1**

<1-2> Phosphorescent compound B2

A phosphorescent compound B2 was synthesized according to the methods described in International Publication No. WO2006/121811 and Japanese Unexamined Patent Publication No. 2013-048190.

[Chemical Formula 88]

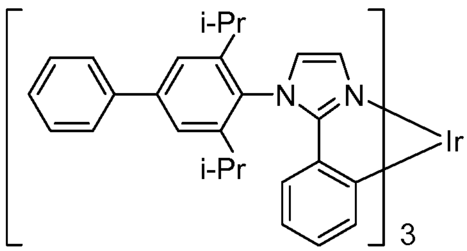

**phosphorescent compound B2**

<1-3> Phosphorescent compound B3

(B3-1) Synthesis of compound S1

[Chemical Formula 89]

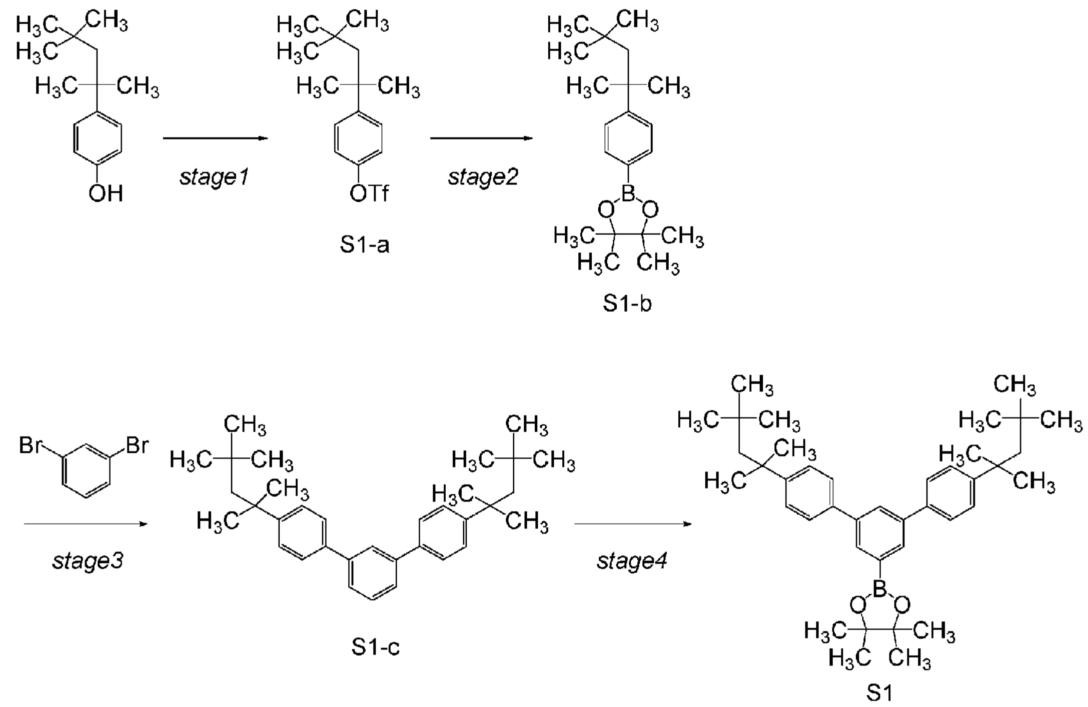


<Stage 1>

The atmosphere in a reaction vessel was turned into a nitrogen gas stream, then, 4-tert-octylphenol (250.00 g, manufactured by Aldrich), N,N-dimethyl-4-aminopyridine (177.64 g) and dichloromethane (3100 mL) were added, and this mixture was cooled down to 5°C with ice. Thereafter, trifluoromethanesulfonic anhydride (376.06 g) was dropped into this over a period of 45 minutes. After completion of dropping, the mixture was stirred for 30 minutes under ice cool, then, returned to room temperature and further stirred for 1.5 hours. To the resultant reaction mixture was added hexane (3100 mL), and this reaction mixture was filtrated using 410 g of silica gel, and further, the silica gel was washed with a mixed solvent (2.5 L) of hexane and dichloromethane (1/1 (by volume)). The resultant filtrate and the wash solution were concentrated, to obtain a compound S1-a (410.94 g) as a colorless oil. The HPLC purity of the resultant compound S1-a was 99.5 % or more.

<Stage 2>

The atmosphere in a reaction vessel was turned into a nitrogen gas stream, then, the compound S1-a (410.94 g), bis(pinacolato)diboron (338.47 g), potassium acetate (237.83 g), 1,4-dioxane (2600 mL), palladium acetate (4.08 g) and tricyclohexylphosphine (10.19 g) were added, and the mixture was refluxed for 2 hours. After cooling down to room temperature, the resultant reaction mixture was filtrated and the filtrate was collected, and further, the filtrated substance was washed with 1,4-dioxane (2.5 L), and the resultant filtrate and the wash solution were concentrated. The resultant residue was dissolved into a mixed solvent of hexane and dichloromethane (1/1 (by volume)), and the solution was filtrated using 770 g silica gel, and further, the silica gel was washed with a mixed solvent (2.5 L) of hexane and dichloromethane (1/1 (by volume)). The resultant filtrate and the wash solution were concentrated, and to the resultant residue was added methanol (1500 mL), and the mixture was ultrasonically cleaned for 30 minutes. Thereafter, this was filtrated to obtain a compound S1-b (274.27 g). The filtrate and the wash solution were concentrated, and methanol was added, and the mixture was ultrasonically cleaned and filtrated, and such an operation was repeated, to obtain a compound S1-b (14.29 g). The total yielded amount of the resultant compound S1-b was 288.56 g.

<Stage 3>

The atmosphere in a reaction vessel was turned into a nitrogen gas stream, then, 1,3-dibromobenzene (102.48

g), the compound S1-b (288.56 g), toluene (2100 mL), a 20 wt% tetraethyl ammonium hydroxide aqueous solution (962.38 g) and bis(triphenylphosphine)palladium(II) dichloride (3.04 g) were added, and the mixture was refluxed for 7 hours. After cooling down to room temperature, the aqueous layer and the organic layer were separated, and the organic layer was collected. To this aqueous layer was added toluene (1 L), and the organic layer was further extracted. The resultant organic layers were combined, and this mixture was washed with a mixed aqueous solution of distilled water and saturated saline (1.5 L/1.5 L). The resultant organic layer was filtrated through 400 g silica gel, and further, the silica gel was washed with toluene (2 L). The resultant solution was concentrated, and the resultant residue was dissolved in hexane. This solution was purified by silica gel column chromatography. Impurities were eluted with a developing solvent hexane, then, developed with a mixed solvent of hexane and dichloromethane (10/1 (by volume)). The each resultant fraction was concentrated under reduced pressure to remove the solvent, obtaining a colorless crystalline compound S1-c (154.08 g, HPLC purity: 99.1%) and a coarse compound S1-c (38.64 g, LC purity: 83%). This coarse compound S1-c was column-purified again under the same developing conditions, and the solvent was distilled off under reduced pressure, to obtain a compound S1-c (28.4 g, LC purity: 99.6%). The total yielded amount the resultant compound S1-c was 182.48 g.

<Stage 4>

The atmosphere in a reaction vessel was turned into a nitrogen gas stream, then, the compound S1-c (182.48 g), bis(pinacolato)diboron (112.09 g), 4,4'-di-tert-butyl-2,2'-dipyridyl (3.23 g), cyclohexane (2000 mL) and bis(1,5-cyclooctadiene)di-μ-methoxydiiridium(I) (3.99 g) were added, and the mixture was refluxed for 2 hours. After cooling with air down to room temperature, silica gel (220 g) was added over a period of 20 minutes while stirring the resultant reaction mixture. The resultant suspension was filtrated through 440 g of silica gel, and further, the silica gel was washed with dichloromethane (2 L), and the solution was concentrated. To the resultant residue were added methanol (1100 mL) and dichloromethane (110 mL), and the mixture was refluxed for 1 hour. After cooling down to room temperature, this was filtrated. The resultant filtrated substance was washed with methanol (500 mL), and the resultant solid was dried, to obtain a compound S1 (220.85 g).
$^1$H-NMR ($CDCl_3$, 300 MHz): δ (ppm) = 8.00 (s,2H), 7.92 (s,, 1H), 7.60 (d, J = 8.5Hz, 4H), 7.44 (d, J = 8.5Hz, 4H), 1.78 (s, 4H), 1.41 (s, 12H), 1.37 (s, 12H), 0.75 (s, 18H).

(B3-2) Synthesis of phosphorescent compound B3

[Chemical Formula 90]

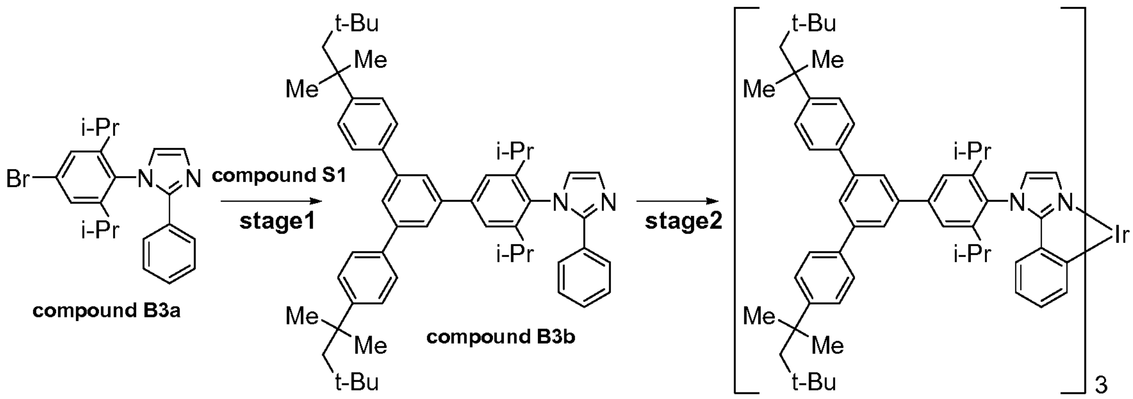


compound B3a

compound B3b

phosphorescent compound B3

<Stage 1>

The atmosphere in a reaction vessel was turned into an argon gas atmosphere, then, a compound B5a (9.9 g) synthesized according to U.S. Unexamined Patent Application Publication No. 2011/0057559, the compound S1 (15 g), 2-dicyclohexylphosphino-2',6'-dimethoxybiphenyl (0.11 g), tris(dibenzylideneacetone)dipalladium (0.12 g), a 20 wt% tetraethylammonium aqueous solution (20 mL), toluene (200 mL) and ethanol (50 mL) were added, and the mixture was stirred for 18 hours under reflux with heating. Thereafter, the mixture was cooled down to room temperature, and toluene was added and extraction was performed. The resultant organic layer was washed using ion-exchange water, then,

concentrated under reduced pressure, to obtain a solid. The resultant solid was purified by silica gel chromatography (a mixed solvent of ethyl acetate and hexane), and further, recrystallized using a mixed solvent of toluene and acetonitrile, then, dried under reduced pressure, to obtain a compound B3b (17 g, yield: 90%).

<Stage 2>

The atmosphere in a reaction vessel was turned into an argon gas atmosphere, then, the compound B3b (10 g), iridium chloride hydrate (2.2 g), 2-ethoxyethanol (120 mL) and water (40 mL) were added, and the mixture was stirred for 14 hours under reflux with heating. Thereafter, the mixture was cooled down to room temperature, and methanol was added, to find generation of a precipitate. The resultant precipitate was filtrated, and the resultant solid was washed with methanol, then, dried under reduced pressure, to obtain an intermediate B3 (10 g, yellow powder).

The atmosphere in a reaction vessel was turned into an argon gas atmosphere, then, the intermediate B3 (9.5 g), silver trifluoromethanesulfonate (31 g), dichloromethane (100 mL) and methanol (30 mL) were added, and the mixture was stirred overnight at room temperature. The deposited precipitate was filtrated, then, the resultant filtrate was concentrated under reduced pressure. Thereafter, to this were added the compound B3b (7.8 g), 2,6-lutidine (6.7 mL) and diethylene glycol dimethyl ether (180 mL), and the mixture was stirred overnight under reflux with heating. Thereafter, the mixture was cooled down to room temperature, and a mixed solvent of ion-exchange water and methanol was added, and the deposited precipitate was filtrated. The resultant solid was purified by silica gel chromatography (a mixed solvent of dichloromethane and hexane), and further, recrystallized using a mixed solvent of toluene and acetonitrile, then, dried under reduced pressure, to obtain a phosphorescent compound B3 (1.2 g, yield: 6.5%).

$^1$H-NMR (600 MHz, $(CD_3)_2CO$-$d_6$): δ (ppm) = 8.01-7.97 (m, 9H), 7.91 (d, 6H), 7.81 (d, 12H), 7.59 (d, 12H), 7.25 (s, 3H), 6.92-6.89 (m, 6H), 6.57 (t, 3H), 5.87-5.81 (m, 6H), 2.89-2.86 (m, 3H), 2.52-2.48 (m, 3H), 1.87 (s, 12H), 1.42 (s, 36H), 1.38 (d, 9H), 1.16 (d, 9H), 1.12 (d, 9H), 1.07 (d, 9H). 0.80 (54H).

(2) Crosslinkable polymer compound

<2-1> Synthesis of compound Ma3

[Chemical Formula 91]

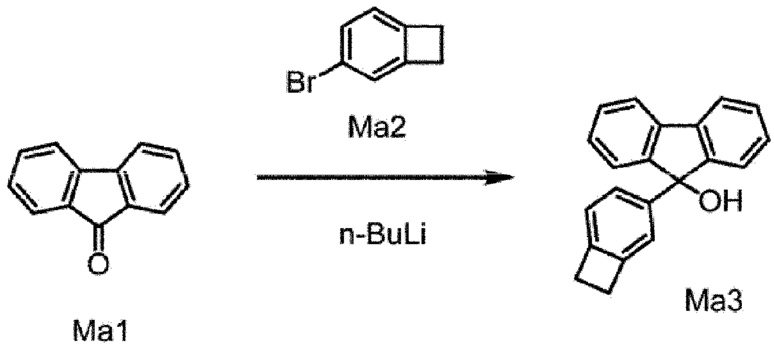


A gas in a flask equipped with a stirrer was purged with a nitrogen gas, then, a compound Ma2 (64.6 g) and tetrahydrofuran (615 mL) were added, and the mixture was cooled down to -70°C. Into this, a n-butyllithium hexane solution (1.6 M, 218 mL) was dropped over a period of 1 hour, then, the mixture was stirred at -70°C for 2 hours. To this, a compound Ma1 (42.1 g) was added in several batches, then, the mixture was stirred at -70°C for 2 hours. Into this, methanol (40 mL) was dropped over a period of 1 hour, then, the mixture was heated up to room temperature. Thereafter, the solvent was distilled off by concentrating under reduced pressure, and toluene and water were added. Thereafter, an aqueous layer was separated and the resultant organic layer was further washed with water. The resultant organic layer was concentrated under reduced pressure, and the resultant residue was purified by using a silica gel column (developing solvent: hexane/ethyl acetate), thereby obtaining 71 g of a compound Ma3 as a colorless oil. The resultant compound Ma3 had an HPLC area percentage value (UV: 254 nm) of 97.5%. This operation was repeated, thereby obtaining a necessary amount of the compound Ma3.

The $^1$H-NMR measurement result of the resultant compound Ma3 is shown below.
$^1$H-NMR ($CDCl_3$, 300 MHz): δ (ppm): 2.43 (1H, s), 3.07-3.13 (4H, m), 6.95 (1H, d),7.07 (1H. s), 7.18-7.28 (3H, m), 7.28-7.40 (4H, m), 7.66 (2H, s).

<2-2> Synthesis of compound Ma4

[Chemical Formula 92]

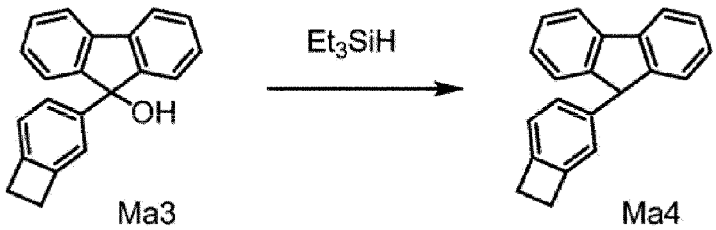


Ma3 Ma4

A gas in a flask equipped with a stirrer was purged with a nitrogen gas, then, the compound Ma3 (72.3 g), toluene (723 mL) and triethylsilane (118.0 g) were added, and the mixture was heated up to 70°C. Into this, methanesulfonic acid (97.7 g) was dropped over a period of 1.5 hours, then, the mixture was stirred at 70°C for 0.5 hours. Thereafter, the mixture was cooled down to room temperature, and toluene (1 L) and water (1 L) were added, then, an aqueous layer was separated. The resultant organic layer was washed with water, a 5 wt% sodium hydrogen carbonate aqueous solution and water in this order. The resultant organic layer was concentrated under reduced pressure, and the resultant coarse product was recrystallized from a mixed solvent of toluene and ethanol, thereby obtaining 51.8 g of a compound Ma4 as a white solid. The resultant compound Ma4 had an HPLC area percentage value (UV: 254 nm) of 99.5% or more. This operation was repeated, thereby obtaining a necessary amount of the compound Ma4.
The $^1$H-NMR measurement result of the resultant compound Ma4 is shown below. $^1$H-NMR ($CDCl_3$, 300 MHz): δ (ppm): 3.03-3.14 (4H, m), 4.99 (1H, s), 6.68 (1H, s), 6.92-7.01 (2H, m), 7.20-7.28 (2H, m), 7.29-7.38 (4H, m), 7.78 (2H, d).
<2-3> Synthesis of compound Mb3

[Chemical Formula 93]

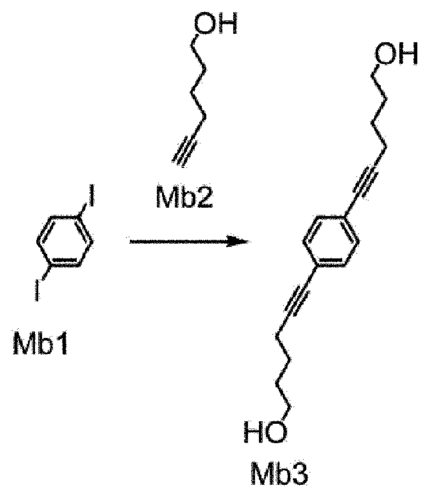

Mb2 Mb1 Mb3

A gas in a flask equipped with a stirrer was purged with a nitrogen gas, then, a compound Mb1 (185.0 g), a compound Mb2 (121.1 g), CuI (3.2 g), dichloromethane (185 mL) and triethylamine (2.59 L) were added, and the mixture was heated up to the reflux temperature. Thereafter, the mixture was stirred at the reflux temperature for 0.5 hours, and cooled down to room temperature. To this was added dichloromethane (1.85 L), then, the mixture was filtrated through a filter paved with celite. To the resultant filtrate was added a 10 wt% sodium hydrogen carbonate aqueous solution, then, an aqueous layer was separated. The resultant organic layer was washed with water twice, washed with a saturated NaCl aqueous solution, then, magnesium sulfate was added. The resultant mixture was filtrated, and the resultant filtrate

was concentrated under reduced pressure. The resultant residue was purified by using a silica gel column (developing solvent: chloroform/ethyl acetate), thereby obtaining a coarse product. The resultant coarse product was dissolved in ethanol (1.4 L), then, activated carbon (5 g) was added, and the mixture was filtrated. The resultant filtrate was concentrated under reduced pressure, and the resultant residue was recrystallized from hexane, thereby obtaining 99.0 g of a compound Mb3 as a white solid. The resultant compound Mb3 had an HPLC area percentage value (UV: 254 nm) of 99.5% or more. This operation was repeated, thereby obtaining a necessary amount of the compound Mb3.

The $^1$H-NMR measurement result of the resultant compound Mb3 is shown below.

$^1$H-NMR (DMSO-d6, 300 MHz): δ (ppm): 1.52-1.55 (8H, m), 2.42 (4H, t), 3.38-3.44 (4H, m), 4.39-4.43 (2H, m), 7.31 (4H, s).

<2-4> Synthesis of compound Mb4

[Chemical Formula 94]

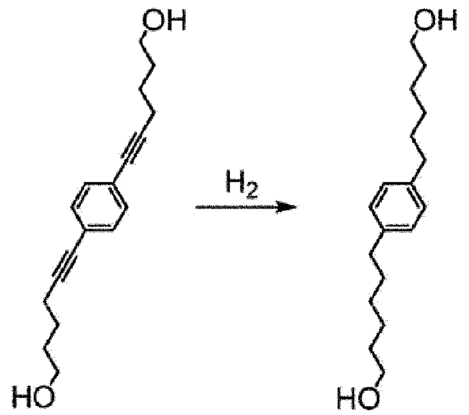


Mb3 Mb4

A gas in a flask equipped with a stirrer was purged with a nitrogen gas, then, the compound Mb3 (110.0 g), ethanol (1.65 L) and palladium/carbon (Pd weight: 10%) (11.0 g) were added, and the mixture was heated up to 30°C. Thereafter, a gas in the flask was purged with a hydrogen gas. Thereafter, the mixture was stirred at 30°C for 3 hours while feeding a hydrogen gas into the flask. Thereafter, a gas in the flask was purged with a nitrogen gas. The resultant mixture was filtrated, and the resultant filtrate was concentrated under reduced pressure. The resultant residue was purified by using a silica gel column (developing solvent: chloroform/ethyl acetate), thereby obtaining a coarse product. The resultant coarse product was recrystallized from hexane, thereby obtaining 93.4 g of a compound Mb4 as a white solid. The resultant compound Mb4 had an HPLC area percentage value (UV: 254 nm) of 98.3%.

The $^1$H-NMR and $^{13}$C-NMR measurement results of the resultant compound Mb4 are shown below.

$^1$H-NMR ($CDCl_3$, 300 MHz): δ (ppm): 1.30-1.40 (8H, m), 1.55-1.65 (8H, m), 2.58 (4H, t), 3.64 (4H, t), 7.09 (4H, s).

$^{13}$C-NMR ($CDCl_3$, 75 MHz): δ (ppm): 25.53, 28.99, 31.39, 32.62, 35.37, 62.90, 128.18, 139.85.

<2-5> Synthesis of compound Mb5

[Chemical Formula 95]

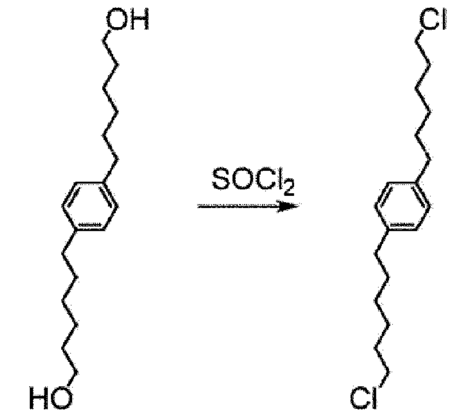


Mb4 Mb5

A gas in a flask equipped with a stirrer was purged with a nitrogen gas, then, the compound Mb4 (61.0 g), pyridine (0.9 g) and toluene (732 mL) were added, and the mixture was heated up to 60°C. Into this, thionyl chloride (91.4 g) was dropped over a period of 1.5 hours, then, the mixture was stirred at 60°C for 5 hours. The resultant mixture was cooled down to room temperature, then, concentrated under reduced pressure. The resultant residue was purified by using a silica gel column (developing solvent: hexane/ethyl acetate), thereby obtaining 64.3 g of a compound Mb5 as a colorless oil. The resultant compound Mb5 had an HPLC area percentage value (UV: 254 nm) of 97.2%.

The $^1$H-NMR measurement result of the resultant compound Mb5 is shown below.

$^1$H-NMR ($CDCl_3$, 300 MHz): δ (ppm): 1.35-1.40 (4H, m), 1.41-1.50 (4H, m), 1.60-1.68 (4H, m), 1.75-1.82 (4H, m), 2.60 (4H, t), 3.55 (4H, t), 7.11 (4H, s).

<2-6> Synthesis of compound Mb6

[Chemical Formula 96]

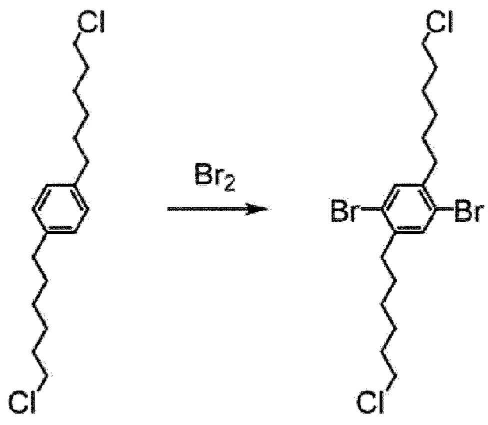


Mb5 Mb6

A gas in a flask equipped with a stirrer was purged with a nitrogen gas, then, the compound Mb5 (42.0 g), an iron powder (1.7 g), iodine (0.3 g) and dichloromethane (800 mL) were added. Thereafter, the whole flask was light-shielded, and cooled at 0 to 5°C. Into this, a mixed liquid of bromine (44.7 g) and dichloromethane (200 mL) was dropped over a period of 1 hour, then, the mixture was stirred at 0 to 5°C overnight. The resultant mixed liquid was added to water (1.2 L) cooled at 0 to 5°C, then, an organic layer was separated. The resultant organic layer was washed with a 10 wt% sodium thiosulfate aqueous solution, and further, washed with a saturated sodium chloride aqueous solution and water in this order. To the resultant organic layer was added sodium sulfate, then, the mixture was filtrated, and the resultant filtrate was concentrated under reduced pressure. The resultant residue was purified by using a silica gel

column (developing solvent; hexane), thereby obtaining a coarse product. The resultant coarse product was recrystallized from hexane, thereby obtaining 47.0 g of a compound Mb6 as a white solid. The resultant compound Mb6 had an HPLC area percentage value (UV: 254 nm) of 98.3%.

The $^{1}$H-NMR measurement result of the resultant compound Mb6 is shown below.
$^{1}$H-NMR ($CDCl_3$, 300 MHz): δ (ppm): 1.38-1.45 (4H, m), 1.47-1.55 (4H, m), 1.57-1.67 (4H, m), 1.77-1.84 (4H, m), 2.66 (4H, t), 3.55 (4H, t), 7.36 (2H, s).

<2-7> Synthesis of compound Mb7

[Chemical Formula 97]

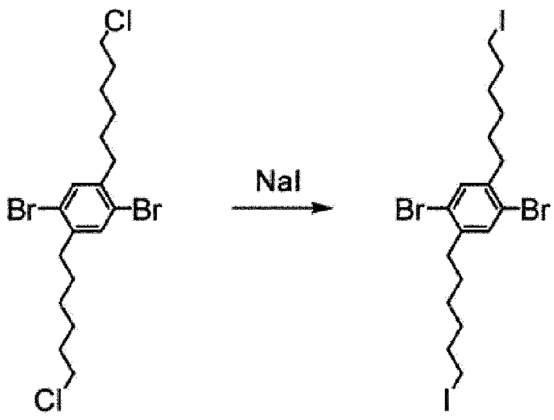


Mb6 Mb7

A gas in a flask equipped with a stirrer was purged with a nitrogen gas, then, sodium iodide (152.1 g) and acetone (600 mL) were added, and the mixture was stirred at room temperature for 0.5 hours. To this was added Mb6 (40.0 g), then, the mixture was heated up to the reflux temperature, and stirred at the reflux temperature for 24 hours. Thereafter, the mixture was cooled down to room temperature, and the resultant mixed liquid was added to water (1.2 L). The deposited solid was separated by filtration, then, washed with water, thereby obtaining a coarse product. The resultant coarse product was recrystallized from a mixed liquid of toluene and methanol, thereby obtaining 46.0 g of a compound Mb7 as a white solid. The resultant compound Mb7 had an HPLC area percentage value (UV: 254 nm) of 99.4%. This operation was repeated, thereby obtaining a necessary amount of the compound Mb7.

The $^{1}$H-NMR measurement result of the resultant compound Mb7 is shown below.
$^{1}$H-NMR ($CDCl_3$, 300 MHz): δ (ppm):1.35-1.50 (8H, m), 1.57-1.65 (4H, m), 1.80-1.89 (4H, m), 2.65 (4H, t), 3.20 (4H, t), 7.36 (2H, s).

<2-8> Synthesis of compound Mb8

[Chemical Formula 98]

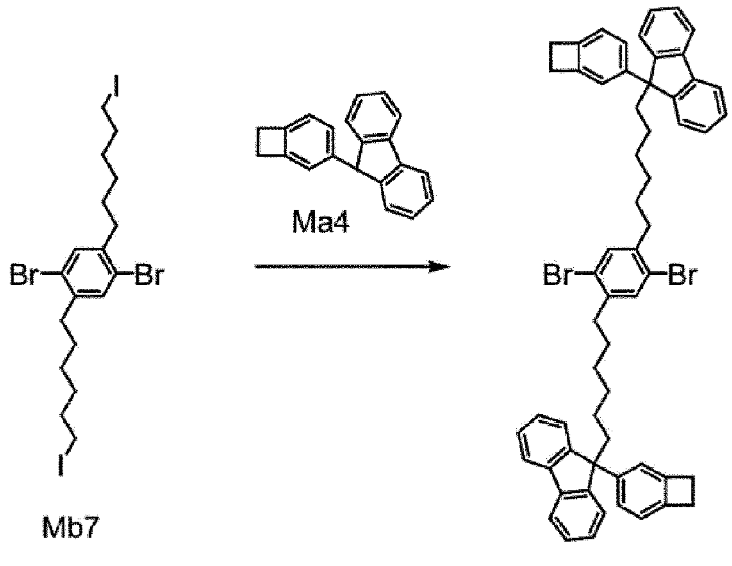

Mb8

A gas in a flask equipped with a stirrer was purged with a nitrogen gas, then, sodium hydride (60 wt%, dispersed in liquid paraffin) (9.4 g), tetrahydrofuran (110 mL) and the compound Mb7 (63.2 g) were added. To this, a compound Ma4 (55.0 g) was added in several batches, then, the mixture was stirred for 12 hours. To this were added toluene (440 mL) and water (220 mL), then, an aqueous layer was separated. The resultant organic layer was washed with water, then, magnesium sulfate was added. The resultant mixed liquid was filtrated, and the resultant filtrate was concentrated under reduced pressure, thereby obtaining a coarse product. The resultant coarse product was purified by using a silica gel column (developing solvent: hexane/toluene). Thereafter, the product was recrystallized from heptane, thereby obtaining 84.1 g of a compound Mb8 as a white solid. The resultant compound Mb8 had an HPLC area percentage value (UV: 254 nm) of 99.5% or more.

The $^1$H-NMR measurement result of the resultant compound Mb8 is shown below.

$^1$H-NMR ($CDCl_3$, 300 MHz): δ (ppm):0.70-0.76 (4H, m), 1.10-1.21 (8H, m), 1.32-1.44 (4H, m), 2.39-2.58 (8H, m), 3.00-3.12 (8H, m), 6.82-6.94 (4H, m), 7.00-7.05 (2H, m), 7.17-7.28 (10H, m), 7.30-7.38 (4H, m), 7.71-7.77 (4H, m).

<2-9> Synthesis of compound MM1

[Chemical Formula 99]

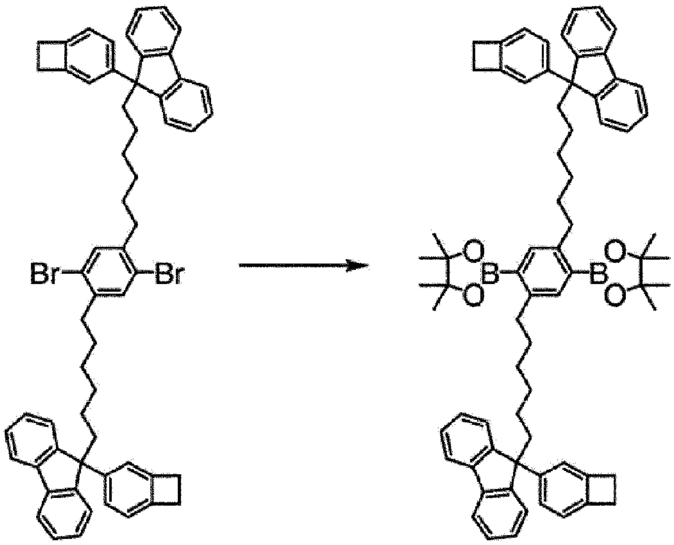

Mb8 MM1

A gas in a flask equipped with a stirrer was purged with a nitrogen gas, then, the compound Mb8 (84.0 g), [1,1'-bis(diphenylphosphino)ferrocene]palladium(II) dichloride dichloromethane adduct ($PdCl_2$(dppf)-$CH_2Cl_2$, 2.2 g), bispinacolatodiboron (68.3 g), potassium acetate (52.8 g) and cyclopentyl methyl ether (840 mL) were added, and the mixture was heated up to the reflux temperature, then, stirred at the reflux temperature for 5 hours. Thereafter, the mixture was cooled down to room temperature, and toluene (500 mL) and water (300 mL) were added, then, an aqueous layer was separated. The resultant organic layer was washed with water, then, activated carbon (18.5 g) was added. The resultant mixed liquid was filtrated, and the resultant filtrate was concentrated under reduced pressure, thereby obtaining a coarse product. The resultant coarse product was purified by using a silica gel column (developing solvent: hexane/toluene). Thereafter, an operation of recrystallizing from a mixed liquid of toluene and acetonitrile was repeated, thereby obtaining 45.8 g of a compound MM1 as a white solid. The resultant compound MM1 had an HPLC area percentage value (UV: 254 nm) of 99.4%.

The $^1$H-NMR measurement result of the resultant compound MM1 is shown below.
$^1$H-NMR ($CDCl_3$, 300 MHz): $\delta$ (ppm):0.70-0.76 (4H, m), 1.24-1.40 (36H, m), 2.39-2.48 (4H, m), 2.66-2.75 (4H, m), 3.00-3.10 (8H, m), 6.76-6.90 (4H, m), 7.00-7.05 (2H, m), 7.19-7.30 (8H, m), 7.30-7.36 (4H, m), 7.43 (2H, s), 7.72 (4H, d).

<2-10> Synthesis of a polymer compound P1

A polymer compound P1 was synthesized through the following steps 1 to 4.

[Chemical Formula 100]

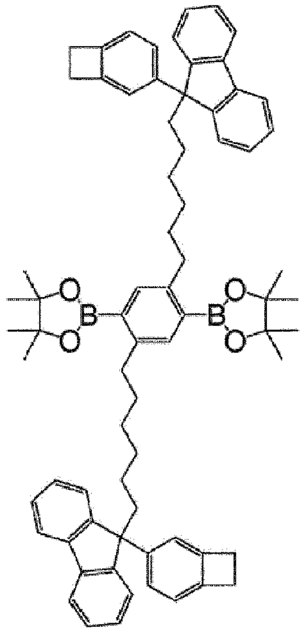

MM1

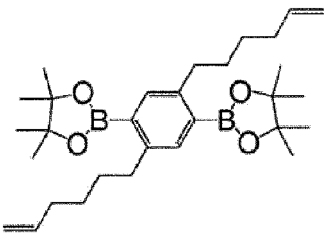

MM2

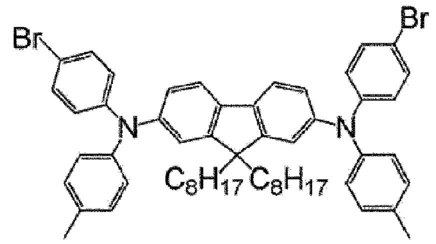

MM3

(Step 1) The atmosphere of a reaction vessel was turned into an inert gas atmosphere, and then, the compound MM1 (0.92303 g), the compound MM2 (0.04956 g) described in International Publication No. WO2013/146806, the compound MM3 (0.91722 g) described in International Publication No. WO2005/049546, dichlorobis(tris-o-methoxyphenylphophine)palladium (1.76 mg) and toluene (34 mL) were added and heated to 105°C.

(Step 2) A 20-wt% tetraethylammonium hydroxide aqueous solution (6.7 mL) was dropped into the reaction solution, and refluxed for 6 hours.

(Step 3) After the reaction, phenylboronic acid (48.8 mg) and dichlorobis(tris-o-methoxyphenylphophine)palladium (0.88 mg) were added thereto, and refluxed for 14.5 hours.

(Step 4) Thereafter, a sodium diethyldithiocarbamate aqueous solution was added thereto, and stirred at 80°C for 2 hours. After cooling down, the resultant reaction solution was washed two times with water, two times with a 3-wt% acetic acid aqueous solution, and two times with water, and the resultant solution was dropped into methanol to find generation of a precipitate. The resultant precipitate was dissolved in toluene and passed through an alumina column and a silica gel column in order, to purify the resultant solution. The resultant solution was dropped into methanol, and stirred, and then, the resultant precipitate was filtered and dried, to obtain 1.23 g of a polymer compound P1.

The polystyrene-equivalent number-average molecular weight of the polymer compound P1 was $2.3 \times 10^4$, and the polystyrene-equivalent weight-average molecular weight thereof was $1.2 \times 10^5$.

The polymer compound P1 is a copolymer constituted of a constitutional unit derived from the compound MM1, a constitutional unit derived from the compound MM2, and a constitutional unit derived from the compound MM3 in a molar ratio of 45 : 5 : 50 on the theoretical value determined from amounts of raw materials fed. For the polymer compound PI, the average number of the crosslinkable groups per 1000 in molecular weight as calculated by the method described above was 1.36.

<2-11> Synthesis of a polymer compound P2

A polymer compound P2 was synthesized by the following method.

[Chemical Formula 101]

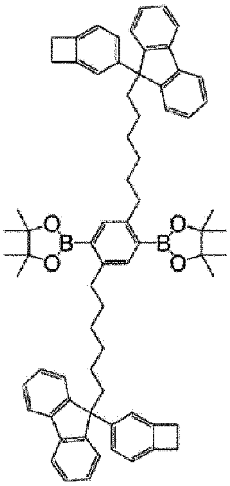

MM1

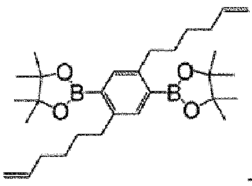

MM2

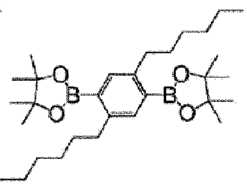

MM4

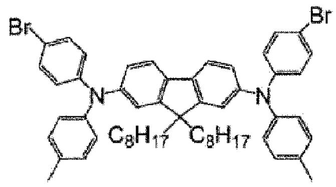

MM3

1.08 g of the polymer compound P2 was obtained by the same method as the synthesis of the polymer compound PI, except for altering (Step 1) in the synthesis of the polymer compound P1 to the following (Step 1-2).

(Step 1-2) The atmosphere of a reaction vessel was turned into an inert gas atmosphere, and then, the compound MM1 (0.51848 g), the compound MM2 (0.04955 g), the compound MMM4 (0.19480 g) described in Japanese Unexamined Patent Publication No. 2010-189630, the compound MM3 (0.91721 g), dichlorobis(tris-o-methoxyphenylphophine)palladium (1.76 mg) and toluene (30 mL) were added and heated to 105°C.

The polystyrene-equivalent number-average molecular weight of the polymer compound P2 was $2.5 \times 10^4$, and the polystyrene-equivalent weight-average molecular weight thereof was $3.0 \times 10^5$.

The polymer compound P2 is a copolymer constituted of a constitutional unit derived from the compound MM1, a constitutional unit derived from the compound MM2, a constitutional unit derived from the compound MM4, and a constitutional unit derived from the compound MM3 in a molar ratio of 25 : 5 : 20 : 50 on the theoretical value determined from amounts of raw materials fed. For the polymer compound P2, the average number of the crosslinkable groups per 1000 in molecular weight as calculated by the method described above was 0.95.

<2-12> Synthesis of a polymer compound P3

A polymer compound P3 was synthesized by the following method.

[Chemical Formula 102]

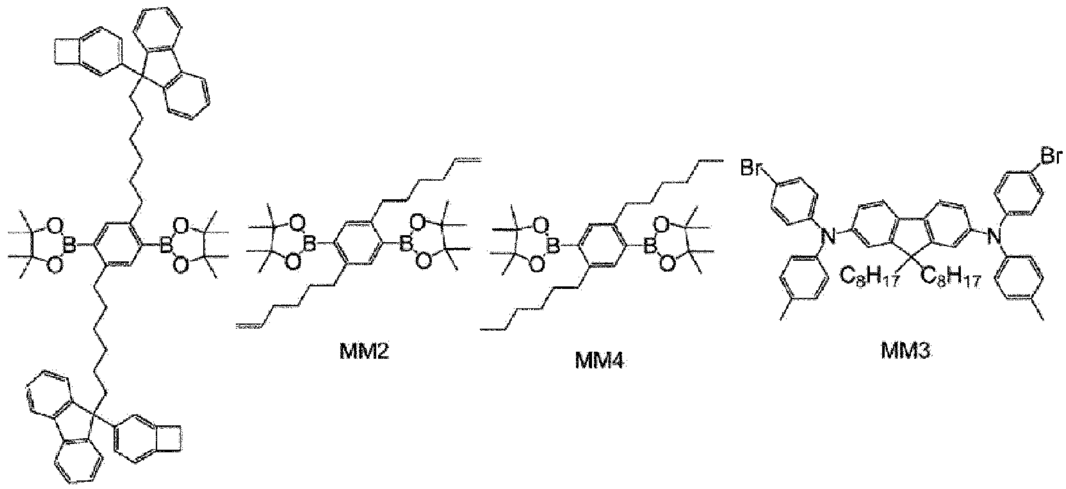

MM2 MM4 MM3

MM1

0.92 g of the polymer compound P3 was obtained by the same method as the synthesis of the polymer compound PI, except for altering (Step 1) in the synthesis of the polymer compound P1 to the following (Step 1-3).

(Step 1-3) The atmosphere of a reaction vessel was turned into an inert gas atmosphere, and then, the compound MM1 (0.31115 g), the compound MM2 (0.04959 g), the compound MM4 (0.29465 g), the compound MM3 (0.91719 g), dichlorobis(tris-o-methoxyphenylphophine)palladium (1.76 mg) and toluene (30 mL) were added and heated to 105°C.

The polystyrene-equivalent number-average molecular weight of the polymer compound P3 was $2.5 \times 10^4$, and the polystyrene-equivalent weight-average molecular weight thereof was $1.3 \times 10^5$.

The polymer compound P3 is a copolymer constituted of a constitutional unit derived from the compound MM1, a constitutional unit derived from the compound MM2, a constitutional unit derived from the compound MM4, and a constitutional unit derived from the compound MM3 in a molar ratio of 15 : 5 : 30 : 50 on the theoretical value determined from amounts of raw materials fed. For the polymer compound P3, the average number of the crosslinkable groups per 1000 in molecular weight as calculated by the method described above was 0.69.

<2-13> Synthesis of a polymer compound P4

A polymer compound P4 was synthesized by the following method.

[Chemical Formula 103]

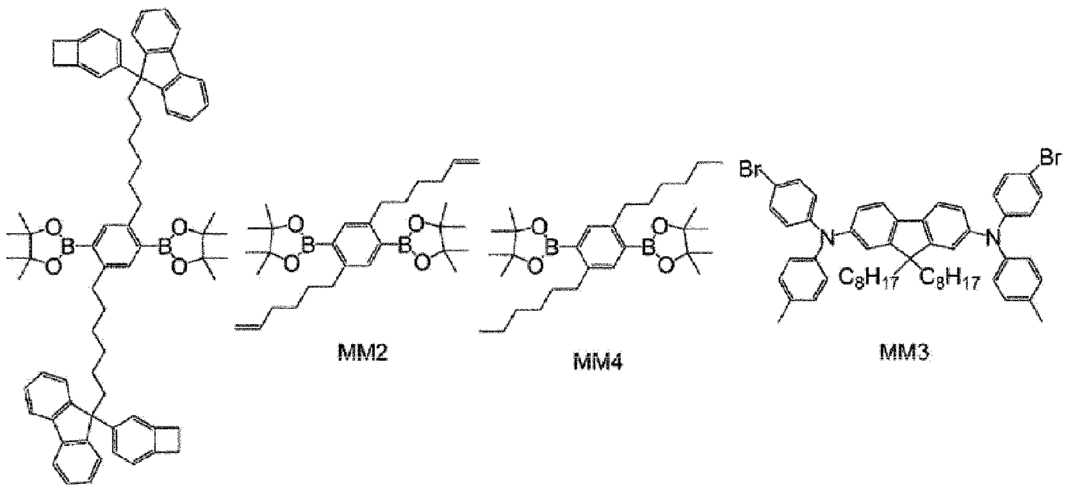

MM2 MM4 MM3

MM1

1.05 g of the polymer compound P4 was obtained by the same method as the synthesis of the polymer compound PI, except for altering (Step 1) in the synthesis of the polymer compound P1 to the following (Step 1-4), (Step 2) to the following (Step 2-2), and (Step 3) to the following (Step 3-2).
(Step 1-4) The atmosphere of a reaction vessel was turned into an inert gas atmosphere, and then, the compound MM1 (0.12976 g), the compound MM2 (0.06195 g), the compound MM4 (0.49334 g), the compound MM3 (1.14646 g), dichlorobis(tris-o-methoxyphenylphophine)palladium (2.20 mg) and toluene (30 mL) were added and heated to 105°C.
(Step 2-2) A 20-wt% tetraethylammonium hydroxide aqueous solution (8.3 mL) was dropped into the reaction solution, and refluxed for 6 hours.
(Step 3-2) After the reaction, phenylboronic acid (61.0 mg) and dichlorobis(triphenylphophine)palladium (1.1 mg) were added and refluxed for 14.5 hours.
The polystyrene-equivalent number-average molecular weight of the polymer compound P4 was $2.4 \times 10^4$, and the polystyrene-equivalent weight-average molecular weight thereof was $1.8 \times 10^5$.
The polymer compound P4 is a copolymer constituted of a constitutional unit derived from the compound MM1, a constitutional unit derived from the compound MM2, a constitutional unit derived from the compound MM4, and a constitutional unit derived from the compound MM3 in a molar ratio of 5 : 5 : 40 : 50 on the theoretical value determined from amounts of raw materials fed. For the polymer compound P4, the average number of the crosslinkable groups per 1000 in molecular weight as calculated by the method described above was 0.38.

(3) Other polymer compounds

<3-1> Synthesis of a polymer compound P5

A polymer compound P5 was synthesized by the following method.

[Chemical Formula 104]

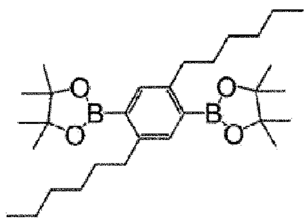
MM4

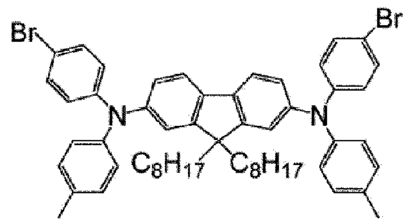
MM3

3.00 g of the polymer compound P5 was obtained by the same method as the synthesis of the polymer compound PI, except for altering (Step 1) in the synthesis of the polymer compound P1 to the following (Step 1-5), (Step 2) to the following (Step 2-3), and (Step 3) to the following (Step 3-3).
(Step 1-5) The atmosphere of a reaction vessel was turned into an inert gas atmosphere, and then, the compound MM4 (1.74 g), the compound MM3 (3.19 g), dichlorobis(triphenylphophine)palladium (2.5 mg) and toluene (40 mL) were added and heated to 80°C.
(Step 2-3) A 20-wt% tetraethylammonium hydroxide aqueous solution (12 mL) was dropped into the reaction solution, and refluxed for 8 hours.
(Step 3-3) After the reaction, phenylboronic acid (0.427 g) and dichlorobis(triphenylphophine)palladium (2.5 mg) were added and refluxed for 17 hours.
The polystyrene-equivalent number-average molecular weight of the polymer compound P5 was $4.5 \times 10^4$, and the polystyrene-equivalent weight-average molecular weight thereof was $1.5 \times 10^5$.
The polymer compound P5 is a copolymer constituted of a constitutional unit derived from the compound MM4 and a constitutional unit derived from the compound MM3 in a molar ratio of 50 : 50 on the theoretical value determined from amounts of raw materials fed. For the polymer compound P5, the average number of the crosslinkable groups per 1000 in molecular weight as calculated by the method described above was 0.

<3-2> Synthesis of a polymer compound E1

A polymer compound E1 was synthesized by the following method.

[Chemical Formula 105]

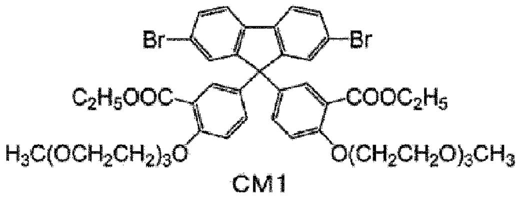
CM1

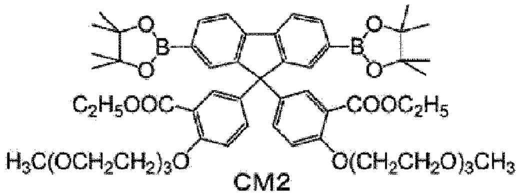
CM2

(Step 1) The atmosphere of a reaction vessel was turned into an inert gas atmosphere, and then, the compound CM1 (0.55 g) synthesized according to the method described in Japanese Unexamined Patent Publication No. 2012-33845, the compound CM2 (0.61 g) synthesized according to the method described in Japanese Unexamined Patent Publication No. 2012-33845, triphenylphophinepalladium (0.01 g), methyltrioctylammonium chloride (manufactured by Sigma-Aldrich Corp., trade name: Aliquat 336(R))(0.20 g) and toluene (10 mL) were added and heated to 105°C.

(Step 2) A 2M sodium carbonate aqueous solution (6 mL) was dropped into the reaction solution, and refluxed for 8 hours.

(Step 3) Thereafter, 4-ter-butylphenylboronic acid (0.01 g) was added thereto, and refluxed for 6 hours.

(Step 4) Thereafter, a sodium diethyldithiocarbamate aqueous solution (10 mL, concentration: 0.05 g/mL) was added thereto, and stirred for 2 hours. The resultant reaction solution was dropped into methanol (300 mL) and stirred for 1 hour. Thereafter, the deposited precipitate was filtrated, dried under reduced pressure for 2 hours, and dissolved in tetrahydrofuran (20 mL). The resultant solution was dropped into a mixed solvent of methanol (120 mL) and a 3-wt% acetic acid aqueous solution (50 mL), and stirred for 1 hour. Thereafter, the deposited precipitate was filtrated and dissolved in tetrahydrofuran (20 mL).

(Step 5) The resultant solution was dropped into methanol (200 mL) and stirred for 30 min. Thereafter, the deposited precipitate was filtrated. The resultant solid was dissolved in tetrahydrofuran, and thereafter, the resultant solution was passed through an alumina column and a silica gel column in order, to be purified. The resultant solution was dropped into methanol and stirred, and thereafter, the deposited precipitate was filtrated. The resultant solid was dried, to obtain 520 mg of a polymer compound E1.

The polystyrene-equivalent number-average molecular weight of the polymer compound E1 was $5.2 \times 10^4$, and the polystyrene-equivalent weight-average molecular weight thereof was $1.5 \times 10^5$.

The polymer compound E1 is a copolymer constituted of a constitutional unit derived from the compound CM1, and a constitutional unit derived from the compound CM2 in a molar ratio of 50 : 50 on the theoretical value determined from amounts of raw materials fed. Here, the structural units having the same structure were derived from the compound CM1 and the compound CM2.

<3-3> Synthesis of a polymer compound E2

The polymer compound E1 (200 mg) was added to a reaction vessel, and thereafter, the atmosphere of the reaction vessel was turned into a nitrogen gas atmosphere. Then, tetrahydrofuran (20 mL) and ethanol (20 mL) were added thereto, and heated to 55°C. Thereafter, a cesium hydroxide aqueous solution obtained by dissolving cesium hydroxide (200 mg) in water (2 mL) was added thereto, and stirred at 55°C for 6 hours. The resultant reaction mixture was cooled to room temperature, and thereafter, the solvent was distilled off under reduced pressure. The resultant solid was washed with water, and thereafter dried under reduced pressure, to obtain a polymer compound E2 (150 mg). It was confirmed by $^1$H-NMR analysis of the polymer compound E2 that the signal of ethyl ester sites in the polymer compound E2 disappeared and the reaction completed.

The polymer compound E2 is theoretically a copolymer consisting of a constitutional unit represented by the following.

[Chemical Formula 106]

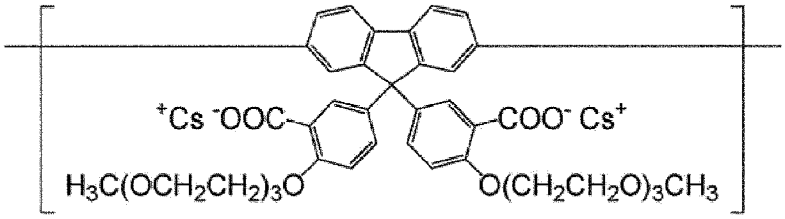

[Example 1] Fabrication and evaluation of a light-emitting device 1

(Formation of an anode and a hole injection layer)

An ITO film was deposited with a thickness of 45 nm on a glass substrate by a sputtering method, to form an anode. A film of a polythiophene·sulfonic acid-based hole injection agent, AQ-1200 (manufactured by Plextronics, Inc.), was formed with a thickness of 35 nm on the anode, and heated in the air atmosphere on a hot plate at 170°C for 15 min, to form a hole injection layer.

(Formation of a hole transporting layer)

The polymer compound P1 was dissolved in a concentration of 0.7% by weight in xylene. By using the resultant xylene solution, a film was formed with a thickness of 20 nm on the hole injection layer by a spin coat method, and heated in a nitrogen gas atmosphere on a hot plate at 180°C for 60 min, to form a hole transporting layer.

(Formation of a light emitting layer)

2,8-Di(9H-carbazol-9-yl)dibenzo[b,d]thiophene (DCzDBT)(manufactured by Luminescence Technology Corp.) and the phosphorescent compound B1 (DCzDBT/phosphorescent compound B1 = 70 wt%/30 wt%) were dissolved in a concentration of 2.0% by weight in toluene. By using the resultant toluene solution, a film was formed with a thickness of 60 nm on the hole transporting layer by a spin coat method, and heated in a nitrogen atmosphere at 130°C for 10 min, to form a light emitting layer.

[Chemical Formula 107]

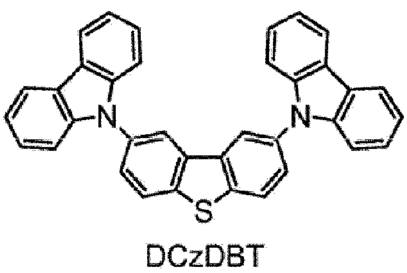

DCzDBT

(Formation of an electron transporting layer)

The polymer compound E2 was dissolved in a concentration of 0.25% by weight in 2,2,3,3,4,4,5,5-octafluoro-1-pentanol. By using the resultant 2,2,3,3,4,4,5,5-octafluoro-1-pentanol solution, a film was formed with a thickness of 10 nm on the light emitting layer by a spin coat method, and heated in a nitrogen gas atmosphere at 130°C for 10 min, to form an electron transporting layer.

(Formation of a cathode)

The substrate having the electron transporting layer formed thereon was put in a vapor deposition machine whose pressure was then reduced to $1.0 \times 10^{-4}$ Pa or less, and thereafter, as a cathode, sodium fluoride was vapor

deposited in about 4 nm on the light emitting layer, and then, aluminum was vapor deposited in about 80 nm on the sodium fluoride layer. After the vapor deposition, the resultant was encapsulated with a glass substrate, to fabricate a light-emitting device 1.

(Evaluation of the light-emitting device)

Electroluminescence was observed by applying a voltage to the light-emitting device 1. When the drive voltage was 3.4 [V], the highest external quantum efficiency was 2.3%, and the chromaticity coordinates (x, y) were (0.18, 0.38).

[Example 2] Fabrication and evaluation of a light-emitting device 2

(Fabrication of a light-emitting device)

A light-emitting device 2 was fabricated as in Example 1, except for using the polymer compound P2 in place of the polymer compound P1.

(Evaluation of the light-emitting device)

Electroluminescence was observed by applying a voltage to the light-emitting device 2. When the drive voltage was 3.4 [V], the highest external quantum efficiency was 2.3%, and the chromaticity coordinates (x, y) were (0.19, 0.38).

[Example 3] Fabrication and evaluation of a light-emitting device 3

(Fabrication of a light-emitting device)

A light-emitting device 3 was fabricated as in Example 1, except for using the polymer compound P3 in place of the polymer compound P1.

(Evaluation of the light-emitting device)

Electroluminescence was observed by applying a voltage to the light-emitting device 3. When the drive voltage was 3.4 [V], the highest external quantum efficiency was 1.9%, and the chromaticity coordinates (x, y) were (0.19, 0.38).

[Comparative Example 1] Fabrication and evaluation of a light-emitting device C1

(Fabrication of a light-emitting device)

A light-emitting device C1 was fabricated as in Example 1, except for using the polymer compound P4 in place of the polymer compound P1.

(Evaluation of the light-emitting device)

Electroluminescence was observed by applying a voltage to the light-emitting device C1. When the drive voltage was 4.8 [V], the highest external quantum efficiency was 1.6%, and the chromaticity coordinates (x, y) were (0.20, 0.39).

The results of Examples 1 to 3 and Comparative Example 1 are shown in Table 3.

[Table 3]

| | Light-emitting device | Hole transporting layer | | Light emitting layer | External quantum efficiency (%) |
|---|---|---|---|---|---|
| | | Crosslinkable polymer compound | Average number of crosslinkable groups | | |
| Example 1 | Light-emitting device 1 | Polymer compound P1 | 1.36 | DCzDBT/ phosphorescent compound B1 (mass ratio: 70/30) | 2.3 |
| Example 2 | Light-emitting device 2 | Polymer compound P2 | 0.95 | | 2.3 |
| Example 3 | Light-emitting device 3 | Polymer compound P3 | 0.69 | | 1.9 |
| Comparative Example 1 | Light-emitting device C1 | Polymer compound P4 | 0.38 | | 1.6 |

[Example 4] Fabrication and evaluation of a light-emitting device 4

(Fabrication of a light-emitting device)

A light-emitting device 4 was fabricated as in Example 1, except for using the phosphorescent compound B2 in place of the phosphorescent compound B1.

(Evaluation of the light-emitting device)

Electroluminescence was observed by applying a voltage to the light-emitting device 4. When the drive voltage was 5.6 [V], the highest external quantum efficiency was 3.8%, and the chromaticity coordinates (x, y) were (0.18, 0.40).

[Example 5] Fabrication and evaluation of a light-emitting device 5

(Fabrication of a light-emitting device)

A light-emitting device 5 was fabricated as in Example 1, except for using the polymer compound P2 in place of the polymer compound P1 and using the phosphorescent compound B2 in place of the phosphorescent compound B1.

(Evaluation of the light-emitting device)

Electroluminescence was observed by applying a voltage to the light-emitting device 5. When the drive voltage was 5.8 [V], the highest external quantum efficiency was 3.2%, and the chromaticity coordinates (x, y) were (0.18, 0.40).

[Example 6] Fabrication and evaluation of a light-emitting device 6

(Fabrication of a light-emitting device)

A light-emitting device 6 was fabricated as in Example 1, except for using the polymer compound P3 in place of the polymer compound P1 and using the phosphorescent compound B2 in place of the phosphorescent compound B1.

(Evaluation of the light-emitting device)

Electroluminescence was observed by applying a voltage to the light-emitting device 6. When the drive voltage was 6.4 V, the highest external quantum efficiency was 2.2%, and the chromaticity coordinates (x, y) were (0.19, 0.40).

[Comparative Example 2] Fabrication and evaluation of a light-emitting device C2

(Fabrication of a light-emitting device)

A light-emitting device C2 was fabricated as in Example 1, except for using the polymer compound P4 in place of the polymer compound P1 and using the phosphorescent compound B2 in place of the phosphorescent compound B1.

(Evaluation of the light-emitting device)

Electroluminescence was observed by applying a voltage to the light-emitting device C2. When the drive voltage was 6.6 [V], the highest external quantum efficiency was 1.8%, and the chromaticity coordinates (x, y) were (0.19, 0.40).

[Table 4]

| | Light-emitting device | Hole transporting layer | | Light emitting layer | External quantum efficiency (%) |
|---|---|---|---|---|---|
| | | Crosslinkable polymer compound | Average number of crosslinkable groups | | |
| Example 4 | Light-emitting device 4 | Polymer compound P1 | 1.36 | DCzDBT/ phosphorescent compound B2 (mass ratio: 70/30) | 3.8 |
| Example 5 | Light-emitting device 5 | Polymer compound P2 | 0.95 | | 3.2 |
| Example 6 | Light-emitting device 6 | Polymer compound P3 | 0.69 | | 2.2 |
| Comparative Example 2 | Light-emitting device C2 | Polymer compound P4 | 0.38 | | 1.8 |

[Example 7] Fabrication and evaluation of a light-emitting device 7

(Fabrication of a light-emitting device)

A light-emitting device 7 was fabricated as in Example 1, except for using the phosphorescent compound B3 in place of the phosphorescent compound B1.

(Evaluation of the light-emitting device)

Electroluminescence was observed by applying a voltage to the light-emitting device 7. When the drive voltage was 3.2 [V], the highest external quantum efficiency was 13.0%, and the chromaticity coordinates (x, y) were (0.18, 0.40).

[Example 8] Fabrication and evaluation of a light-emitting device 8

(Fabrication of a light-emitting device)

A light-emitting device 8 was fabricated as in Example 1, except for using the polymer compound P2 in place of the polymer compound P1 and using the phosphorescent compound B3 in place of the phosphorescent compound B1.

(Evaluation of the light-emitting device)

Electroluminescence was observed by applying a voltage to the light-emitting device 8. When the drive voltage was 3.2 [V], the highest external quantum efficiency was 10.4%, and the chromaticity coordinates (x, y) were (0.18, 0.41).

[Example 9] Fabrication and evaluation of a light-emitting device 9

(Fabrication of a light-emitting device)

A light-emitting device 9 was fabricated as in Example 1, except for using the polymer compound P3 in place of the polymer compound P1 and using the phosphorescent compound B3 in place of the phosphorescent compound B1.

(Evaluation of the light-emitting device)

Electroluminescence was observed by applying a voltage to the light-emitting device 9. When the drive voltage was 3.2 [V], the highest external quantum efficiency was 6.9%, and the chromaticity coordinates (x, y) were (0.19, 0.41).

[Comparative Example 3] Fabrication and evaluation of a light-emitting device C3

(Fabrication of a light-emitting device)

A light-emitting device C3 was fabricated as in Example 1, except for using the polymer compound P4 in place of the polymer compound P1 and using the phosphorescent compound B3 in place of the phosphorescent compound B1.

(Evaluation of the light-emitting device)

Electroluminescence was observed by applying a voltage to the light-emitting device C3. When the drive voltage was 3.2 [V], the highest external quantum efficiency was 5.1%, and the chromaticity coordinates (x, y) were (0.19, 0.40).

[Comparative Example 4] Fabrication and evaluation of a light-emitting device C4

(Fabrication of a light-emitting device)

A light-emitting device C4 was fabricated as in Example 1, except for using the polymer compound P4 and the polymer compound P5 (polymer compound P4/polymer compound P5 = 50 wt%/50 wt%) in place of the polymer compound P1 and using the phosphorescent compound B3 in place of the phosphorescent compound B1.

(Evaluation of the light-emitting device)

Electroluminescence was observed by applying a voltage to the light-emitting device C4. When the drive voltage was 3.2 [V], the highest external quantum efficiency was 5.3%, and the chromaticity coordinates (x, y) were (0.19, 0.41).

[Table 5]

| | Light-emitting device | Hole transporting layer | | Light emitting layer | External quantum efficiency (%) |
|---|---|---|---|---|---|
| | | Crosslinkable polymer compound | Average number of crosslinkable groups | | |
| Example 7 | Light-emitting device 4 | Polymer compound P1 | 1.36 | DCzDBT/phosphorescent compound B3 (mass ratio: 70/30) | 13.0 |
| Example 8 | Light-emitting device 5 | Polymer compound P2 | 0.95 | | 10.4 |
| Example 9 | Light-emitting device 6 | Polymer compound P3 | 0.69 | | 6.9 |
| Comparative Example 3 | Light-emitting device C3 | Polymer compound P4 | 0.38 | | 5.1 |
| Comparative Example 4 | Light-emitting device C4 | Polymer compound P4/polymer compound P5 (weight ratio: 50/50) | 0.19 | | 5.3 |

**Industrial Applicability**

According to the present invention, a light-emitting device excellent in the external quantum efficiency is provided. The light-emitting device according to the present invention can suitably be utilized for planar light sources, displays and the like, and is excellent in the industrial applicability.

**Claims**

**1.** A light-emitting device, comprising:

an anode;
a cathode;
a first organic layer disposed between the anode and the cathode; and
a second organic layer disposed between the anode and the first organic layer and adjacent to the first organic layer,
wherein the first organic layer comprises a phosphorescent compound represented by the formula (1);
the second organic layer comprises a cured polymer product formed from a polymer composition in which one or two or more polymer compounds including a crosslinkable polymer compound having at least one crosslinkable group selected from Group A of crosslinkable groups are compounded; and
with respect to each monomer unit constituting the polymer compounds, a value x obtained by multiplying a molar ratio C of the each monomer unit to a total mol of all the monomer units by a molecular weight M of the each monomer unit, and a value y obtained by multiplying the molar ratio C by a number n of the crosslinkable groups in the each monomer unit are determined, a value of $(Y_1 \times 1000)/X_1$, calculated from $X_1$ being the total of the values x and $Y_1$ being the total of the values y, being 0.5 or more: [Chemical Formula 1]

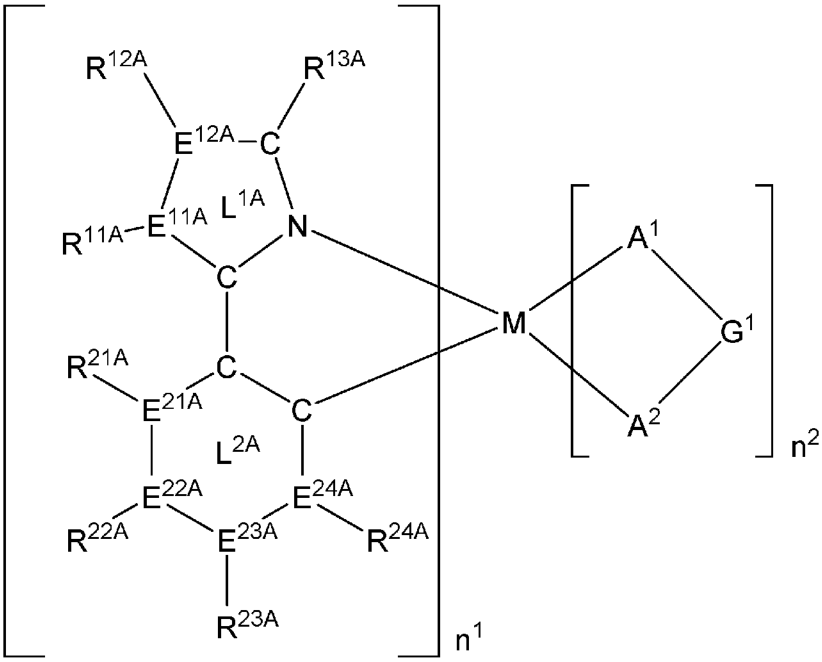

**(1)**

wherein,

M represents a ruthenium atom, a rhodium atom, a palladium atom, an iridium atom or a platinum atom; $n^1$ represents an integer of 1 to 3, $n^2$ represents an integer of 0 to 2, and $n^1 + n^2$ is 2 or 3; and $n^1 + n^2$ is 3 when M is a ruthenium atom, a rhodium atom or an iridium atom, while $n^1 + n^2$ is 2 when M is a palladium atom or a platinum atom;

$E^{11A}$, $E^{12A}$, $E^{21A}$, $E^{22A}$, $E^{23A}$ and $E^{24A}$ each independently represent a nitrogen atom or a carbon atom; when a plurality of $E^{11A}$, $E^{12A}$, $E^{21A}$, $E^{22A}$, $E^{23A}$ and $E^{24A}$ are present, they may be the same or different at each occurrence, provided that one of $E^{11A}$ and $E^{12A}$ is a carbon atom and the other is a nitrogen atom; and when $E^{21A}$, $E^{22A}$, $E^{23A}$ and $E^{24A}$ are nitrogen atoms, $R^{21A}$, $R^{22A}$, $R^{23A}$ and $R^{24A}$ are not present;

$R^{11A}$, $R^{12A}$, $R^{13A}$, $R^{21A}$, $R^{22A}$, $R^{23A}$ and $R^{24A}$ each independently represent a hydrogen atom, an alkyl group, a cycloalkyl group, an alkoxy group, a cycloalkoxy group, an aryl group, an aryloxy group, a monovalent heterocyclic group, a substituted amino group or a halogen atom, and these groups each optionally have a substituent; when a plurality of $R^{11A}$, $R^{12A}$, $R^{13A}$ $R2^{1A}$ $R^{22A}$, $R^{23A}$ and $R^{24A}$ are present, they may be the same or different at each occurrence; and $R^{11A}$ and $R^{12A}$, $R^{12A}$ and $R^{13A}$ , $R^{11A}$ and $R^{21A}$ , $R^{21A}$ and $R^{22A}$ , $R^{22A}$ and $R^{23A}$ , and $R^{23A}$ and $R^{24A}$ each may be combined together to form a ring together with the atoms to which they are attached;

a ring $L^{1A}$ represents an imidazole ring constituted of a nitrogen atom, two carbon atoms, $E^{11A}$ and $E^{12A}$;

a ring $L^{2A}$ represents a benzene ring, a pyridine ring or a pyrimidine ring constituted of two carbon atoms, $E^{21A}$, $E^{22A}$, $E^{23A}$ and $E^{24A}$; and

$A^1$-$G^1$-$A^2$ represents an anionic bidentate ligand; $A^1$ and $A^2$ each independently represent a carbon atom, an oxygen atom or a nitrogen atom, and these atoms may be atoms constituting a ring; $G^1$ represents a single bond, or an atomic group constituting the bidentate ligand together with $A^1$ and $A^2$; and when a plurality of $A^1$-$G^1$-$A^2$ are present, they may be the same or different at each occurrence

(Group A of crosslinkable groups)

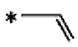

(XL-1)

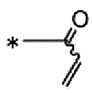

(XL-2)

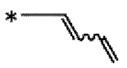

(XL-3)

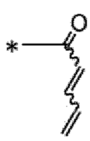

(XL-4)

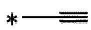

(XL-5)

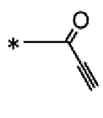

(XL-6)

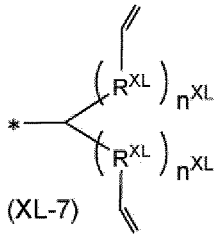
(XL-7)

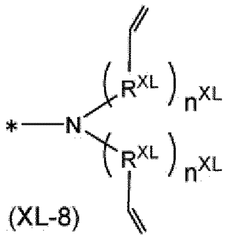
(XL-8)

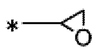
(XL-9)

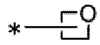
(XL-10)

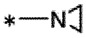
(XL-11)

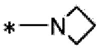
(XL-12)

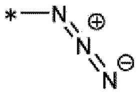
(XL-13)

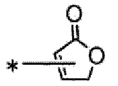
(XL-14)

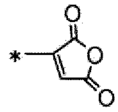
(XL-15)

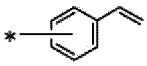
(XL-16)

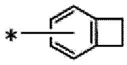
(XL-17)

wherein $R^{XL}$ represents a methylene group, an oxygen atom or a sulfur atom, and $n^{XL}$ represents an integer of 0 to 5; when a plurality of $R^{XL}$ are present, they may be the same or different; and when a plurality of $n^{XL}$ are present, they may be the same or different; * represents a bonding position; and these crosslinkable groups each optionally have a substituent;
wherein the light emitting device is not a light emitting device prepared by any of the following methods (a) to (k):

(a) An ITO film with a thickness of 45 nm was attached to a glass substrate by a sputtering method, to form an anode; on the anode, a polythiophene-sulfonic acid type hole injection material AQ-1200 (manufactured by Plectronics) was spin-coated to form a film with a thickness of 35 nm, and the film was heated on a hot plate at 170°C for 15 minutes under an air atmosphere, to form a hole injection layer;

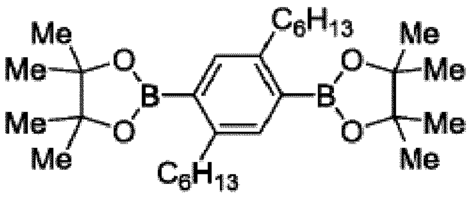
Compound CM1

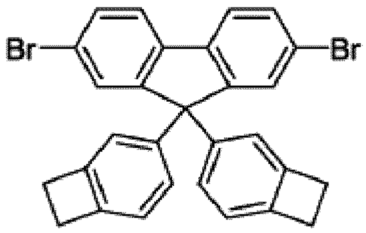
Compound CM2

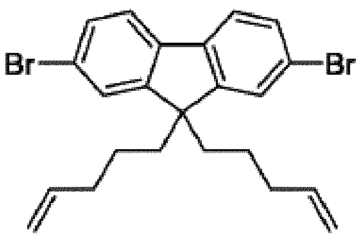
Compound CM3

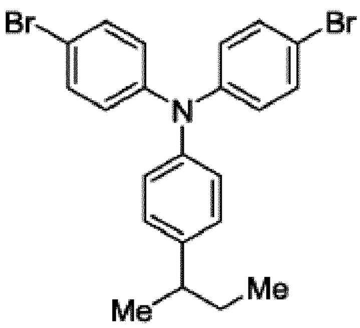
Compound CM4

A polymer compound HTL-1 was dissolved at a concentration of 0.7 wt% in xylene, wherein HTL-1 is a copolymer constituted of constitutional units derived from the monomer compounds CM1, CM2, CM3 and CM4 at a molar ratio of 50:5:5:40; the resultant xylene solution was spin-coated on the hole injection layer to form a film with a thickness of 20 nm, and the film was heated on a hot plate at 180°C for 60 minutes under a nitrogen gas atmosphere, to form a hole transporting layer;

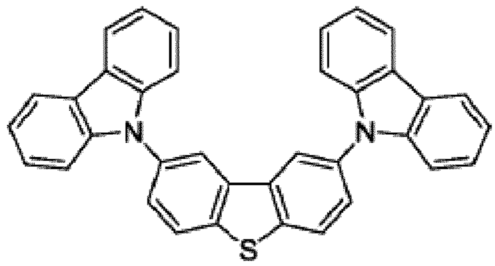

Low molecular weight compound SM1

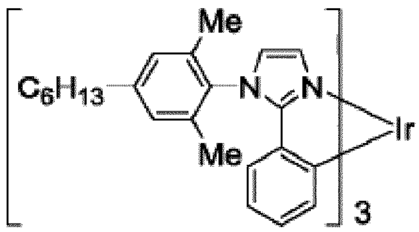

Metal complex 3

A low molecular weight compound SM1 (manufactured by Luminescense Technology) and a metal complex 3 (low molecular weight compound SM1/metal complex 3 = 75 wt%/25 wt%) were dissolved at a concentration of 2.0 wt% in toluene; the resultant toluene solution was spin-coated on the hole transporting layer to form a film with a thickness of 75 nm, and the film was heated at 130°C for 10 minutes under a nitrogen gas atmosphere, to form a light emitting layer;

The substrate carrying the light emitting layer formed thereon was placed in a vapor deposition machine, and the pressure was reduced to $1.0 \times 10^{-4}$ Pa or less, then, as a cathode, sodium fluoride was vapor-deposited with a thickness of about 7 nm on the light emitting layer, then, aluminum was vapor-deposited with a thickness of about 120 nm on the sodium fluoride layer; after vapor deposition, sealing was performed using a glass substrate, to fabricate a light emitting device;

(b) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer;

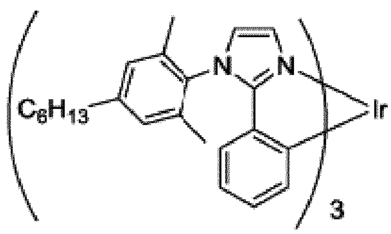

Compound G2

The polymer compound P1 and the compound G2 (polymer compound P1/compound G2 = 85 wt%/15 wt%) were dissolved at a concentration of 0.5 wt% in chlorobenzene, wherein P1 is a copolymer constituted of constitutional units derived from the monomer compounds CM1, CM2, CM3 and CM4 as defined in (a) above at a molar ratio of 50:5:5:40; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound P1;

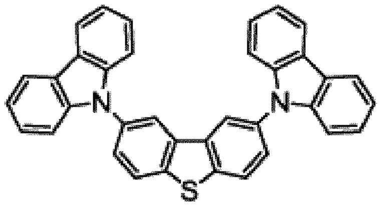

DCzDBT

2,8-di(9H-carbazol-9-yl)dibenzo[b,d]thiophene (DCzDBT) (manufactured by Luminescence Technology Corp) and the compound G2 (DCzDBT/compound G2 = 70 wt%/30 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer;

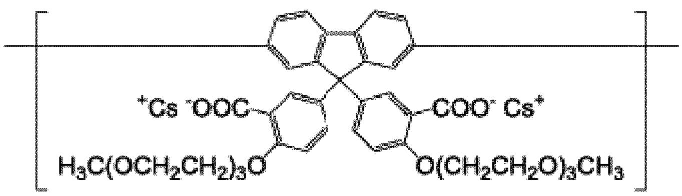

Polymer compound P4 repeat unit

The polymer compound P4 was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer;

The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device;

(c) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer;

The polymer compound P1 and the compound G2 as defined in (b) above (polymer compound PI/compound G2 = 70 wt%/30 wt%) were dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound P1;

2,8-di(9H-carbazol-9-yl)dibenzo[b,d]thiophene (DCzDBT) (manufactured by Luminescence Technology Corp) and the compound G2 as defined in (b) above (DCzDBT/compound G2 = 70 wt%/30 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer;

The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer;

The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device;

(d) A glass substrate was attached with an ITO film with a thickness of 45 nm by a sputtering method, to form an anode; on the anode, a polythiophene·sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer;
The polymer compound P1 and the compound G2 as defined in (b) above (polymer compound PI/compound G2 = 85 wt%/15 wt%) were dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound PI;

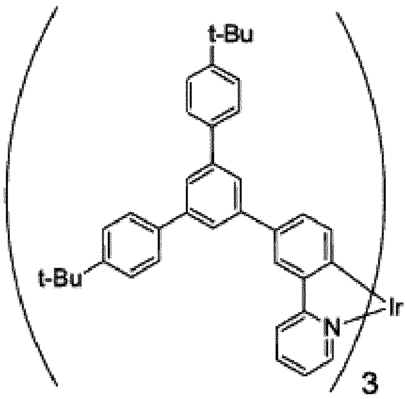

Compound G1

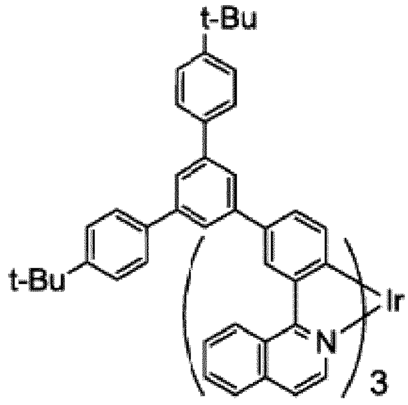

Compound G3

2,8-di(9H-carbazol-9-yl)dibenzo[b,d]thiophene (DCzDBT) (manufactured by Luminescence Technology Corp), the compound G2 as defined in (b) above, the compound G1 and the compound G3 (DCzDBT/compound G2/compound G1/compound G3 = 69 wt%/30 wt%/0.6 wt%/0.4 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer;
The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer;
The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device;
(e) A glass substrate was attached with an ITO film with a thickness of 45 nm by a sputtering method, to form an anode; on the anode, a polythiophene·sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer;
The polymer compound P1 as defined in (b) above, the compound G1 and the compound G3 as defined in (d) above (polymer compound PI/compound G1/compound G3 = 95 wt%/3 wt%/2 wt%) were dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound PI;
2,8-di(9H-carbazol-9-yl)dibenzo[b,d]thiophene (DCzDBT) (manufactured by Luminescence Technology Corp), the compound G2 as defined in (b) above, the compound G1 and the compound G3 as defined in (d) above (DCzDBT/compound G2/compound G1/compound G3 = 69 wt%/30 wt%/0.6 wt%/0.4 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under

a nitrogen gas atmosphere, thereby forming a light emitting layer;

The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer;

The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device;

(f) A glass substrate was attached with an ITO film with a thickness of 45 nm by a sputtering method, to form an anode; on the anode, a polythiophene·sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer;

The polymer compound P1 as defined in (b) above, the compound G1 and the compound G3 as defined in (d) above (polymer compound PI/compound G1/compound G3 = 90 wt%/6 wt%/4 wt%) were dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound P1;

2,8-di(9H-carbazol-9-yl)dibenzo[b,d]thiophene (DCzDBT) (manufactured by Luminescence Technology Corp), the compound G2 as defined in (b) above, the compound G1 and the compound G3 as defined in (d) above (DCzDBT/compound G2/compound G1/compound G3 = 69 wt%/30 wt%/0.6 wt%/0.4 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer;

The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer;

The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device;

(g) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer;

The polymer compound P1 as defined in (b) above was dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound PI;

2,8-di(9H-carbazol-9-yl)dibenzo[b,d]thiophene (DCzDBT) (manufactured by Luminescence Technology Corp) and the compound G2 as defined in (b) above (DCzDBT/compound G2 = 70 wt%/30 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer;

The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer;

The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device;

(h) A glass substrate was attached with an ITO film with a thickness of 45 nm by a sputtering method, to form an anode; on the anode, a polythiophene-sulfonic acid type hole injection agent AQ-1200 (manufactured by Plectronics) was spin-coated to form a film with a thickness of 35 nm, and the film was heated on a hot plate at 170°C for 15 minutes under an air atmosphere, thereby forming a hole injection layer;
The polymer compound P1 as defined in (b) above was dissolved at a concentration of 0.5 wt% in chlorobenzene; the resultant chlorobenzene solution was spin-coated on the hole injection layer to form a film with a thickness of 20 nm, and the film was heated on a hot plate at 180°C for 60 minutes under a nitrogen gas atmosphere, thereby forming a hole transporting layer; by heating on a hot plate at 180°C for 60 minutes, the polymer compound P1 becomes a crosslinked body of the polymer compound PI;
2,8-di(9H-carbazol-9-yl)dibenzo[b,d]thiophene (DCzDBT) (manufactured by Luminescence Technology Corp), the compound G2 as defined in (b) above, the compound G1 and the compound G3 as defined in (d) above (DCzDBT/compound G2/compound G1/compound G3 = 69 wt%/30 wt%/0.6 wt%/0.4 wt%) were dissolved at a concentration of 2.0 wt% in chlorobenzene; the resultant chlorobenzene solution was spin-coated on the hole transporting layer to form a film with a thickness of 60 nm, and the film was heated 130°C for 10 minutes under a nitrogen gas atmosphere, thereby forming a light emitting layer;
The polymer compound P4 as defined in (b) above was dissolved at a concentration of 0.25 wt% in 2,2,3,3,4,4,5,5-octafluoro-1-pentanol; the resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, thereby forming an electron transporting layer;
The substrate carrying the electron transporting layer formed thereon was placed in a vapor deposition machine, and the pressured was reduced to 1.0 x $10^{-4}$ Pa or less, then, as a cathode, sodium fluoride was vapor-deposited with a thickness of about 4 nm on the light emitting layer, then, aluminum was vapor-deposited with a thickness of about 80 nm on the sodium fluoride layer; after vapor deposition, sealing with a glass substrate was performed, thereby fabricating a light emitting device;
(i) An anode was formed by providing an ITO film having a thickness of 45 nm by sputtering method on a glass substrate; on the anode, AQ-1200 (manufactured by Plectronics Inc.) as a hole injection agent based on polythiophene·sulfonic acid was applied by spin-coating method to form a film having a thickness of 35 nm, and then it was heated on a hot plate for 15 minutes at 170°C in an ambient atmosphere, thereby forming a hole injection layer;

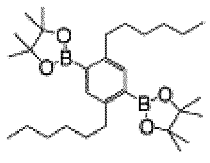
Compound 1

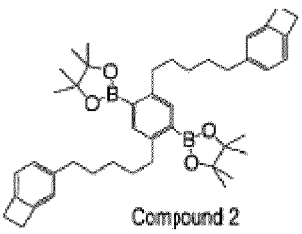
Compound 2

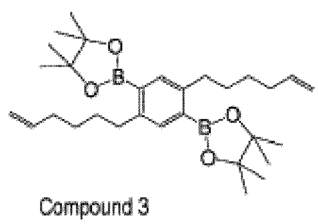
Compound 3

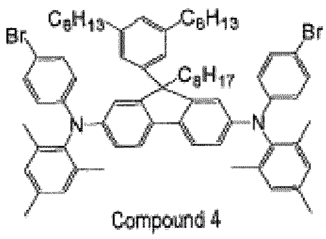
Compound 4

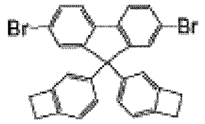
Compound 5

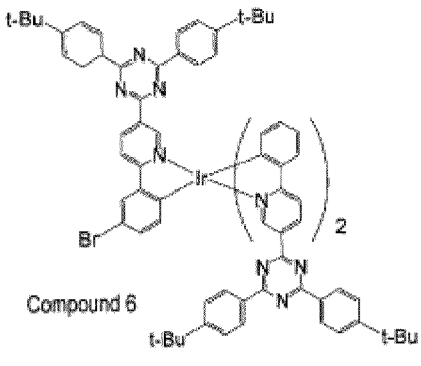
Compound 6

Polymer compound 1 was dissolved in xylene at a concentration of 0.6 wt%, wherein polymer compound 1 is a copolymer comprising constitutional units derived from Compound 1, Compound 2, Compound 3, Compound 4, Compound 5 and Compound 6 at a molar ratio of 30:10:10:39.4:10:1.2; the resultant xylene solution was used to form a film having a thickness of 20 nm by spin-coating on the hole injection layer, and then it was heated on a hot plate for 60 minutes at 180°C in a nitrogen gas atmosphere, thereby forming a first light-emitting layer.

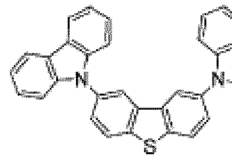
(H-21)

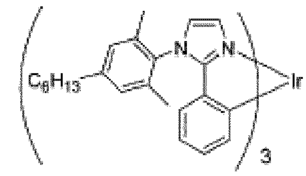
(1-A3-6)

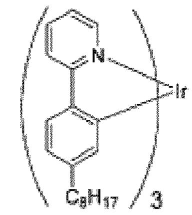
COM-1

A first ink was prepared by dissolving Compound (H-21), Compound (1-A3-6), Compound COM-1 (Compound (H-21)/Compound (1-A3-6)/Compound COM-1 (weight ratio)=69.77/30/0.23) in toluene at a concentration of 2.0 wt%; the first ink was applied on the first light-emitting layer by spin-coating method to form a film having a thickness of 75 nm, and then it was heated on a hot plate for 10 minutes at 130°C in a nitrogen gas atmosphere, thereby forming a second light-emitting layer;

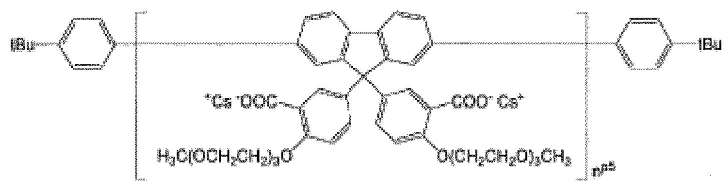
Polymer compound 5

A second ink was prepared by dissolving Polymer compound 5 in 2,2,3,3,4,4,5,5-octafluoro-1-pentanol at a concentration of 0.25 wt%; the structure of Polymer compound 5 is shown above, wherein $n^{p5}$ denotes a polymerization degree; the second ink was applied on the second light-emitting layer by spin-coating method to form a film having a thickness of 10 nm, and then it was heated on a hot plate for 10 minutes at 130°C in a nitrogen gas atmosphere, thereby forming an electron transport layer; on the electron transport layer, sodium fluoride as a cathode was evaporated to have a thickness of about 7 nm and then aluminum was evaporated to have a thickness of about 120 nm, whereby a light emitting device was fabricated;

(j) An anode was formed by providing an ITO film having a thickness of 45 nm by sputtering method on a glass substrate; on the anode, AQ-1200 (manufactured by Plectronics Inc.) as a hole injection agent based on polythiophene·sulfonic acid was applied by spin-coating method to form a film having a thickness of 35 nm, and then it was heated on a hot plate for 15 minutes at 170°C in an ambient atmosphere, thereby forming a hole injection layer;

Polymer compound 1 as defined in (i) above was dissolved in xylene at a concentration of 0.6 wt%; the resultant xylene solution was used to form a film having a thickness of 20 nm by spin-coating on the hole injection layer, and then it was heated on a hot plate for 60 minutes at 180°C in a nitrogen gas atmosphere, thereby forming a first light-emitting layer;

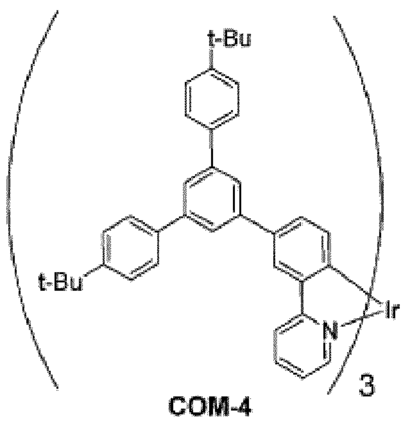
COM-4

A first ink was prepared by dissolving Compound (H-21) and

Compound (1-A3-6), as defined in (i) above, and Compound COM-4 (Compound (H-21)/Compound (1-A3-6)/Compound COM-4 weight ratio =69.6/30/0.4) in toluene at a concentration of 2.0 wt%; the first ink was applied on the first light-emitting layer by spin-coating method to form a film having a thickness of 75 nm, and then it was heated on a hot plate for 10 minutes at 130°C in a nitrogen gas atmosphere, thereby forming a second light-emitting layer;

A second ink was prepared by dissolving Polymer compound 5 as defined in (i) above in 2,2,3,3,4,4,5,5-octafluoro-1-pentanol at a concentration of 0.25 wt%; the second ink was applied on the second light-emitting layer by spin-coating method to form a film having a thickness of 10 nm, and then it was heated on a hot plate for 10 minutes at 130°C in a nitrogen gas atmosphere, thereby forming an electron transport layer; on the electron transport layer, sodium fluoride as a cathode was evaporated to have a thickness of about 7 nm and then aluminum was evaporated to have a thickness of about 120 nm, whereby a light emitting device was fabricated;

(k) An anode was formed by providing an ITO film having a thickness of 45 nm by sputtering method on a glass substrate; on the anode, AQ-1200 (manufactured by Plectronics Inc.) as a hole injection agent based on polythiophene·sulfonic acid was applied by spin-coating method to form a film having a thickness of 35 nm, and then it was heated on a hot plate for 15 minutes at 170°C in an ambient atmosphere, thereby forming a hole injection layer;

Polymer compound 1 as defined in (i) above was dissolved in xylene at a concentration of 0.6 wt%; the resultant xylene solution was used to form a film having a thickness of 20 nm by spin-coating on the hole injection layer, and then it was heated on a hot plate for 60 minutes at 180°C in a nitrogen gas atmosphere, thereby forming a first light-emitting layer;

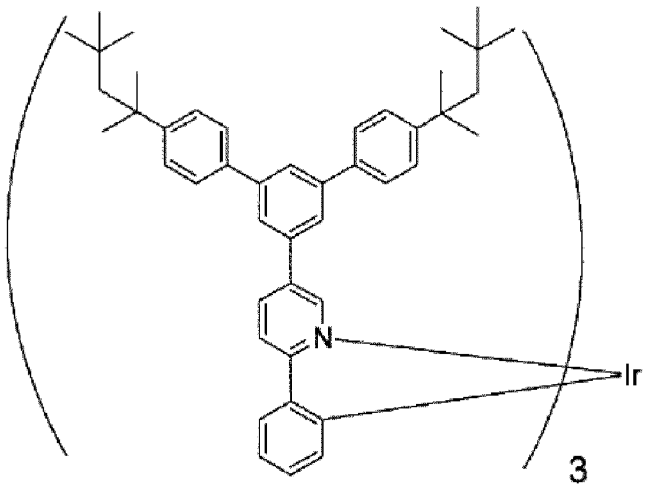

COM-9

A first ink was prepared by dissolving Compound (H-21), Compound (1-A3-6), Compound COM-4 as defined in (i) and (j) above, and Compound COM-9 (Compound (H-21)/Compound (1-A3-6)/Compound COM-4/Compound COM-9 weight ratio =69.6/30/0.2/0.2) in toluene at a concentration of 2.0 wt%; the first ink was applied on the first light-emitting layer by spin-coating method to form a film having a thickness of 75 nm, and then it was heated on a hot plate for 10 minutes at 130°C in a nitrogen gas atmosphere, thereby forming a second light-emitting layer;

A second ink was prepared by dissolving Polymer compound 5 as defined in (i) above in 2,2,3,3,4,4,5,5-octafluoro-1-pentanol at a concentration of 0.25 wt%; the second ink was applied on the second light-emitting layer by spin-coating method to form a film having a thickness of 10 nm, and then it was heated on a hot plate for 10 minutes at 130°C in a nitrogen gas atmosphere, thereby forming an electron transport layer; on the electron transport layer, sodium fluoride as a cathode was evaporated to have a thickness of about 7 nm and then aluminum was evaporated to have a thickness of about 120 nm, whereby a light emitting device was fabricated.

**2.** The light emitting device according to claim 1 wherein the phosphorescent compound is not a phosphorescent compound represented by any of the following formula COM-17, B2 or B3:

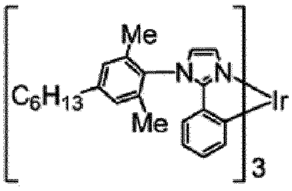

COM-17

,

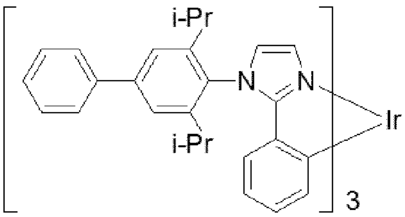

phosphorescent compound B2

, or

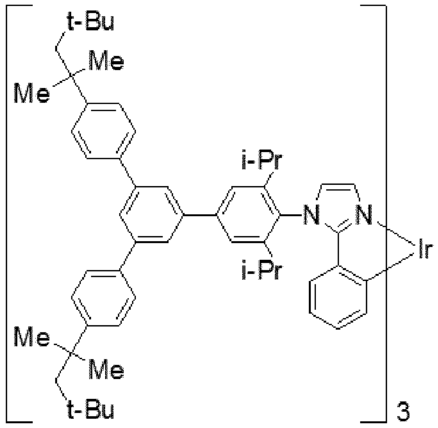

phosphorescent compound B3

.

**3.** The light-emitting device according to claim 1 wherein the phosphorescent compound of formula (1) is a phosphorescent compound represented by the following formula COM-18 to COM-28:

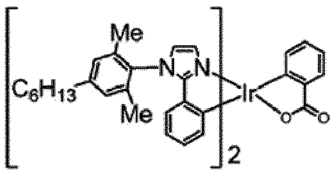

COM-18

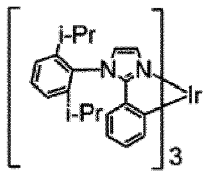

COM-19

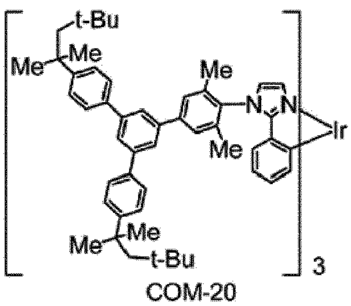

COM-20

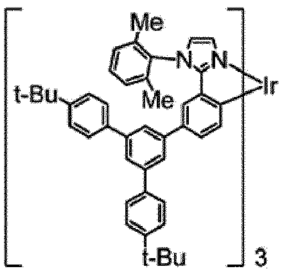

COM-21

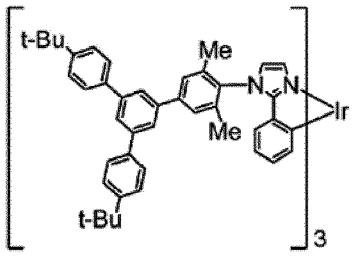

COM-22

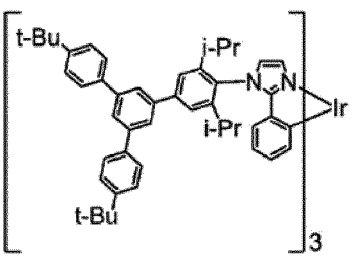

COM-23

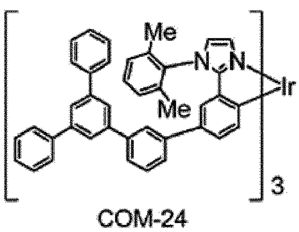

COM-24

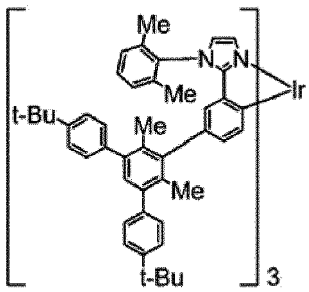

COM-25

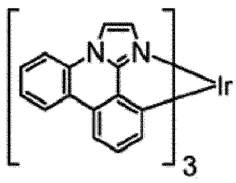
COM-26

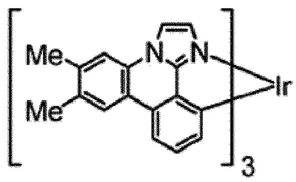
COM-27

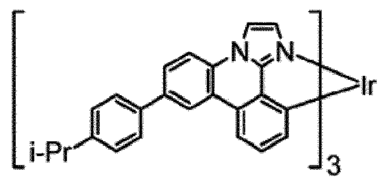
COM-28

.

4. The light-emitting device according to any one of claims 1 to 3, wherein the value of $(Y_1 \times 1000)/X_1$ is 0.65 or more.

5. The light-emitting device according to any one of claims 1 to 4, wherein at least one selected from the group consisting of the $R^{11A}$, $R^{12A}$, $R^{13A}$, $R^{21A}$, $R^{22A}$, $R^{23A}$ and $R^{24A}$ is a group represented by the formula (D-A) or (D-B):

[Chemical Formula 2]

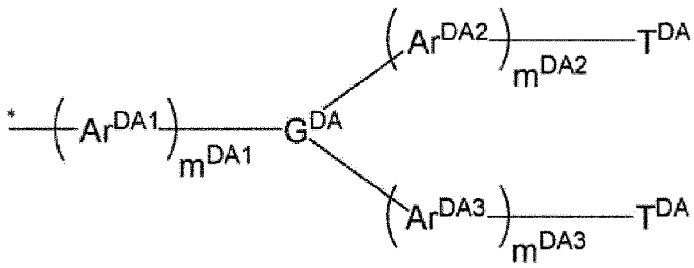
**(D-A)**

wherein,

$m^{DA1}$, $m^{DA2}$ and $m^{DA3}$ each independently represent an integer of 0 or more;
$G^{DA}$ represents a nitrogen atom, an aromatic hydrocarbon group or a heterocyclic group, and these groups each optionally have a substituent;
$Ar^{DA1}$, $Ar^{DA2}$ and $Ar^{DA3}$ each independently represent an arylene group or a divalent heterocyclic group, and these groups each optionally have a substituent; and when a plurality of $Ar^{DA1}$, $Ar^{DA2}$ and $Ar^{DA3}$ are present, they may be the same or different at each occurrence; and
$T^{DA}$ represents an aryl group or a monovalent heterocyclic group, and these groups each optionally have a substituent; and the plurality of $T^{DA}$ may be the same or different; and
* represents a bonding position, and

[Chemical Formula 3]

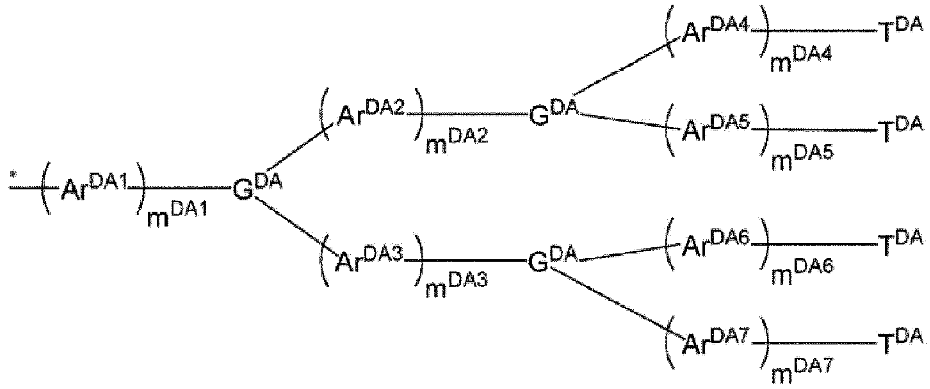
**(D-B)**

wherein,

$m^{DA1}$ , $m^{DA2}$, $m^{DA3}$, $m^{DA4}$, $m^{DA5}$, $m^{DA6}$ and $m^{DA7}$ each independently represent an integer of 0 or more;
$G^{DA}$ represents a nitrogen atom, an aromatic hydrocarbon group or a heterocyclic group, and these groups each optionally have a substituent, and the plurality of $G^{DA}$ may be the same or different;
$Ar^{DA1}$, $Ar^{DA2}$, $Ar^{DA3}$, $Ar^{DA4}$, $Ar^{DA5}$, $Ar^{DA6}$ and $Ar^{DA7}$ each independently represent an arylene group or a divalent heterocyclic group, and these groups each optionally have a substituent; and when a plurality of $Ar^{DA1}$, $Ar^{DA2}$, $Ar^{DA3}$, $Ar^{DA4}$, $Ar^{DA5}$, $Ar^{DA6}$ and $Ar^{DA7}$ are present, they may be the same or different at each occurrence; and
$T^{DA}$ represents an aryl group or a monovalent heterocyclic group, and these groups each optionally have a substituent, and the plurality of $T^{DA}$ may be the same or different; and
* represents a bonding position.

6. The light-emitting device according to any one of claims 1, 4 or 5, wherein the phosphorescent compound is represented by the formula (1-1) or (1-2):

[Chemical Formula 4]

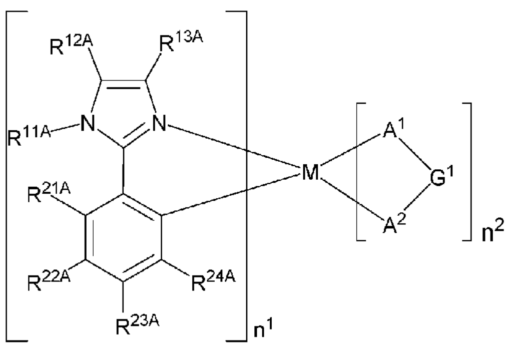

(1-1)

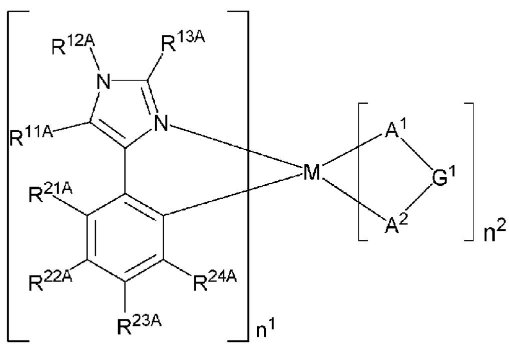

(1-2)

wherein M, $n^1$, $n^2$, $R^{11A}$, $R^{12A}$, $R^{13A}$, $R^{21A}$, $R^{22A}$, $R^{23A}$, $R^{24A}$ and $A^1$-$G^1$-$A^2$ represent the same meanings as described above.

7. The light-emitting device according to any one of claims 1 to 6, wherein the crosslinkable polymer compound comprises a constitutional unit represented by the formula (2):

[Chemical Formula 5]

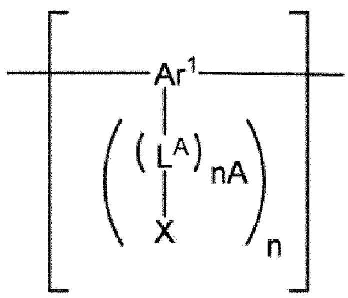

(2)

wherein,

nA represents an integer of 0 to 5, and n represents 1 or 2;
$Ar^1$ represents an aromatic hydrocarbon group or a heterocyclic group, and these groups each optionally have a substituent;
$L^A$ represents an alkylene group, a cycloalkylene group, an arylene group, a divalent heterocyclic group, a group

represented by -NR'-, an oxygen atom or a sulfur atom, and these groups each optionally have a substituent; R' represents a hydrogen atom, an alkyl group, a cycloalkyl group, an aryl group or a monovalent heterocyclic group, and these groups each optionally have a substituent: and when a plurality of $L^A$ are present, they may be the same or different; and

X represents a crosslinkable group selected from Group A of crosslinkable groups, and when a plurality of X are present, they may be the same or different.

**8.** The light-emitting device according to any one of claims 1 to 7, wherein the crosslinkable polymer compound comprises a constitutional unit represented by the formula (3):

[Chemical Formula 6]

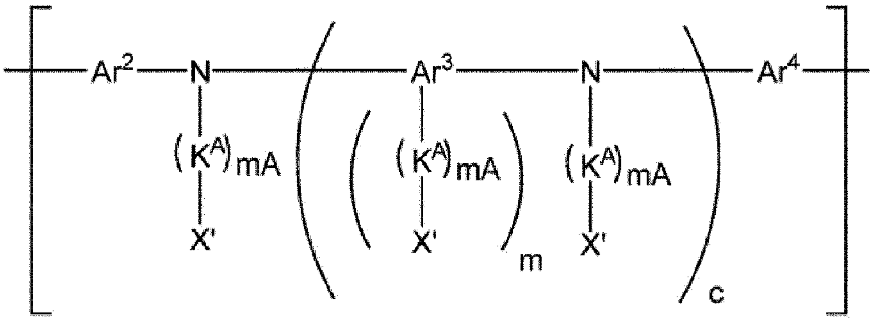

(3)

wherein,

mA represents an integer of 0 to 5, m represents an integer of 1 to 4, c represents 0 or 1, and when a plurality of mA are present, they may be the same or different;

$Ar^3$ represents an aromatic hydrocarbon group, a heterocyclic group or a group in which at least one aromatic hydrocarbon ring and at least one heterocyclic ring are bonded directly to each other, and these groups each optionally have a substituent;

$Ar^2$ and $Ar^4$ each independently represent an arylene group or a divalent heterocyclic group, and these groups each optionally have a substituent;

each of $Ar^2$, $Ar^3$ and $Ar^4$ may be bonded directly or via an oxygen atom or a sulfur atom to a group that is different from that group and that is attached to the nitrogen atom to which that group is attached, thereby forming a ring;

$K^A$ represents an alkylene group, a cycloalkylene group, an arylene group, a divalent heterocyclic group, a group represented by -NR"-, an oxygen atom or a sulfur atom, and these groups each optionally have a substituent; and R" represents a hydrogen atom, an alkyl group, a cycloalkyl group, an aryl group or a monovalent heterocyclic group, and these groups each optionally have a substituent; and when a plurality of $K^A$ are present, they may be the same or different; and

X' represents a crosslinkable group selected from Group A of crosslinkable groups, a hydrogen atom, an alkyl group, a cycloalkyl group, an aryl group or a monovalent heterocyclic group, and these groups each optionally have a substituent; and when a plurality of X' are present, they may be the same or different; provided that at least one X' is a crosslinkable group selected from Group A of crosslinkable groups.

**9.** The light-emitting device according to any one of claims 1 to 8, wherein the first organic layer further comprises a polymer compound comprising a constitutional unit represented by the formula (Y):

[Chemical Formula 8] $-[Ar^{Y1}]-$ (Y)

wherein $Ar^{Y1}$ represents an arylene group, a divalent heterocyclic group or a divalent group in which at least one arylene group and at least one divalent heterocyclic group are bonded directly to each other, and these groups each optionally have a substituent.

**10.** The light-emitting device according to any one of claims 1 to 8, wherein the first organic layer further comprises a

compound represented by the formula (H-1):

[Chemical Formula 9]

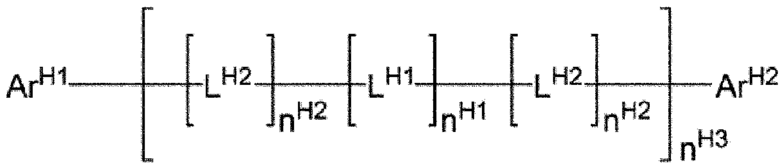

(H-1)

wherein,

$Ar^{H1}$ and $Ar^{H2}$ each independently represent an aryl group or a monovalent heterocyclic group, and these groups each optionally have a substituent;

$n^{H1}$ and $n^{H2}$ each independently represent 0 or 1; when a plurality of $n^{H1}$ are present, they may be the same or different; and when a plurality of $n^{H2}$ are present, they may be the same or different;

$n^{H3}$ represents an integer of 0 or more;

$L^{H1}$ represents an arylene group, a divalent heterocyclic group or a group represented by $-[C(R^{H11})_2]n^{H11}-$, and these groups each optionally have a substituent; and when a plurality of $L^{H1}$ are present, they may be the same or different;

$n^{H11}$ represents an integer of 1 to 10; $R^{H11}$ represents a hydrogen atom, an alkyl group, a cycloalkyl group, an alkoxy group, a cycloalkoxy group, an aryl group or a monovalent heterocyclic group, and these groups each optionally have a substituent; the plurality of $R^{H11}$ may be the same or different and may be combined together to form a ring together with the carbon atoms to which they are attached;

$L^{H2}$ represents a group represented by $-N(-L^{H21}-R^{H21})-$; and when a plurality of $L^{H2}$ are present, they may be the same or different; and

$L^{H21}$ represents a single bond, an arylene group or a divalent heterocyclic group, and these groups each optionally have a substituent; and $R^{H21}$ represents a hydrogen atom, an alkyl group, a cycloalkyl group, an aryl group or a monovalent heterocyclic group, and these groups each optionally have a substituent.

## Patentansprüche

**1.** Lichtemittierende Vorrichtung, umfassend:

eine Anode;
eine Kathode;
eine erste organische Schicht, die zwischen der Anode und der Kathode; und
eine zweite organische Schicht, die zwischen der Anode und der ersten organischen Schicht und neben der ersten organischen Schicht angeordnet ist,
wobei die erste organische Schicht eine phosphoreszierende Verbindung umfasst, die durch die Formel (1) dargestellt wird;
die zweite organische Schicht ein gehärtetes Polymerprodukt umfasst, das aus einer Polymerzusammensetzung ausgebildet ist, in der eine oder zwei oder mehr Polymerverbindungen, einschließlich einer vernetzbaren Polymerverbindung mit wenigstens einer vernetzbaren Gruppe, die aus Gruppe A von vernetzbaren Gruppen ausgewählt ist, verbunden werden; und
in Bezug auf jede Monomereinheit, die die Polymerverbindungen bildet, ein Wert x, der durch ein Multiplizieren eines Molverhältnisses C der jeweiligen Monomereinheit auf ein Gesamtmol aller der Monomereinheiten mit einem Molekulargewicht M der jeweiligen Monomereinheit erhalten wird, und ein Wert y, der durch das Multiplizieren des Molverhältnisses C mit einer Anzahl n der vernetzbaren Gruppen in der jeweiligen Monomereinheit erhalten wird, bestimmt werden, wobei ein Wert von $(Y_1 \times 1000)X_1$, berechnet aus $X_1$ als die Summe der Werte x und $Y_1$ als die Summe der Werte y, 0,5 oder mehr ist: [Chemische Formel 1]

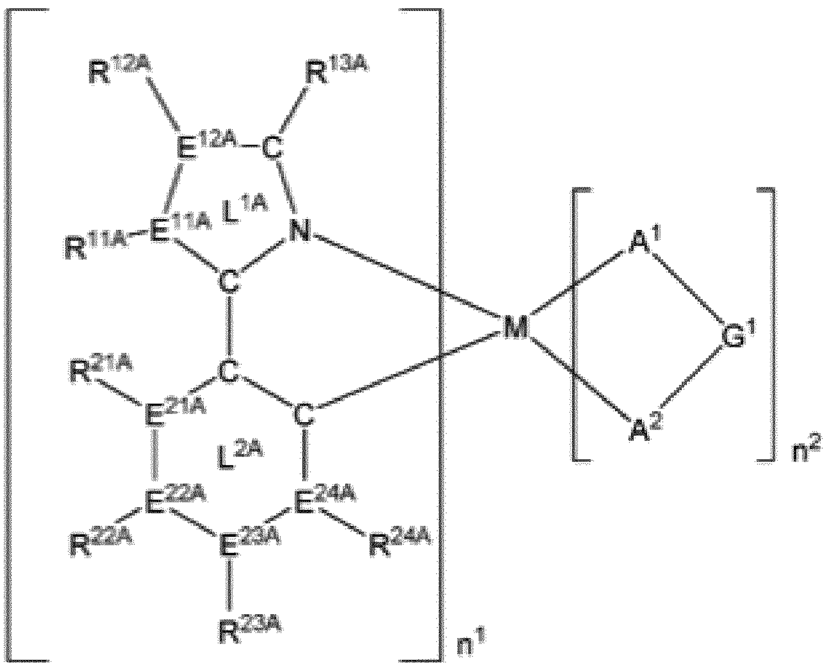

(1)

wobei,

M ein Rutheniumatom, ein Rhodiumatom, ein Palladiumatom, ein Iridiumatom oder ein Platinatom darstellt; $n^1$ eine ganze Zahl von 1 bis 3 darstellt, $n^2$ eine ganze Zahl von 0 bis 2 darstellt und $n^1 + n^2$ 2 oder 3 ist; und $n^1 + n^2$ 3 ist, wenn M ein Rutheniumatom, ein Rhodiumatom oder ein Iridiumatom ist, während $n^1 + n^2$ 2 ist, wenn M ein Palladiumatom oder ein Platinatom ist;
$E^{11A}$, $E^{12A}$, $E^{21A}$, $E^{22A}$, $G^{23A}$ und $E^{24A}$ jeweils unabhängig ein Stickstoffatom oder ein Kohlenstoffatom darstellen; wenn mehrere von $E^{11A}$, $E^{12A}$, $E^{21A}$, $E^{22A}$, $E^{23A}$ und $E^{24A}$ vorhanden sind, können sie dieselben oder unterschiedlich bei jedem Auftreten sein, vorausgesetzt das eines von $E^{11A}$und $E^{12A}$ ein Kohlenstoffatom ist und das andere ein Stickstoffatom ist; und wenn $E^{21A}$, $E^{22A}$, $E^{23A}$ und $E^{24A}$ Stickstoffatome sind, $R^{21A}$, $R^{22A}$, $R^{23A}$ und $R^{24A}$ nicht vorhanden sind;
$R^{11A,}$ $R^{12A}$, $R^{13A}$, $R^{21A}$, $R^{23A}$ und $R^{24A}$ jeweils ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, eine substituierte Aminogruppe oder ein Halogenatom darstellen und diese Gruppe jeweils optional einen Substituenten aufweisen; wenn mehrere $R^{11A}$, $R^{12A}$, $RR^{13A}$, $R^{21A}$, $R^{23A}$ und $R^{24A}$ vorhanden sind, können sie dieselben oder unterschiedlich bei jedem Auftreten sein; und $R^{11A}$ und $R^{12A}$, $R^{12A}$ und $RR^{13A}$, $R^{11A}$ und $R^{21A}$, $R^{21A}$ und $R^{22A}$, $R^{22A}$ und $R^{23A}$, und $R^{23A}$ und $R^{24A}$ können jeweils zusammen kombiniert werden, um zusammen mit den Atomen, an die sie gebunden sind, einen Ring auszubilden;
ein Ring $L^{1A}$ einen Imidazolring darstellt, der aus einem Stickstoffatom, aus zwei Kohlenstoffatomen, $E^{21A}$, $E^{12A}$ gebildet ist; und
ein Ring $L^{2A}$ einen Benzolring, einen Pyridinring oder einen Pyrimidinring darstellt, der aus zwei Kohlenstoffatomen, $E^{21A}$, $E^{22A}$, $E^{23A}$ und $E^{24A}$ gebildet ist; und
$A^1$-$G^1$-$A^2$ einen anionischen zweizähnigen Liganden darstellt; $A^1$ und $A^2$ jeweils unabhängig ein Kohlenstoffatom, ein Sauerstoffatom oder ein Stickstoffatom darstellen und diese Atome Atome sein können, die einen Ring bilden; $G^1$ eine Einfachbindung oder eine atomare Gruppe darstellt, die den zweizähnigen Liganden zusammen mit $A^1$ und $A^2$ bildet; und wenn mehrere $A^1$-$G^1$-$A^2$ vorhanden sind, können sie dieselben oder bei jedem Auftreten unterschiedlich sein

(Gruppe A von vernetzbaren Gruppen)

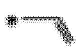
(XL-1)

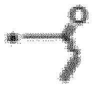
(XL-2)

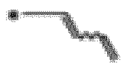
(XL-3)

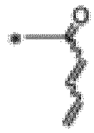
(XL-4)

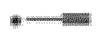
(XL-5)

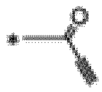
(XL-6)

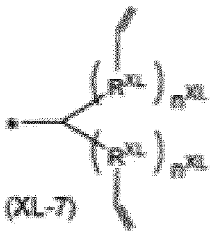
(XL-7)

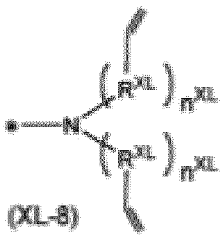
(XL-8)

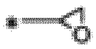
(XL-9)

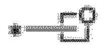
(XL-10)

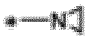
(XL-11)

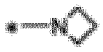
(XL-12)

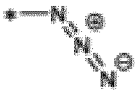
(XL-13)

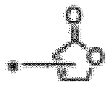
(XL-14)

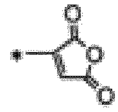
(XL-15)

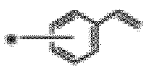
(XL-16)

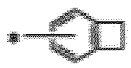
(XL-17)

wobei $R^{XL}$ eine Methylengruppe, ein Sauerstoffatom oder ein Schwefelatom darstellt und $n^{XL}$ eine ganze Zahl von 0 bis 5 darstellt; wenn mehrere $R^{XL}$ vorhanden sind, können sie dieselben oder unterschiedlich sein; und wenn mehrere $n^{XL}$ vorhanden sind, können sie dieselben oder unterschiedlich sein; * eine Bindungsposition darstellt; und diese vernetzbaren Gruppen jeweils optional einen Substituenten aufweisen;
wobei die lichtemittierende Vorrichtung keine lichtemittierende Vorrichtung ist, die durch eines der folgenden Verfahren (a) bis (k) hergestellt wird:

(a) Eine ITO-Folie mit einer Dicke von 45 nm wurde an einem Glassubstrat durch ein Zerstäubungsverfahren befestigt, um eine Anode auszubilden; auf der Anode wurde ein Lochinjektionsmaterial des Polythiophensulfonsäure-Typs AQ-1200 (hergestellt durch Plectronics) rotationsbeschichtet, um eine Folie mit einer Dicke von 35 nm auszubilden und die Folie wurde auf einer Heizplatte bei 170 °C für 15 Minuten unter einer Luftatmosphäre erhitzt, um eine Lochinjektionsschicht auszubilden;

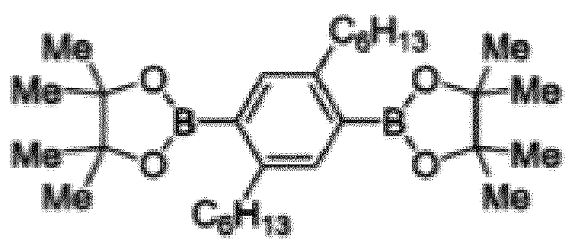
Verbindung CM1

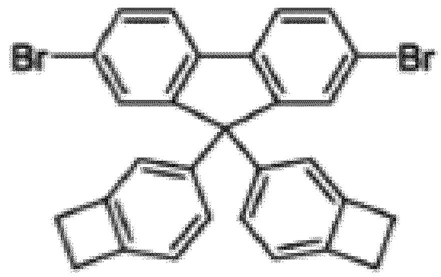
Verbindung CM2

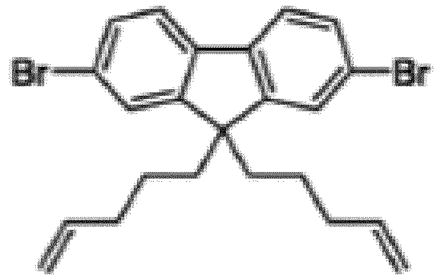

Verbindung CM3

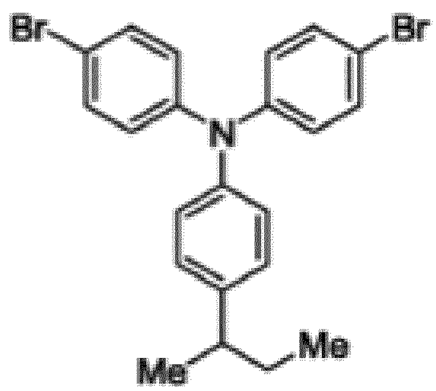

Verbindung CM4

Eine Polymerverbindung HTL-1 wurde bei einer Konzentration von 0,7 Gew.-% in Xylen aufgelöst, wobei HTL-1 ein Copolymer ist, das auf Konstitutionseinheiten gebildet wird, die von den Monomerverbindungen CM1, CM2, CM3 und CM4 bei einem Molverhältnis von 50:5:5:40 gewonnen werden; wobei die resultierende Xylenlösung auf die Lochinjektionsschicht rotationsbeschichtet wurde, um eine Folie mit einer Dicke von 20 nm auszubilden, und die Folie auf einer Heizplatte bei 180 °C für 60 Minuten unter eine Stickstoffgasatmosphäre erhitzt wurde, um eine Lochtransportschicht auszubilden;

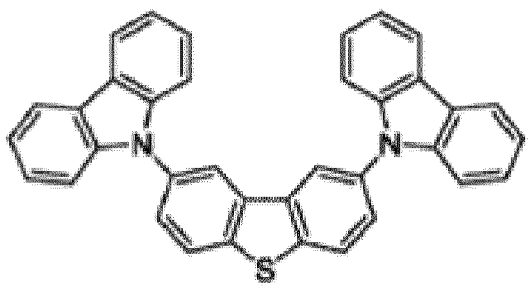

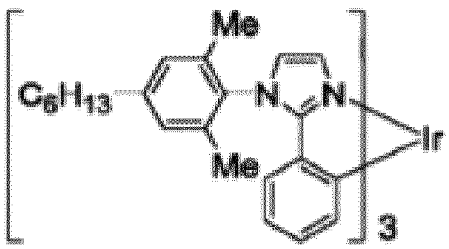

Metallkomplex 3

Verbindung mit einem niedrigen
Molekulargewicht SM1

Eine Verbindung mit einem niedrigen Molekulargewicht SM1 (hergestellt durch Luminescense Technology) und ein Metallkomplex 3 (Verbindung mit einem niedrigen Molekulargewicht SM1/Metallkomplex 3 = 75 Gew.-%/25 Gew.-%) wurden bei einer Konzentration von 2,0 Gew.-% in Toluol aufgelöst; die resultierende Toluollösung wurde auf die Lochtransportschicht rotationsbeschichtet, um eine Folie mit einer Dicke von 75 nm auszubilden und die Folie bei 130 °C für 10 Minuten unter einer Stickstoffgasatmosphäre erhitzt, um eine lichtemittierende Schicht auszubilden;

das Substrat, das die darauf ausgebildete lichtemittierende Schicht trug, wurde in eine Gasphasenabscheidungsmaschine platziert und der Druck wurde auf 1,0 x $10^{-4}$ Pa oder weniger reduziert, dann wurde Natriumfluorid als eine Kathode mit einer Dicke von etwa 7 nm auf die lichtemittierende Schicht gasphasenabgeschieden, dann wurde Aluminium mit einer Dicke von etwa 120 nm auf die Natriumfluoridschicht gasphasenabgeschieden; nach der Gasphasenabscheidung wurde ein Abdichten unter Verwendung eines Glassubstrates durchgeführt, um eine lichtemittierende Vorrichtung zu fertigen;

(b) Ein Glassubstrat wurde mit einer ITO-Folie mit einer Dicke von 45 nm durch ein Zerstäubungsverfahren befestigt, um eine Anode auszubilden; auf der Anode wurde ein Lochinjektionsmittel des Polythiophensulfonsäure-Typs AQ-1200 (hergestellt durch Plectronics) rotationsbeschichtet, um eine Folie mit einer Dicke von 35 nm auszubilden und die Folie wurde auf einer Heizplatte bei 170 °C für 15 Minuten unter einer Luftatmosphäre erhitzt, wobei dadurch eine Lochinjektionsschicht ausgebildet wurde;

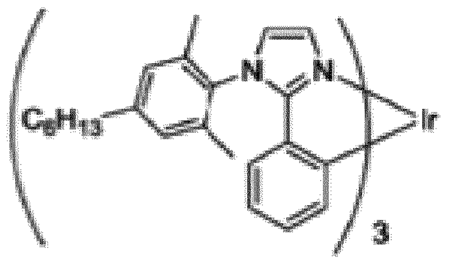

Verbindung G2

die Polymerverbindung P1 und die Verbindung G2 (Polymerverbindung P1/Verbindung G2 = 85 Gew.-%/15 Gew.-%) wurden bei einer Konzentration von 0,5 Gew.-% in Chlorobenzol aufgelöst, wobei P1 ein Copolymer ist, das auf Konstitutionseinheiten gebildet wird, die von den Monomerverbindungen CM1, CM2, CM3 und CM4, wie in (a) vorstehend definiert, bei einem Molverhältnis von 50:5:5:40 gewonnen werden; wobei die resultierende Chlorobenzollösung auf die Lochinjektionsschicht rotationsbeschichtet wurde, um eine Folie mit einer Dicke von 20 nm auszubilden, und die Folie auf einer Heizplatte bei 180 °C für 60 Minuten unter eine Stickstoffgasatmosphäre erhitzt wurde, wobei dadurch eine Lochtransportschicht auszubilden; durch das Erhitzen auf einer Heizplatte bei 180 °C für 60 Minuten wird die Polymerverbindung P1 ein vernetzter Körper der Polymerverbindung P1;

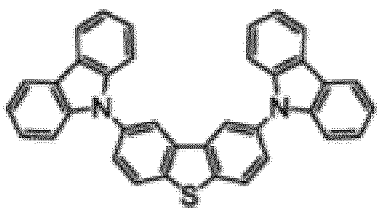

DCzDBT

2,8-di(9H-Carbazol-9-yl)dibenzo[b,d]thiophen (DCzDBT) (hergestellt durch Luminescence Technology Corp) und die Verbindung G2 (DCzDBT/Verbindung G2 = 70 Gew-%/30 Gew.-%) wurden bei einer Konzentration von 2,0 Gew.-% in Chlorobenzol aufgelöst; die resultierende Chlorobenzollösung wurde auf die Lochtransportschicht rotationsbeschichtet, um eine Folie mit einer Dicke von 60 nm auszubilden und die Folie wurde bei 130 °C für 10 Minuten unter einer Stickstoffgasatmosphäre erhitzt, wobei dadurch eine lichtemittierende Schicht ausgebildet wurde;

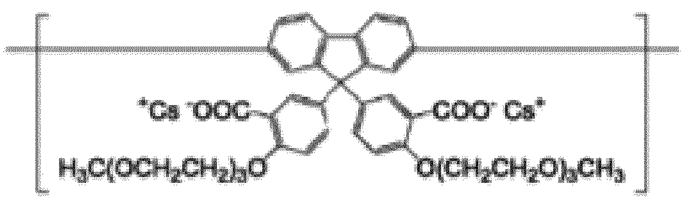

Polymerverbindung P4, Wiederholungseinheit

die Polymerverbindung P4 wurde bei einer Konzentration von 0,25 Gew.-% in 2,2,3,3,4,4,5,5,-Octafluoro-1-pentanol aufgelöst; die resultierende 2,2,3,3,4,4,5,5,-Octafluoro-1-pentanol-Lösung wurde auf die lichtemittierenden Schicht rotationsbeschichtet, um eine Folie mit einer Dicke von 10 nm auszubilden und die Folie wurde bei 130 °C für 10 Minuten unter einer Stickstoffgasatmosphäre erhitzt, wobei dadurch eine Elektronentransportschicht ausgebildet wurde;

das Substrat, das die darauf ausgebildete Elektronentransportschicht trug, wurde in eine Gasphasenabscheidungsmaschine platziert und der Druck wurde auf 1,0 x $10^{-4}$ Pa oder weniger reduziert, dann wurde Natriumfluorid als eine Kathode mit einer Dicke von etwa 4 nm auf die lichtemittierende Schicht gasphasenabgeschieden, dann wurde Aluminium mit einer Dicke von etwa 80 nm auf die Natriumfluoridschicht gasphasenabgeschieden;

nach der Gasphasenabscheidung wurde ein Abdichten mit einem Glassubstrat durchgeführt, wobei dadurch eine lichtemittierende Vorrichtung gefertigt wurde;

(c) Ein Glassubstrat wurde mit einer ITO-Folie mit einer Dicke von 45 nm durch ein Zerstäubungsverfahren befestigt, um eine Anode auszubilden; auf der Anode wurde ein Lochinjektionsmittel des Polythiophensulfonsäure-Typs AQ-1200 (hergestellt durch Plectronics) rotationsbeschichtet, um eine Folie mit einer Dicke von 35 nm auszubilden und die Folie wurde auf einer Heizplatte bei 170 °C für 15 Minuten unter einer Luftatmosphäre erhitzt, wobei dadurch eine Lochinjektionsschicht ausgebildet wurde;

die Polymerverbindung P1 und die Verbindung G2, wie vorstehend in (b) definiert, (Polymerverbindung P1/Verbindung G2 = 70 Gew.-%/30 Gew.-%) wurden bei einer Konzentration von 0,5 Gew.-% in Chlorobenzol aufgelöst; die resultierende Chlorobenzollösung wurde auf die Lochinjektionsschicht rotationsbeschichtet, um eine Folie mit einer Dicke von 20 nm auszubilden und die Folie wurde auf einer Heizplatte bei 180 °C für 60 Minuten unter einer Stickstoffgasatmosphäre erhitzt, wobei dadurch eine Lochtransportschicht ausgebildet wurde; durch das Erhitzen auf einer Heizplatte bei 180 °C für 60 Minuten wird die Polymerverbindung P1 ein vernetzter Körper der Polymerverbindung P1;

2,8-di(9H-Carbazol-9-yl)dibenzo[b,d]thiophen (DCzDBT) (hergestellt durch Luminescence Technology Corp) und die Verbindung G2, wie vorstehend in (b) definiert, (DCzDBT/Verbindung G2 = 70 Gew-%/30 Gew.-%) wurden bei einer Konzentration von 2,0 Gew.-% in Chlorobenzol aufgelöst; die resultierende Chlorobenzollösung wurde auf die Lochtransportschicht rotationsbeschichtet, um eine Folie mit einer Dicke von 60 nm auszubilden und die Folie wurde bei 130 °C für 10 Minuten unter einer Stickstoffgasatmosphäre erhitzt, wobei dadurch eine lichtemittierende Schicht ausgebildet wurde;

die Polymerverbindung P4, wie vorstehend in (b) definiert, wurde bei einer Konzentration von 0,25 Gew.-% in 2,2,3,3,4,4,5,5,-Octafluoro-1-pentanol aufgelöst; die resultierende 2,2,3,3,4,4,5,5,-Octafluoro-1-pentanol-Lösung wurde auf die lichtemittierenden Schicht rotationsbeschichtet, um eine Folie mit einer Dicke von 10 nm auszubilden und die Folie wurde bei 130 °C für 10 Minuten unter einer Stickstoffgasatmosphäre erhitzt, wobei dadurch eine Elektronentransportschicht ausgebildet wurde;

das Substrat, das die darauf ausgebildete Elektronentransportschicht trug, wurde in eine Gasphasenabscheidungsmaschine platziert und der Druck wurde auf 1,0 x $10^{-4}$ Pa oder weniger reduziert, dann wurde Natriumfluorid als eine Kathode mit einer Dicke von etwa 4 nm auf die lichtemittierende Schicht gasphasenabgeschieden, dann wurde Aluminium mit einer Dicke von etwa 80 nm auf die Natriumfluoridschicht gasphasenabgeschieden; nach der Gasphasenabscheidung wurde ein Abdichten mit einem Glassubstrat durchgeführt, wobei dadurch eine lichtemittierende Vorrichtung gefertigt wurde;

(d) Ein Glassubstrat wurde mit einer ITO-Folie mit einer Dicke von 45 nm durch ein Zerstäubungsverfahren befestigt, um eine Anode auszubilden; auf der Anode wurde ein Lochinjektionsmittel des Polythiophensulfonsäure-Typs AQ-1200 (hergestellt durch Plectronics) rotationsbeschichtet, um eine Folie mit einer Dicke von 35 nm auszubilden und die Folie wurde auf einer Heizplatte bei 170 °C für 15 Minuten unter einer Luftatmosphäre erhitzt, wobei dadurch eine Lochinjektionsschicht ausgebildet wurde;

die Polymerverbindung P1 und die Verbindung G2, wie vorstehend in (b) definiert, (Polymerverbindung P1/Verbindung G2 = 85 Gew.-%/15 Gew.-%) wurden bei einer Konzentration von 0,5 Gew.-% in Chlorobenzol aufgelöst; die resultierende Chlorobenzollösung wurde auf die Lochinjektionsschicht rotationsbeschichtet, um eine Folie mit einer Dicke von 20 nm auszubilden und die Folie wurde auf einer Heizplatte bei 180 °C für 60 Minuten unter einer Stickstoffgasatmosphäre erhitzt, wobei dadurch eine Lochtransportschicht ausgebildet wurde; durch das Erhitzen auf einer Heizplatte bei 180 °C für 60 Minuten wird die Polymerverbindung P1 ein vernetzter Körper der Polymerverbindung P1;

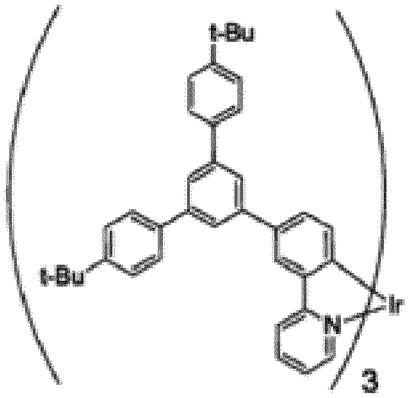

Verbindung G1

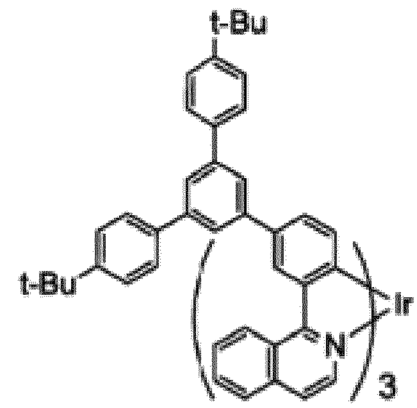

Verbindung G3

2,8-di(9H-Carbazol-9-yl)dibenzo[b,d]thiophen (DCzDBT) (hergestellt durch Luminescence Technology Corp), die Verbindung G2, wie vorstehend in (b) definiert, die Verbindung G1 und die Verbindung G3 (DCzDBT/Verbindung G2/Verbindung G1/Verbindung G3 = 69 Gew-%/30 Gew.-%/0,6 Gew.-%/0,4 Gew.-%) wurden bei einer Konzentration von 2,0 Gew.-% in Chlorobenzol aufgelöst; die resultierende Chlorobenzollösung wurde auf die Lochtransportschicht rotationsbeschichtet, um eine Folie mit einer Dicke von 60 nm auszubilden und die Folie wurde bei 130 °C für 10 Minuten unter einer Stickstoffgasatmosphäre erhitzt, wobei dadurch eine lichtemittierende Schicht ausgebildet wurde;
die Polymerverbindung P4, wie vorstehend in (b) definiert, wurde bei einer Konzentration von 0,25 Gew.-% in 2,2,3,3,4,4,5,5,-Octafluoro-1-pentanol aufgelöst; die resultierende 2,2,3,3,4,4,5,5,-Octafluoro-1-pentanol-Lösung wurde auf die lichtemittierenden Schicht rotationsbeschichtet, um eine Folie mit einer Dicke von 10 nm auszubilden und die Folie wurde bei 130 °C für 10 Minuten unter einer Stickstoffgasatmosphäre erhitzt, wobei dadurch eine Elektronentransportschicht ausgebildet wurde;
das Substrat, das die darauf ausgebildete Elektronentransportschicht trug, wurde in eine Gasphasenabscheidungsmaschine platziert und der Druck wurde auf 1,0 x $10^{-4}$ Pa oder weniger reduziert, dann wurde Natriumfluorid als eine Kathode mit einer Dicke von etwa 4 nm auf die lichtemittierende Schicht gasphasenabgeschieden, dann wurde Aluminium mit einer Dicke von etwa 80 nm auf die Natriumfluoridschicht gasphasenabgeschieden; nach der Gasphasenabscheidung wurde ein Abdichten mit einem Glassubstrat durchgeführt, wobei dadurch eine lichtemittierende Vorrichtung gefertigt wurde;
(e) Ein Glassubstrat wurde mit einer ITO-Folie mit einer Dicke von 45 nm durch ein Zerstäubungsverfahren befestigt, um eine Anode auszubilden; auf der Anode wurde ein Lochinjektionsmittel des Polythiophensulfonsäure-Typs AQ-1200 (hergestellt durch Plectronics) rotationsbeschichtet, um eine Folie mit einer Dicke von 35 nm auszubilden und die Folie wurde auf einer Heizplatte bei 170 °C für 15 Minuten unter einer Luftatmosphäre erhitzt, wobei dadurch eine Lochinjektionsschicht ausgebildet wurde;
die Polymerverbindung P1, wie vorstehend in (b) definiert, die Verbindung G1 und die Verbindung G3, wie vorstehend in (d) definiert, (Polymerverbindung P1/Verbindung G1/Verbindung G3 = 95 Gew.-%/3 Gew.-%/2 Gew.-%) wurden bei einer Konzentration von 0,5 Gew.-% in Chlorobenzol aufgelöst; die resultierende Chlorobenzollösung wurde auf die Lochinjektionsschicht rotationsbeschichtet, um eine Folie mit einer Dicke von 20 nm auszubilden und die Folie wurde auf einer Heizplatte bei 180 °C für 60 Minuten unter einer Stickstoffgasatmosphäre erhitzt, wobei dadurch eine Lochtransportschicht ausgebildet wurde; durch das Erhitzen auf einer Heizplatte bei 180 °C für 60 Minuten wird die Polymerverbindung P1 ein vernetzter Körper der Polymerverbindung P1;
2,8-di(9H-Carbazol-9-yl)dibenzo[b,d]thiophen (DCzDBT) (hergestellt durch Luminescence Technology Corp), die Verbindung G2, wie vorstehend in (b) definiert, die Verbindung G1 und die Verbindung G3, wie vorstehend in (d) definiert, (DCzDBT/Verbindung G2/Verbindung G1/Verbindung G3 = 69 Gew-%/30 Gew.-%/0,6 Gew.-%/0,4 Gew.-%) wurden bei einer Konzentration von 2,0 Gew.-% in Chlorobenzol aufgelöst; die resultierende Chlorobenzollösung wurde auf die Lochtransportschicht rotationsbeschichtet, um eine Folie mit einer Dicke von 60 nm auszubilden und die Folie wurde bei 130 °C für 10 Minuten unter einer Stickstoffgasatmosphäre erhitzt, wobei dadurch eine lichtemittierende Schicht ausgebildet wurde;
die Polymerverbindung P4, wie vorstehend in (b) definiert, wurde bei einer Konzentration von 0,25 Gew.-% in 2,2,3,3,4,4,5,5,-Octafluoro-1-pentanol aufgelöst; die resultierende 2,2,3,3,4,4,5,5,-Octafluoro-1-pentanol-Lösung wurde auf die lichtemittierende Schicht rotationsbeschichtet, um eine Folie mit einer Dicke von 10 nm

auszubilden und die Folie wurde bei 130 °C für 10 Minuten unter einer Stickstoffgasatmosphäre erhitzt, wobei dadurch eine Elektronentransportschicht ausgebildet wurde;

das Substrat, das die darauf ausgebildete Elektronentransportschicht trug, wurde in eine Gasphasenabscheidungsmaschine platziert und der Druck wurde auf 1,0 x $10^{-4}$ Pa oder weniger reduziert, dann wurde Natriumfluorid als eine Kathode mit einer Dicke von etwa 4 nm auf die lichtemittierende Schicht gasphasenabgeschieden, dann wurde Aluminium mit einer Dicke von etwa 80 nm auf die Natriumfluoridschicht gasphasenabgeschieden; nach der Gasphasenabscheidung wurde ein Abdichten mit einem Glassubstrat durchgeführt, wobei dadurch eine lichtemittierende Vorrichtung gefertigt wurde;

(f) Ein Glassubstrat wurde mit einer ITO-Folie mit einer Dicke von 45 nm durch ein Zerstäubungsverfahren befestigt, um eine Anode auszubilden; auf der Anode wurde ein Lochinjektionsmittel des Polythiophensulfonsäure-Typs AQ-1200 (hergestellt durch Plectronics) rotationsbeschichtet, um eine Folie mit einer Dicke von 35 nm auszubilden und die Folie wurde auf einer Heizplatte bei 170 °C für 15 Minuten unter einer Luftatmosphäre erhitzt, wobei dadurch eine Lochinjektionsschicht ausgebildet wurde;

die Polymerverbindung P1, wie vorstehend in (b) definiert, die Verbindung G1 und die Verbindung G3, wie vorstehend in (d) definiert, (Polymerverbindung P1/Verbindung G1/Verbindung G3 = 90 Gew.-%/6 Gew.-%/4 Gew.-%) wurden bei einer Konzentration von 0,5 Gew.-% in Chlorobenzol aufgelöst; die resultierende Chlorobenzollösung wurde auf die Lochinjektionsschicht rotationsbeschichtet, um eine Folie mit einer Dicke von 20 nm auszubilden und die Folie wurde auf einer Heizplatte bei 180 °C für 60 Minuten unter einer Stickstoffgasatmosphäre erhitzt, wobei dadurch eine Lochtransportschicht ausgebildet wurde; durch das Erhitzen auf einer Heizplatte bei 180 °C für 60 Minuten wird die Polymerverbindung P1 ein vernetzter Körper der Polymerverbindung P1;

2,8-di(9H-Carbazol-9-yl)dibenzo[b,d]thiophen (DCzDBT) (hergestellt durch Luminescence Technology Corp), die Verbindung G2, wie vorstehend in (b) definiert, die Verbindung G1 und die Verbindung G3, wie vorstehend in (d) definiert, (DCzDBT/Verbindung G2/Verbindung G1/Verbindung G3 = 69 Gew-%/30 Gew.-%/0,6 Gew.-%/0,4 Gew.-%) wurden bei einer Konzentration von 2,0 Gew.-% in Chlorobenzol aufgelöst; die resultierende Chlorobenzollösung wurde auf die Lochtransportschicht rotationsbeschichtet, um eine Folie mit einer Dicke von 60 nm auszubilden und die Folie wurde bei 130 °C für 10 Minuten unter einer Stickstoffgasatmosphäre erhitzt, wobei dadurch eine lichtemittierende Schicht ausgebildet wurde;

die Polymerverbindung P4, wie vorstehend in (b) definiert, wurde bei einer Konzentration von 0,25 Gew.-% in 2,2,3,3,4,4,5,5,-Octafluoro-1-pentanol aufgelöst; die resultierende 2,2,3,3,4,4,5,5,-Octafluoro-1-pentanol-Lösung wurde auf die lichtemittierende Schicht rotationsbeschichtet, um eine Folie mit einer Dicke von 10 nm auszubilden und die Folie wurde bei 130 °C für 10 Minuten unter einer Stickstoffgasatmosphäre erhitzt, wobei dadurch eine Elektronentransportschicht ausgebildet wurde;

das Substrat, das die darauf ausgebildete Elektronentransportschicht trug, wurde in eine Gasphasenabscheidungsmaschine platziert und der Druck wurde auf 1,0 x $10^{-4}$ Pa oder weniger reduziert, dann wurde Natriumfluorid als eine Kathode mit einer Dicke von etwa 4 nm auf die lichtemittierende Schicht gasphasenabgeschieden, dann wurde Aluminium mit einer Dicke von etwa 80 nm auf die Natriumfluoridschicht gasphasenabgeschieden; nach der Gasphasenabscheidung wurde ein Abdichten mit einem Glassubstrat durchgeführt, wobei dadurch eine lichtemittierende Vorrichtung gefertigt wurde;

(g) Ein Glassubstrat wurde mit einer ITO-Folie mit einer Dicke von 45 nm durch ein Zerstäubungsverfahren befestigt, um eine Anode auszubilden; auf der Anode wurde ein Lochinjektionsmittel des Polythiophensulfonsäure-Typs AQ-1200 (hergestellt durch Plectronics) rotationsbeschichtet, um eine Folie mit einer Dicke von 35 nm auszubilden und die Folie wurde auf einer Heizplatte bei 170 °C für 15 Minuten unter einer Luftatmosphäre erhitzt, wobei dadurch eine Lochinjektionsschicht ausgebildet wurde;

die Polymerverbindung P1, wie vorstehend in (b) definiert, wurde bei einer Konzentration von 0,5 Gew.-% in Chlorobenzol aufgelöst; die resultierende Chlorobenzollösung wurde auf die Lochinjektionsschicht rotationsbeschichtet, um eine Folie mit einer Dicke von 20 nm auszubilden und die Folie wurde auf einer Heizplatte bei 180 °C für 60 Minuten unter einer Stickstoffgasatmosphäre erhitzt, wobei dadurch eine Lochtransportschicht ausgebildet wurde; durch das Erhitzen auf einer Heizplatte bei 180 °C für 60 Minuten wird die Polymerverbindung P1 ein vernetzter Körper der Polymerverbindung P1;

2,8-di(9H-Carbazol-9-yl)dibenzo[b,d]thiophen (DCzDBT) (hergestellt durch Luminescence Technology Corp) und die Verbindung G2, wie vorstehend in (b) definiert, (DCzDBT/Verbindung G2 = 70 Gew-%/30 Gew.-%) wurden bei einer Konzentration von 2,0 Gew.-% in Chlorobenzol aufgelöst; die resultierende Chlorobenzollösung wurde auf die Lochtransportschicht rotationsbeschichtet, um eine Folie mit einer Dicke von 60 nm auszubilden und die Folie wurde bei 130 °C für 10 Minuten unter einer Stickstoffgasatmosphäre erhitzt, wobei dadurch eine lichtemittierende Schicht ausgebildet wurde;

die Polymerverbindung P4, wie vorstehend in (b) definiert, wurde bei einer Konzentration von 0,25 Gew.-% in 2,2,3,3,4,4,5,5,-Octafluoro-1-pentanol aufgelöst; die resultierende 2,2,3,3,4,4,5,5,-Octafluoro-1-pentanol-Lösung wurde auf die lichtemittierende Schicht rotationsbeschichtet, um eine Folie mit einer Dicke von 10 nm auszubilden und die Folie wurde bei 130 °C für 10 Minuten unter einer Stickstoffgasatmosphäre erhitzt, wobei dadurch eine Elektronentransportschicht ausgebildet wurde;

das Substrat, das die darauf ausgebildete Elektronentransportschicht trug, wurde in eine Gasphasenabscheidungsmaschine platziert und der Druck wurde auf 1,0 x $10^{-4}$ Pa oder weniger reduziert, dann wurde Natriumfluorid als eine Kathode mit einer Dicke von etwa 4 nm auf die lichtemittierende Schicht gasphasenabgeschieden, dann wurde Aluminium mit einer Dicke von etwa 80 nm auf die Natriumfluoridschicht gasphasenabgeschieden; nach der Gasphasenabscheidung wurde ein Abdichten mit einem Glassubstrat durchgeführt, wobei dadurch eine lichtemittierende Vorrichtung gefertigt wurde;

(h) Ein Glassubstrat wurde mit einer ITO-Folie mit einer Dicke von 45 nm durch ein Zerstäubungsverfahren befestigt, um eine Anode auszubilden; auf der Anode wurde ein Lochinjektionsmittel des Polythiophensulfonsäure-Typs AQ-1200 (hergestellt durch Plectronics) rotationsbeschichtet, um eine Folie mit einer Dicke von 35 nm auszubilden und die Folie wurde auf einer Heizplatte bei 170 °C für 15 Minuten unter einer Luftatmosphäre erhitzt, wobei dadurch eine Lochinjektionsschicht ausgebildet wurde;

die Polymerverbindung P1, wie vorstehend in (b) definiert, wurde bei einer Konzentration von 0,5 Gew.-% in Chlorobenzol aufgelöst; die resultierende Chlorobenzollösung wurde auf die Lochinjektionsschicht rotationsbeschichtet, um eine Folie mit einer Dicke von 20 nm auszubilden und die Folie wurde auf einer Heizplatte bei 180 °C für 60 Minuten unter einer Stickstoffgasatmosphäre erhitzt, wobei dadurch eine Lochtransportschicht ausgebildet wurde; durch das Erhitzen auf einer Heizplatte bei 180 °C für 60 Minuten wird die Polymerverbindung P1 ein vernetzter Körper der Polymerverbindung P1;

2,8-di(9H-Carbazol-9-yl)dibenzo[b,d]thiophen (DCzDBT) (hergestellt durch Luminescence Technology Corp), die Verbindung G2, wie vorstehend in (b) definiert, die Verbindung G1 und die Verbindung G3, wie vorstehend in (d) definiert, (DCzDBT/Verbindung G2/Verbindung G1/Verbindung G3 = 69 Gew-%/30 Gew.-%/0,6 Gew.-%/0,4 Gew.-%) wurden bei einer Konzentration von 2,0 Gew.-% in Chlorobenzol aufgelöst; die resultierende Chlorobenzollösung wurde auf die Lochtransportschicht rotationsbeschichtet, um eine Folie mit einer Dicke von 60 nm auszubilden und die Folie wurde bei 130 °C für 10 Minuten unter einer Stickstoffgasatmosphäre erhitzt, wobei dadurch eine lichtemittierende Schicht ausgebildet wurde;

die Polymerverbindung P4, wie vorstehend in (b) definiert, wurde bei einer Konzentration von 0,25 Gew.-% in 2,2,3,3,4,4,5,5,-Octafluoro-1-pentanol aufgelöst; die resultierende 2,2,3,3,4,4,5,5,-Octafluoro-1-pentanol-Lösung wurde auf die lichtemittierende Schicht rotationsbeschichtet, um eine Folie mit einer Dicke von 10 nm auszubilden und die Folie wurde bei 130 °C für 10 Minuten unter einer Stickstoffgasatmosphäre erhitzt, wobei dadurch eine Elektronentransportschicht ausgebildet wurde;

das Substrat, das die darauf ausgebildete Elektronentransportschicht trug, wurde in eine Gasphasenabscheidungsmaschine platziert und der Druck wurde auf 1,0 x $10^{-4}$ Pa oder weniger reduziert, dann wurde Natriumfluorid als eine Kathode mit einer Dicke von etwa 4 nm auf die lichtemittierende Schicht gasphasenabgeschieden, dann wurde Aluminium mit einer Dicke von etwa 80 nm auf die Natriumfluoridschicht gasphasenabgeschieden; nach der Gasphasenabscheidung wurde ein Abdichten mit einem Glassubstrat durchgeführt, wobei dadurch eine lichtemittierende Vorrichtung gefertigt wurde;

(i) Eine Anode wurde durch das Bereitstellen einer ITO-Folie mit einer Dicke von 45 nm durch ein Zerstäubungsverfahren auf einem Glassubstrat ausgebildet; auf der Anode wurde ein AQ-1200 (hergestellt durch Plectronics Inc.) als ein Lochinjektionsmittel auf Polythiophensulfonsäurebasis durch ein Rotationsbeschichtungsverfahren angewendet, um eine Folie mit einer Dicke von 35 nm auszubilden und es wurde dann auf einer Heizplatte für 15 Minuten bei 170 °C in einer Umgebungsatmosphäre erhitzt, wobei dadurch eine Lochinjektionsschicht ausgebildet wurde;

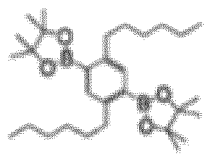
Verbindung 1

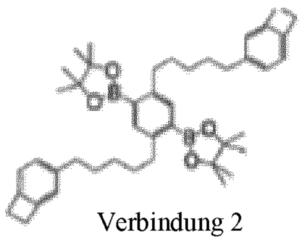
Verbindung 2

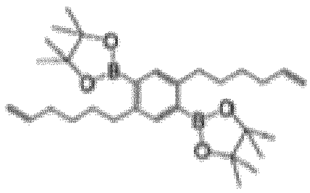
Verbindung 3

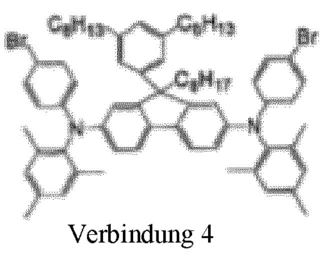

Verbindung 4

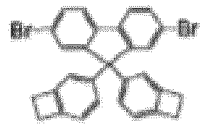

Verbindung 5

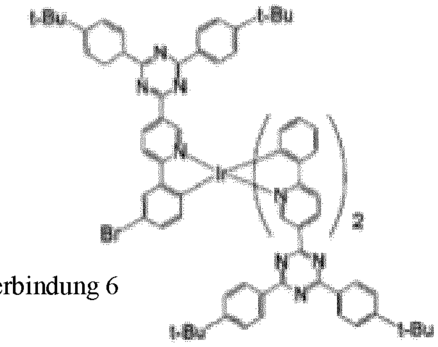

Verbindung 6

Polymerverbindung 1 wurde in Xylen bei einer Konzentration von 0,6 Gew.-% aufgelöst, wobei die Polymerverbindung 1 ein Copolymer ist, das Konstitutionseinheiten umfasst, die aus Verbindung 1, Verbindung 2, Verbindung 3, Verbindung 4, Verbindung 5 und Verbindung 6 bei einem Molverhältnis von 30:10:10:39,4:10:1,2 gewonnen werden; die resultierende Xylenlösung wurde verwendet, um eine Folie mit einer Dicke von 20 nm durch das Rotationsbeschichten auf die Lochinjektionsschicht auszubilden und wurde dann auf einer Heizplatte für 60 Minuten bei 180 °C in einer Stickstoffgasatmosphäre erhitzt, wobei dadurch eine erste lichtemittierende Schicht ausgebildet wurde.

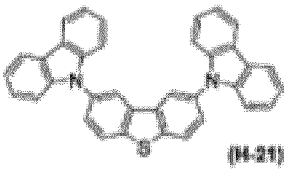

(H-21)

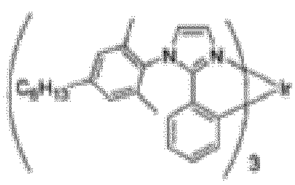

(1-A3-6)

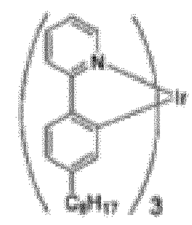

COM-1

Eine erste Tinte wurde durch das Auflösen von Verbindung (H-21), Verbindung (1-A3-6), Verbindung COM-1 (Verbindung (H-21)/Verbindung (1-A3-6)/Verbindung COM-1 (Gewichtsverhältnis = 69,77/30/0,23) in Toluol bei einer Konzentration von 2,0 Gew.-% hergestellt; die erste Tine wurde auf die erste lichtemittierende Schicht durch ein Rotationsbeschichtungsverfahren angewendet, um eine Folie mit einer Dicke von 75 nm auszubilden, und wurde dann auf einer Heizplatte für 10 Minuten bei 130 °C in einer Stickstoffgasatmosphäre erhitzt, wobei dadurch eine zweite lichtemittierende Schicht ausgebildet wurde;

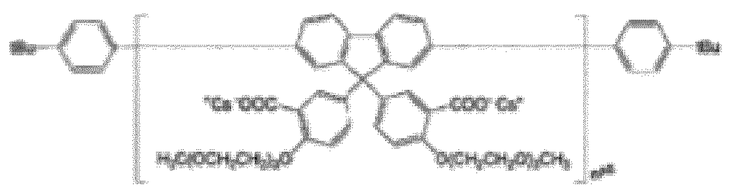

Polymerverbindung 5

eine zweite Tinte wurde durch das Auflösen der Polymerverbindung 5 in 2,2,3,3,4,4,5,5-Octafluoro-1-pentanol bei einer Konzentration von 0,25 Gew.-% hergestellt; die Struktur der Polymerverbindung 5 wird vorstehend gezeigt, wobei $n^{p5}$ einen Polymerisierungsgrad angibt; die zweite Tinte wurde auf die zweite lichtemittierende Schicht durch ein Rotationsbeschichtungsverfahren angewendet, um eine Folie mit einer Dicke von 10 nm auszubilden und dann wurde sie auf einer Heizplatte für 10 Minuten bei 130 °C in einer Stickstoffgasatmosphäre erhitzt, wobei dadurch eine Elektronentransportschicht ausgebildet wurde; auf der Elektronentransportschicht wurde Natriumfluorid als eine Kathode verdampft, um eine Dicke von etwa 7 nm aufzuweisen, und dann wurde Aluminium verdampft, um eine Dicke von etwa 120 nm aufweisen, wodurch eine lichtemittierende Vorrichtung gefertigt wurde;

(j) Eine Anode wurde durch das Bereitstellen einer ITO-Folie mit einer Dicke von 45 nm durch ein Zerstäubungsverfahren auf einem Glassubstrat ausgebildet; auf der Anode wurde ein AQ-1200 (hergestellt durch

Plectronics Inc.) als ein Lochinjektionsmittel auf Polythiophensulfonsäurebasis durch ein Rotationsbeschichtungsverfahren angewendet, um eine Folie mit einer Dicke von 35 nm auszubilden, und es wurde dann auf einer Heizplatte für 15 Minuten bei 170 °C in einer Umgebungsatmosphäre erhitzt, wobei dadurch eine Lochinjektionsschicht ausgebildet wurde;

Polymerverbindung 1, wie in (i) vorstehend definiert, wurde in Xylen bei einer Konzentration von 0,6 Gew.-% aufgelöst; die resultierende Xylenlösung wurde verwendet, um eine Folie mit einer Dicke von 20 nm durch das Rotationsbeschichten auf die Lochinjektionsschicht auszubilden, und wurde dann auf einer Heizplatte für 60 Minuten bei 180 °C in einer Stickstoffgasatmosphäre erhitzt, wobei dadurch eine erste lichtemittierende Schicht ausgebildet wurde;

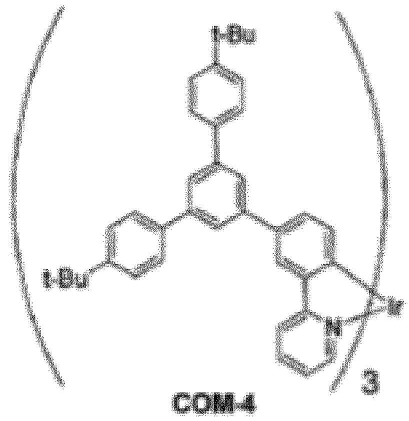

COM-4

eine erste Tinte wurde durch das Auflösen von Verbindung (H-21) und Verbindung (1-A3-6), wie vorstehend in (i) definiert, Verbindung COM-4 (Verbindung (H-21)/Verbindung (1-A3-6)/Verbindung COM-4 Gewichtsverhältnis = 69,6/30/0,4) in Toluol bei einer Konzentration von 2,0 Gew.-% hergestellt; die erste Tine wurde auf die erste lichtemittierende Schicht durch ein Rotationsbeschichtungsverfahren angewendet, um eine Folie mit einer Dicke von 75 nm auszubilden, und wurde dann auf einer Heizplatte für 10 Minuten bei 130 °C in einer Stickstoffgasatmosphäre erhitzt, wobei dadurch eine zweite lichtemittierende Schicht ausgebildet wurde;

eine zweite Tinte wurde durch das Auflösen der Polymerverbindung 5, wie vorstehend in (i) definiert, in 2,2,3,3,4,4,5,5-Octafluoro-1-pentanol bei einer Konzentration von 0,25 Gew.-% hergestellt; die zweite Tinte wurde auf die zweite lichtemittierende Schicht durch ein Rotationsbeschichtungsverfahren angewendet, um eine Folie mit einer Dicke von 10 nm auszubilden und dann wurde sie auf einer Heizplatte für 10 Minuten bei 130 °C in einer Stickstoffgasatmosphäre erhitzt, wobei dadurch eine Elektronentransportschicht ausgebildet wurde; auf der Elektronentransportschicht wurde Natriumfluorid als eine Kathode verdampft, um eine Dicke von etwa 7 nm aufzuweisen, und dann wurde Aluminium verdampft, um eine Dicke von etwa 120 nm aufweisen, wodurch eine lichtemittierende Vorrichtung gefertigt wurde;

(k) Eine Anode wurde durch das Bereitstellen einer ITO-Folie mit einer Dicke von 45 nm durch ein Zerstäubungsverfahren auf einem Glassubstrat ausgebildet; auf der Anode wurde ein AQ-1200 (hergestellt durch Plectronics Inc.) als ein Lochinjektionsmittel auf Polythiophensulfonsäurebasis durch ein Rotationsbeschichtungsverfahren angewendet, um eine Folie mit einer Dicke von 35 nm auszubilden, und es wurde dann auf einer Heizplatte für 15 Minuten bei 170 °C in einer Umgebungsatmosphäre erhitzt, wobei dadurch eine Lochinjektionsschicht ausgebildet wurde;

Polymerverbindung 1, wie in (i) vorstehend definiert, wurde in Xylen bei einer Konzentration von 0,6 Gew.-% aufgelöst; die resultierende Xylenlösung wurde verwendet, um eine Folie mit einer Dicke von 20 nm durch das Rotationsbeschichten auf die Lochinjektionsschicht auszubilden, und wurde dann auf einer Heizplatte für 60 Minuten bei 180 °C in einer Stickstoffgasatmosphäre erhitzt, wobei dadurch eine erste lichtemittierende Schicht ausgebildet wurde;

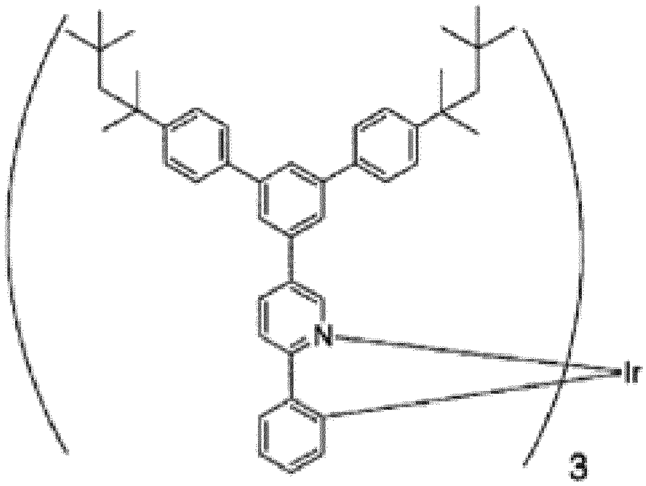

COM-9

eine erste Tinte wurde durch das Auflösen von Verbindung (H-21), Verbindung (1-A3-6), Verbindung COM-4, wie vorstehend in (i) und (j) definiert und Verbindung COM-9 (Verbindung (H-21)/Verbindung (1-A3-6)/Verbindung COM-4/Verbindung COM-9 Gewichtsverhältnis = 69,6/30/0,2/0,2) in Toluol bei einer Konzentration von 2,0 Gew.-% hergestellt; die erste Tine wurde auf die erste lichtemittierende Schicht durch ein Rotationsbeschichtungsverfahren angewendet, um eine Folie mit einer Dicke von 75 nm auszubilden, und wurde dann auf einer Heizplatte für 10 Minuten bei 130 °C in einer Stickstoffgasatmosphäre erhitzt, wobei dadurch eine zweite lichtemittierende Schicht ausgebildet wurde;
eine zweite Tinte wurde durch das Auflösen der Polymerverbindung 5, wie vorstehend in (i) definiert, in 2,2,3,3,4,4,5,5-Octafluoro-1-pentanol bei einer Konzentration von 0,25 Gew.-% hergestellt; die zweite Tinte wurde auf die zweite lichtemittierende Schicht durch ein Rotationsbeschichtungsverfahren angewendet, um eine Folie mit einer Dicke von 10 nm auszubilden und dann wurde sie auf einer Heizplatte für 10 Minuten bei 130 °C in einer Stickstoffgasatmosphäre erhitzt, wobei dadurch eine Elektronentransportschicht ausgebildet wurde; auf der Elektronentransportschicht wurde Natriumfluorid als eine Kathode verdampft, um eine Dicke von etwa 7 nm aufzuweisen, und dann wurde Aluminium verdampft, um eine Dicke von etwa 120 nm aufweisen, wodurch eine lichtemittierende Vorrichtung gefertigt wurde.

**2.** Lichtemittierende Vorrichtung nach Anspruch 1, wobei die phosphoreszierende Verbindung keine phosphoreszierende Verbindung ist, die durch eine der folgenden Formeln COM-17, B2 oder B3 dargestellt wird:

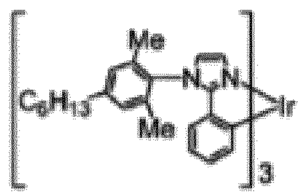

COM-17

,

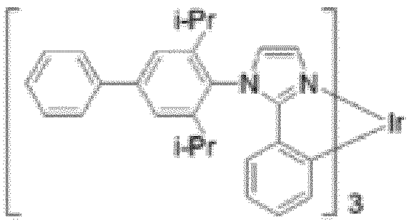

Phosphoreszierende Verbindung B2 oder

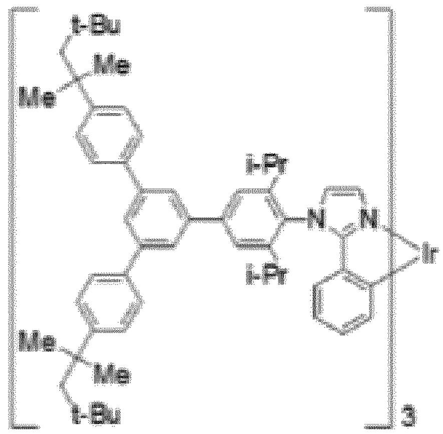

Phosphoreszierende Verbindung B3

**3.** Lichtemittierende Vorrichtung nach Anspruch 1, wobei die phosphoreszierende Verbindung mit Formel (1) eine phosphoreszierende Verbindung ist, die durch die folgenden Formeln COM-18 bis COM-28 dargestellt wird:

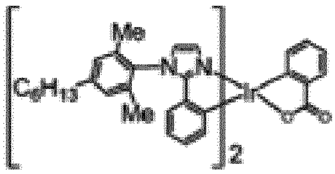

COM-18

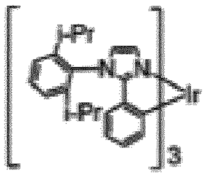

COM-19

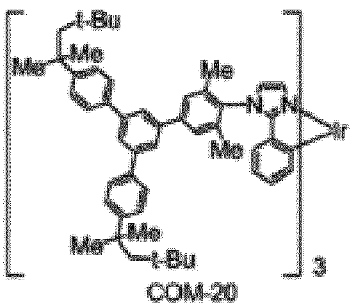

COM-20

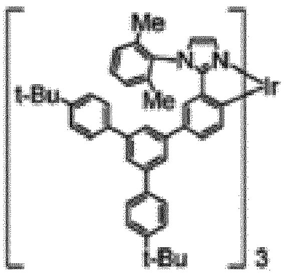

COM-21

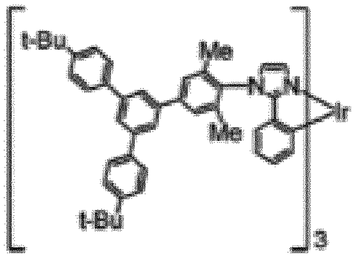

COM-22

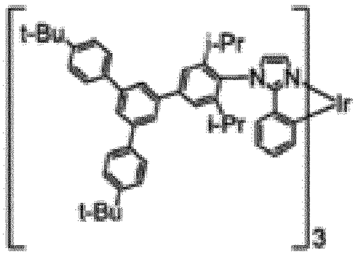

COM-23

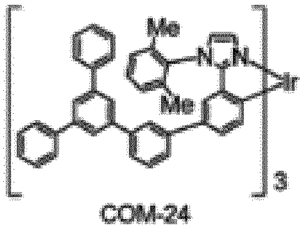

COM-24

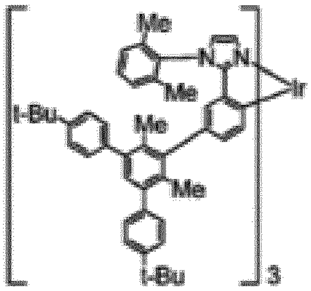

COM-25

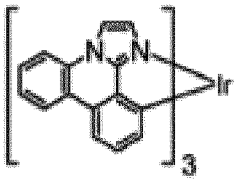

COM-26

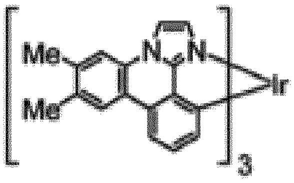

COM-27

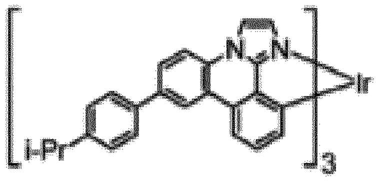

COM-28

4. Lichtemittierende Vorrichtung nach einem der Ansprüche 1 bis 3, wobei der Wert von $(Y_1 \times 1000)/X_1$ 0,65 oder mehr ist.

5. Lichtemittierende Vorrichtung nach einem der Ansprüche 1 bis 4, wobei wenigstens eine, die aus der Gruppe, bestehend aus $R^{11A}$, $R^{12A}$, $R^{13A}$, $R^{21A}$, $R^{22A}$, $R^{23A}$ und $R^{24A}$ ausgewählt ist, eine Gruppe ist, die durch die Formeln (D-A) oder (D-B) dargestellt wird:

[Chemische Formel 2]

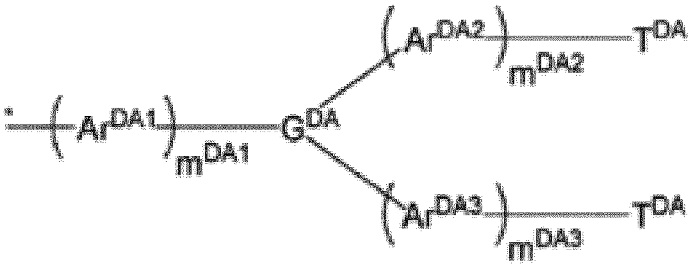

(D-A)

wobei

$m^{DA1}$, $m^{DA2}$ und $m^{DA3}$ jeweils unabhängig eine ganze Zahl von 0 oder mehr darstellen;
$G^{DA}$ ein Stickstoffatom, eine aromatische Kohlenwasserstoffgruppe oder eine heterocyclische Gruppe darstellt und diese Gruppen jeweils optional einen Substituenten aufweisen;
$Ar^{DA1}$, $Ar^{DA2}$ und $Ar^{DA3}$ jeweils unabhängig eine Arylengruppe oder eine zweiwertige heterocyclische Gruppe darstellen und diese Gruppen jeweils optional einen Substituenten aufweisen; und wenn mehrere $Ar^{DA1}$, $Ar^{DA2}$ und $Ar^{DA3}$ vorhanden sind, können sie dieselben oder bei jedem Auftreten unterschiedlich sein; und
$T^{DA}$ eine Arylgruppe oder eine einwertige heterocyclische Gruppe darstellt und diese Gruppen jeweils optional einen Substituenten aufweisen; und die mehreren $T^{DA}$ dieselben oder unterschiedlich sein können; und
* eine Bindungsstelle darstellt und

[Chemische Formel 3]

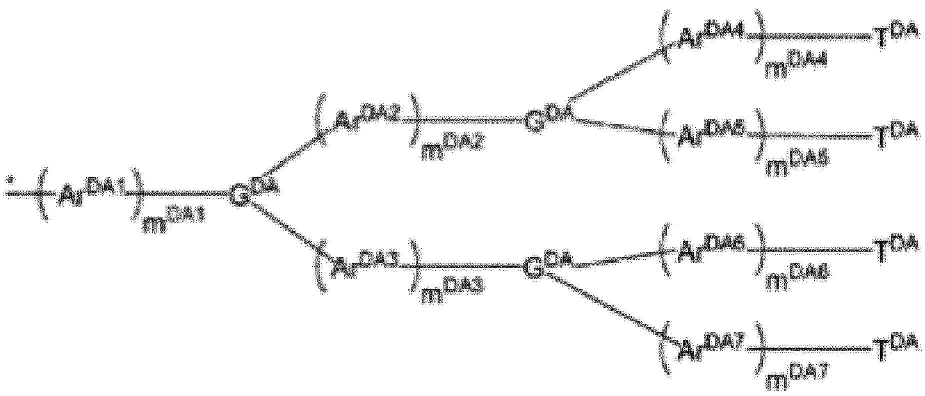

(D-B)

wobei

$m^{DA1}$, $m^{DA2}$, $m^{DA3}$, $m^{DA4}$, $m^{DA5}$, $m^{DA6}$ und $m^{DA7}$ jeweils unabhängig eine ganze Zahl von 0 oder mehr darstellen;
$G^{DA}$ ein Stickstoffatom, eine aromatische Kohlenwasserstoffgruppe oder eine heterocyclische Gruppe darstellt und diese Gruppen jeweils optional einen Substituenten aufweisen und die mehreren $G^{DA}$ dieselben oder unterschiedlich können sein;
$Ar^{DA1}$, $Ar^{DA2}$, $Ar^{DA1}$, $Ar^{DA4}$, $Ar^{DA1}$, $Ar^{DA6}$ und $Ar^{DA7}$ jeweils unabhängig eine Arylengruppe oder eine zweiwertige heterocyclische Gruppe darstellen und diese Gruppen jeweils unabhängig einen Substituenten aufweisen; und wenn mehrere $Ar^{DA1}$, $Ar^{DA2}$, $Ar^{DA3}$, $Ar^{DA4}$, $Ar^{DA5}$, $Ar^{DA6}$ und $Ar^{DA7}$ vorhanden sind, sie dieselben oder unterschiedlich sein können;
$T^{DA}$ eine Arylgruppe oder eine einwertige heterocyclische Gruppe darstellt und diese Gruppen jeweils optional einen Substituenten aufweisen und die mehreren $T^{DA}$ dieselben oder unterschiedlich sein können; und
* eine Bindungsstelle darstellt.

**6.** Lichtemittierende Vorrichtung nach einem der Ansprüche 1, 4 oder 5, wobei die phosphoreszierende Verbindung durch die Formel (1-1) oder (1-2) dargestellt wird:

[Chemische Formel 4]

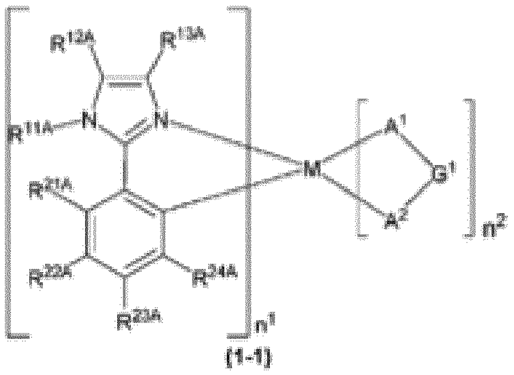

(1-1)

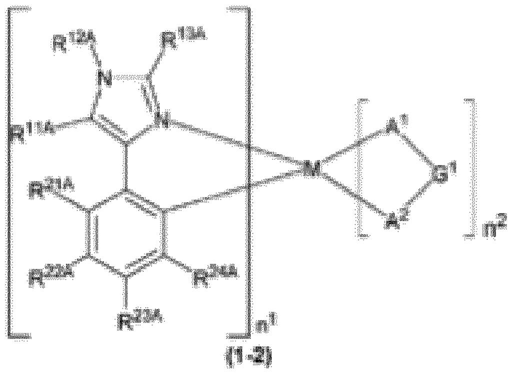

(1-2)

wobei M, $n^1$, $n^2$, $R^{11A}$, $R^{12A}$, $R^{13A}$, $R^{21A}$, $R^{22A}$, $R^{23A}$, $R^{24A}$ und $A^1$-$G^1$-$A^2$ dieselben Bedeutungen wie vorstehend beschrieben darstellen.

**7.** Lichtemittierende Vorrichtung nach einem der Ansprüche 1 bis 6, wobei die vernetzbare Polymerverbindung eine Konstitutionseinheit eine Konstitutionseinheit umfasst, die durch die Formel (2) dargestellt wird:

[Chemische Formel 5]

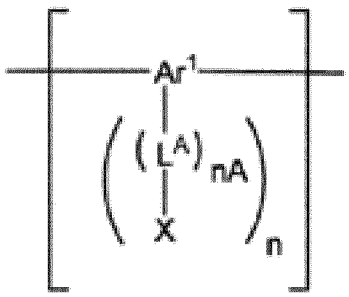

(2)

wobei

$n^A$ eine ganze Zahl von 0 bis 5 darstellt und n 1 oder 2 darstellt;

$Ar^1$ eine aromatische Kohlenstoffgruppe oder eine heterocyclische Gruppe darstellt und diese Gruppen jeweils optional einen Substituenten aufweisen;
$L^A$ eine Alkylengruppe, eine Cycloalkylengruppe, eine Arylengruppe, eine zweiwertige hetereocyclische Gruppe, eine Gruppe, die durch -NR'- dargestellt wird, ein Sauerstoffatom oder ein Schwefelatom darstellt und diese Gruppen jeweils optional einen Substituenten aufweisen; R' ein Wasserstoffatom, eine Alkylgruppe, eine Cycloalkylgrupe, eine Arylgruppe oder eine einwertige heterocyclische Gruppe darstellt und diese Gruppen jeweils optional einen Substituenten aufweisen: und wenn mehrere $L^A$ vorhanden sind, sie dieselben oder unterschiedlich sein können; und
X eine vernetzbare Gruppe darstellt, die aus der Gruppe A von vernetzbaren Gruppen ausgewählt ist, und wenn mehrere X vorhanden sind, sie dieselben oder unterschiedlich sein können.

8. Lichtemittierende Vorrichtung nach einem der Ansprüche 1 bis 7, wobei die vernetzbare Polymerverbindung eine Konstitutionseinheit umfasst, die durch die Formel (3) dargestellt ist:

[Chemische Formel 6]

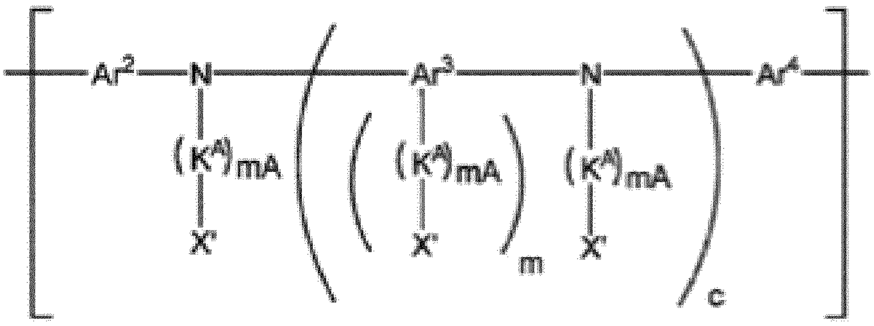

(3)

wobei

mA eine ganze Zahl von 0 bis 5 darstellt, m eine ganze Zahl von 1 bis 4 darstellt, c 0 oder 1 darstellt und wenn mehrere mA vorhanden sind, sie dieselben oder unterschiedlich sein können;
$Ar^3$ eine aromatische Kohlenwasserstoffgruppe, eine heterocyclische Gruppe oder eine Gruppe darstellt, in der wenigstens ein aromatischer Kohlenwasserstoffring und wenigstens ein heterocyclischer Ring direkt aneinander gebunden sind, und diese Gruppen optional einen Substituenten aufweisen;
$Ar^2$ und $Ar^4$ jeweils unabhängig eine Arylengruppe oder eine zweiwertige heterocyclische Gruppe darstellen und diese Gruppen jeweils optional einen Substituenten aufweisen;
$Ar^2$, $Ar^3$ und $Ar^4$ jeweils direkt oder über ein Sauerstoffatom oder ein Schwefelatom an eine Gruppe gebunden sein können, die sich von dieser Gruppe unterscheidet und die an dem Stickstoffatom befestigt ist, an dem die Gruppe befestigt ist, wobei dadurch ein Ring ausgebildet wird;
$K^A$ eine Alkylengruppe, eine Cycloalkylengruppe, eine Arylengruppe, eine zweiwertige heterocyclische Gruppe, eine Gruppe, die durch -NR"- dargestellt wird, ein Sauerstoffatom oder ein Schwefelatom darstellt und diese Gruppen jeweils optional einen Substituenten aufweisen; und R" ein Wasserstoffatom ein Wasserstoffatom, eine Alkylgruppe, eine Cycloalkylgruppe, eine Arylgruppe oder eine einwertige heterocyclische Gruppe darstellt und diese Gruppen jeweils optional einen Substituenten aufweisen;
und wenn mehrere $K^A$ vorhanden sind, sie dieselben oder unterschiedlich sein können; und
X' eine vernetzbare Gruppe darstellt, die aus der Gruppe A von vernetzbaren Gruppen, einem Wasserstoffatom, einer Alkylgruppe, einer Cycloalkylgruppe, einer Arylgruppe oder einer einwertigen hetercyclischen Gruppe ausgewählt ist, und diese Gruppen jeweils optional einen Substituenten aufweisen können; und wenn mehrere X' vorhanden sind, sie dieselben oder unterschiedlich sein können; vorausgesetzt, dass wenigstens ein X' eine vernetzbare Gruppe ist, die aus der Gruppe A von vernetzbaren Gruppen ausgewählt ist.

9. Lichtemittierende Vorrichtung nach einem der Ansprüche 1 bis 8, wobei die erste organische Schicht ferner eine Polymerverbindung umfasst, die eine Konstitutionseinheit umfasst, die durch die Formel (Y) dargestellt ist:

[Chemische Formel 8] $-[Ar^{Y1}]-$ (Y)

wobei $Ar^{Y1}$ eine Arylengruppe, eine zweiwertige heterocyclische Gruppe oder eine zweiwertige Gruppe darstellt, in der wenigstens eine Arylengruppe und wenigstens eine zweiwertige heterocyclische Gruppe direkt aneinander gebunden sind, und diese Gruppen jeweils optional einen Substituenten aufweisen.

**10.** Lichtemittierende Vorrichtung nach einem der Ansprüche 1 bis 8, wobei die erste organische Schicht ferner eine Verbindung umfasst, die durch die Formel (H-1) dargestellt ist:

[Chemische Formel 9]

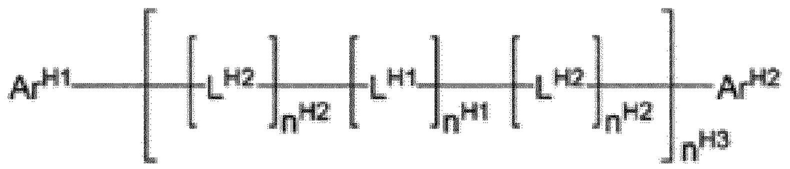

**(H-1)**

wobei

$Ar^{H1}$ und $Ar^{H2}$ jeweils unabhängig eine Arylgruppe oder eine einwertige heterocyclische Gruppe darstellen und diese Gruppen jeweils optional einen Substituenten aufweisen;
$n^{H1}$ und $n^{H2}$ jeweils unabhängig 0 oder 1 darstellen; wenn mehrere $n^{H1}$ vorhanden sind, sie dieselben oder unterschiedlich sein können; und wenn mehrere $n^{H2}$ vorhanden sind, sie dieselben oder unterschiedlich sein können;
$n^{H3}$ eine ganze Zahl von 0 oder mehr darstellt;
$L^{H1}$ eine Arylengruppe, eine zweiwertige heterocyclische Gruppe oder eine Gruppe, die durch $-[C(R^{H11})_2]n^{H11}-$ dargestellt ist, darstellt und diese Gruppen jeweils optional einen Substituenten aufweisen; und wenn mehrere $L^{H1}$ vorhanden sind, sie dieselben oder unterschiedlich sein können;
$n^{H11}$ eine ganze Zahl von 1 bis 10 darstellt; $R^{H11}$ ein Wasserstoffatom, eine Alkylgruppe, eine Cycloalkylgruppe, eine Alkoxygruppe, eine Cycloalkoxygruppe, eine Arylgruppe oder eine einwertige heterocyclische Gruppe darstellt und diese Gruppen jeweils optional einen Substituenten aufweisen; die mehreren $R^{H11}$ dieselben oder unterschiedlich sein können und zusammen kombiniert werden können, um einen Ring zusammen mit den Kohlenstoffatomen, an die sie befestigt sind, auszubilden;
$L^{H2}$ eine Gruppe darstellt, die durch $-N(-L^{H21}-R^{H21})-$ dargestellt ist; und wenn mehrere $L^{H2}$ vorhanden sind, sie dieselben oder unterschiedlich sein können; und
$L^{H21}$ eine Einfachbindung, eine Arylengruppe oder eine zweiwertige heterocyclische Gruppe darstellt und diese Gruppen jeweils optional einen Substituenten aufweisen; und $R^{H21}$ ein Wasserstoffatom, eine Alkylgruppe, eine Cycloalkylgruppe, eine Arylgruppe oder eine einwertige heterocyclische Gruppe darstellt und diese Gruppen jeweils optional einen Substituenten aufweisen.

## Revendications

**1.** Dispositif électroluminescent, comprenant :

une anode ;
une cathode ;
une première couche organique disposée entre l'anode et la cathode ; et
une deuxième couche organique disposée entre l'anode et la première couche organique et adjacente à la première couche organique,
dans lequel la première couche organique comprend un composé phosphorescent représenté par la formule (1) ;
la deuxième couche organique comprend un produit de polymère durci formé à partir d'une composition de polymère dans laquelle un ou deux composés de polymère ou plus incluant un composé de polymère réticulable ayant au moins un groupe réticulable choisi dans le groupe A de groupes réticulables sont composés ; et
vis-à-vis de chaque motif monomère constituant les composés de polymère, une valeur x obtenue par multiplication du rapport molaire C entre chaque motif de monomère et une quantité molaire totale de l'ensemble des motifs de monomère par un poids moléculaire M de chaque motif de monomère, et une valeur y obtenue par multiplication du rapport molaire C par un nombre n des groupes réticulables dans chaque motif de monomère sont déterminées, une valeur de $(Y_1 \times 1000)/Xi$, calculée à partir de Xi qui est le total des valeurs x et $Y_1$ qui

est le total des valeurs y, étant de 0,5 ou plus : [formule chimique 1]

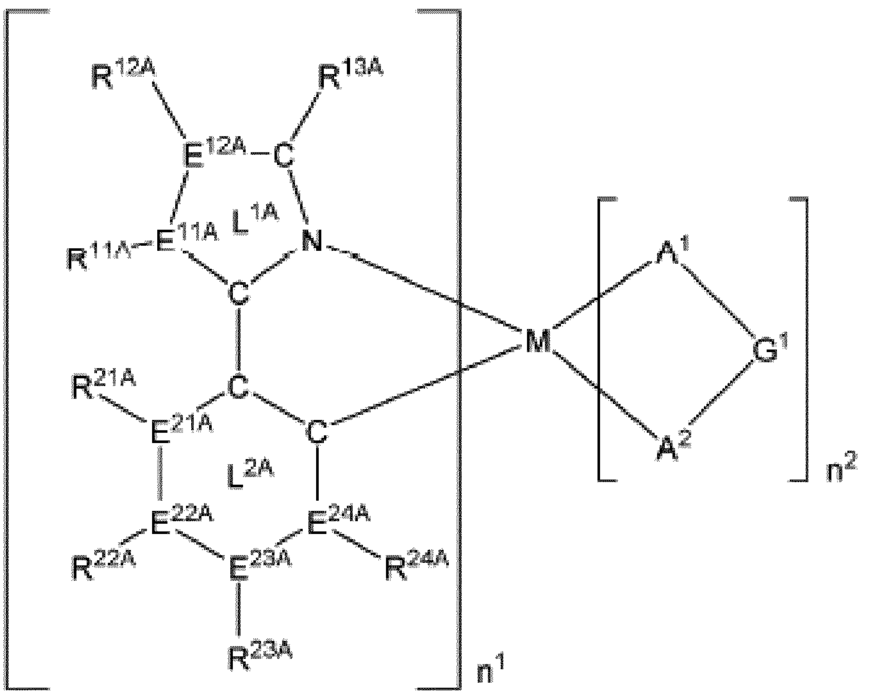

(1)

où,

M représente un atome de ruthénium, un atome de rhodium, un atome de palladium, un atome d'iridium ou un atome de platine ;

$n^1$ représente un entier de 1 à 3, $n^2$ représente un entier de 0 ou 2, et $n^1 + n^2$ vaut 2 ou 3 ; et $n^1 + n^2$ vaut 3 lorsque M est un atome de ruthénium, un atome de rhodium ou un atome d'iridium, tandis que $n^1 + n^2$ vaut 2 lorsque M est un atome de palladium ou un atome de platine ;

$E^{11A}$, $E^{12A}$, $E^{21A}$, $E^{22A}$, $E^{23A}$ et $E^{24A}$ représentent chacun indépendamment un atome d'azote ou un atome de carbone ; lorsqu'une pluralité de $E^{11A}$, $E^{12A}$, $E^{21A}$, $E^{22A}$, $E^{23A}$ et $E^{24A}$ sont présents, ils peuvent être identiques ou différents à chaque occurrence, à condition que l'un de $E^{11A}$ et $E^{12A}$ soit un atome de carbone et que l'autre soit un atome d'azote ; et lorsque $E^{21A}$, $E^{22A}$, $E^{23A}$ et $E^{24A}$ sont des aromes d'azote, $R^{21A}$, $R^{22A}$, $R^{23A}$ et $R^{24A}$ ne sont pas présents ;

$R^{11A}$, $R^{12A}$, $R^{13A}$, $R^{21A}$, $R^{22A}$, $R^{23A}$ et $R^{24A}$ représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un groupe amino substitué ou un atome d'halogène, et ces groupes ont éventuellement chacun un substituant ; lorsqu'une pluralité de $R^{11A}$, $R^{12A}$, $R^{13A}$, $R^{21A}$, $R^{22A}$, $R^{23A}$ et $R^{24A}$ sont présents, ils peuvent être identiques ou différents à chaque occurrence ; et $R^{11A}$ et $R^{12A}$, $R^{12A}$ et $R^{13A}$, $R^{11A}$ et $R^{21A}$, $R^{21A}$ et $R^{22A}$, $R^{22A}$ et $R^{23A}$, et $R^{23A}$ et $R^{24A}$ peuvent chacun être combinés ensemble pour former un cycle conjointement aux atomes auxquels ils sont attachés ;

un cycle $L^{1A}$ représente un cycle imidazole constitué d'un atome d'azote, de deux atomes de carbone, de $E^{11A}$ et $E^{12A}$;

un cycle $L^{2A}$ représente un cycle benzène, un cycle pyridine ou un cycle pyrimidine constitué de deux atomes de carbone, de $E^{21A}$, $E^{22A}$, $E^{23A}$ et $E^{24A}$ ; et

$A^1$-$G^1$-$A^2$ représente un ligand bidentate anionique ; $A^1$ et $A^2$ représentent chacun indépendamment un atome de carbone, ou un atome d'azote, et ces atomes peuvent être des atomes constituant un cycle ; $G^1$ représente une liaison simple, ou un groupe atomique constituant un ligand bidentate anionique conjointement à $A^1$ et $A^2$ ; et lorsqu'une pluralité de $A^1$-$G^1$-$A^2$ sont présents, ils peuvent être identiques ou différents à chaque occurrence

(Groupe A de groupes réticulables)

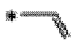
(XL-1)

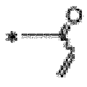
(XL-2)

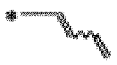
(XL-3)

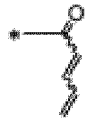
(XL-4)

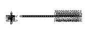
(XL-5)

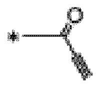
(XL-6)

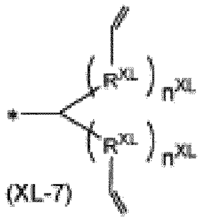
(XL-7)

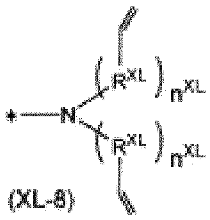
(XL-8)

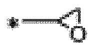
(XL-9)

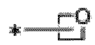
(XL-10)

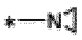
(XL-11)

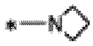
(XL-12)

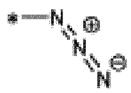
(XL-13)

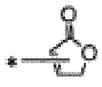
(XL-14)

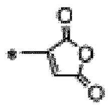
(XL-15)

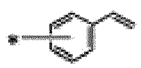
(XL-16)

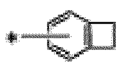
(XL-17)

où $R^{XL}$ représente un groupe méthylène, un atome d'oxygène ou un atome de soufre, et $n^{XL}$ représente un entier de 0 à 5 ; lorsqu'une pluralité de $R^{XL}$ sont présents, ils peuvent être identiques ou différents ; et lorsqu'une pluralité de $n^{XL}$ sont présents, ils peuvent être identiques ou différents ; * représente une position de liaison ; et ces groupes réticulables ont éventuellement chacun un substituant ;
dans lequel le dispositif électroluminescent n'est pas un dispositif électroluminescent préparé par l'un quelconque des procédés (a) à (k) suivants :

(a) On a attaché un film d'ITO d'une épaisseur de 45 nm à un substrat en verre par un procédé de pulvérisation cathodique, pour former une anode ; sur l'anode, on a déposé à la tournette un matériau d'injection de trous de type polythiophène-acide sulfonique AQ-1200 (fabriqué par Plectronics) pour former un film avec une épaisseur de 35 nm, et on a chauffé le film sur une plaque chaude à 170 °C pendant 15 minutes sous atmosphère d'air, pour former une couche d'injection de trous ;

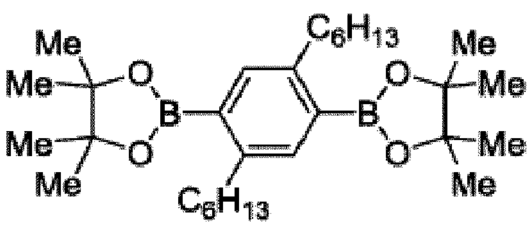
Composé CM1

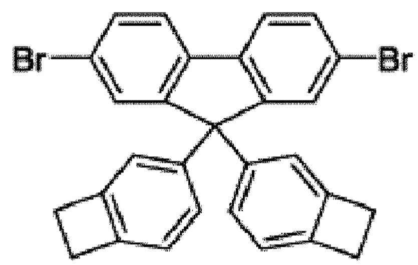
Composé CM2

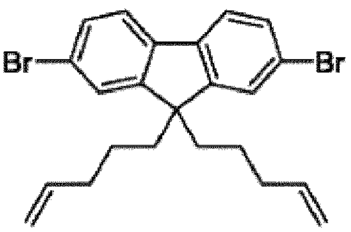

Composé CM3

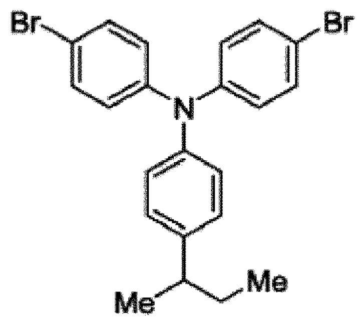

Composé CM4

On a dissous un composé de polymère HTL-1 à une concentration de 0,7 % en poids dans du xylène, où HTL-1 est un copolymère constitué de motifs constitutifs dérivés des composés de monomère CM1, CM2, CM3 et CM4 à un rapport molaire de 50:5:5:40 ; on a déposé à la tournette la solution de xylène résultante sur la couche d'injection de trous pour former un film avec une épaisseur de 20 nm, et on a chauffé le film sur une plaque chaude à 180 °C pendant 60 minutes sous atmosphère d'azote gazeux, pour former une couche de transport de trous ;

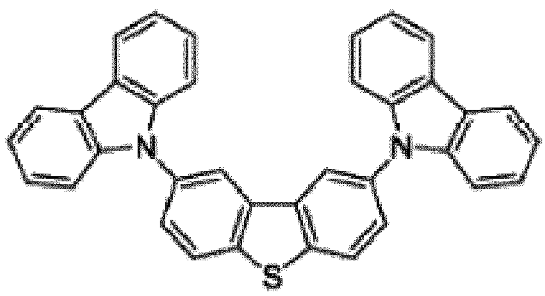

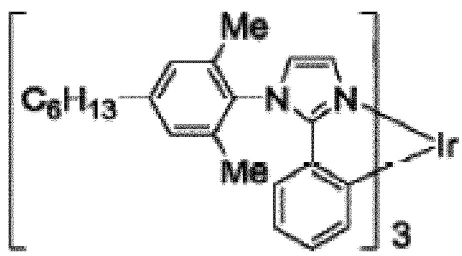

Complexe métallique 3

Composé de faible poids moléculaire SM1

On a dissous un composé de faible poids moléculaire SM1 (fabriqué par Luminescense Technology) et un complexe métallique 3 (composé de faible poids moléculaire SM1/complexe métallique 3 = 75 % en poids/25 % en poids) à une concentration de 2,0 % en poids dans du toluène ; on a déposé à la tournette la solution de toluène résultante sur la couche de transport de trous pour former un film avec une épaisseur de 75 nm, et on a chauffé le film à 130 °C pendant 10 minutes sous atmosphère d'azote gazeux, pour former une couche électroluminescente ;

On a placé le substrat portant la couche électroluminescente formé sur celui-ci dans une machine de dépôt en phase vapeur, et on a réduit la pression à 1,0 x $10^{-4}$ Pa ou moins, puis on a déposé en phase vapeur, en tant que cathode, du fluorure de sodium avec une épaisseur d'environ 7 nm sur la couche électroluminescente, puis on a déposé en phase vapeur de l'aluminium avec une épaisseur d'environ 120 nm sur la couche de fluorure de sodium ; après le dépôt en phase vapeur, on a réalisé un scellage à l'aide d'un substrat en verre, pour fabriquer un dispositif électroluminescent ;

(b) On a attaché un substrat en verre avec un film d'ITO avec une épaisseur de 45 nm par un procédé de pulvérisation cathodique, pour former une anode ; sur l'anode, on a déposé à la tournette un agent d'injection de trous de type polythiophène-acide sulfonique AQ-1200 (fabriqué par Plectronics) pour former un film avec une épaisseur de 35 nm, et on a chauffé le film sur une plaque chaude à 170 °C pendant 15 minutes sous atmosphère d'air, pour ainsi former une couche d'injection de trous ;

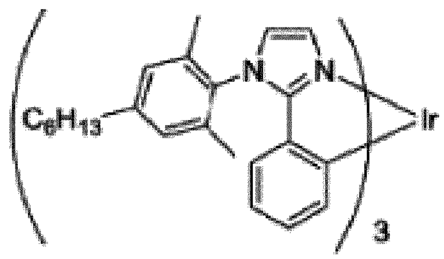

Composé G2

On a dissous le composé de polymère P1 et le composé G2 (composé de polymère P1/composé G2 = 85 % en poids/15 % en poids) à une concentration de 0,5 % en poids dans du chlorobenzène, où P1 est un copolymère constitué de motifs constitutifs dérivés des composés de monomère CM1, CM2, CM3 et CM4 tels que définis en (a) ci-avant à un rapport molaire de 50:5:5:40 ; on a déposé à la tournette la solution de chlorobenzène résultante sur la couche d'injection de trous pour former un film avec une épaisseur de 20 nm, et on a chauffé le film sur une plaque chaude à 180 °C pendant 60 minutes sous atmosphère d'azote gazeux, pour ainsi former une couche de transport de trous ; par le chauffage sur une plaque chaude à 180 °C pendant 60 minutes, le composé de polymère P1 devient un corps réticulé du composé de polymère P1 ;

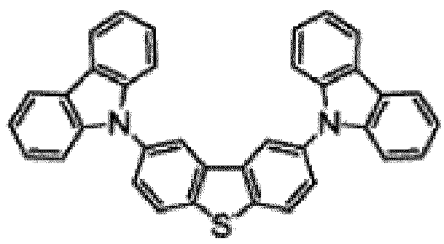

DCzDBT

On a dissous du 2,8-di(9H-carbazol-9-yl)dibenzo[b,d]thiophène (DCzDBT) (fabriqué par Luminescence Technology Corp) et le composé G2 (DCzDBT/composé G2 = 70 % en poids/30 % en poids) à une concentration de 2,0 % en poids dans du chlorobenzène ; on a déposé à la tournette la solution de chlorobenzène résultante sur la couche de transport de trous pour former un film avec une épaisseur de 60 nm, et on a chauffé le film à 130 °C pendant 10 minutes sous atmosphère d'azote gazeux, pour ainsi former une couche électroluminescente ;

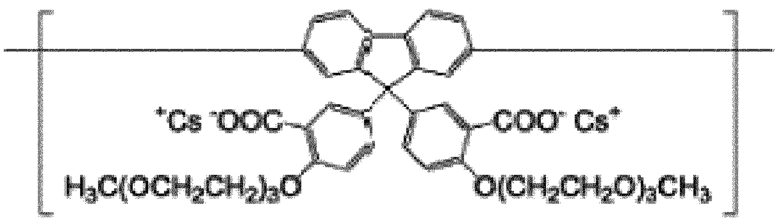

Motif répété de composé de polymère P4

On a dissous le composé de polymère P4 à une concentration de 0,25 % en poids dans du 2,2,3,3,4,4,5,5-octafluoro-1-pentanol ; on a déposé à la tournette la solution de 2,2,3,3,4,4,5,5-octafluoro-1-pentanol résultante sur la couche électroluminescente pour former un film avec une épaisseur de 10 nm, et on a chauffé le film à 130 °C pendant 10 minutes sous atmosphère d'azote gazeux, pour ainsi former une couche de transport d'électrons ;

On a placé le substrat portant la couche de transport d'électrons formée sur celui-ci dans une machine de dépôt en phase vapeur, et on a réduit la pression à 1,0 x $10^{-4}$ Pa ou moins, puis on a déposé en phase vapeur, en tant que cathode, du fluorure de sodium avec une épaisseur d'environ 4 nm sur la couche électroluminescente, puis on a déposé en phase vapeur de l'aluminium avec une épaisseur d'environ 80 nm sur la couche de fluorure

de sodium ; après le dépôt en phase vapeur, on a réalisé un scellage avec un substrat en verre, pour ainsi fabriquer un dispositif électroluminescent ;

(c) On a attaché un substrat en verre avec un film d'ITO avec une épaisseur de 45 nm par un procédé de pulvérisation cathodique, pour former une anode ; sur l'anode, on a déposé à la tournette un agent d'injection de trous de type polythiophène-acide sulfonique AQ-1200 (fabriqué par Plectronics) pour former un film avec une épaisseur de 35 nm, et on a chauffé le film sur une plaque chaude à 170 °C pendant 15 minutes sous atmosphère d'air, pour ainsi former une couche d'injection de trous ;

On a dissous le composé de polymère P1 et le composé G2 tel que défini en (b) ci-avant (composé de polymère P1/composé G2 = 70 % en poids/30 % en poids) à une concentration de 0,5 % en poids dans du chlorobenzène ; on a déposé à la tournette la solution de chlorobenzène résultante sur la couche d'injection de trous pour former un film avec une épaisseur de 20 nm, et on a chauffé le film sur une plaque chaude à 180 °C pendant 60 minutes sous atmosphère d'azote gazeux, pour ainsi former une couche de transport de trous ; par le chauffage sur une plaque chaude à 180 °C pendant 60 minutes, le composé de polymère P1 devient un corps réticulé du composé de polymère P1 ;

On a dissous du 2,8-di(9H-carbazol-9-yl)dibenzo[b,d]thiophène (DCzDBT) (fabriqué par Luminescence Technology Corp) et le composé G2 tel que défini en (b) ci-avant (DCzDBT/composé G2 = 70 % en poids/30 % en poids) à une concentration de 2,0 % en poids dans du chlorobenzène ; on a déposé à la tournette la solution de chlorobenzène résultante sur la couche de transport de trous pour former un film avec une épaisseur de 60 nm, et on a chauffé le film à 130 °C pendant 10 minutes sous atmosphère d'azote gazeux, pour ainsi former une couche électroluminescente ;

On a dissous le composé de polymère P4 tel que défini en (b) ci-avant à une concentration de 0,25 % en poids dans du 2,2,3,3,4,4,5,5-octafluoro-1-pentanol ; on a déposé à la tournette la solution de 2,2,3,3,4,4,5,5-octafluoro-1-pentanol résultante sur la couche électroluminescente pour former un film avec une épaisseur de 10 nm, et on a chauffé le film à 130 °C pendant 10 minutes sous atmosphère d'azote gazeux, pour ainsi former une couche de transport d'électrons ;

On a placé le substrat portant la couche de transport d'électrons formée sur celui-ci dans une machine de dépôt en phase vapeur, et on a réduit la pression à $1,0 \times 10^{-4}$ Pa ou moins, puis on a déposé en phase vapeur, en tant que cathode, du fluorure de sodium avec une épaisseur d'environ 4 nm sur la couche électroluminescente, puis on a déposé en phase vapeur de l'aluminium avec une épaisseur d'environ 80 nm sur la couche de fluorure de sodium ; après le dépôt en phase vapeur, on a réalisé un scellage avec un substrat en verre, pour ainsi fabriquer un dispositif électroluminescent ;

(d) On a attaché un substrat en verre avec un film d'ITO avec une épaisseur de 45 nm par un procédé de pulvérisation cathodique, pour former une anode ; sur l'anode, on a déposé à la tournette un agent d'injection de trous de type polythiophène-acide sulfonique AQ-1200 (fabriqué par Plectronics) pour former un film avec une épaisseur de 35 nm, et on a chauffé le film sur une plaque chaude à 170 °C pendant 15 minutes sous atmosphère d'air, pour ainsi former une couche d'injection de trous ;

On a dissous le composé de polymère P1 et le composé G2 tel que défini en (b) ci-avant (composé de polymère P1/composé G2 = 85 % en poids/15 % en poids) à une concentration de 0,5 % en poids dans du chlorobenzène ; on a déposé à la tournette la solution de chlorobenzène résultante sur la couche d'injection de trous pour former un film avec une épaisseur de 20 nm, et on a chauffé le film sur une plaque chaude à 180 °C pendant 60 minutes sous atmosphère d'azote gazeux, pour ainsi former une couche de transport de trous ; par le chauffage sur une plaque chaude à 180 °C pendant 60 minutes, le composé de polymère P1 devient un corps réticulé du composé de polymère P1;

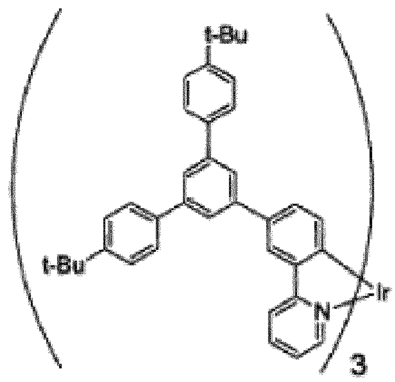

Composé G1

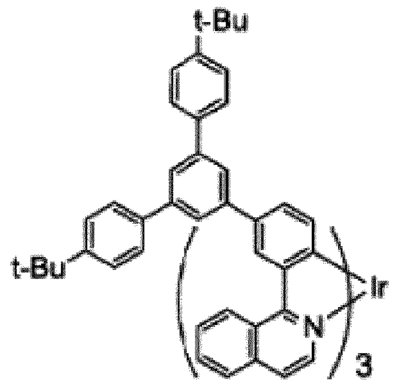

Composé G3

On a dissous du 2,8-di(9H-carbazol-9-yl)dibenzo[b,d]thiophène (DCzDBT) (fabriqué par Luminescence Technology Corp), le composé G2 tel que défini en (b) ci-avant, le composé G$^1$ et le composé G3 (DCzDBT/composé G2/composé G1/composé G3 = 69 % en poids/30 % en poids/0,6 % en poids/0,4 % en poids) à une concentration de 2,0 % en poids dans du chlorobenzène ; on a déposé à la tournette la solution de chlorobenzène résultante sur la couche de transport de trous pour former un film avec une épaisseur de 60 nm, et on a chauffé le film à 130 °C pendant 10 minutes sous atmosphère d'azote gazeux, pour ainsi former une couche électroluminescente ;

On a dissous le composé de polymère P4 tel que défini en (b) ci-avant à une concentration de 0,25 % en poids dans du 2,2,3,3,4,4,5,5-octafluoro-1-pentanol ; on a déposé à la tournette la solution de 2,2,3,3,4,4,5,5-octafluoro-1-pentanol résultante sur la couche électroluminescente pour former un film avec une épaisseur de 10 nm, et on a chauffé le film à 130 °C pendant 10 minutes sous atmosphère d'azote gazeux, pour ainsi former une couche de transport d'électrons ;

On a placé le substrat portant la couche de transport d'électrons formée sur celui-ci dans une machine de dépôt en phase vapeur, et on a réduit la pression à 1,0 x $10^{-4}$ Pa ou moins, puis on a déposé en phase vapeur, en tant que cathode, du fluorure de sodium avec une épaisseur d'environ 4 nm sur la couche électroluminescente, puis on a déposé en phase vapeur de l'aluminium avec une épaisseur d'environ 80 nm sur la couche de fluorure de sodium ; après le dépôt en phase vapeur, on a réalisé un scellage avec un substrat en verre, pour ainsi fabriquer un dispositif électroluminescent ;

(e) On a attaché un substrat en verre avec un film d'ITO avec une épaisseur de 45 nm par un procédé de pulvérisation cathodique, pour former une anode ; sur l'anode, on a déposé à la tournette un agent d'injection de trous de type polythiophène-acide sulfonique AQ-1200 (fabriqué par Plectronics) pour former un film avec une épaisseur de 35 nm, et on a chauffé le film sur une plaque chaude à 170 °C pendant 15 minutes sous atmosphère d'air, pour ainsi former une couche d'injection de trous ;

On a dissous le composé de polymère P1 tel que défini en (b) ci-avant, le composé G1 et le composé G3 tels que définis en (d) ci-avant (composé de polymère P1/composé G1/composé G3 = 95 % en poids/3 % en poids/2 % en poids) à une concentration de 0,5 % en poids dans du chlorobenzène ; on a déposé à la tournette la solution de chlorobenzène résultante sur la couche d'injection de trous pour former un film avec une épaisseur de 20 nm, et on a chauffé le film sur une plaque chaude à 180 °C pendant 60 minutes sous atmosphère d'azote gazeux, pour ainsi former une couche de transport de trous ; par le chauffage sur une plaque chaude à 180 °C pendant 60 minutes, le composé de polymère P1 devient un corps réticulé du composé de polymère P1;

On a dissous du 2,8-di(9H-carbazol-9-yl)dibenzo[b,d]thiophène (DCzDBT) (fabriqué par Luminescence Technology Corp), le composé G2 tel que défini en (b) ci-avant, le composé G1 et le composé G3 tels que définis en (d) ci-avant (DCzDBT/composé G2/composé G1/composé G3 = 69 % en poids/30 % en poids/0,6 % en poids/0,4 % en poids) à une concentration de 2,0 % en poids dans du chlorobenzène ; on a déposé à la tournette la solution de chlorobenzène résultante sur la couche de transport de trous pour former un film avec une épaisseur de 60 nm, et on a chauffé le film à 130 °C pendant 10 minutes sous atmosphère d'azote gazeux, pour ainsi former une couche électroluminescente ;

On a dissous le composé de polymère P4 tel que défini en (b) ci-avant à une concentration de 0,25 % en poids dans du 2,2,3,3,4,4,5,5-octafluoro-1-pentanol ; on a déposé à la tournette la solution de 2,2,3,3,4,4,5,5-octafluoro-1-pentanol résultante sur la couche électroluminescente pour former un film avec une épaisseur de 10 nm, et on a chauffé le film à 130 °C pendant 10 minutes sous atmosphère d'azote gazeux, pour ainsi former une couche de transport d'électrons ;

On a placé le substrat portant la couche de transport d'électrons formée sur celui-ci dans une machine de dépôt en phase vapeur, et on a réduit la pression à 1,0 x $10^{-4}$ Pa ou moins, puis on a déposé en phase vapeur, en tant que cathode, du fluorure de sodium avec une épaisseur d'environ 4 nm sur la couche électroluminescente, puis on a déposé en phase vapeur de l'aluminium avec une épaisseur d'environ 80 nm sur la couche de fluorure de sodium ; après le dépôt en phase vapeur, on a réalisé un scellage avec un substrat en verre, pour ainsi fabriquer un dispositif électroluminescent ;

(f) On a attaché un substrat en verre avec un film d'ITO avec une épaisseur de 45 nm par un procédé de pulvérisation cathodique, pour former une anode ; sur l'anode, on a déposé à la tournette un agent d'injection de trous de type polythiophène-acide sulfonique AQ-1200 (fabriqué par Plectronics) pour former un film avec une épaisseur de 35 nm, et on a chauffé le film sur une plaque chaude à 170 °C pendant 15 minutes sous atmosphère d'air, pour ainsi former une couche d'injection de trous ;

On a dissous le composé de polymère P1 tel que défini en (b) ci-avant, le composé G1 et le composé G3 tels que définis en (d) ci-avant (composé de polymère P1/composé G1/composé G3 = 90 % en poids/6 % en poids/4 % en poids) à une concentration de 0,5 % en poids dans du chlorobenzène ; on a déposé à la tournette la solution de chlorobenzène résultante sur la couche d'injection de trous pour former un film avec une épaisseur de 20 nm, et on a chauffé le film sur une plaque chaude à 180 °C pendant 60 minutes sous atmosphère d'azote gazeux, pour ainsi former une couche de transport de trous ; par le chauffage sur une plaque chaude à 180 °C pendant 60 minutes, le composé de polymère P1 devient un corps réticulé du composé de polymère P1;

On a dissous du 2,8-di(9H-carbazol-9-yl)dibenzo[b,d]thiophène (DCzDBT) (fabriqué par Luminescence Technology Corp), le composé G2 tel que défini en (b) ci-avant, le composé G1 et le composé G3 tels que définis en (d) ci-avant (DCzDBT/composé G2/composé G1/composé G3 = 69 % en poids/30 % en poids/0,6 % en poids/0,4 % en poids) à une concentration de 2,0 % en poids dans du chlorobenzène ; on a déposé à la tournette la solution de chlorobenzène résultante sur la couche de transport de trous pour former un film avec une épaisseur de 60 nm, et on a chauffé le film à 130 °C pendant 10 minutes sous atmosphère d'azote gazeux, pour ainsi former une couche électroluminescente ;

On a dissous le composé de polymère P4 tel que défini en (b) ci-avant à une concentration de 0,25 % en poids dans du 2,2,3,3,4,4,5,5-octafluoro-1-pentanol ; on a déposé à la tournette la solution de 2,2,3,3,4,4,5,5-octafluoro-1-pentanol résultante sur la couche électroluminescente pour former un film avec une épaisseur de 10 nm, et on a chauffé le film à 130 °C pendant 10 minutes sous atmosphère d'azote gazeux, pour ainsi former une couche de transport d'électrons ;

On a placé le substrat portant la couche de transport d'électrons formée sur celui-ci dans une machine de dépôt en phase vapeur, et on a réduit la pression à 1,0 x $10^{-4}$ Pa ou moins, puis on a déposé en phase vapeur, en tant que cathode, du fluorure de sodium avec une épaisseur d'environ 4 nm sur la couche électroluminescente, puis on a déposé en phase vapeur de l'aluminium avec une épaisseur d'environ 80 nm sur la couche de fluorure de sodium ; après le dépôt en phase vapeur, on a réalisé un scellage avec un substrat en verre, pour ainsi fabriquer un dispositif électroluminescent ;

(g) On a attaché un substrat en verre avec un film d'ITO avec une épaisseur de 45 nm par un procédé de pulvérisation cathodique, pour former une anode ; sur l'anode, on a déposé à la tournette un agent d'injection de trous de type polythiophène-acide sulfonique AQ-1200 (fabriqué par Plectronics) pour former un film avec une épaisseur de 35 nm, et on a chauffé le film sur une plaque chaude à 170 °C pendant 15 minutes sous atmosphère d'air, pour ainsi former une couche d'injection de trous ;

On a dissous le composé de polymère P1 tel que défini en (b) ci-avant à une concentration de 0,5 % en poids dans du chlorobenzène ; on a déposé à la tournette la solution de chlorobenzène résultante sur la couche d'injection de trous pour former un film avec une épaisseur de 20 nm, et on a chauffé le film sur une plaque chaude à 180 °C pendant 60 minutes sous atmosphère d'azote gazeux, pour ainsi former une couche de transport de trous ; par le chauffage sur une plaque chaude à 180 °C pendant 60 minutes, le composé de polymère P1 devient un corps réticulé du composé de polymère P1 ;

On a dissous du 2,8-di(9H-carbazol-9-yl)dibenzo[b,d]thiophène (DCzDBT) (fabriqué par Luminescence Technology Corp), le composé G2 tel que défini en (b) ci-avant (DCzDBT/composé G2 = 70 % en poids/30 % en poids) à une concentration de 2,0 % en poids dans du chlorobenzène ; on a déposé à la tournette la solution de chlorobenzène résultante sur la couche de transport de trous pour former un film avec une épaisseur de 60 nm, et on a chauffé le film à 130 °C pendant 10 minutes sous atmosphère d'azote gazeux, pour ainsi former une couche électroluminescente ;

On a dissous le composé de polymère P4 tel que défini en (b) ci-avant à une concentration de 0,25 % en poids dans du 2,2,3,3,4,4,5,5-octafluoro-1-pentanol ; on a déposé à la tournette la solution de 2,2,3,3,4,4,5,5-octafluoro-1-pentanol résultante sur la couche électroluminescente pour former un film avec une épaisseur de 10 nm, et on a chauffé le film à 130 °C pendant 10 minutes sous atmosphère d'azote gazeux, pour ainsi former une couche de transport d'électrons ;

On a placé le substrat portant la couche de transport d'électrons formée sur celui-ci dans une machine de dépôt en phase vapeur, et on a réduit la pression à 1,0 x $10^{-4}$ Pa ou moins, puis on a déposé en phase vapeur, en tant que cathode, du fluorure de sodium avec une épaisseur d'environ 4 nm sur la couche électroluminescente, puis on a déposé en phase vapeur de l'aluminium avec une épaisseur d'environ 80 nm sur la couche de fluorure de sodium ; après le dépôt en phase vapeur, on a réalisé un scellage avec un substrat en verre, pour ainsi fabriquer un dispositif électroluminescent ;

(h) On a attaché un substrat en verre avec un film d'ITO avec une épaisseur de 45 nm par un procédé de pulvérisation cathodique, pour former une anode ; sur l'anode, on a déposé à la tournette un agent d'injection de trous de type polythiophène-acide sulfonique AQ-1200 (fabriqué par Plectronics) pour former un film avec une épaisseur de 35 nm, et on a chauffé le film sur une plaque chaude à 170 °C pendant 15 minutes sous atmosphère d'air, pour ainsi former une couche d'injection de trous ;

On a dissous le composé de polymère P1 tel que défini en (b) ci-avant à une concentration de 0,5 % en poids dans du chlorobenzène ; on a déposé à la tournette la solution de chlorobenzène résultante sur la couche d'injection de trous pour former un film avec une épaisseur de 20 nm, et on a chauffé le film sur une plaque chaude à 180 °C pendant 60 minutes sous atmosphère d'azote gazeux, pour ainsi former une couche de transport de trous ; par le chauffage sur une plaque chaude à 180 °C pendant 60 minutes, le composé de polymère P1 devient un corps réticulé du composé de polymère P1 ;

On a dissous du 2,8-di(9H-carbazol-9-yl)dibenzo[b,d]thiophène (DCzDBT) (fabriqué par Luminescence Technology Corp), le composé G2 tel que défini en (b) ci-avant, le composé G1 et le composé G3 tels que définis en (d) ci-avant (DCzDBT/composé G2/composé G1/composé G3 = 69 % en poids/30 % en poids/0,6 % en poids/0,4 % en poids) à une concentration de 2,0 % en poids dans du chlorobenzène ; on a déposé à la tournette la solution de chlorobenzène résultante sur la couche de transport de trous pour former un film avec une épaisseur de 60 nm, et on a chauffé le film à 130 °C pendant 10 minutes sous atmosphère d'azote gazeux, pour ainsi former une couche électroluminescente ;

On a dissous le composé de polymère P4 tel que défini en (b) ci-avant à une concentration de 0,25 % en poids dans du 2,2,3,3,4,4,5,5-octafluoro-1-pentanol ; on a déposé à la tournette la solution de 2,2,3,3,4,4,5,5-octafluoro-1-pentanol résultante sur la couche électroluminescente pour former un film avec une épaisseur de 10 nm, et on a chauffé le film à 130 °C pendant 10 minutes sous atmosphère d'azote gazeux, pour ainsi former une couche de transport d'électrons ;

On a placé le substrat portant la couche de transport d'électrons formée sur celui-ci dans une machine de dépôt en phase vapeur, et on a réduit la pression à 1,0 x $10^{-4}$ Pa ou moins, puis on a déposé en phase vapeur, en tant que cathode, du fluorure de sodium avec une épaisseur d'environ 4 nm sur la couche électroluminescente, puis on a déposé en phase vapeur de l'aluminium avec une épaisseur d'environ 80 nm sur la couche de fluorure de sodium ; après le dépôt en phase vapeur, on a réalisé un scellage avec un substrat en verre, pour ainsi fabriquer un dispositif électroluminescent ;

(i) On a formé une anode par la fourniture d'un film d'ITO ayant une épaisseur de 45 nm par un procédé de pulvérisation cathodique sur un substrat en verre ; sur l'anode, on a appliqué par un procédé de dépôt à la tournette du AQ-1200 (fabriqué par Plectronics Inc.) en tant qu'agent d'injection de trous à base de polythiophène-acide sulfonique pour former un film ayant une épaisseur de 35 nm, puis on l'a chauffé sur une plaque chaude pendant 15 minutes à 170 °C dans une atmosphère ambiante, pour ainsi former une couche d'injection de trous ;

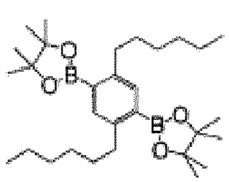
Composé 1

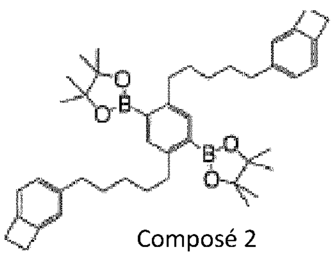
Composé 2

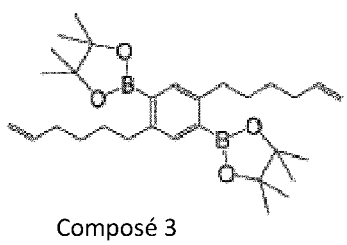
Composé 3

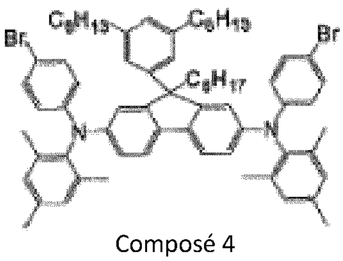

Composé 4

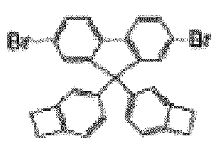

Composé 5

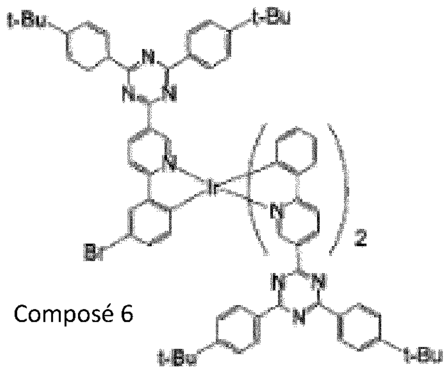

Composé 6

On a dissous le composé de polymère 1 dans du xylène à une concentration de 0,6 % en poids, où le composé de polymère 1 est un copolymère comprenant des motifs constitutifs dérivés du composé 1, du composé 2, du composé 3, du composé 4, du composé 5 et du composé 6 à un rapport molaire de 30:10:10:39,4:10:1,2 ; on a utilisé la solution de xylène résultante pour former un film ayant une épaisseur de 20 nm par dépôt à la tournette sur la couche d'injection de trous, puis on l'a chauffé sur une plaque chaude pendant 60 minutes à 180 °C dans une atmosphère d'azote gazeux, pour ainsi former une première couche électroluminescente.

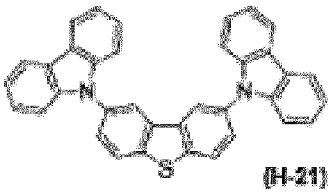

(H-21)

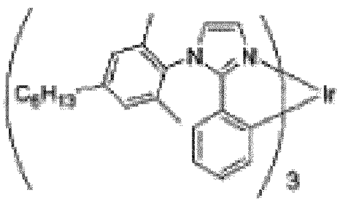

(1-A3-6)

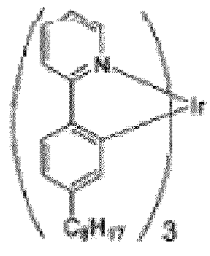

COM-1

On a préparé une première encre par dissolution du composé (H-21), du composé (1-A3-6), du composé COM-1 (composé (H-21)/composé (1-A3-6)/composé COM-1 (rapport en poids) = 69,77/30/0,23) dans du toluène à une concentration de 2,0 % en poids ; on a appliqué la première encre sur la première couche électroluminescente par un procédé de dépôt à la tournette pour former un film ayant une épaisseur de 75 nm, puis on l'a chauffé sur une plaque chaude pendant 10 minutes à 130 °C dans une atmosphère d'azote gazeux, pour ainsi former une deuxième couche électroluminescente ;

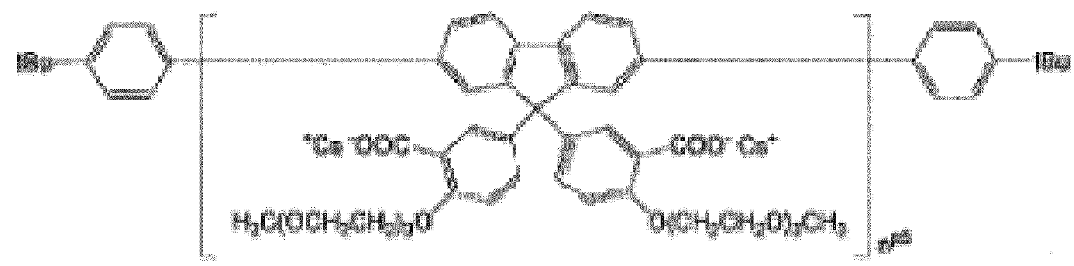

Composé de polymère 5

On a préparé une deuxième encre par dissolution du composé de polymère 5 dans du 2,2,3,3,4,4,5,5-octafluoro-1-pentanol à une concentration de 0,25 % en poids ; la structure di composé de polymère 5 est présentée ci-avant, dans laquelle $n^{p5}$ désigne un degré de polymérisation ; on a appliqué la deuxième encre sur la deuxième couche électroluminescente par un procédé de dépôt à la tournette pour former un film ayant une épaisseur de 10 nm, puis on l'a chauffé sur une plaque chaude pendant 10 minutes à 130 °C dans une atmosphère d'azote gazeux, pour ainsi former une couche de transport d'électrons ; sur la couche de transport d'électrons, on a évaporé, en tant que cathode, du fluorure de sodium pour lui donner une épaisseur d'environ 7 nm, puis on a évaporé de l'aluminium pour lui donner une épaisseur d'environ 120 nm, pour ainsi fabriquer un dispositif électroluminescent ;

(j) On a formé une anode par la fourniture d'un film d'ITO ayant une épaisseur de 45 nm par un procédé de pulvérisation cathodique sur un substrat en verre ; sur l'anode, on a appliqué par un procédé de dépôt à la tournette du AQ-1200 (fabriqué par Plectronics Inc.) en tant qu'agent d'injection de trous à base de polythiophène-acide sulfonique pour former un film ayant une épaisseur de 35 nm, puis on l'a chauffé sur une plaque chaude pendant 15 minutes à 170 °C dans une atmosphère ambiante, pour ainsi former une couche d'injection de trous ;

On a dissous le composé de polymère 1 tel que défini en (i) ci-avant dans du xylène à une concentration de 0,6 % en poids ; on a utilisé la solution de xylène résultante pour former un film ayant une épaisseur de 20 nm par dépôt à la tournette sur la couche d'injection de trous, puis on l'a chauffé sur une plaque chaude pendant 60 minutes à 180 °C dans une atmosphère d'azote gazeux, pour ainsi former une première couche électroluminescente ;

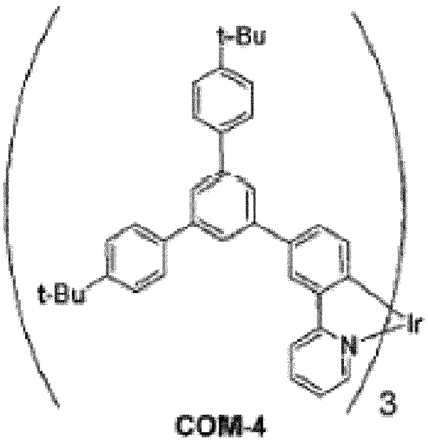

COM-4

On a préparé une première encre par dissolution du composé (H-21) et du composé (1-A3-6), tel que défini en (i) ci-avant, et du composé COM-4 (rapport en poids de composé (H-21)/composé (1-A3-6)/composé COM-4 = 69,6/30/0,4) dans du toluène à une concentration de 2,0 % en poids ; on a appliqué la première encre sur la première couche électroluminescente par un procédé de dépôt à la tournette pour former un film ayant une épaisseur de 75 nm, puis on l'a chauffé sur une plaque chaude pendant 10 minutes à 130 °C dans une atmosphère d'azote gazeux, pour ainsi former une deuxième couche électroluminescente ;

On a préparé une deuxième encre par dissolution du composé de polymère 5 tel que défini en (i) ci-avant dans du 2,2,3,3,4,4,5,5-octafluoro-1-pentanol à une concentration de 0,25 % en poids ; on a appliqué la deuxième encre sur la deuxième couche électroluminescente par un procédé de dépôt à la tournette pour former un film ayant une épaisseur de 10 nm, puis on l'a chauffé sur une plaque chaude pendant 10 minutes à 130 °C dans une atmosphère d'azote gazeux, pour ainsi former une couche de transport d'électrons ; sur la couche de transport d'électrons, on a évaporé, en tant que cathode, du fluorure de sodium pour lui donner une épaisseur d'environ 7 nm, puis on a évaporé de l'aluminium pour lui donner une épaisseur d'environ 120 nm, pour ainsi fabriquer un dispositif électroluminescent ;

(k) On a formé une anode par la fourniture d'un film d'ITO ayant une épaisseur de 45 nm par un procédé de pulvérisation cathodique sur un substrat en verre ; sur l'anode, on a appliqué par un procédé de dépôt à la tournette du AQ-1200 (fabriqué par Plectronics Inc.) en tant qu'agent d'injection de trous à base de polythiophène-acide sulfonique pour former un film ayant une épaisseur de 35 nm, puis on l'a chauffé sur une plaque chaude pendant 15 minutes à 170 °C dans une atmosphère ambiante, pour ainsi former une couche d'injection de trous ;

On a dissous le composé de polymère P1 tel que défini en (i) ci-avant dans du xylène à une concentration de 0,6 % en poids ; on a utilisé la solution de xylène résultante pour former un film ayant une épaisseur de 20 nm par dépôt à la tournette sur la couche d'injection de trous, puis on l'a chauffé sur une plaque chaude pendant 60 minutes à 180 °C dans une atmosphère d'azote gazeux, pour ainsi former une première couche électroluminescente ;

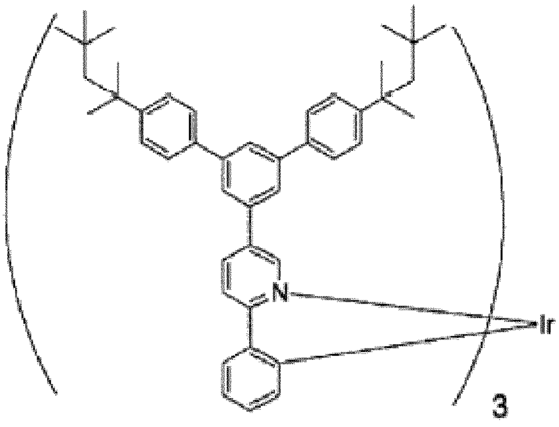

COM-9

On a préparé une première encre par dissolution du composé (H-21), du composé (1-A3-6), du composé COM-4 tel que défini en (i) et (j) ci-avant, et du composé COM-9 (rapport en poids de composé (H-21)/composé (1-A3-6)/composé COM-4/composé COM-9 = 69,6/30/0,2/0,2) dans du toluène à une concentration de 2,0 % en poids ; on a appliqué la première encre sur la première couche électroluminescente par un procédé de dépôt à la tournette pour former un film ayant une épaisseur de 75 nm, puis on l'a chauffé sur une plaque chaude pendant 10 minutes à 130 °C dans une atmosphère d'azote gazeux, pour ainsi former une deuxième couche électroluminescente ;
On a préparé une deuxième encre par dissolution du composé de polymère 5 tel que défini en (i) ci-avant dans du 2,2,3,3,4,4,5,5-octafluoro-1-pentanol à une concentration de 0,25 % en poids ; on a appliqué la deuxième encre sur la deuxième couche électroluminescente par un procédé de dépôt à la tournette pour former un film ayant une épaisseur de 10 nm, puis on l'a chauffé sur une plaque chaude pendant 10 minutes à 130 °C dans une atmosphère d'azote gazeux, pour ainsi former une couche de transport d'électrons ; sur la couche de transport d'électrons, on a évaporé, en tant que cathode, du fluorure de sodium pour lui donner une épaisseur d'environ 7 nm, puis on a évaporé de l'aluminium pour lui donner une épaisseur d'environ 120 nm, pour ainsi fabriquer un dispositif électroluminescent.

2. Dispositif électroluminescent selon la revendication 1, dans lequel le composé phosphorescent n'est pas un composé phosphorescent représenté par l'une quelconque de la formule COM-17, B2 ou B3 suivante :

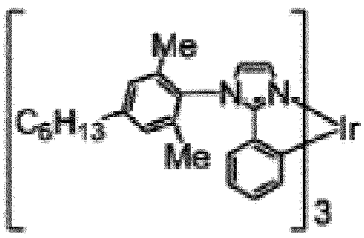

COM-17

,

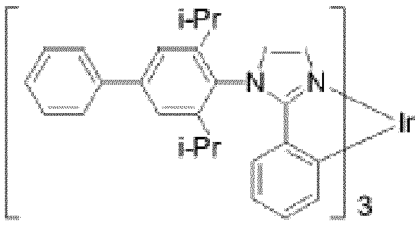

**composé phosphorescent B2,** ou

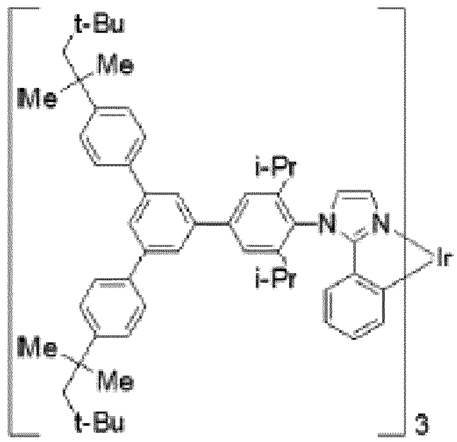

**composé phosphorescent B3**

3. Dispositif électroluminescent selon la revendication 1, dans lequel le composé phosphorescent de formule (1) est un composé phosphorescent représenté par les formules COM-18 à COM-28 suivantes :

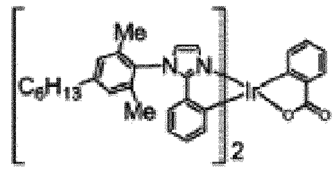

COM-18

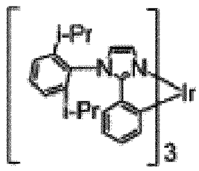

COM-19

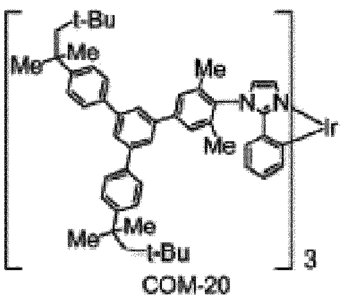

COM-20

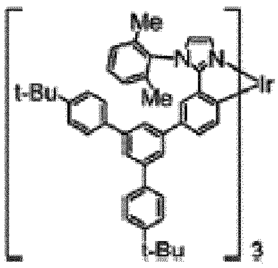

COM-21

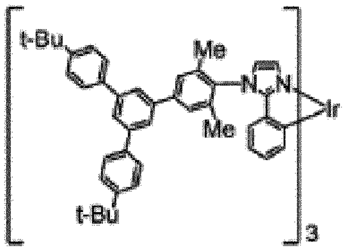

COM-22

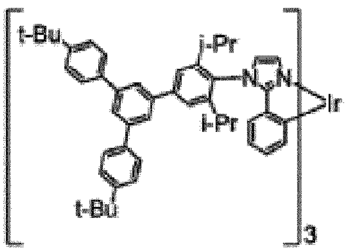

COM-23

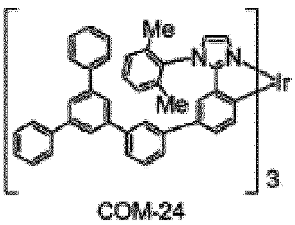

COM-24

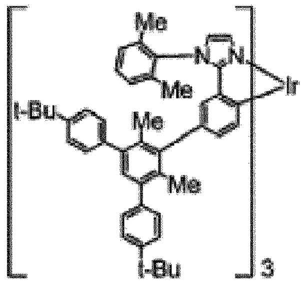

COM-25

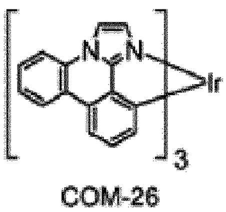

COM-26

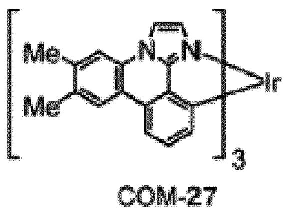

COM-27

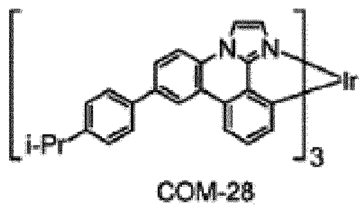

COM-28

**4.** Dispositif électroluminescent selon l'une quelconque des revendications 1 à 3, dans lequel la valeur de $(Y_1 \times 1000)/X_1$ est de 0,65 ou plus.

**5.** Dispositif électroluminescent selon l'une quelconque des revendications 1 à 4, dans lequel au moins l'un choisi dans le groupe constitué par $R^{11A}$, $R^{12A}$, $R^{13A}$, $R^{21A}$, $R^{22A}$, $R^{23A}$ et $R^{24A}$ est un groupe représenté par la formule (D-A) ou (D-B) :

[formule chimique 2]

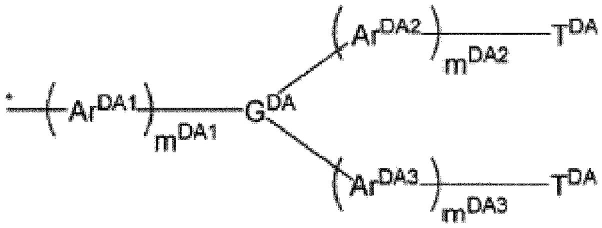

**(D-A)**

où,

$m^{DA1}$, $m^{DA2}$ et $m^{DA3}$ représentent chacun indépendamment un entier de 0 ou plus ;
$G^{DA}$ représente un atome d'azote, un groupe hydrocarboné aromatique ou un groupe hétérocyclique, et ces groupes ont chacun éventuellement un substituant ;
$Ar^{DA1}$, $Ar^{DA2}$ et $Ar^{DA3}$ représentent chacun indépendamment un groupe arylène ou un groupe hétérocyclique divalent, et ces groupes ont chacun éventuellement un substituant ; et lorsqu'une pluralité de $Ar^{DA1}$, $Ar^{DA2}$ et $Ar^{DA3}$ sont présents, ils peuvent être identiques ou différents à chaque occurrence ; et
$T^{DA}$ représente un groupe aryle ou un groupe hétérocyclique monovalent, et ces groupes ont chacun éventuellement un substituant ; et la pluralité de $T^{DA}$ peuvent être identiques ou différents ; et
* représente une position de liaison, et

[formule chimique 3]

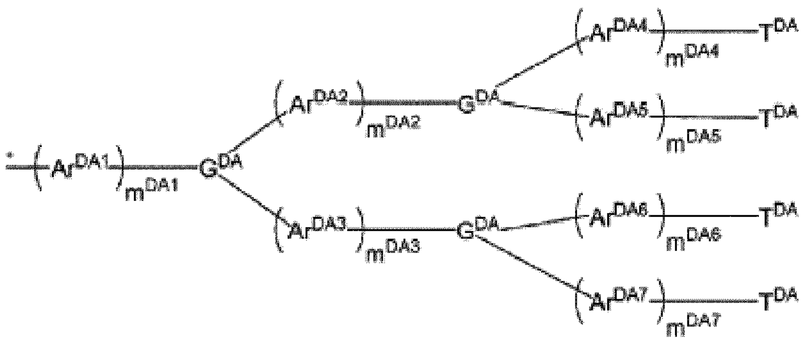

**(D-B)**

où,

$m^{DA1}$, $m^{DA2}$, $m^{DA3}$, $m^{DA4}$, $m^{DA5}$, $m^{DA6}$ et $m^{DA7}$ représentent chacun indépendamment un entier de 0 ou plus ;
$G^{DA}$ représente un atome d'azote, un groupe hydrocarboné aromatique ou un groupe hétérocyclique, et ces groupes ont chacun éventuellement un substituant, et la pluralité de $G^{DA}$ peuvent être identiques ou différents ;
$Ar^{DA1}$, $Ar^{DA2}$, $Ar^{DA3}$, $Ar^{DA4}$, $Ar^{DA5}$, $Ar^{DA6}$ et $Ar^{DA7}$ représentent chacun indépendamment un groupe arylène ou un groupe hétérocyclique divalent, et ces groupes ont chacun éventuellement un substituant ; et lorsqu'une pluralité de $Ar^{DA1}$, $Ar^{DA2}$, $Ar^{DA3}$, $Ar^{DA4}$, $Ar^{DA5}$, $Ar^{DA6}$ et $Ar^{DA7}$ sont présents, ils peuvent être identiques ou différents à chaque occurrence ; et
$T^{DA}$ représente un groupe aryle ou un groupe hétérocyclique monovalent, et ces groupes ont chacun éventuellement un substituant, et la pluralité de $T^{DA}$ peuvent être identiques ou différents ; et

* représente une position de liaison.

**6.** Dispositif électroluminescent selon l'une quelconque des revendications 1, 4 ou 5, dans lequel le composé phosphorescent est représenté par la formule (1-1) ou (1-2) :

[formule chimique 4]

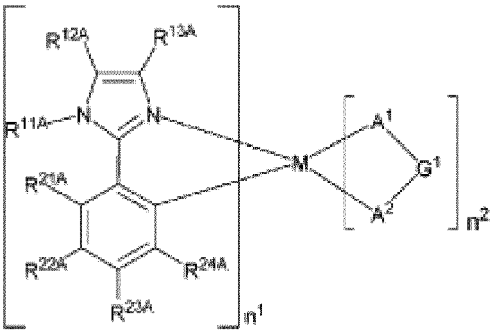

(1-1)

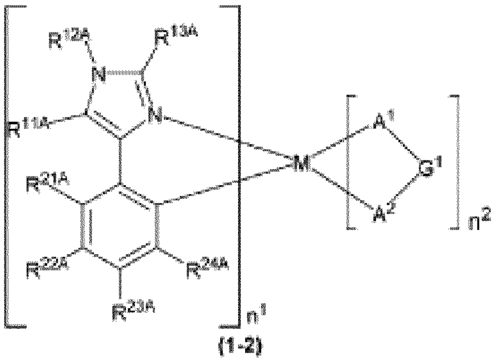

(1-2)

où M, $n^1$, $n^2$, $R^{11A}$, $R^{12A}$, $R^{13A}$, $R^{21A}$ $R^{22A}$, $R^{23A}$, $R^{24A}$ et $A^1$-$G^1$-$A^2$ représentent les mêmes significations que décrit ci-avant.

**7.** Dispositif électroluminescent selon l'une quelconque des revendications 1 à 6, dans lequel le composé de polymère réticulable comprend un motif constitutif représenté par la formule (2) :

[formule chimique 5]

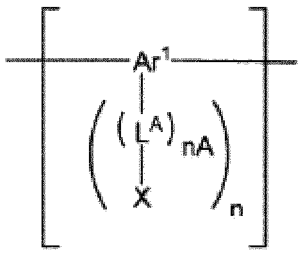

(2)

où,

nA représente un entier de 0 à 5, et n représente 1 ou 2 ;
$Ar^1$ représente un groupe hydrocarboné aromatique ou un groupe hétérocyclique, et ces groupes ont chacun éventuellement un substituant ;
$L^A$ représente un groupe alkylène, un groupe cycloalkylène, un groupe arylène, un groupe hétérocyclique divalent, un groupe représenté par -NR'-, un atome d'oxygène ou un atome de soufre, et ces groupes ont chacun éventuellement un substituant ; R' représente un atome d'hydrogène, un groupe alkyle, un groupe cycloalkyle, un groupe aryle ou un groupe hétérocyclique monovalent, et ces groupes ont chacun éventuellement un substituant : et lorsqu'une pluralité de $L^A$ sont présents, ils peuvent être identiques ou différents ; et
X représente un groupe réticulable choisi dans le groupe A de groupes réticulables, et lorsqu'une pluralité de X sont présents, ils peuvent être identiques ou différents.

**8.** Dispositif électroluminescent selon l'une quelconque des revendications 1 à 7, dans lequel le composé de polymère réticulable comprend un motif constitutif représenté par la formule (3) :

[formule chimique 6]

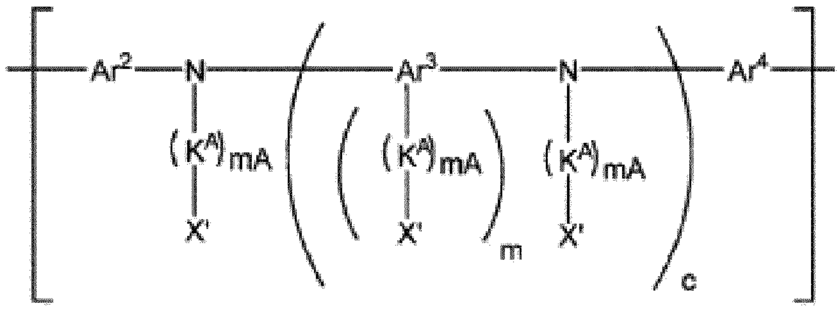

(3)

où,

mA représente un entier de 0 à 5, m représente 1 à 4, c représente 0 ou 1, et lorsqu'une pluralité de mA sont présents, ils peuvent être identiques ou différents ;
$Ar^3$ représente un groupe hydrocarboné aromatique, un groupe hétérocyclique ou un groupe dans lequel au moins un cycle hydrocarboné aromatique et au moins un cycle hétérocyclique sont liés directement l'un à l'autre, et ces groupes ont chacun éventuellement un substituant ;
$Ar^2$ et $Ar^4$ représentent chacun indépendamment un groupe arylène ou un groupe hétérocyclique divalent, et ces groupes ont chacun éventuellement un substituant ;
chacun de $Ar^2$, $Ar^3$ et $Ar^4$ peut être lié directement ou via un atome d'oxygène ou un atome de soufre à un groupe qui est différent de ce groupe et qui est attaché à l'atome d'azote auquel ce groupe est attaché, pour ainsi former un cycle ;
$K^A$ représente un groupe alkylène, un groupe cycloalkylène, un groupe arylène, un groupe hétérocyclique divalent, un groupe représenté par -NR"-, un atome d'oxygène ou un atome de soufre, et ces groupes ont chacun éventuellement un substituant ; R" représente un atome d'hydrogène, un groupe alkyle, un groupe cycloalkyle, un groupe aryle ou un groupe hétérocyclique monovalent, et ces groupes ont chacun éventuellement un substituant ; et lorsqu'une pluralité de $K^A$ sont présents, ils peuvent être identiques ou différents ; et
X' représente un groupe réticulable choisi dans le groupe A de groupes réticulables, un atome d'hydrogène, un groupe alkyle, un groupe cycloalkyle, un groupe aryle ou un groupe hétérocyclique monovalent, et ces groupes ont chacun éventuellement un substituant ; et lorsqu'une pluralité de X' sont présents, ils peuvent être identiques ou différents ; à condition qu'au moins un X' soit un groupe réticulable choisi dans le groupe A de groupes réticulables.

**9.** Dispositif électroluminescent selon l'une quelconque des revendications 1 à 8, dans lequel la première couche organique comprend en outre un composé de polymère comprenant un motif constitutif représenté par la formule (Y) :

[formule chimique 8] $-[Ar^{Y1}]-$ (Y)

où $Ar^{Y1}$ représente un groupe arylène, un groupe hétérocyclique divalent ou un groupe divalent dans lequel au moins un groupe arylène et au moins un groupe hétérocyclique divalent sont liés directement l'un à l'autre, et ces groupes ont chacun éventuellement un substituant.

**10.** Dispositif électroluminescent selon l'une quelconque des revendications 1 à 8, dans lequel la première couche organique comprend en outre un composé représenté par la formule (H-1) :

[formule chimique 9]

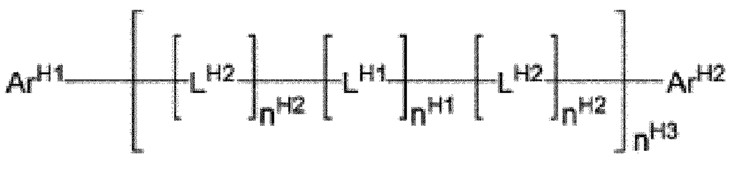

**(H-1)**

où,

$Ar^{H1}$ et $Ar^{H2}$ représentent chacun indépendamment un groupe aryle ou un groupe hétérocyclique monovalent, et ces groupes ont chacun éventuellement un substituant ;
$n^{H1}$ et $n^{H2}$ représentent chacun indépendamment 0 ou 1 ; lorsqu'une pluralité de $n^{H1}$ sont présents, ils peuvent être identiques ou différents ; et lorsqu'une pluralité de $n^{H2}$ sont présents, ils peuvent être identiques ou différents ;
$n^{H3}$ représente un entier de 0 ou plus ;
$L^{H1}$ représente un groupe arylène, un groupe hétérocyclique divalent ou un groupe représenté par $-[C(R^{H11})_2]n^{H11}-$, et ces groupes ont chacun éventuellement un substituant ; et lorsqu'une pluralité de $L^{H1}$ sont présents, ils peuvent être identiques ou différents ;
$n^{H11}$ représente un entier de 1 à 10 ; $R^{H11}$ représente un atome d'hydrogène, un groupe alkyle, un groupe cycloalkyle, un groupe alcoxy, un groupe cycloalcoxy, un groupe aryle ou un groupe hétérocyclique monovalent, et ces groupes ont chacun éventuellement un substituant ; la pluralité de $R^{H11}$ peuvent être identiques ou différents et peuvent être combinés ensemble pour former un cycle conjointement aux atomes de carbone auxquels ils sont attachés ;
$L^{H2}$ représente un groupe représenté par $-N(-L^{H21}-RH^{21})-$ ; et lorsqu'une pluralité de $L^{H2}$ sont présents, ils peuvent être identiques ou différents ; et
$L^{H21}$ représente une liaison simple, un groupe arylène ou un groupe hétérocyclique divalent, et ces groupes ont chacun éventuellement un substituant ; et $R^{H21}$ représente un atome d'hydrogène, un groupe alkyle, un groupe cycloalkyle, un groupe aryle ou un groupe hétérocyclique monovalent, et ces groupes ont chacun éventuellement un substituant.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2013191086 A
- JP 2013216789 A
- EP 3131131 A
- EP 3154101 A
- EP 3136462 A
- WO 2007076146 A
- WO 02067343 A
- JP 2003231692 A
- WO 2003079736 A
- WO 2006097717 A
- JP 2004530254 A
- JP 2008179617 A
- JP 2011105701 A
- JP 2007504272 A
- JP 2013147449 A
- JP 2013147450 A
- WO 2006121811 A
- JP 2013048190 A
- US 20110057559
- WO 2013146806 A
- WO 2005049546 A
- JP 2010189630 A
- JP 2012033845 A


### Non-patent literature cited in the description


- *Chem. Rev.,* 2009, vol. 109, 897-1091